(19) Europäisches Patentamt
European Patent Office
Office européen des brevets

(11) **EP 4 729 524 A1**

(12) **EUROPEAN PATENT APPLICATION**
published in accordance with Art. 153(4) EPC

(43) Date of publication:
**22.04.2026 Bulletin 2026/17**

(21) Application number: **23792852.8**

(22) Date of filing: **30.06.2023**

(51) International Patent Classification (IPC):
***C07F 5/02*** *(2006.01)* ***C09K 11/06*** *(2006.01)*
***H10K 85/60*** *(2023.01)* ***H10K 50/11*** *(2023.01)*

(52) Cooperative Patent Classification (CPC):
**H10K 85/658; C07F 5/027; C09K 11/06; H05B 33/14; H10K 50/00; H10K 50/15; H10K 85/633; H10K 85/636; H10K 85/6572; H10K 85/6574; H10K 85/6576;** C09K 2211/1018; H10K 50/11

(86) International application number:
**PCT/CN2023/104688**

(87) International publication number:
**WO 2024/254915 (19.12.2024 Gazette 2024/51)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **13.06.2023 CN 202310696805**

(71) Applicant: **Shenzhen China Star Optoelectronics Semiconductor Display Technology Co., Ltd.**
**Shenzhen, Guangdong 518132 (CN)**

(72) Inventors:
- **SONG, Xinlong**
  **Shenzhen**
  **Guangdong 518132 (CN)**
- **LEI, Jinlong**
  **Shenzhen**
  **Guangdong 518132 (CN)**
- **HE, Ruifeng**
  **Shenzhen**
  **Guangdong 518132 (CN)**
- **SONG, Jingyao**
  **Shenzhen**
  **Guangdong 518132 (CN)**

(74) Representative: **Herrero & Asociados, S.L.**
**Edificio Aqua - Calle Agustín de Foxá, 4-10, 2ºA**
**28036 Madrid (ES)**

(54) **ORGANIC COMPOUND, MIXTURE, COMPOSITION, ORGANIC LIGHT-EMITTING DEVICE AND DISPLAY PANEL**

(57) Embodiments of the present disclosure provide an organic compound having a structure represented by a general formula (1) or (2), an organic light-emitting device, and a display panel, so as to improve the material performance, improve the luminous efficiency of the organic light-emitting device, and prolong the lifetime of the organic light-emitting device.

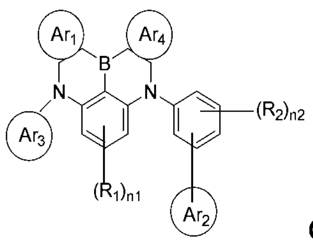

General formula (1)

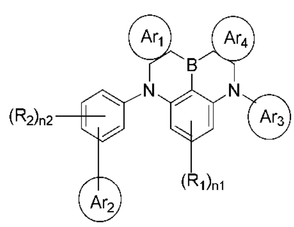

General formula (2)

EP 4 729 524 A1

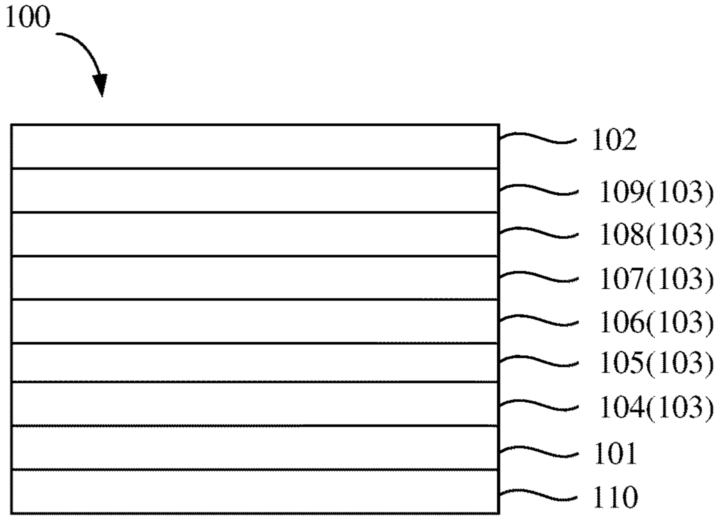


FIG. 1

## Description

TECHNICAL FIELD

The present disclosure relates to the field of display, and in particular, to an organic compound, a mixture, a composition, an organic light-emitting device, and a display panel.

BACKGROUND

At present, organic electroluminescent elements such as organic light-emitting diodes (OLEDs), generally each include an anode, a cathode, and an organic layer therebetween. Organic substances of the organic layer are capable of converting electric energy into light energy, so as to achieve organic electroluminescence. In order to improve luminous efficiency and lifetime of the organic electroluminescent element, the organic layer is usually implemented as a multilayer structure, in which each layer contains different organic substances from each other. The organic layer mainly includes a hole injection layer, a hole transport layer, a light-emitting layer, an electron transport layer, and an electron injection layer. When a voltage is applied between the anode and the cathode of the organic electroluminescent element, the anode injects holes into the organic layer, and the cathode injects electrons into the organic layer. The injected holes and electrons are combined to form excitons. When the excitons transition back to the ground state, light is emitted, thereby achieving light emission of the organic electroluminescent element. The organic electroluminescent element has characteristics such as self-luminous, high brightness, high efficiency, low voltage driving, wide viewing angle, high contrast, and high response. Therefore, the organic electroluminescent device has a wide application prospect.

In order to improve the luminous efficiency of the organic electroluminescent element, various light-emitting material systems based on fluorescence or phosphorescence have been developed. Although the organic electroluminescent element using a fluorescent material has a high reliability, its internal electroluminescent quantum efficiency may be limited to 25% or less, because the excitons have a branching ratio of the singlet excited state to the triplet excited state of 1:3 at electric excitation. However, the organic electroluminescent element using a phosphorescent material can achieve almost 100% of internal electroluminescent quantum efficiency. The phosphorescent material typically includes a metal complex containing iridium or platinum, which is expensive and has complex synthesis procedures. In addition, the phosphorescent organic electroluminescent element may generate a roll-off effect, i.e., the luminous efficiency decreases rapidly with the increase of current or brightness, which limits its application at high luminance levels.

In order to overcome the above defects, a combination of various organic compound-based materials, such as compound excited state materials and thermally activated delayed fluorescence (TADF) materials, is generally used in the prior art to intend to reach a high efficiency comparable to the phosphorescent organic electroluminescent by reverse internal conversion. However, the conventional TADF-containing organic compound has limited improvement of performance in terms of both efficiency and lifetime, resulting in difficulties in improving the luminous efficiency and lifetime of the organic electroluminescent element to which the TADF-containing organic compound is applied.

Therefore, it is desirable to provide an organic compound used for the organic light-emitting device to solve the above defects.

TECHNICAL PROBLEM

An embodiment of the present disclosure provides an organic compound, a mixture, a composition, an organic light-emitting device, and a display panel, so as to improve the luminous efficiency and lifetime of an organic electroluminescent element.

TECHNICAL SOLUTIONS

In order to solve the above defects, the present disclosure provides the following solutions.

An embodiment of the present disclosure provides an organic compound having a strucuture represented by a general formula (1) or (2):

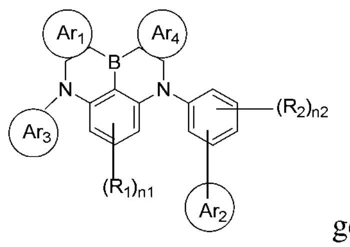

general formula (1)

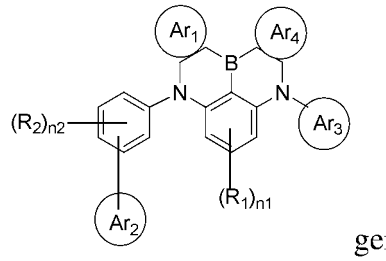

general formula (2).

$Ar_1$ is independently a structure represented by any one selected from the group consisting of formulae (X-1) to (X-3):

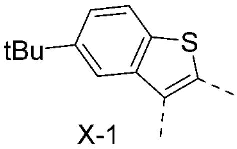

X-1

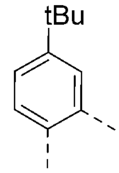

X-2

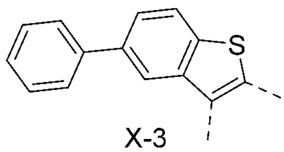

X-3

.

$Ar_3$ and $Ar_4$ are each independently a structure represented by any one selected from the group consisting of formulae (A-1) to (A-5):

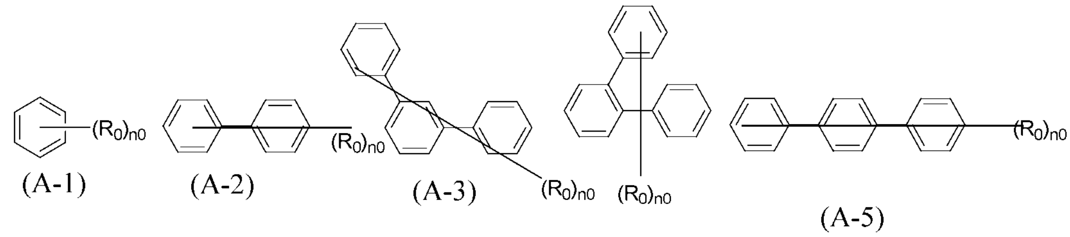

(A-1) (A-2) (A-3) (A-4) (A-5)

.

When $Ar_1$ is formula X-2, $Ar_4$ is independently a structure represented by any one selected from the group consisting of formulae (A-2) to (A-5).

A linkage site of $Ar_3$ is at a carbon atom of any phenyl ring in $Ar_3$, and fused sites of $Ar_4$ are at two ortho carbon atoms of a same phenyl ring in $Ar_4$.

$Ar_2$ is a structure represented by any one selected from the group consisting of formulae (B-1) to (B-4):

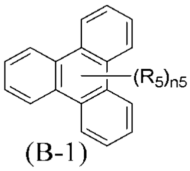

(B-1)

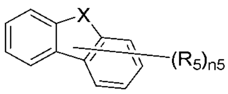

(B-2)

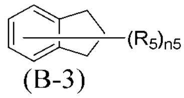

(B-3)

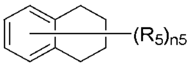

(B-4)

.

X is each independently selected from the group consisting of O, S, N-$CH_3$, N-Ph, and $C(CH_3)_2$.

$n_0$, $n_1$, $n_2$, and $n_5$ are each independently a positive integer selected from the group consisting of 0 to 14.

$R_0$, $R_1$, $R_2$, and $R_5$ are each independently selected from the group consisting of -H, -D, a linear alkyl group having 1 to 20 carbon atoms, a linear alkoxy group having 1 to 20 carbon atoms, a linear thioalkoxy group having 1 to 20 carbon atoms, a branched alkyl group having 3 to 20 carbon atoms, a cyclic alkyl group having 3 to 20 carbon atoms, a branched alkoxy group having 3 to 20 carbon atoms, a cyclic alkoxy group having 3 to 20 carbon atoms, a branched thioalkoxy group having 3 to 20 carbon atoms, a cyclic thioalkoxy group having 3 to 20 carbon atoms, a silyl group, a ketone group having 1 to 20 carbon atoms, an alkoxycarbonyl group having 2 to 20 carbon atoms, an aryloxycarbonyl group having 7 to 20 carbon atoms, an alkylene group having 1 to 20 carbon atoms, -CN, a carbamoyl group, a haloformyl group, a formyl group, an isocyano group, an isocyanate group, a thiocyanate group, an isothiocyanate group, a hydroxyl group, a nitro group, -$CF_3$, -Cl, -Br, -F, a substituted or unsubstituted aromatic group having 6 to 30 ring atoms, a substituted or unsubstituted

heteroaromatic group having 5 to 30 ring atoms, a substituted or unsubstituted aryloxy group having 6 to 30 ring atoms, and a substituted or unsubstituted heteroaryloxy group having 5 to 30 ring atoms.

When $n_0$ is greater than or equal to 2, two adjacent $R_0$ radicals form a ring or do not form a ring with each other. When $n_1$ is greater than or equal to 2, two adjacent $R_1$ radicals form a ring or do not form a ring with each other. When $n_2$ is greater than or equal to 2, two adjacent $R_2$ radicals form a ring or do not form a ring with each other. When $n_5$ is greater than or equal to 2, two adjacent $R_5$ radicals form a ring or do not form a ring with each other.

Preferably, the organic compound has a structure represented by any one of general formulae (2-1) to (2-28):

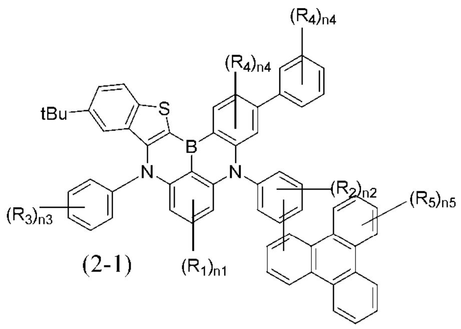
(2-1)

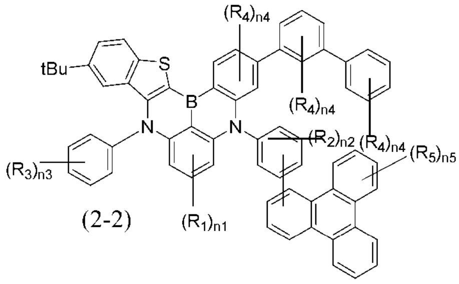
(2-2)

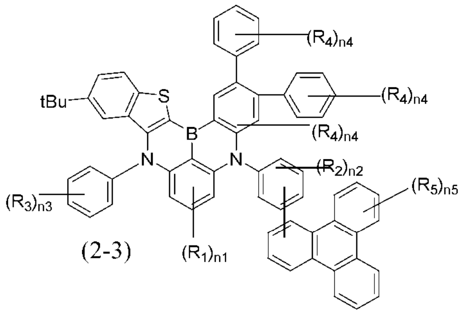
(2-3)

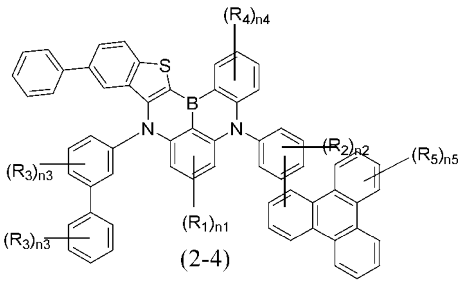
(2-4)

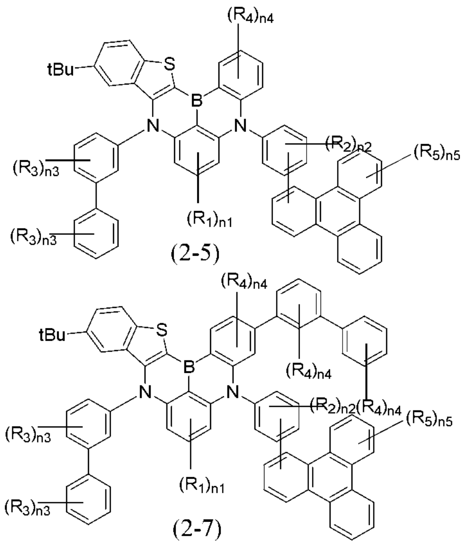
(2-5)

(2-7)

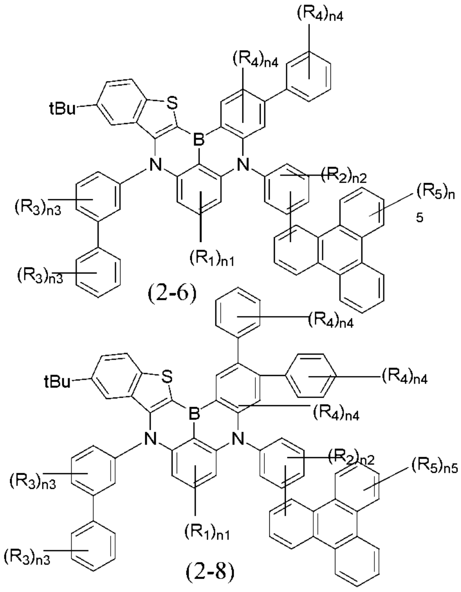
(2-6)

(2-8)

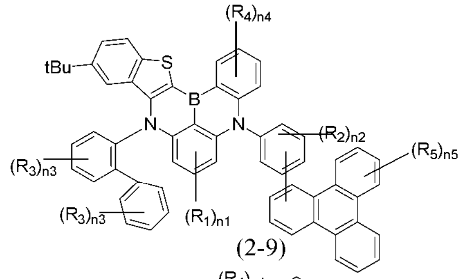
(2-9)

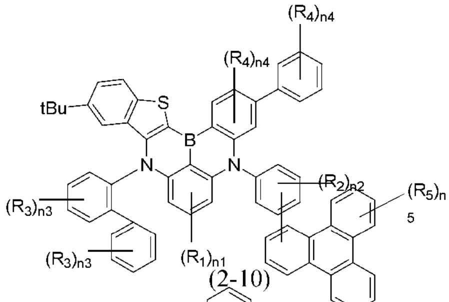
(2-10)

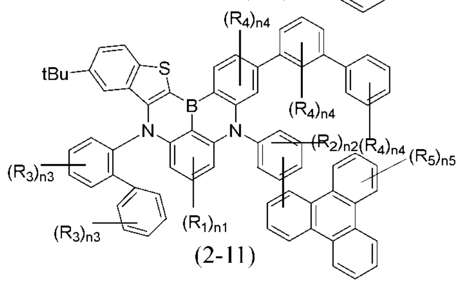
(2-11)

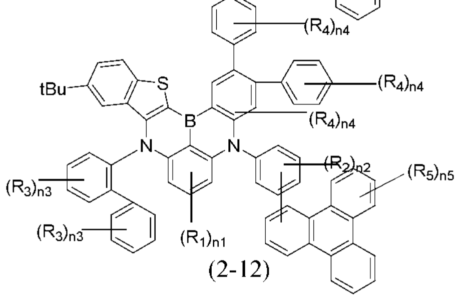
(2-12)

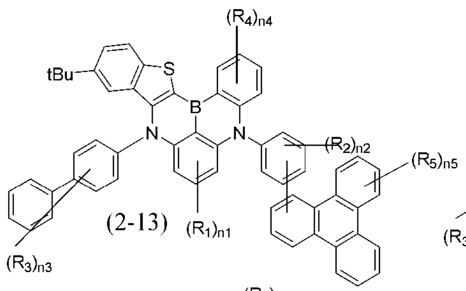
(2-13)

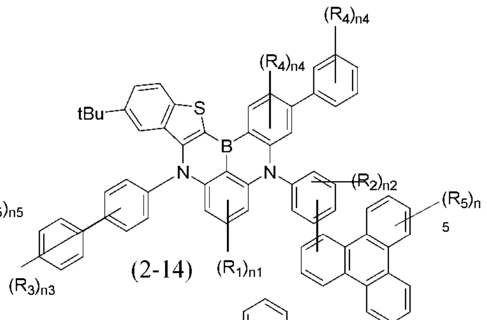
(2-14)

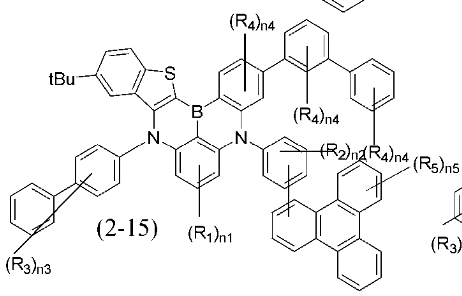
(2-15)

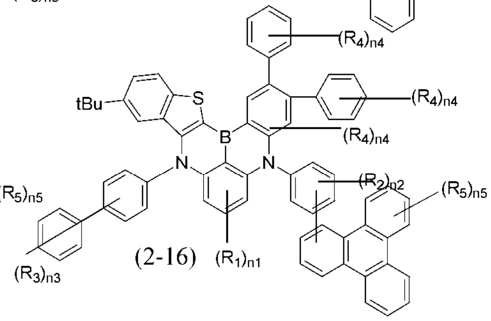
(2-16)

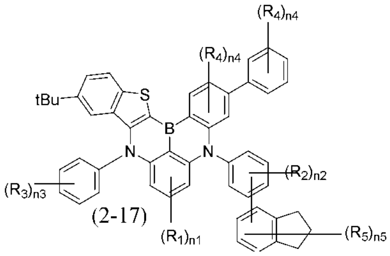
(2-17)

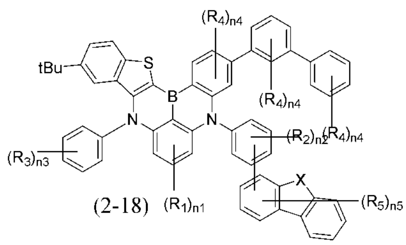
(2-18)

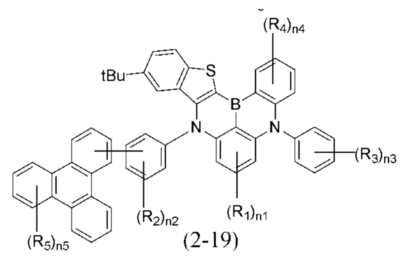

(2-19)

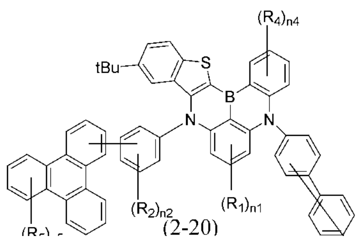

(2-20)

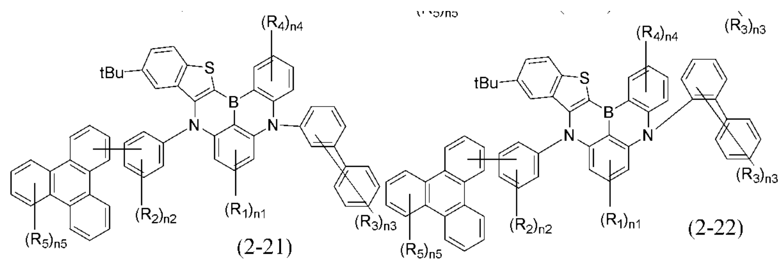

(2-21) (2-22)

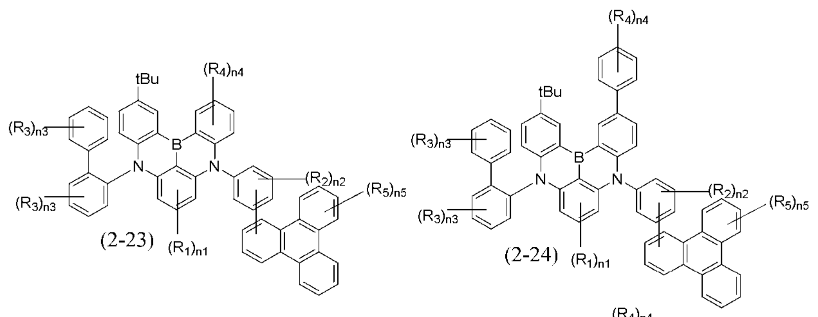

(2-23) (2-24)

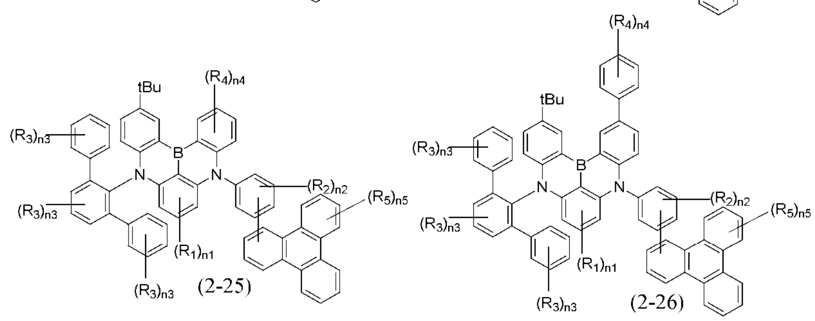

(2-25) (2-26)

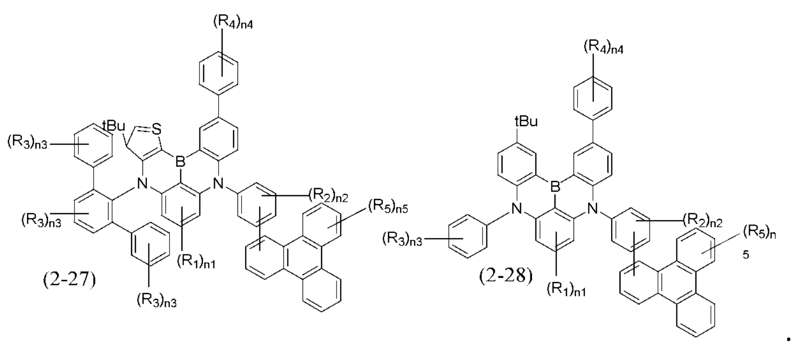

(2-27) (2-28)

$R_3$ and $R_4$ are each independently selected from the group consisting of -H, -D, a linear alkyl group having 1 to 20 carbon atoms, a linear alkoxy group having 1 to 20 carbon atoms, a linear thioalkoxy group having 1 to 20 carbon atoms, a branched alkyl group having 3 to 20 carbon atoms, a cyclic alkyl group having 3 to 20 carbon atoms, a branched alkoxy group having 3 to 20 carbon atoms, a cyclic alkoxy group having 3 to 20 carbon atoms, a branched thioalkoxy group having 3 to 20 carbon atoms, a cyclic thioalkoxy group having 3 to 20 carbon atoms, a silyl group, a ketone group having 1 to 20 carbon atoms, an alkoxycarbonyl group having 2 to 20 carbon atoms, an aryloxycarbonyl group having 7 to 20 carbon atoms, an alkylene group having 1 to 20 carbon atoms, -CN, a carbamoyl group, a haloformyl group, a formyl group, an

isocyano group, an isocyanate group, a thiocyanate group, an isothiocyanate group, a hydroxyl group, a nitro group, -$CF_3$, -Cl, -Br, -F, a substituted or unsubstituted aromatic group having 6 to 30 ring atoms, a substituted or unsubstituted heteroaromatic group having 5 to 30 ring atoms, a substituted or unsubstituted aryloxy group having 6 to 30 ring atoms, and a substituted or unsubstituted heteroaryloxy group having 5 to 30 ring atoms.

$n_3$ is greater than or equal to 0 and less than or equal to 5.

When $n_3$ is greater than or equal to 2, two adjacent $R_3$ radicals form a ring or do not form a ring with each other.

$n_4$ is greater than or equal to 0 and less than or equal to 5.

When $n_4$ is greater than or equal to 2, two adjacent $R_4$ radicals form a ring or do not form a ring with each other.

Preferably, any one of $R_1$, $R_2$, $R_3$, $R_4$, or $R_5$ is independently selected from the group consisting of -H, -D, a linear alkyl group having 1 to 10 carbon atoms, a branched alkyl group having 3 to 10 carbon atoms, and a cyclic alkyl group having 3 to 10 carbon atoms.

Preferably, any one of $R_1$, $R_2$, $R_3$, $R_4$, or $R_5$ is independently selected from the group consisting of -H, -D, a linear alkyl group having 1 to 4 carbon atoms, and a branched alkyl group having 3 to 5 carbon atoms.

Preferably, when $Ar_2$ is the structure represented by the formula (B-2), the structure represented by the formula (B-2) is at least one selected from the group consisting of:

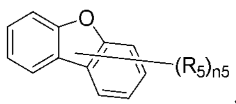, 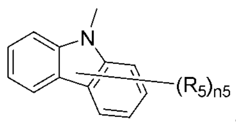, and 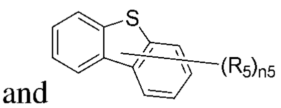.

Preferably, the organic compound is a blue light-emitting material.

Preferably, the organic compound is selected from the group consisting of the following compounds:

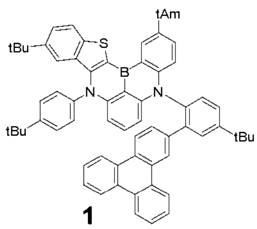
1

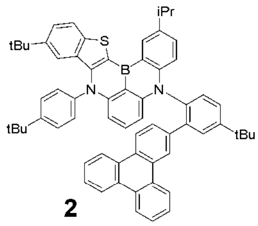
2

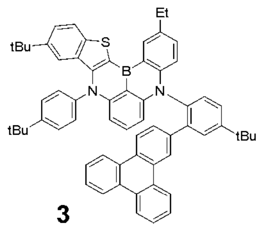
3

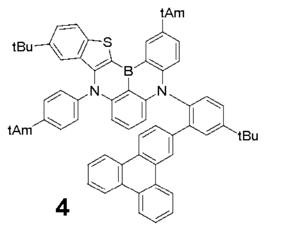
4

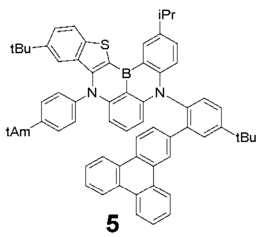
5

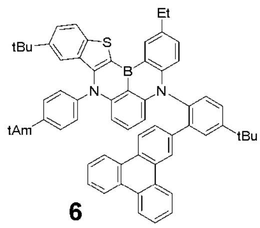
6

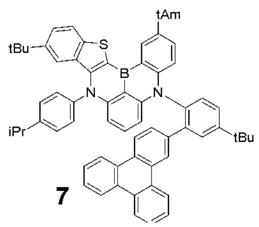
7

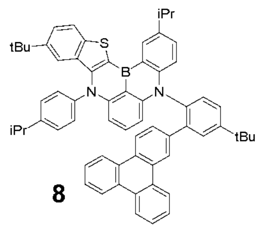
8

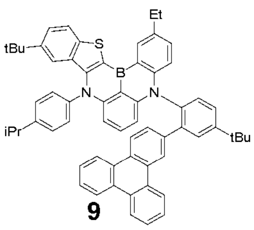
9

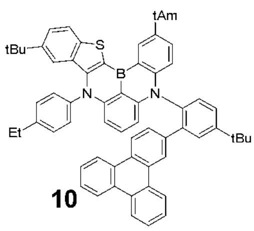
10

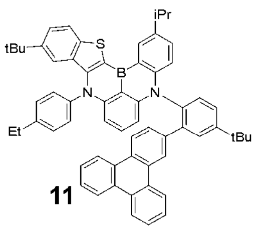
11

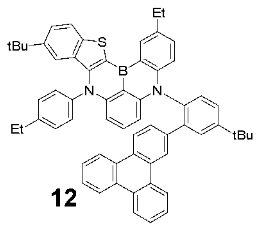
12

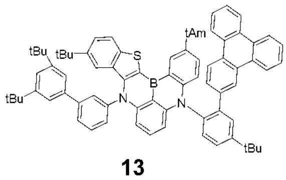
13

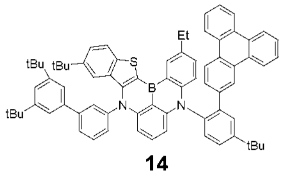
14

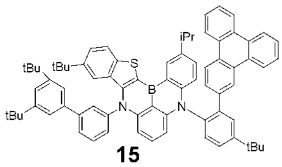
15

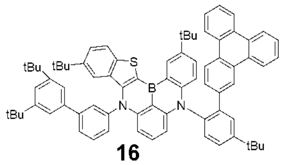
16

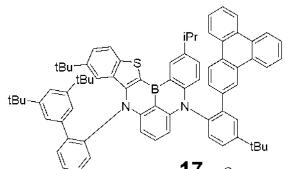
17

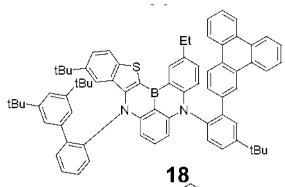
18

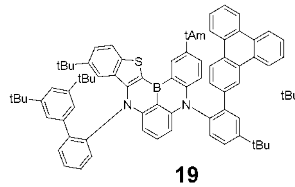
19

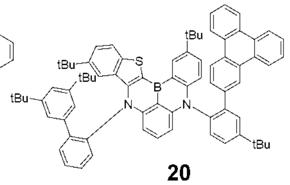
20

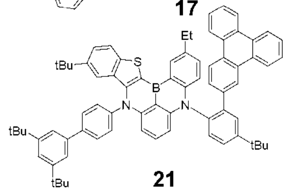
21

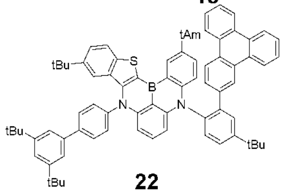
22

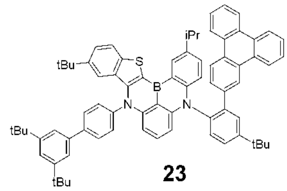
23

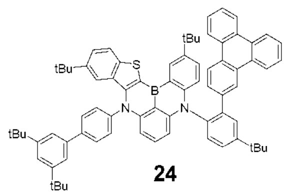
24

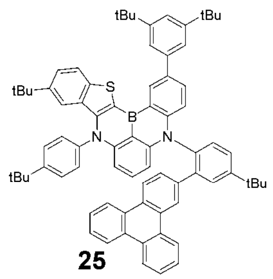
25

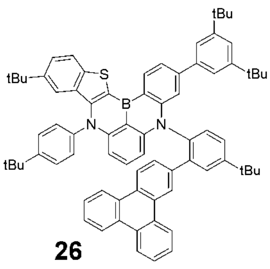
26

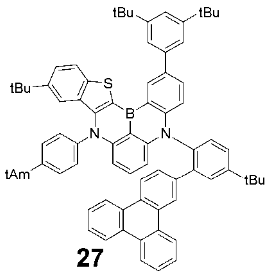
27

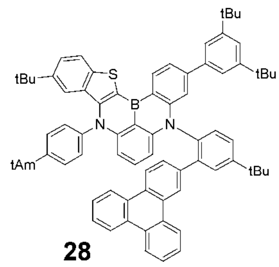
28

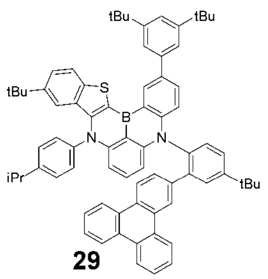
29

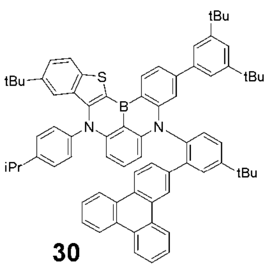
30

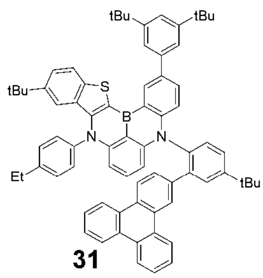
31

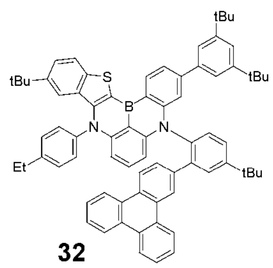
32

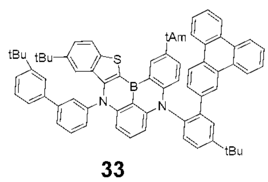
33

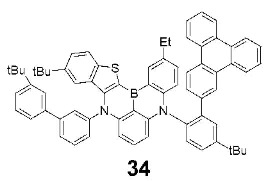
34

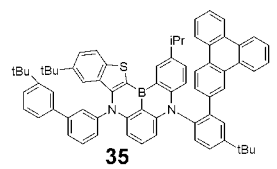
35

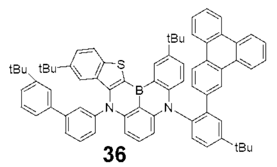
36

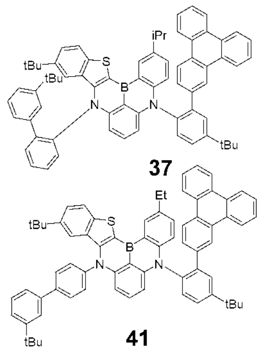

37

41

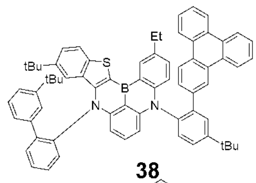

38

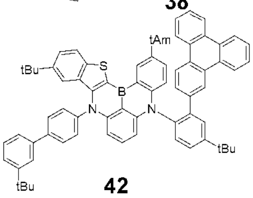

42

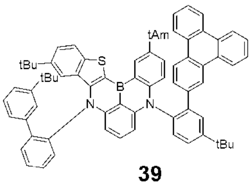

39

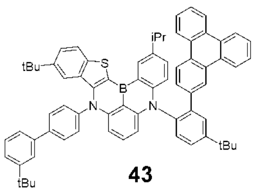

43

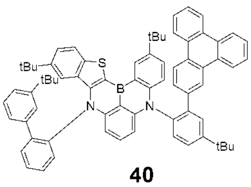

40

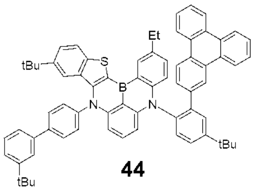

44

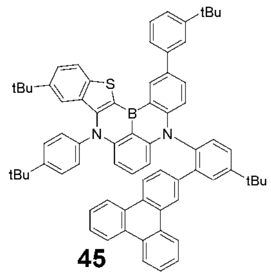

45

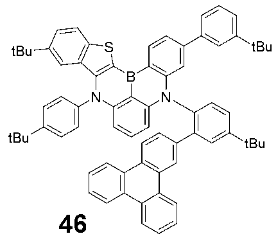

46

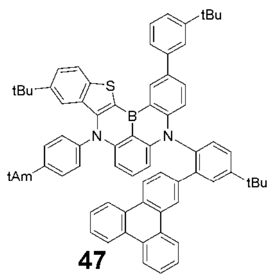

47

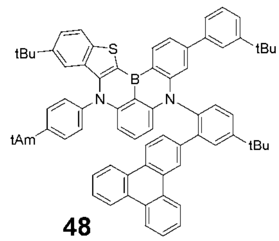

48

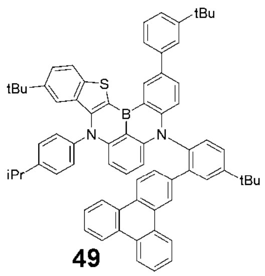

49

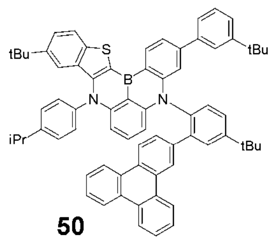

50

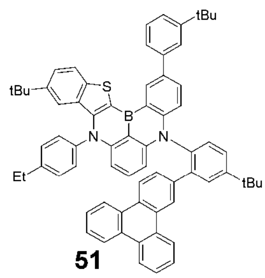

51

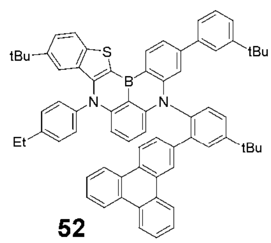

52

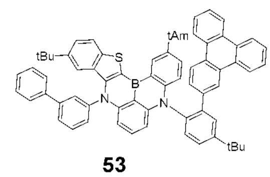

53

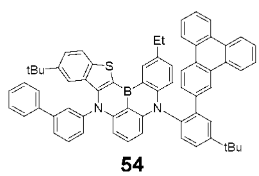

54

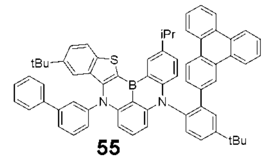

55

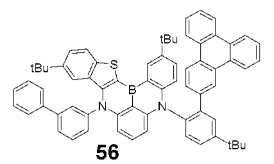

56

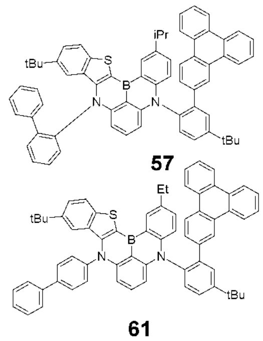

57

61

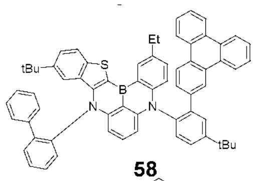

58

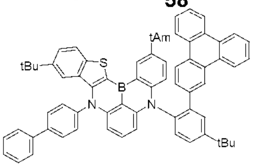

62

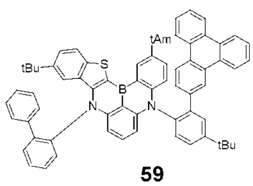

59

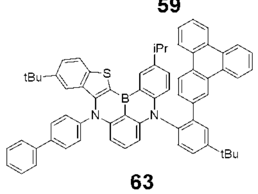

63

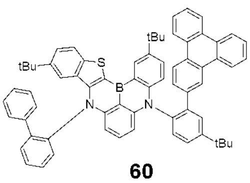

60

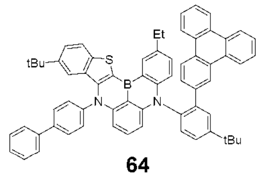

64

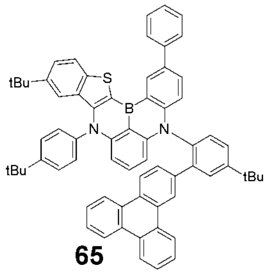
65
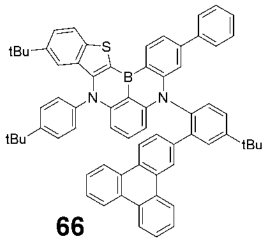
66
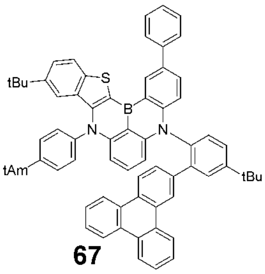
67
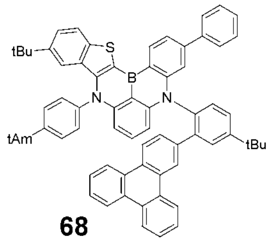
68

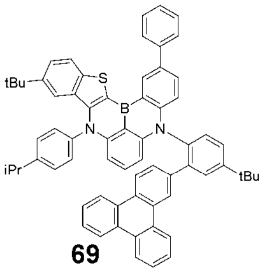
69
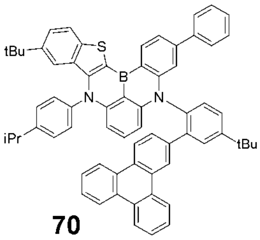
70
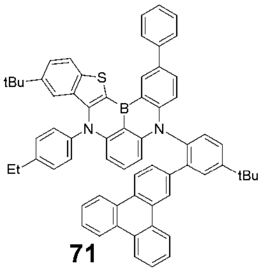
71
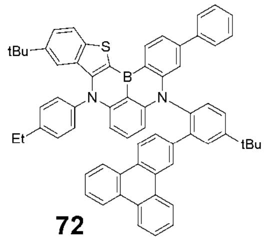
72

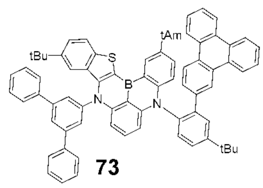
73
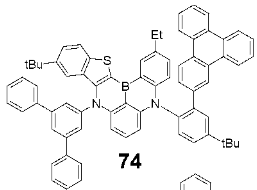
74
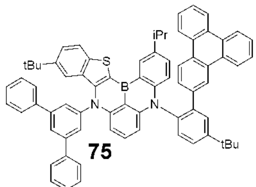
75
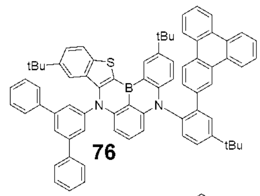
76

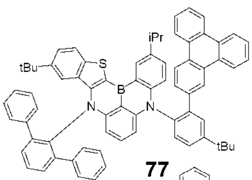
77
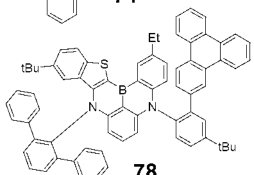
78
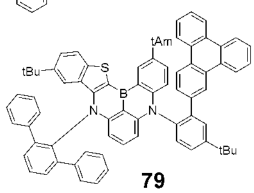
79
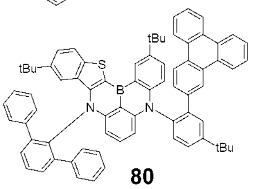
80

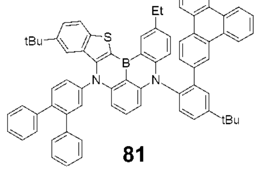
81
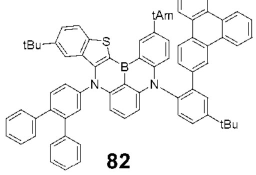
82
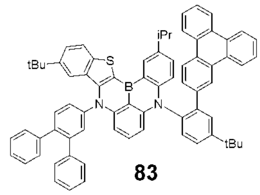
83
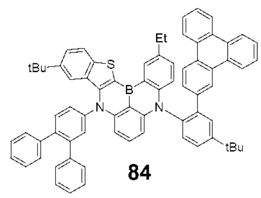
84

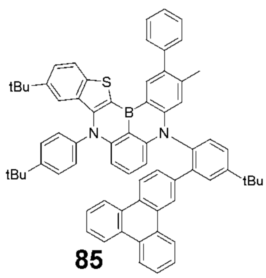
85
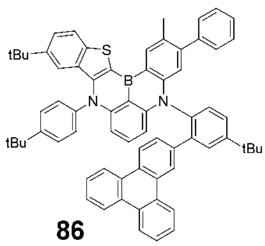
86
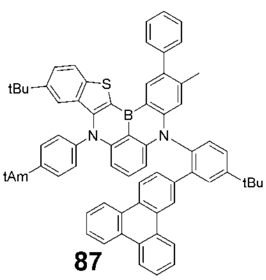
87
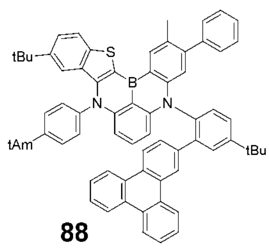
88

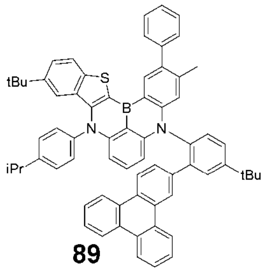
89

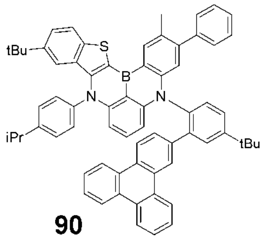
90

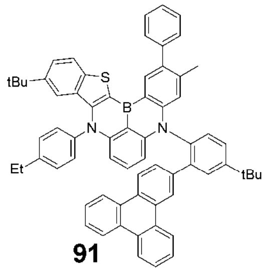
91

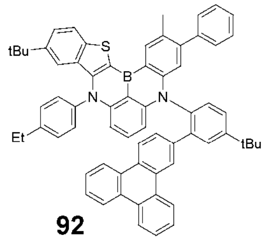
92

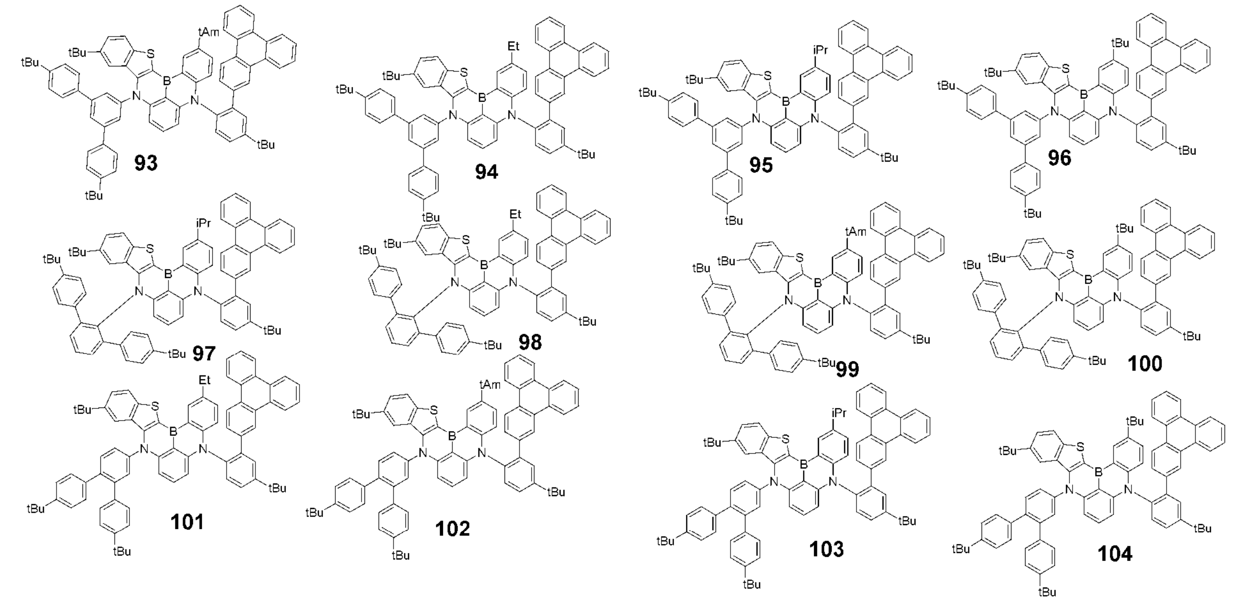
93 94 95 96

97 98 99 100

101 102 103 104

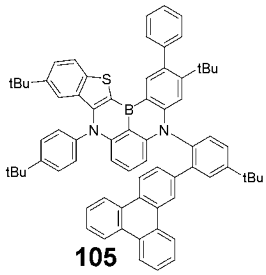
105

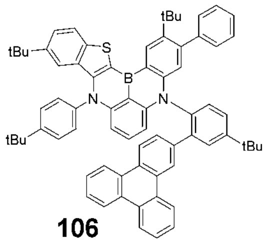
106

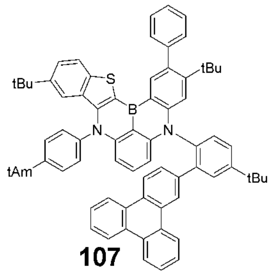
107

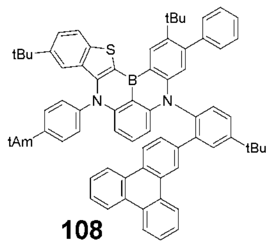
108

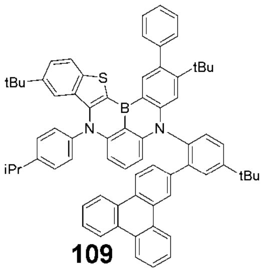
109

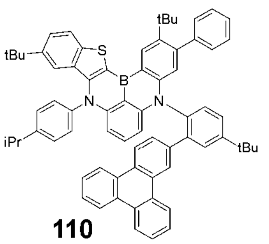
110

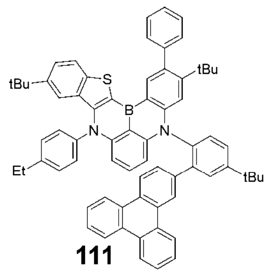
111

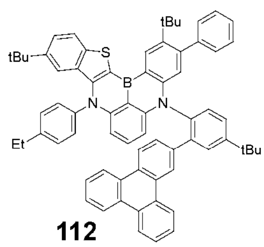
112

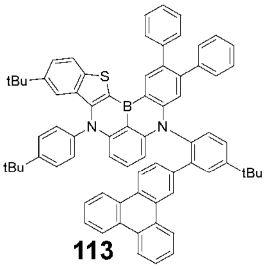
113

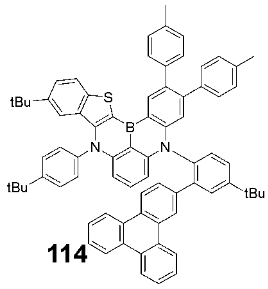
114

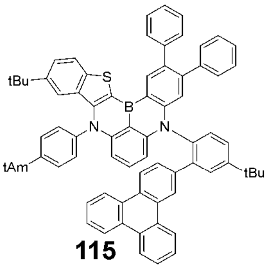
115

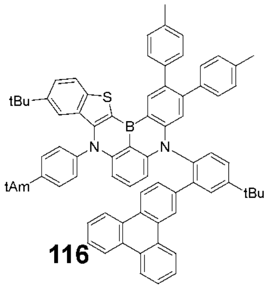
116

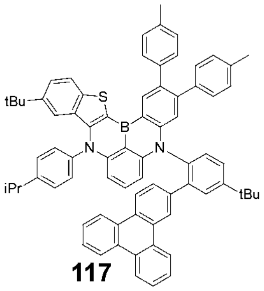
117

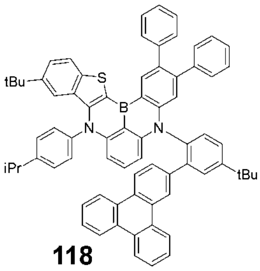
118

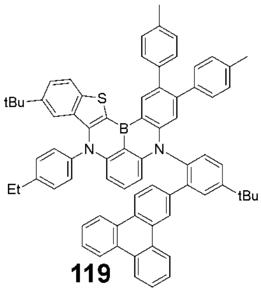
119

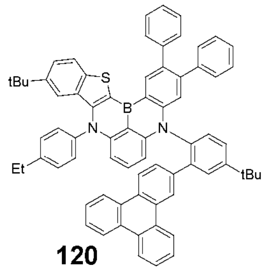
120

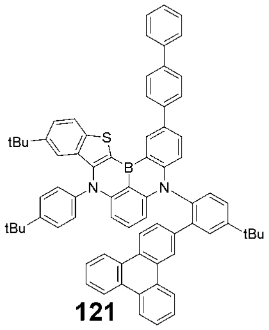
121

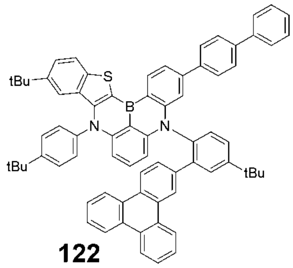
122

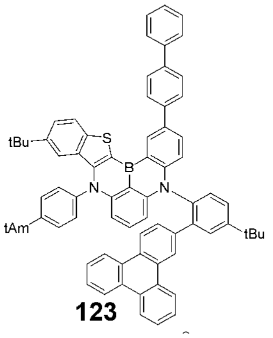
123

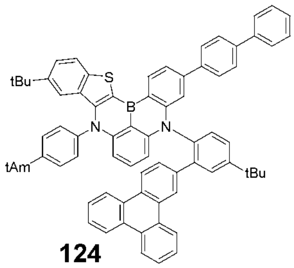
124

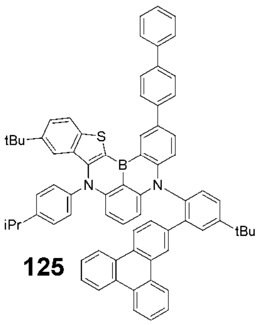
125

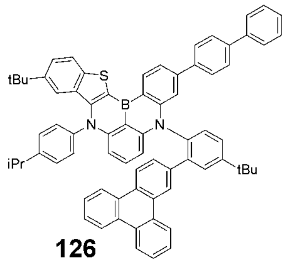
126

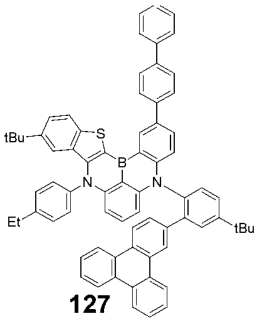
127

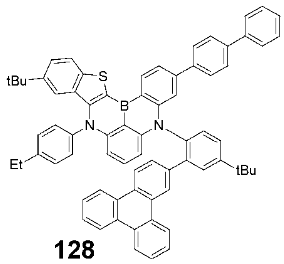
128

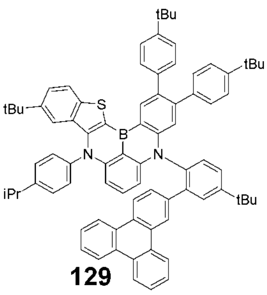
129

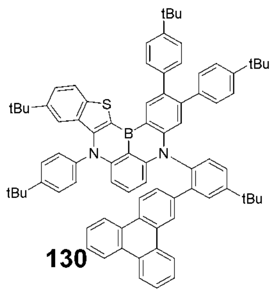
130

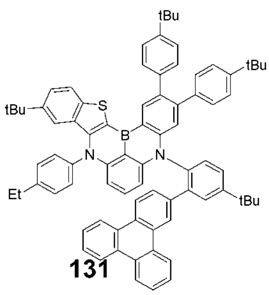
131

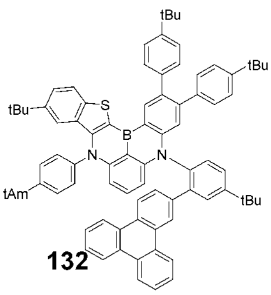
132

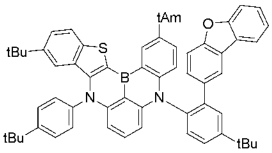
133
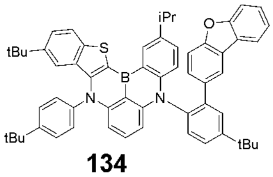
134
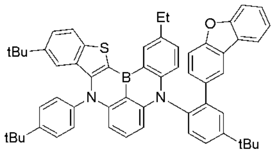
135
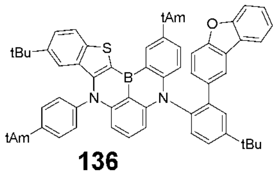
136

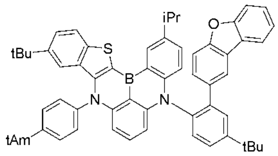
137
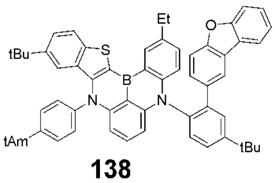
138
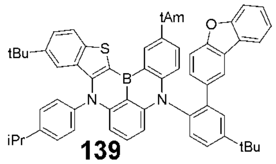
139
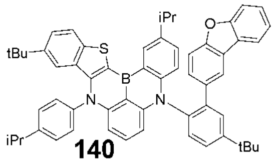
140

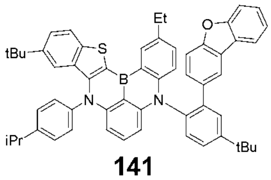
141
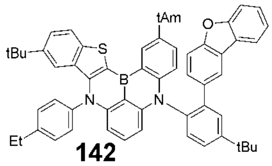
142
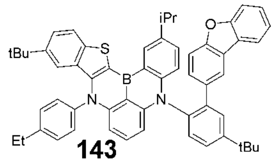
143
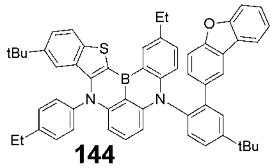
144

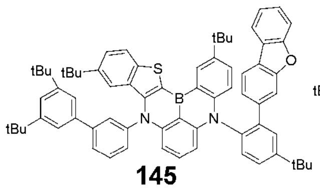
145
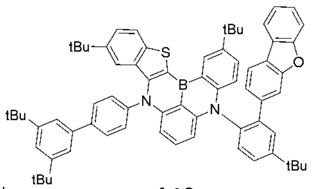
146
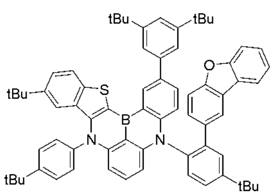
147
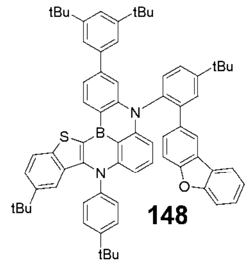
148

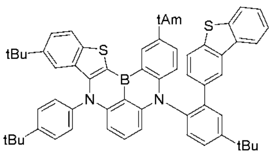
149
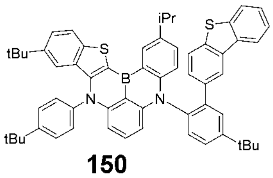
150
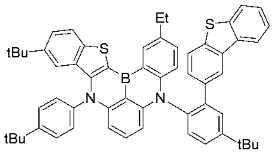
151
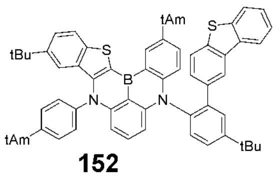
152

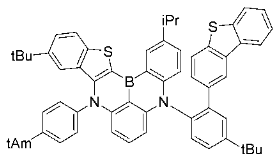
153
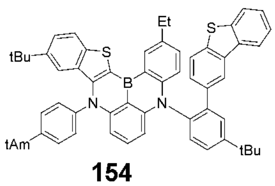
154
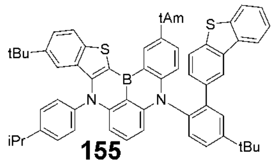
155
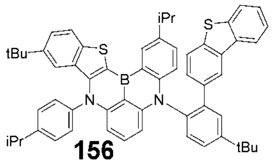
156

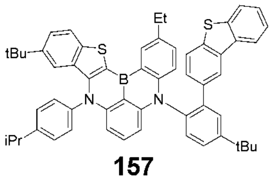
157
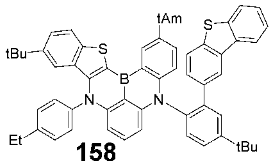
158
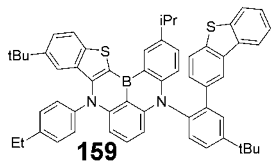
159
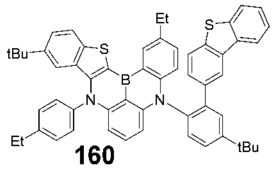
160

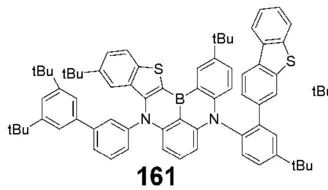
161

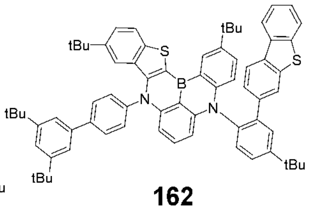
162

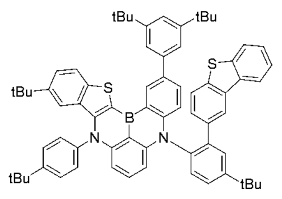
163

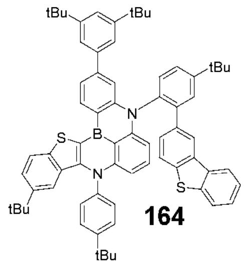
164

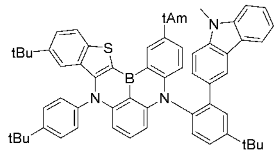
165

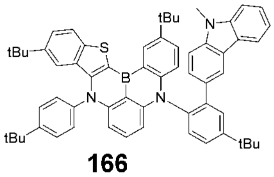
166

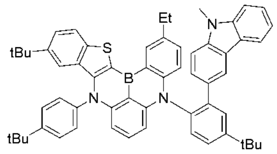
167

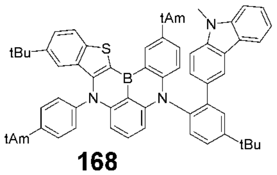
168

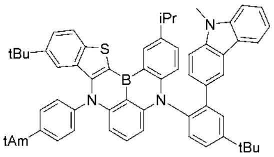
169

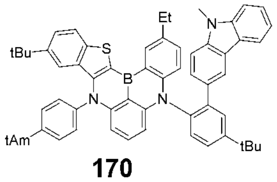
170

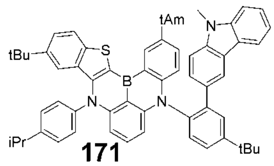
171

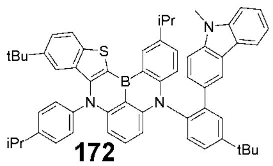
172

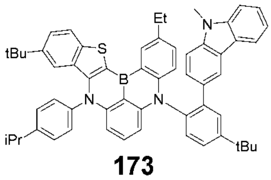
173

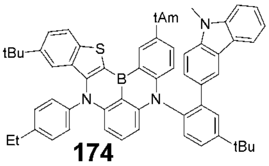
174

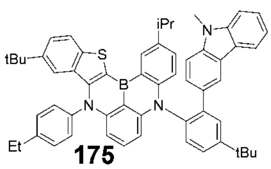
175

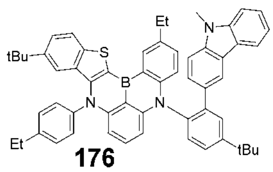
176

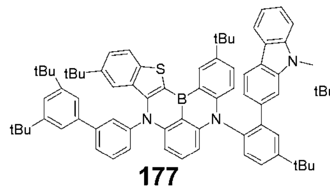
177

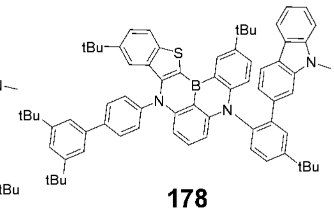
178

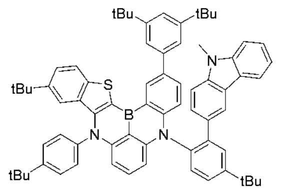
179

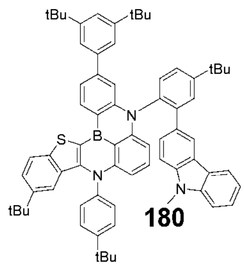
180

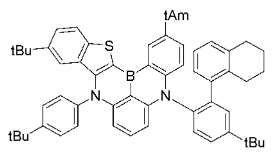
181

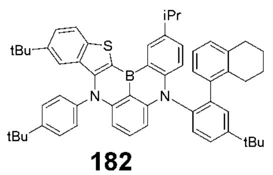
182

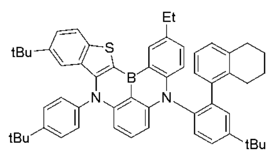
183

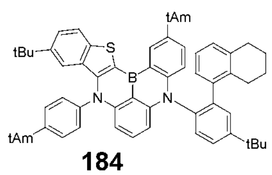
184

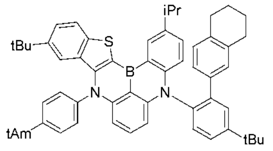
185

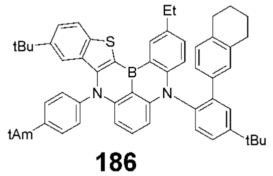
186

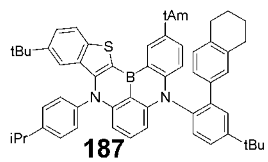
187

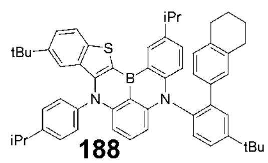
188

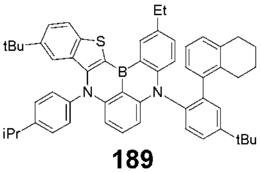
189

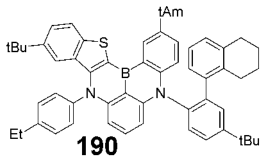
190

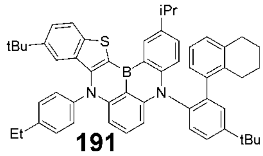
191

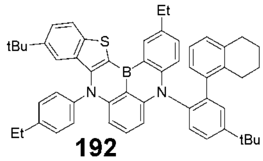
192

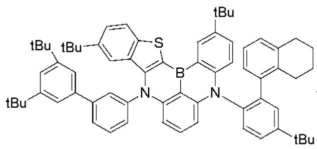
193

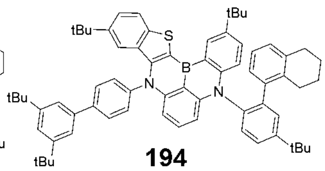
194

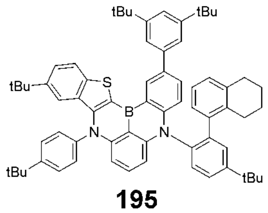
195

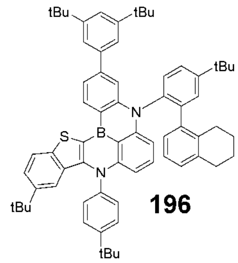
196

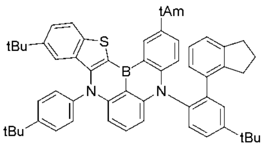
197

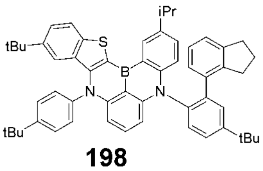
198

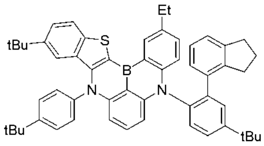
199

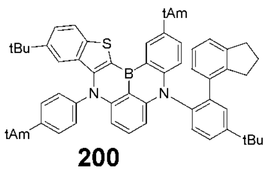
200

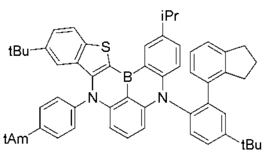
201

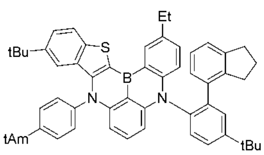
202

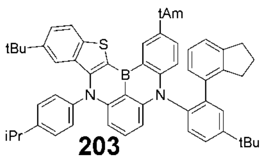
203

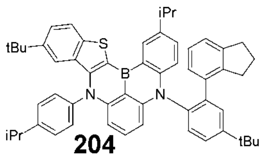
204

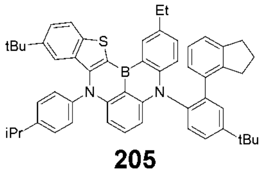
205

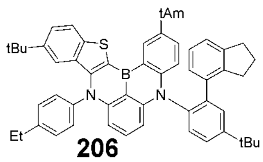
206

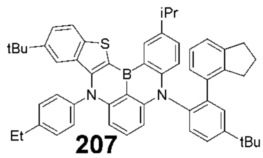
207

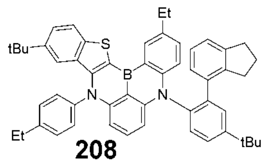
208

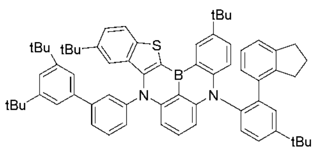
209

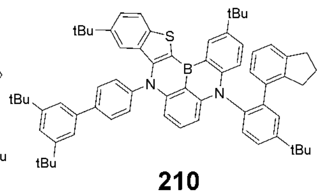
210

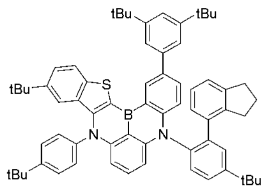
211

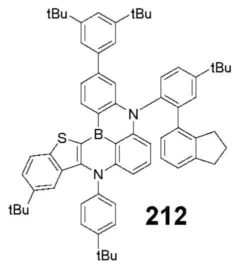
212

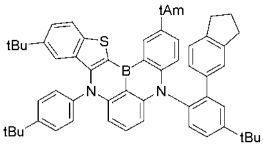
213

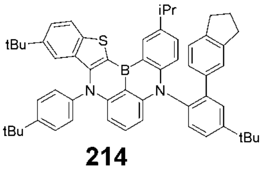
214

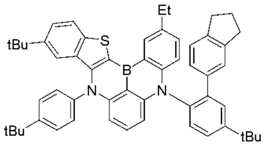
215

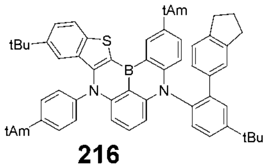
216

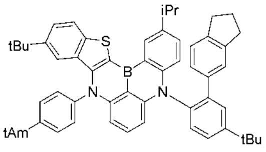

**217**

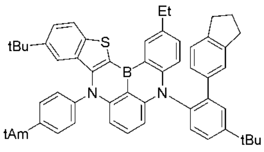

**218**

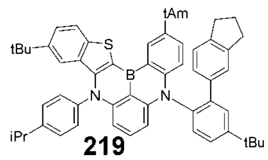

**219**

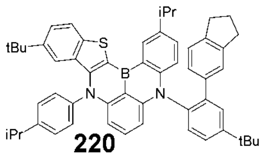

**220**

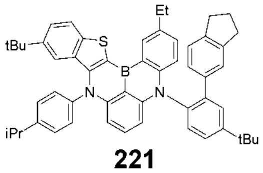

**221**

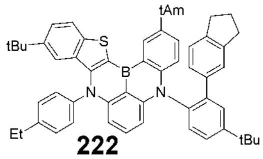

**222**

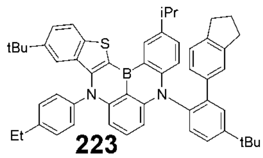

**223**

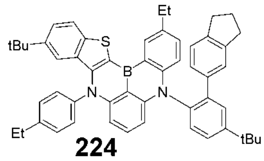

**224**

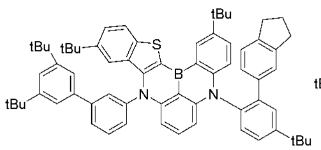

**225**

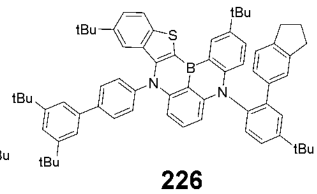

**226**

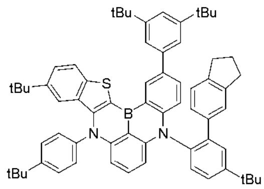

**227**

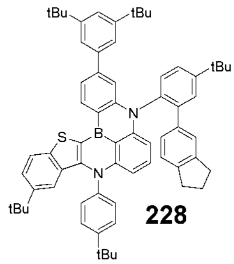

**228**

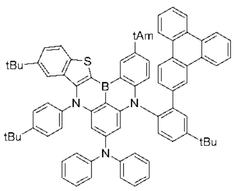

**229**

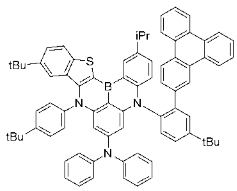

**230**

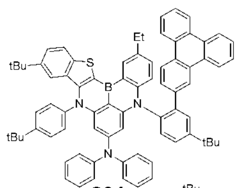

**231**

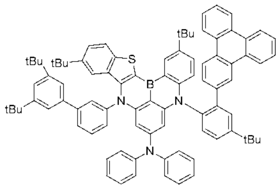

**232**

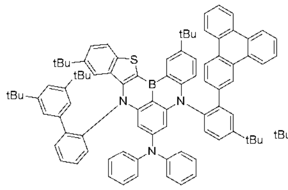

**233**

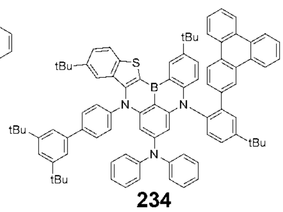

**234**

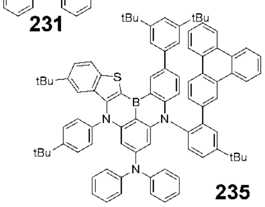

**235**

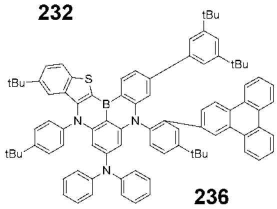

**236**

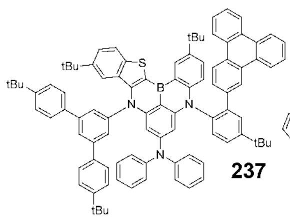

**237**

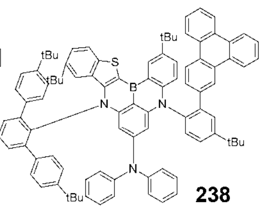

**238**

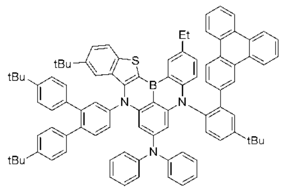

**239**

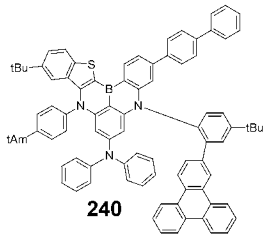

**240**

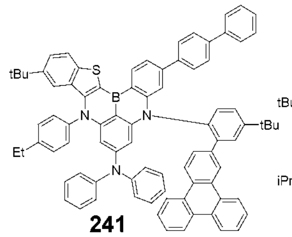
241

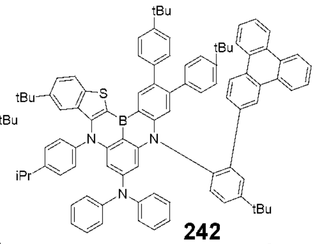
242

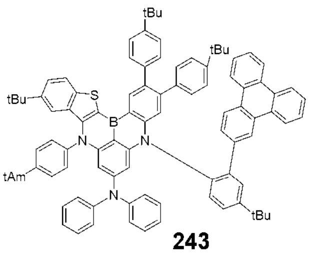
243

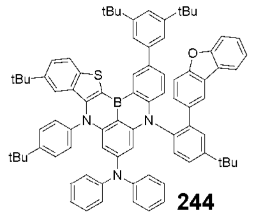
244

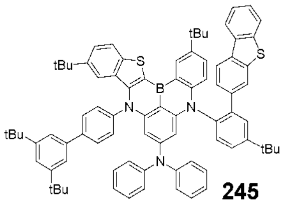
245

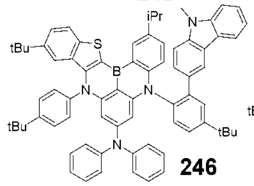
246

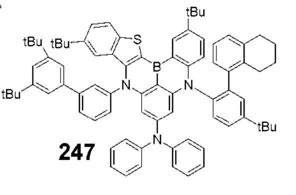
247

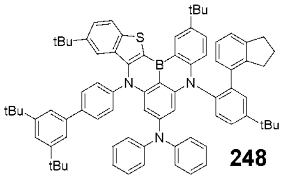
248

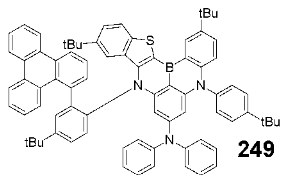
249

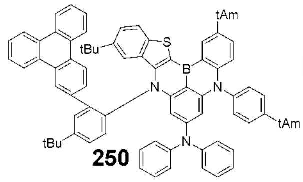
250

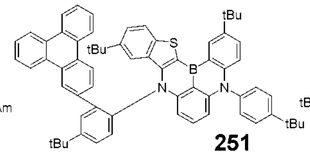
251

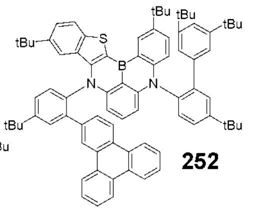
252

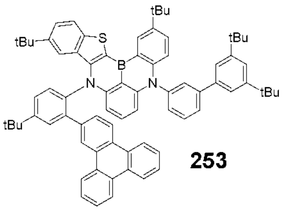
253

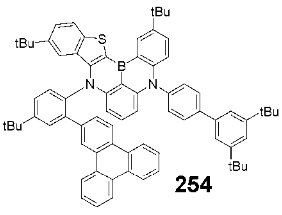
254

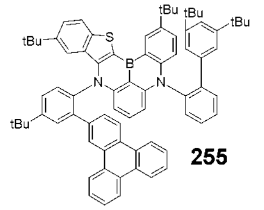
255

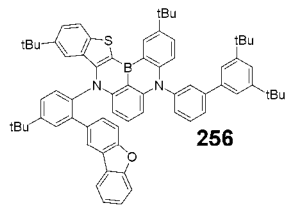
256

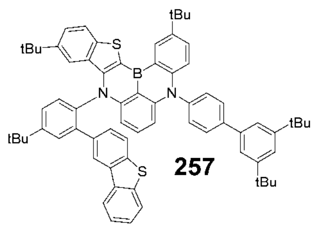
257

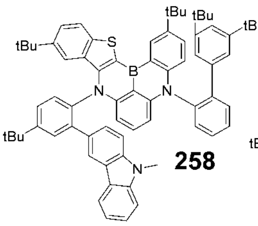
258

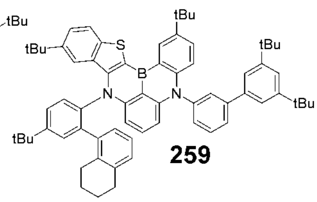
259

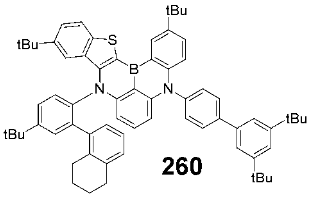
260

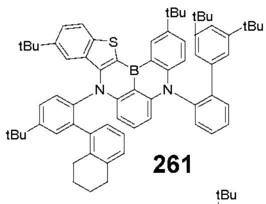
261

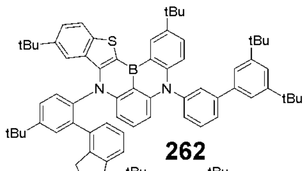
262

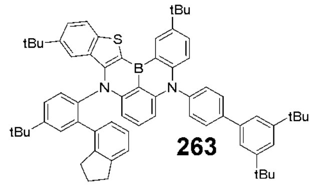
263

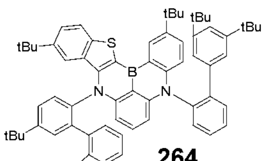
264

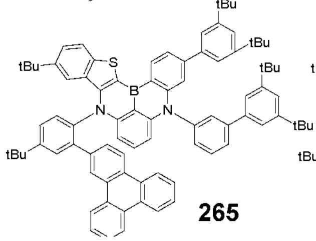
265

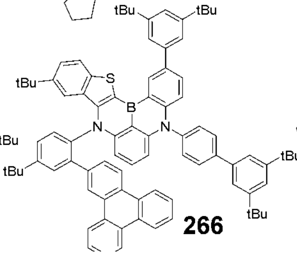
266

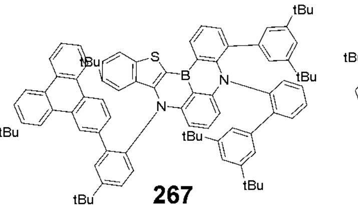
267

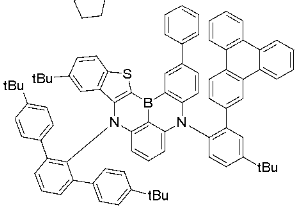
268

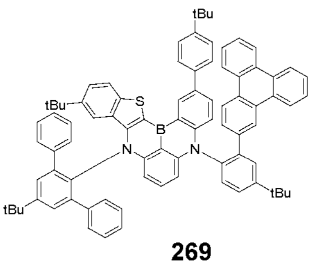
269
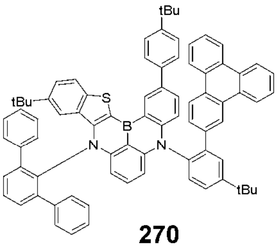
270
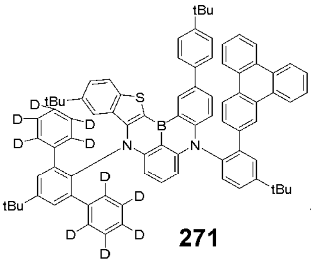
271
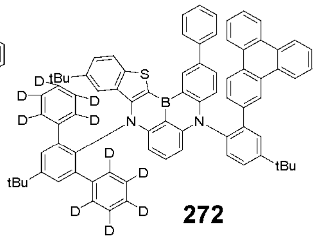
272

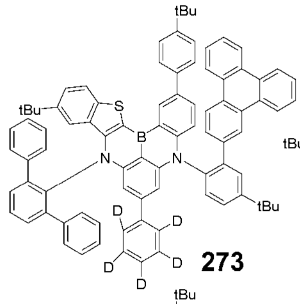
273
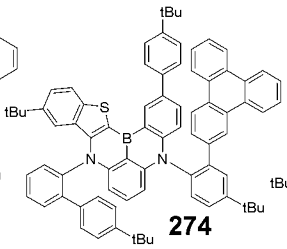
274
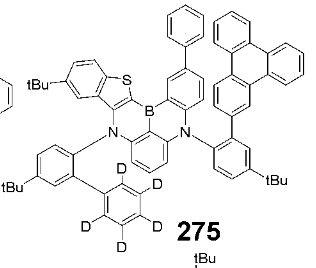
275
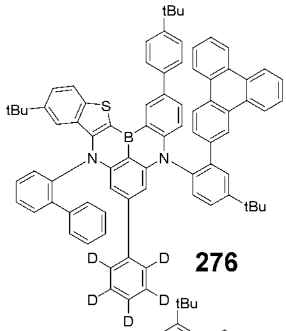
276

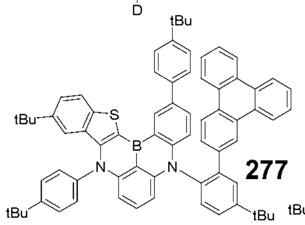
277
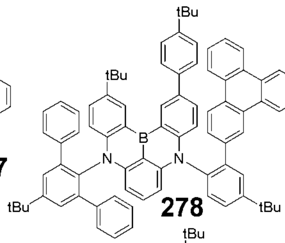
278
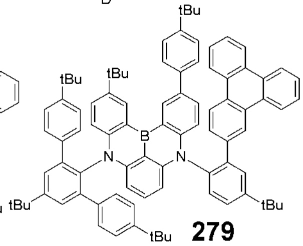
279
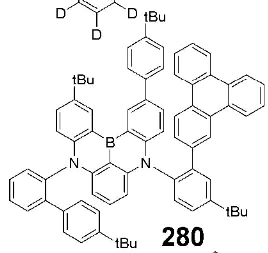
280

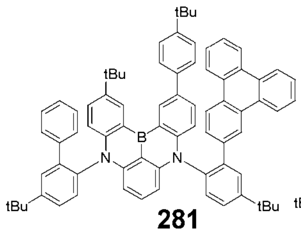
281
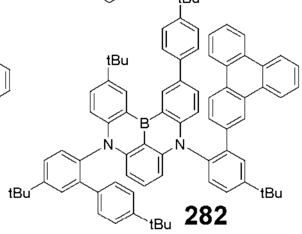
282
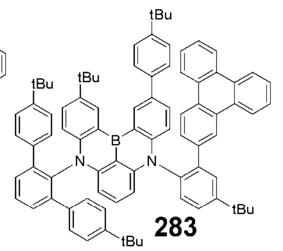
283
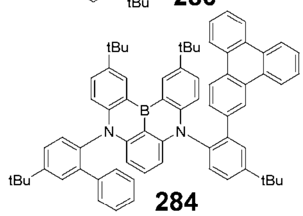
284

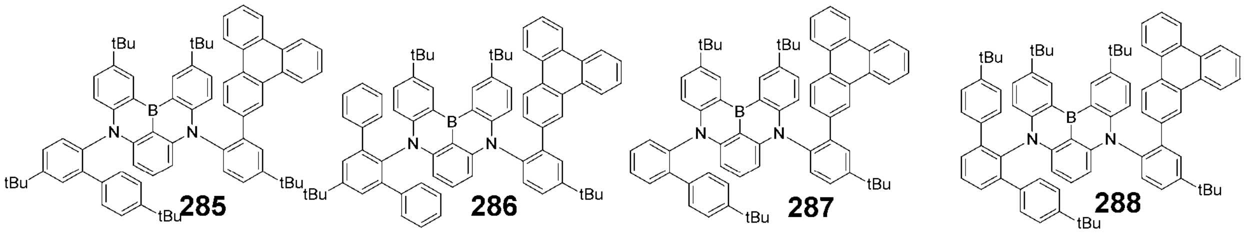

285 286 287 288

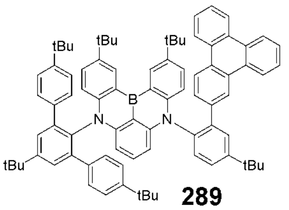

289

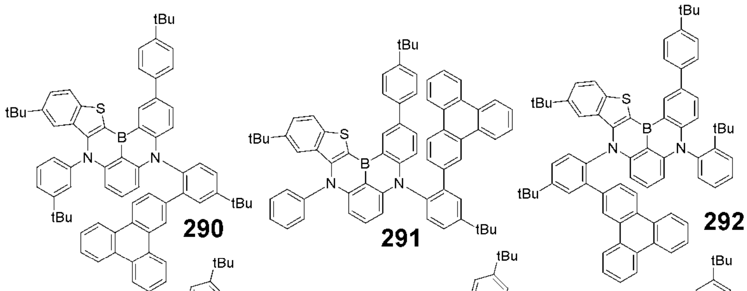

290 291 292

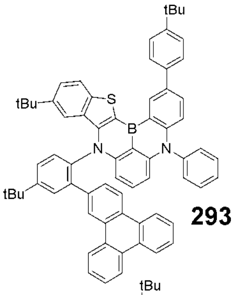

293

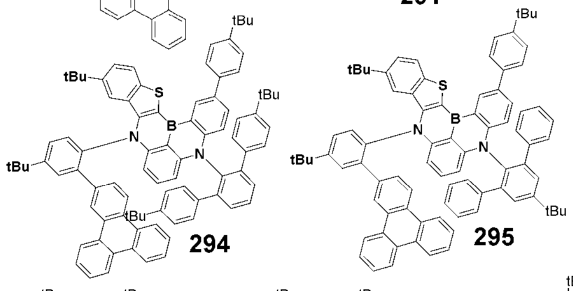

294 295

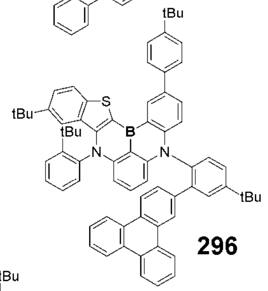

296

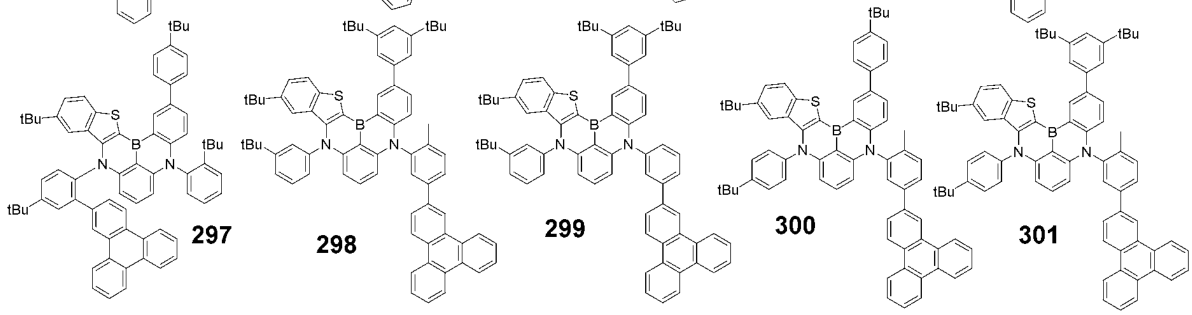

297 298 299 300 301

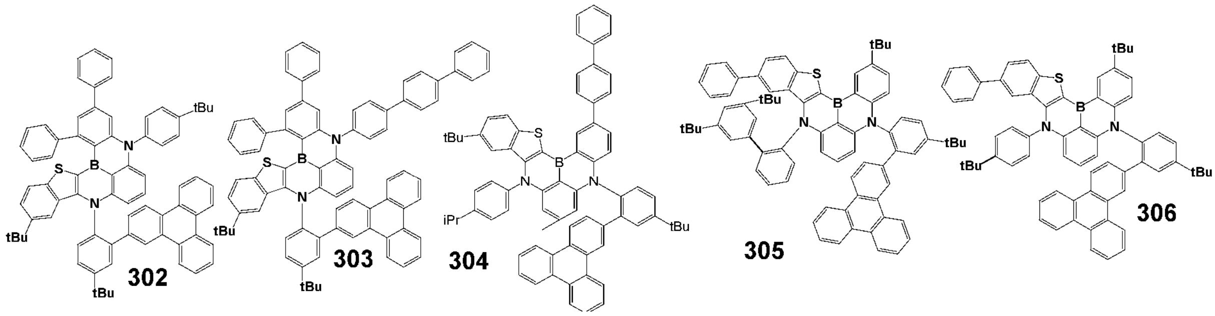

302 303 304 305 306

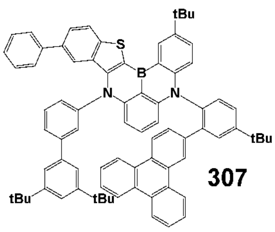

307

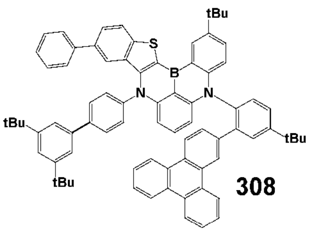

308

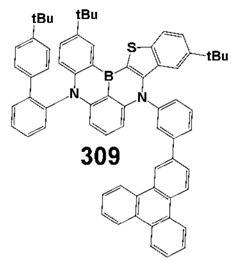

309

The present disclosure further provides a mixture including an organic compound and at least one organic functional material. The organic functional material is selected from a hole injection material, a hole transport material, an electron transport material, an electron injection material, an electron blocking material, a hole blocking material, a light-emitting material, a host material, or an organic dye.

The organic compound has a structure represented by a general formula (1) or (2):

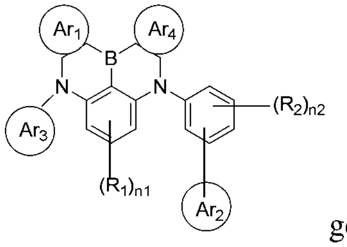
general formula (1)
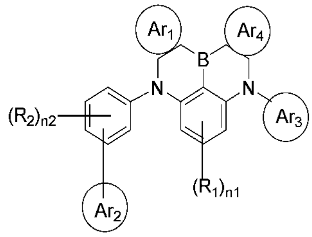
general formula (2).

$Ar_1$ is independently a structure represented by any one selected from the group consisting of formulae (X-1) to (X-3):

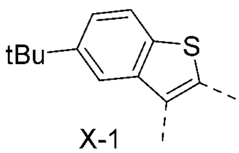
X-1
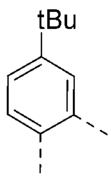
X-2
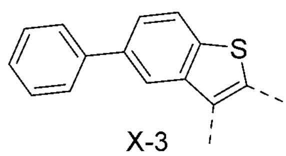
X-3
.

$Ar_3$ and $Ar_4$ are each independently a structure represented by any one selected from the group consisting of formulae (A-1) to (A-5):

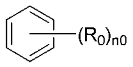
(A-1)
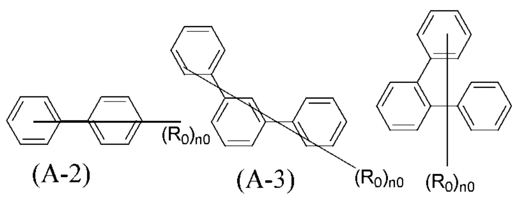
(A-2) (A-3) (A-4)
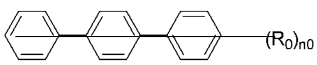
(A-5)
.

When $Ar_1$ is formula X-2, $Ar_4$ is independently a structure represented by any one selected from the group consisting of formulae (A-2) to (A-5).

A linkage site of $Ar_3$ is at a carbon atom of any phenyl ring in $Ar_3$, and fused sites of $Ar_4$ are at two ortho carbon atoms of a same phenyl ring in $Ar_4$.

$Ar_2$ is a structure represented by any one selected from the group consisting of formulae (B-1) to (B-4):

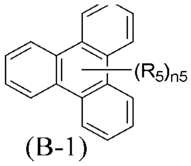
(B-1)
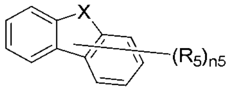
(B-2)
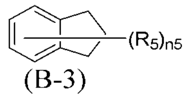
(B-3)
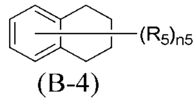
(B-4)
.

X is each independently selected from the group consisting of O, S, N-$CH_3$, N-Ph, and $C(CH_3)_2$.

$n_0$, $n_1$, $n_2$, and $n_5$ are each independently a positive integer selected from the group consisting of 0 to 14.

$R_0$, $R_1$, $R_2$, and $R_5$ are each independently selected from the group consisting of -H, -D, a linear alkyl group having 1 to 20 carbon atoms, a linear alkoxy group having 1 to 20 carbon atoms, a linear thioalkoxy group having 1 to 20 carbon atoms, a branched alkyl group having 3 to 20 carbon atoms, a cyclic alkyl group having 3 to 20 carbon atoms, a branched alkoxy group having 3 to 20 carbon atoms, a cyclic alkoxy group having 3 to 20 carbon atoms, a branched thioalkoxy group having 3 to 20 carbon atoms, a cyclic thioalkoxy group having 3 to 20 carbon atoms, a silyl group, a ketone group having 1 to

20 carbon atoms, an alkoxycarbonyl group having 2 to 20 carbon atoms, an aryloxycarbonyl group having 7 to 20 carbon atoms, an alkylene group having 1 to 20 carbon atoms, -CN, a carbamoyl group, a haloformyl group, a formyl group, an isocyano group, an isocyanate group, a thiocyanate group, an isothiocyanate group, a hydroxyl group, a nitro group, $-CF_3$, -Cl, -Br, -F, a substituted or unsubstituted aromatic group having 6 to 30 ring atoms, a substituted or unsubstituted heteroaromatic group having 5 to 30 ring atoms, a substituted or unsubstituted aryloxy group having 6 to 30 ring atoms, and a substituted or unsubstituted heteroaryloxy group having 5 to 30 ring atoms.

When $n_0$ is greater than or equal to 2, two adjacent $R_0$ radicals form a ring or do not form a ring with each other. When $n_1$ is greater than or equal to 2, two adjacent $R_1$ radicals form a ring or do not form a ring with each other. When $n_2$ is greater than or equal to 2, two adjacent $R_2$ radicals form a ring or do not form a ring with each other. When $n_5$ is geater than or equal to 2, two adjacent $R_5$ radicals form a ring or do not form a ring with each other.

The present disclosure furhter provides a composition including an organic compound or a mixture, and at least one organic solvent.

The mixture includes the organic compound and at least one organic functional material. The organic functional material is selected from a hole injection material, a hole transport material, an electron transport material, an electron injection material, an electron blocking material, a hole blocking material, a light-emitting material, a host material, or an organic dye.

The organic compound has a structure represented by a general formula (1) or (2):

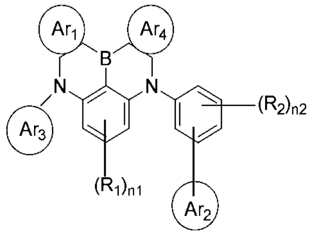

general formula (1)

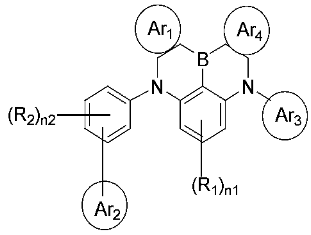

general formula (2).

$Ar_1$ is independently a structure represented by any one selected from the group consisting of formulae (X-1) to (X-3):

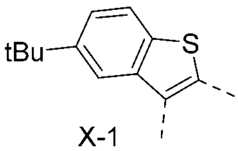

X-1

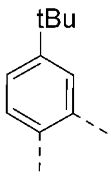

X-2

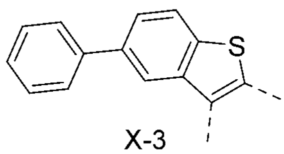

X-3

.

$Ar_3$ and $Ar_4$ are each independently a structure represented by any one selected from the group consisting of formulae (A-1) to (A-5):

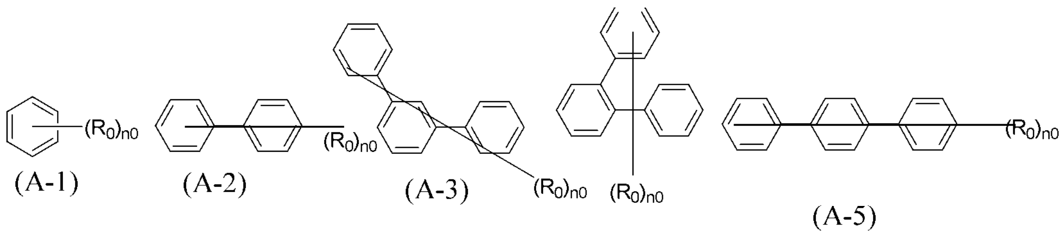

(A-1) (A-2) (A-3) (A-4) (A-5)

.

When $Ar_1$ is formula X-2, $Ar_4$ is independently a structure represented by any one selected from the group consisting of formulae (A-2) to (A-5).

A linkage site of $Ar_3$ is at a carbon atom of any phenyl ring in $Ar_3$, and fused sites of $Ar_4$ are at two ortho carbon atoms of a same phenyl ring in $Ar_4$.

$Ar_2$ is a structure represented by any one selected from the group consisting of formulae (B-1) to (B-4):

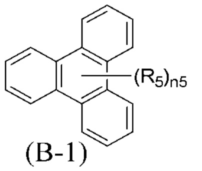
(B-1)
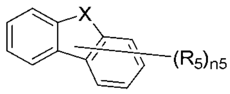
(B-2)
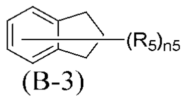
(B-3)
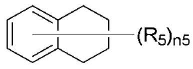
(B-4)
.

X is each independently selected from the group consisting of O, S, N-$CH_3$, N-Ph, and $C(CH_3)_2$.

$n_0$, $n_1$, $n_2$, and $n_5$ are each independently a positive integer selected from the group consisting of 0 to 14.

$R_0$, $R_1$, $R_2$, and $R_5$ are each independently selected from the group consisting of -H, -D, a linear alkyl group having 1 to 20 carbon atoms, a linear alkoxy group having 1 to 20 carbon atoms, a linear thioalkoxy group having 1 to 20 carbon atoms, a branched alkyl group having 3 to 20 carbon atoms, a cyclic alkyl group having 3 to 20 carbon atoms, a branched alkoxy group having 3 to 20 carbon atoms, a cyclic alkoxy group having 3 to 20 carbon atoms, a branched thioalkoxy group having 3 to 20 carbon atoms, a cyclic thioalkoxy group having 3 to 20 carbon atoms, a silyl group, a ketone group having 1 to 20 carbon atoms, an alkoxycarbonyl group having 2 to 20 carbon atoms, an aryloxycarbonyl group having 7 to 20 carbon atoms, an alkylene group having 1 to 20 carbon atoms, -CN, a carbamoyl group, a haloformyl group, a formyl group, an isocyano group, an isocyanate group, a thiocyanate group, an isothiocyanate group, a hydroxyl group, a nitro group, -$CF_3$, -Cl, -Br, -F, a substituted or unsubstituted aromatic group having 6 to 30 ring atoms, a substituted or unsubstituted heteroaromatic group having 5 to 30 ring atoms, a substituted or unsubstituted aryloxy group having 6 to 30 ring atoms, and a substituted or unsubstituted heteroaryloxy group having 5 to 30 ring atoms.

When $n_0$ is greater than or equal to 2, two adjacent $R_0$ radicals form a ring or do not form a ring with each other. When $n_1$ is greater than or equal to 2, two adjacent $R_1$ radicals form a ring or do not form a ring with each other. When $n_2$ is greater than or equal to 2, two adjacent $R_2$ radicals form a ring or do not form a ring with each other. When $n_5$ is greater than or equal to 2, two adjacent $R_5$ radicals form a ring or do not form a ring with each other.

The present disclosure further provides an organic light-emitting device including:

a first electrode;
a second electrode disposed opposite to the first electrode; and
an organic functional layer between the first electrode and the second electrode.

A material for the organic functional layer includes at least one organic compound, or a mixture, or is one prepared from a composition.

The composition includes the organic compound or the mixture, and at least one organic solvent.

The mixture includes the organic compound and at least one organic functional material, and the organic functional material is selected from a hole injection material, a hole transport material, an electron transport material, an electron injection material, an electron blocking material, a hole blocking material, a light-emitting material, a host material, or an organic dye.

The organic compound has a structure represented by a general formula (1) or (2):

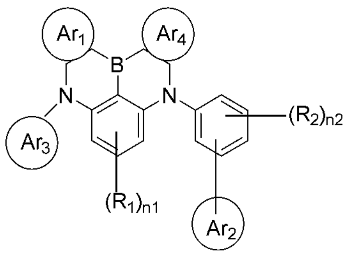
general formula (1)

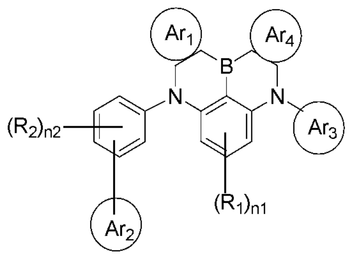
general formula (2).

$Ar_1$ is independently a structure represented by any one selected from the group consisting of formulae (X-1) to (X-3):

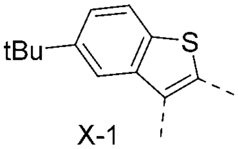
X-1
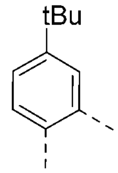
X-2
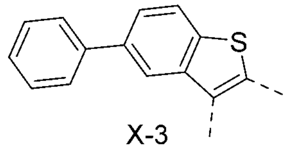
X-3
.

$Ar_3$ and $Ar_4$ are each independently a structure represented by any one selected from the group consisting of formulae (A-1) to (A-5):

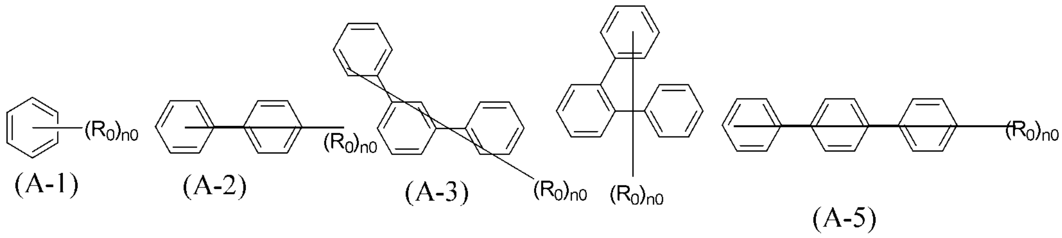
(A-1) (A-2) (A-3) (A-4) (A-5)
.

When $Ar_1$ is formula X-2, $Ar_4$ is independently a structure represented by any one selected from the group consisting of formulae (A-2) to (A-5).

A linkage site of $Ar_3$ is at a carbon atom of any phenyl ring in $Ar_3$, and fused sites of $Ar_4$ are at two ortho carbon atoms of a same phenyl ring in $Ar_4$.

$Ar_2$ is a structure represented by any one selected from the group consisting of formulae (B-1) to (B-4):

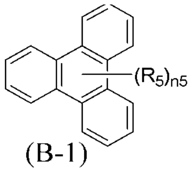
(B-1)
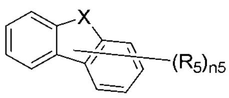
(B-2)
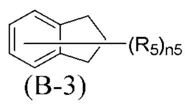
(B-3)
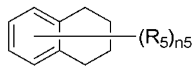
(B-4)
.

X is each independently selected from the group consisting of O, S, N-$CH_3$, N-Ph, and $C(CH_3)_2$.

$n_0$, $n_1$, $n_2$, and $n_5$ are each independently a positive integer selected from the group consisting of 0 to 14.

$R_0$, $R_1$, $R_2$, and $R_5$ are each independently selected from the group consisting of -H, -D, a linear alkyl group having 1 to 20 carbon atoms, a linear alkoxy group having 1 to 20 carbon atoms, a linear thioalkoxy group having 1 to 20 carbon atoms, a branched alkyl group having 3 to 20 carbon atoms, a cyclic alkyl group having 3 to 20 carbon atoms, a branched alkoxy group having 3 to 20 carbon atoms, a cyclic alkoxy group having 3 to 20 carbon atoms, a branched thioalkoxy group having 3 to 20 carbon atoms, a cyclic thioalkoxy group having 3 to 20 carbon atoms, a silyl group, a ketone group having 1 to 20 carbon atoms, an alkoxycarbonyl group having 2 to 20 carbon atoms, an aryloxycarbonyl group having 7 to 20 carbon atoms, an alkylene group having 1 to 20 carbon atoms, -CN, a carbamoyl group, a haloformyl group, a formyl group, an isocyano group, an isocyanate group, a thiocyanate group, an isothiocyanate group, a hydroxyl group, a nitro group, $-CF_3$, -Cl, -Br, -F, a substituted or unsubstituted aromatic group having 6 to 30 ring atoms, a substituted or unsubstituted heteroaromatic group having 5 to 30 ring atoms, a substituted or unsubstituted aryloxy group having 6 to 30 ring atoms, and a substituted or unsubstituted heteroaryloxy group having 5 to 30 ring atoms.

When $n_0$ is greater than or equal to 2, two adjacent $R_0$ radicals form a ring or do not form a ring with each other. When $n_1$ is greater than or equal to 2, two adjacent $R_1$ radicals form a ring or do not form a ring with each other. When $n_2$ is greater than or equal to 2, two adjacent $R_2$ radicals form a ring or do not form a ring with each other. When $n_5$ is greater than or equal to 2, two adjacent $R_5$ radicals form a ring or do not form a ring with each other.

Preferably, the organic functional layer includes at least a light-emitting layer, the light-emitting layer includes a host material and a guest material, the guest material is the at least one organic compound, and the host material includes a fused aromatic derivative or a heteroaromatic compound.

Preferably, the host material includes one or more of an anthracene derivative, a pyrene derivative, a naphthalene derivative, a pentacene derivative, a phenanthrene compound, a fluoranthene compound, a carbazole derivative, a dibenzofuran derivative, a ladder-type furan compound, or a pyrimidine derivative.

Preferably, a mass ratio of the host material to the guest material is 99:1 to 70:30.

The present disclosure further provides a display panel including an organic light-emitting device, the organic light-emitting device including:

a first electrode;
a second electrode disposed opposite to the first electrode; and
an organic functional layer between the first electrode and the second electrode.

A material for the organic functional layer includes at least one organic compound, or a mixture, or is one prepared from a composition.
The composition includes the organic compound or the mixture, and at least one organic solvent.
The mixture includes the organic compound, and at least one organic functional material, and the organic functional material is selected from a hole injection material, a hole transport material, an electron transport material, an electron injection material, an electron blocking material, a hole blocking material, a light-emitting material, a host material, or an organic dye.
The organic compound has a structure represented by a general formula (1) or (2):

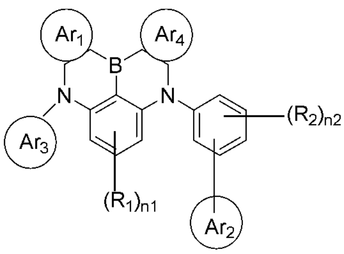
general formula (1)

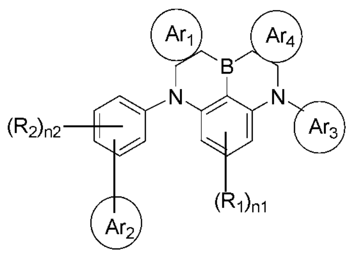
general formula (2).

$Ar_1$ is independently a structure represented by any one selected from the group consisting of formulae (X-1) to (X-3):

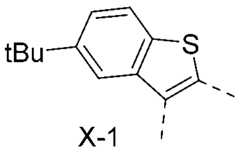
X-1

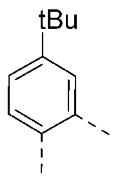
X-2

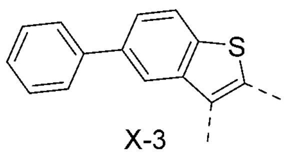
X-3

.

$Ar_3$ and $Ar_4$ are each independently a structure represented by any one selected from the group consisting of formulae (A-1) to (A-5):

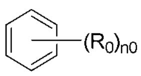
(A-1)

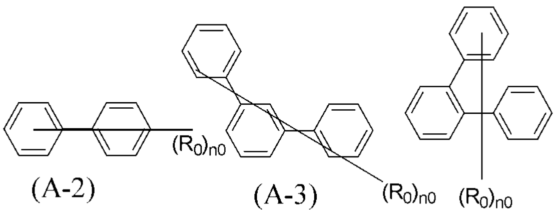
(A-2) (A-3) (A-4)

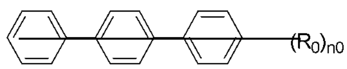
(A-5)

.

When $Ar_1$ is formula X-2, $Ar_4$ is independently a structure represented by any one selected from the group consisting of formulae (A-2) to (A-5).
A linkage site of $Ar_3$ is at a carbon atom of any phenyl ring in $Ar_3$, and fused sites of $Ar_4$ are at two ortho carbon atoms of a same phenyl ring in $Ar_4$.
$Ar_2$ is a structure represented by any one selected from the group consisting of formulae (B-1) to (B-4):

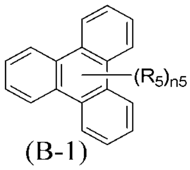
(B-1)
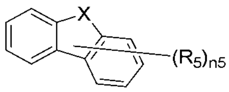
(B-2)
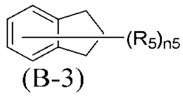
(B-3)
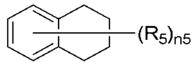
(B-4)
.

X is each independently selected from the group consisting of O, S, N-$CH_3$, N-Ph, and $C(CH_3)_2$.

$n_0$, $n_1$, $n_2$, and $n_5$ are each independently a positive integer selected from the group consisting of 0 to 14.

$R_0$, $R_1$, $R_2$, and $R_5$ are each independently selected from the group consisting of -H, -D, a linear alkyl group having 1 to 20 carbon atoms, a linear alkoxy group having 1 to 20 carbon atoms, a linear thioalkoxy group having 1 to 20 carbon atoms, a branched alkyl group having 3 to 20 carbon atoms, a cyclic alkyl group having 3 to 20 carbon atoms, a branched alkoxy group having 3 to 20 carbon atoms, a cyclic alkoxy group having 3 to 20 carbon atoms, a branched thioalkoxy group having 3 to 20 carbon atoms, a cyclic thioalkoxy group having 3 to 20 carbon atoms, a silyl group, a ketone group having 1 to 20 carbon atoms, an alkoxycarbonyl group having 2 to 20 carbon atoms, an aryloxycarbonyl group having 7 to 20 carbon atoms, an alkylene group having 1 to 20 carbon atoms, -CN, a carbamoyl group, a haloformyl group, a formyl group, an isocyano group, an isocyanate group, a thiocyanate group, an isothiocyanate group, a hydroxyl group, a nitro group, -$CF_3$, -Cl, -Br, -F, a substituted or unsubstituted aromatic group having 6 to 30 ring atoms, a substituted or unsubstituted heteroaromatic group having 5 to 30 ring atoms, a substituted or unsubstituted aryloxy group having 6 to 30 ring atoms, and a substituted or unsubstituted heteroaryloxy group having 5 to 30 ring atoms.

When $n_0$ is greater than or equal to 2, two adjacent $R_0$ radicals form a ring or do not form a ring with each other. When $n_1$ is greater than or equal to 2, two adjacent $R_1$ radicals form a ring or do not form a ring with each other. When $n_2$ is greater than or equal to 2, two adjacent $R_2$ radicals form a ring or do not form a ring with each other. When $n_5$ is greater than or equal to 2, two adjacent $R_5$ radicals form a ring or do not form a ring with each other.

Preperably, the organic compound has a structure represented by any one of general formulae (2-1) to (2-28):

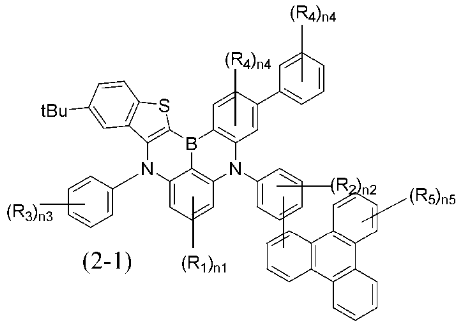
(2-1)
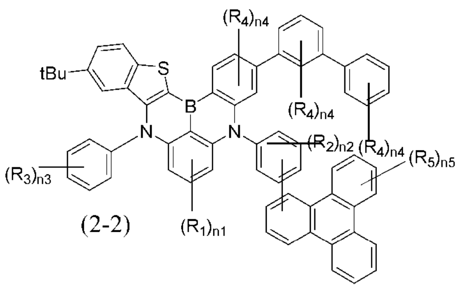
(2-2)
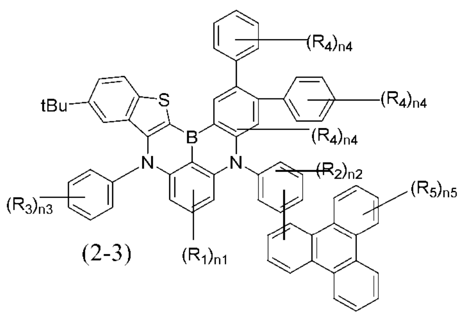
(2-3)
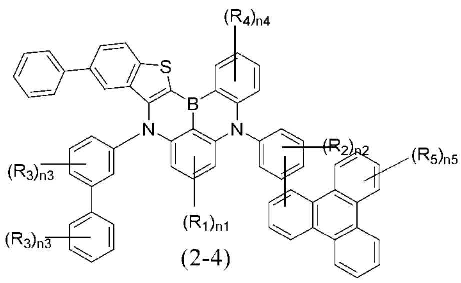
(2-4)

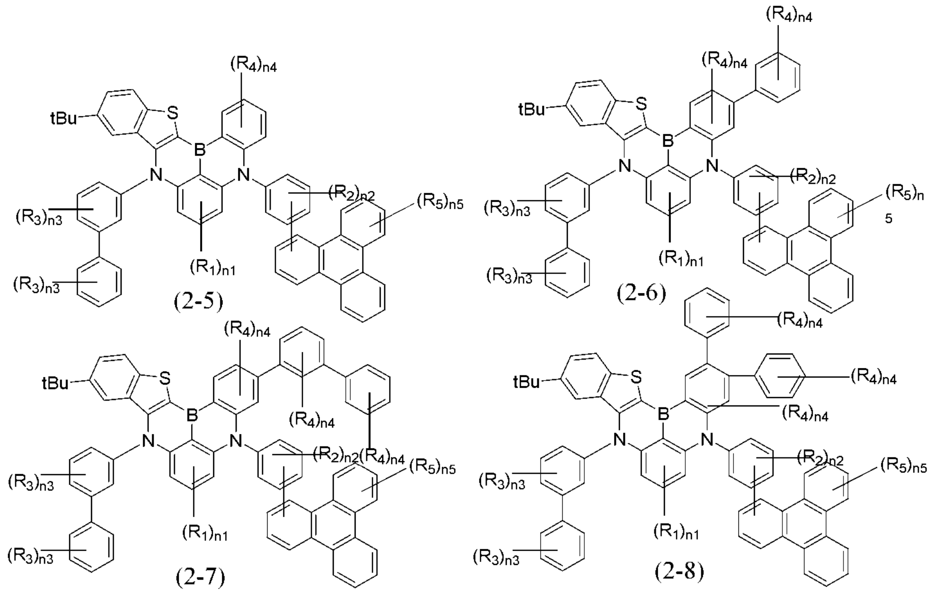

(2-5) (2-6) (2-7) (2-8)

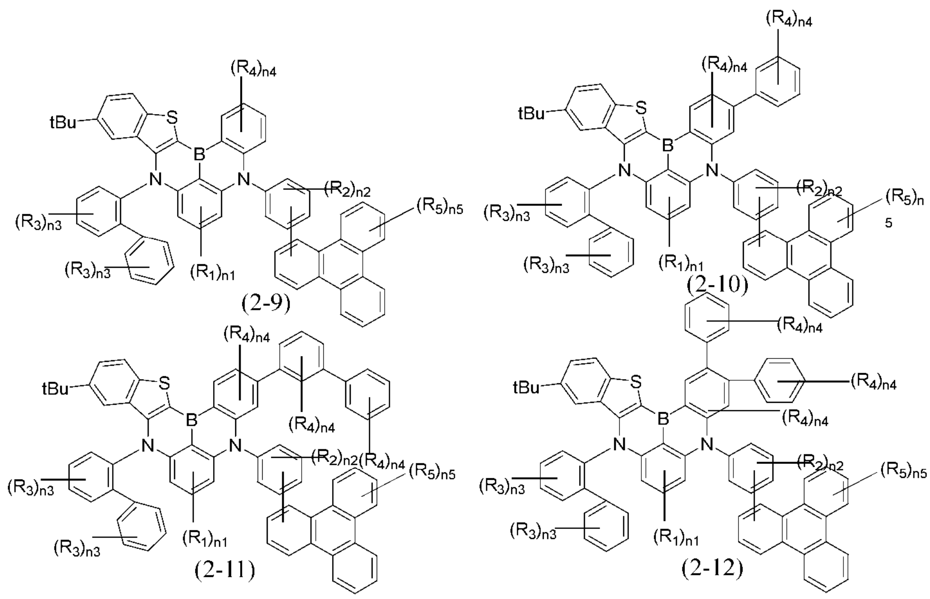

(2-9) (2-10) (2-11) (2-12)

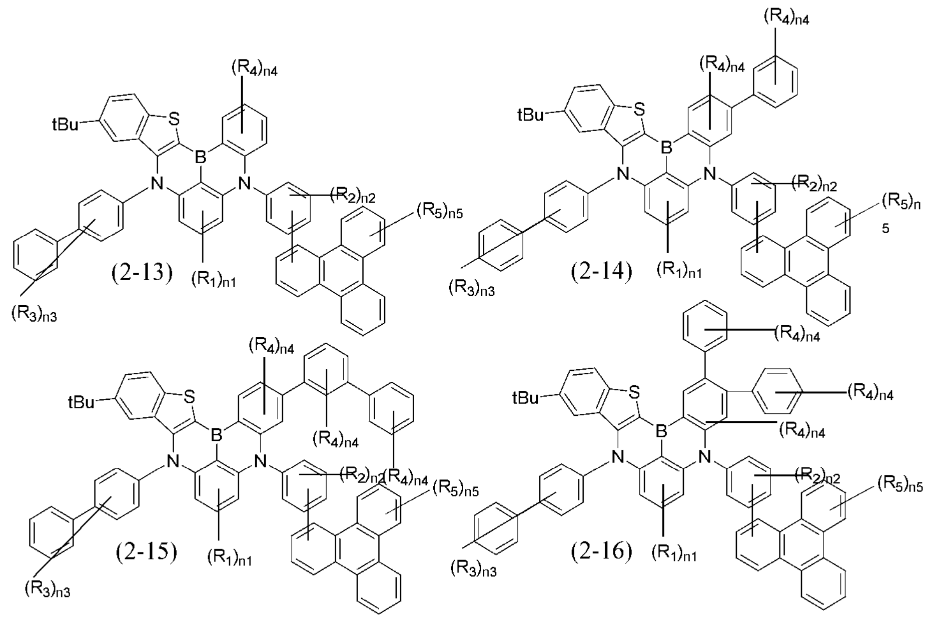

(2-13) (2-14)

(2-15) (2-16)

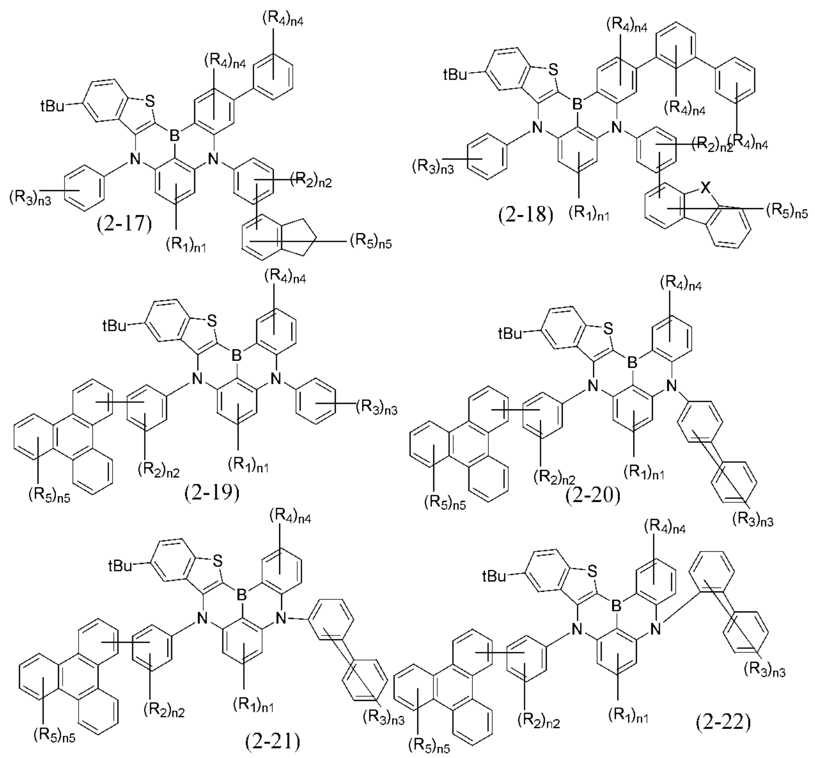

(2-17) (2-18)

(2-19) (2-20)

(2-21) (2-22)

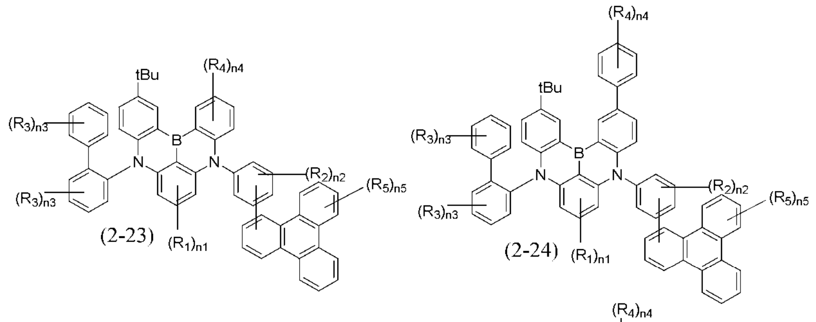

(2-23) (2-24)

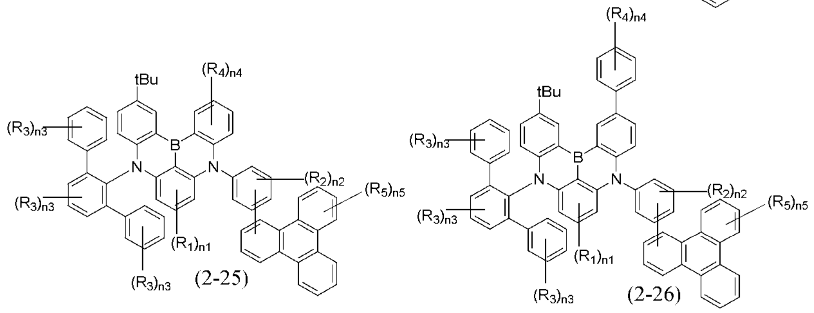

(2-25) (2-26)

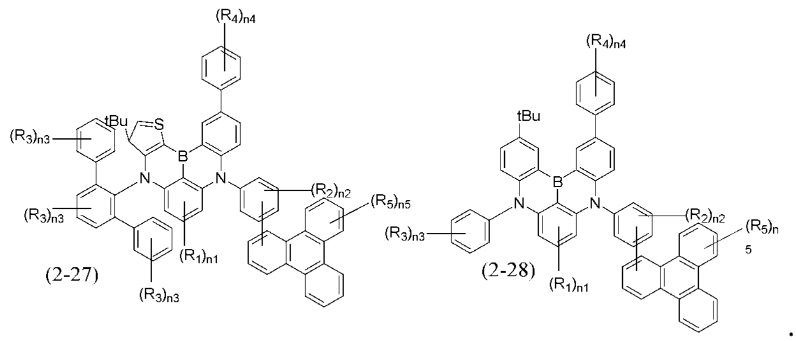

(2-27) (2-28)

.

$R_3$ and $R_4$ are each independently selected from the group consisting of -H, -D, a linear alkyl group having 1 to 20 carbon atoms, a linear alkoxy group having 1 to 20 carbon atoms, a linear thioalkoxy group having 1 to 20 carbon atoms, a branched alkyl group having 3 to 20 carbon atoms, a cyclic alkyl group having 3 to 20 carbon atoms, a branched alkoxy group having 3 to 20 carbon atoms, a cyclic alkoxy group having 3 to 20 carbon atoms, a branched thioalkoxy group having 3 to 20 carbon atoms, a cyclic thioalkoxy group having 3 to 20 carbon atoms, a silyl group, a ketone group having 1 to 20 carbon atoms, an alkoxycarbonyl group having 2 to 20 carbon atoms, an aryloxycarbonyl group having 7 to 20 carbon atoms, an alkylene group having 1 to 20 carbon atoms, -CN, a carbamoyl group, a haloformyl group, a formyl group, an isocyano group, an isocyanate group, a thiocyanate group, an isothiocyanate group, a hydroxyl group, a nitro group, - $CF_3$, -Cl, -Br, -F, a substituted or unsubstituted aromatic group having 6 to 30 ring atoms, a substituted or unsubstituted heteroaromatic group having 5 to 30 ring atoms, a substituted or unsubstituted aryloxy group having 6 to 30 ring atoms, and a substituted or unsubstituted heteroaryloxy group having 5 to 30 ring atoms.

$n_3$ is greater than or equal to 0 and less than or equal to 5.

When $n_3$ is greater than or equal to 2, two adjacent $R_3$ radicals form a ring or do not form a ring with each other.

$n_4$ is greater than or equal to 0 and less than or equal to 5.

When $n_4$ is greater than or equal to 2, two adjacent $R_4$ radicals form a ring or do not form a ring with each other.

Preferably, any one of $R_1$, $R_2$, $R_3$, $R_4$, or $R_5$ is independently selected from the group consisting of -H, -D, a linear alkyl group having 1 to 10 carbon atoms, a branched alkyl group having 3 to 10 carbon atoms, and a cyclic alkyl group having 3 to 10 carbon atoms

Preferably, any one of $R_1$, $R_2$, $R_3$, $R_4$, or $R_5$ is independently selected from the group consisting of -H, -D, a linear alkyl group having 1 to 4 carbon atoms, and a branched alkyl group having 3 to 5 carbon atoms.

Preferably, when $Ar_2$ is the structure represented by the formula (B-2), the structure represented by the formula (B-2) is at least one selected from the group consisting of:

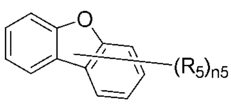, 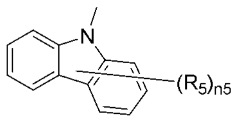, and 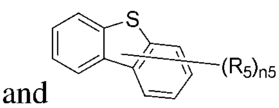.

Preferably, the organic functional layer includes at least a light-emitting layer, the light-emitting layer includes a host material and a guest material, the guest material is the at least one organic compound, and the host material includes a fused aromatic derivative or a heteroaromatic compound.

Preferably, the host material includes one or more of an anthracene derivative, a pyrene derivative, a naphthalene derivative, a pentacene derivative, a phenanthrene compound, a fluoranthene compound, a carbazole derivative, a dibenzofuran derivative, a ladder-type furan compound, or a pyrimidine derivative.

BENEFICIAL EFFECT

According to the present disclosure, a group that allows the overall compound conjugation to be greater is introduced in the boron-nitrogen compound, so as to improve the material performance, improve the luminous efficiency of the organic light-emitting device, and prolong the lifetime of the organic light-emitting device.

BRIEF DESCRIPTION OF DRAWINGS

FIG. 1 is a schematic diagram of a first structure of an organic light-emitting device according to an embodiment of the present disclosure.

FIG. 2 is schematic diagram of a second structure of an organic light-emitting device according to an embodiment of the present disclosure.

FIG. 3 shows a nuclear magnetic resonance hydrogen spectrum of an organic compound M16 according to an embodiment of the present disclosure.

FIG. 4 shows a nuclear magnetic resonance hydrogen spectrum of an organic compound M25 according to an embodiment of the present disclosure.

FIG. 5 shows a nuclear magnetic resonance hydrogen spectrum of an organic compound M277 according to an embodiment of the present disclosure.

FIG. 6 shows a nuclear magnetic resonance hydrogen spectrum of an organic compound M290 according to an embodiment of the present disclosure.

DETAILED DESCRIPTION OF EMBODIMENTS

An embodiment of the present disclosure provides an organic compound, a mixture, a composition, an organic light-emitting device, and a display panel. To make the objective, technical solutions, and effects of the present disclosure clear and explicit, the present disclosure will be described in detail with reference to the accompanying drawings and examples. It is to be understood that the specific embodiments herein are merely illustrative of the present disclosure and are not intended to limit the present disclosure.

An embodiment of the present disclosure provides an organic compound, a mixture, a composition, an organic light-emitting device, and a display panel. Detailed descriptions are given below. It is to be noted that the order in which the following examples are described is not intended to define a preferred order of the examples.

In the present disclosure, an aromatic group, an aryl group, and an aromatic ring system have the same meaning and may be interchangeable.

In the present disclosure, a heteroaromatic group, a heteroaryl group, and a heteroaromatic ring system have the same meaning and may be interchangeable.

In the present disclosure, "substituted" means that a hydrogen atom of a group to be substituted is replaced by a substituent.

In the present disclosure, when the same substituent occurs multiple times, the substituent, at each occurrence, may be independently selected fromdifferent groups. For example, when a general formula contains a plurality of R radicals, the R radicals can be independently selected from different groups.

In the present disclosure, "substituted or unsubstituted" represents that a defined group may or may not be substituted. When the defined group is substituted, it is to be understood that the defined group may be substituted with one or more R substituents, which may be selected from, but not limited to, a deuterium atom, a cyano group, an isocyano group, a nitro group or halogen, an alkyl group having 1 to 20 carbon atoms, a heterocyclyl group having 3 to 20 ring atoms,

an aromatic group having 6 to 20 ring atoms, a heteroaromatic group having 5 to 20 ring atoms, - NR'R", a silanyl group, a carbonyl group, an alkoxycarbonyl group, an aryloxycarbonyl group, a carbamoyl group, a haloformyl group, a formyl group, an isocyanate group, a thiocyanate group, an isothiocyanate group, a hydroxyl group, or a trifluoromethyl group, and these groups may be further substituted with substituents accepted in the art. It is to be understood that R' and R" in -NR'R" are each independently selected from, but not limited to, H, a deuterium atom, a cyano group, an isocyano group, a nitro group or halogen, an alkyl group having 1 to 10 carbon atoms, a heterocyclyl group having 3 to 20 ring atoms, an aromatic group having 6 to 20 ring atoms, or a heteroaromatic group having 5 to 20 ring atoms. For example, R is selected from, but not limited to, a deuterium atom, a cyano group, an isocyano group, a nitro group or halogen, an alkyl group having 1 to 10 carbon atoms, a heterocyclyl group having 3 to 10 ring atoms, an aromatic group having 6 to 20 ring atoms, a heteroaromatic group having 5 to 20 ring atoms, a silanyl group, a carbonyl group, an alkoxycarbonyl group, an aryloxycarbonyl group, a carbamoyl group, a haloformyl group, a formyl group, an isocyanate group, a thiocyanate group, an isothiocyanate group, a hydroxyl group, or a trifluoromethyl group, and these groups may be further substituted with substituents accepted in the art.

In the present disclosure, the number of "ring atoms" denotes the number of atoms that constitute, by atomic bonding, a ring structure of a compound (e.g., a monocyclic compound, a fused ring compound, a cross-linking compound, a carbocyclic compound, or a heterocyclic compound). It is to be noted that when the ring is substituted with a substituent, the atoms contained in the substituent do not fall within the ring-forming atoms. The description of the number of "ring atoms" may also be appropriate for the following, unless otherwise specified. For example, the number of ring atoms in benzene is 6, the number of ring atoms in naphthalene is 10, and the number of ring atoms in a thiophenyl group is 5.

In the present disclosure, "aryl group" or "aromatic group" means an aromatic hydrocarbon group derived by removing a hydrogen atom from an aromatic ring compound. The aryl group may be a monocyclic, fused-ring, or polycyclic aryl group. For the polycyclic aryl group, at least one of rings is an aromatic ring system. For example, "a substituted or unsubstituted aryl group having 6 to 40 ring atoms" refers to an aryl group having 6 to 40 ring atoms, preferably a substituted or unsubstituted aryl group having 6 to 30 ring atoms, more preferably a substituted or unsubstituted aryl group having 6 to 18 ring atoms, particularly preferably a substituted or unsubstituted aryl group having 6 to 14 ring atoms, and optionally the aryl group is substituted. Suitable examples include, but are not limited to, phenyl, biphenyl, terphenyl, naphthyl, anthracenyl, phenanthrenyl, fluoranthenyl, triphenylenyl, pyrenyl, perylenyl, tetracenyl, fluorenyl, perylenyl, acenaphthenyl, or derivatives thereof. It is to be understood that a plurality of aryl groups may be connected by intervening short non-aromatic units (e.g., the non-aromatic units preferably contain non-H atoms, such as C, N or O atoms, less than 10%), for example, acenaphthene, fluorene, or 9,9-diarylfluorene, triarylamine, a diaryl ether system, which should also be encompassed in the definition of the aryl group.

In the present disclosure, "heteroaryl group" or "heteroaromatic group" means that at least one carbon atom of an aryl group is replaced by a non-carbon atom such as an N atom, an O atom, or an S atom.. For example, "substituted or unsubstituted heteroaryl group having 5 to 40 ring atoms" refers to a heteroaryl group having 5 to 40 ring atoms, preferably a substituted or unsubstituted heteroaryl group having 6 to 30 ring atoms, more preferably a substituted or unsubstituted heteroaryl group having 6 to 18 ring atoms, particularly preferably a substituted or unsubstituted heteroaryl group having 6 to 14 ring atoms, and optionally the heteroaryl group is further substituted. Suitable examples include, but are not limited to: thienyl, furanyl, pyrrolyl, imidazolyl, diazolyl, triazolyl, imidazolyl, pyridyl, bipyridyl, pyrimidinyl, triazinyl, acridinyl, pyridazinyl, pyrazinyl, quinolinyl, isoquinolinyl, quinazolinyl, quinoxalinyl, phthalazinyl, pyridopyrimidinyl, pyridopyrazinyl, benzothiophenyl, benzofuranyl, indolyl, pyrroloimidazolyl, pyrrolopyrrolyl, thienopyrrolyl, thienothiophenyl, furopyrrolyl, furofuranyl, thienofuranyl, benzoisoxazolyl, benzoisothiazolyl, benzimidazolyl, cinnolinyl, phenanthridinyl, perimidinyl, quinazolinonyl, dibenzothiophenyl, dibenzofuranyl, carbazolyl, or derivatives thereof.

In the present disclosure, "alkyl group" may indicate a linear, branched and/or cyclic alkyl group. The number of carbon atoms in the alkyl group may be 1 to 50, 1 to 30, 1 to 20, 1 to 10, or 1 to 6. A phrase containing the term, for example, "$C_{1-9}$ alkyl", refers to an alkyl group having 1 to 9 carbon atoms, which at each occurrence may independently be, a $C_1$ alkyl group, a $C_2$ alkyl group, a $C_3$ alkyl group, a $C_4$ alkyl group, a $C_5$ alkyl group, a $C_6$ alkyl group, a $C_7$ alkyl group, a $C_8$ alkyl group, or a $C_9$ alkyl group. Non-limiting examples of the alkyl group include methyl, ethyl, n-propyl, isopropyl, n-butyl, sec-butyl, tert-butyl, isobutyl, 2-ethylbutyl, 3,3-dimethylbutyl, n-pentyl, isopentyl, neopentyl, tert-pentyl, cyclopentyl, 1-methylpentyl, 3-methylpentyl, 2-ethylpentyl, 4-methyl-2-pentyl, n-hexyl, 1-methylhexyl, 2-ethylhexyl, 2-butylhexyl, cyclohexyl, 4-methylcyclohexyl, 4-tert-butylcyclohexyl, n-heptyl, 1-methylheptyl, 2,2-dimethylheptyl, 2-ethylheptyl, 2-butylheptyl, n-octyl, tert-octyl, 2-ethyloctyl, 2-butyloctyl, 2-hexyloctyl, 3,7-dimethyloctyl, cyclooctyl, n-nonyl, n-decyl, adamantyl, 2-ethyldecyl, 2-butyldecyl, 2-hexyldecyl, 2-octyldecyl, n-undecyl, n-dodecyl, 2-ethyldodecyl, 2-butyldodecyl, 2-hexyldodecyl, 2-octyldodecyl, n-tridecyl, n-tetradecyl, n-pentadecyl, n-hexadecyl, 2-ethylhexadecyl, 2-butylhexadecyl, 2-hexylhexadecyl, 2-octylhexadecyl, n-heptadecyl, n-octadecyl, n-nonadecyl, n-eicosyl, 2-ethyleicosyl, 2-butyleicosyl, 2-hexyleicosyl, 2-octyleicosyl, n-heneicosyl, n-docosyl, n-tricosyl, n-tetracosanyl, n-pentacosanyl, n-hexacosanyl, n-heptacosanyl, n-octacosanyl, n-nonacosanyl, n-triacontanyl, or the like.

In the present disclosure, abbreviations for substituents are represented as: n-*normal, sec-secondary*, i-*iso*, ter-*tertiary*, o-*ortho*, m-*meta*, p-*para,* Me-methyl, Et-ethyl, Pr-propyl, Bu-butyl, Am -amyl (pentyl), Hx-hexyl, and Cy-cyclohexyl.

In the present disclosure, "amino group" refers to a derivative of amine that has a structure represented by formula -$N(X)_2$, in which each "X" is independently H, a substituted or unsubstituted alkyl group, a substituted or unsubstituted cycloalkyl group, a substituted or unsubstituted heterocyclyl group, or the like. Non-limiting examples of the amino group include - $NH_2$, -N(alkyl)$_2$, -NH(alkyl), -N(cycloalkyl)$_2$, -NH(cycloalkyl), -N(heterocyclyl)$_2$, - NH(heterocyclyl), -N(aryl)$_2$, -NH(aryl), -N(alkyl)(aryl), -N(alkyl)(heterocyclyl), - N(cycloalkyl)(heterocyclyl), -N(aryl)(heteroaryl), -N(alkyl)(heteroaryl), or the like.

In the present disclosure, unless specifically defined, a hydroxyl group refers to -OH, a carboxyl group refers to -COOH, a carbonyl group refers to -C(=O)-, an amino group refers to - $NH_2$, a formyl group refers to -C(=O)H, a haloformyl group refers to -C(=O)Z (Z denotes halogen), a carbamoyl group refers to -C(=O)$NH_2$, an isocyanate group refers to -NCO, and an isothiocyanate group refers to -NCS.

In the present disclosure, the term "alkoxy group" refers to a group having a structure of "-O-alkyl", i.e., a group obtained by connecting an alkyl group as defined above to the remaining moiety via an oxygen atom. Suitable examples of a phrase containing the term include, but are not limited to, methoxy (-O-$CH_3$ or -OMe), ethoxy (-O-$CH_2CH_3$ or -OEt), or tert-butoxy (-O-C($CH_3$)$_3$ or -OtBu).

In the present disclosure, "*" attached to a single bond denotes a linkage site or fused sites.

In the present disclosure, where no linkage site is specified in a group, it means that any linkable site in the group can be optionally used as the linkage site.

In the present disclosure, where no fused site is specified in a group, it means that any site in the group that may be fused to the remaining moiety can be optionally used as the fused sites, preferably two or more sites at ortho positions in the group as the fused sites.

In the present disclosure, when the same group has a plurality of substituents of same symbol, the substituents may be the same as or different from each other. For example, in

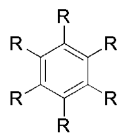,

six R radicals on the phenyl ring may be the same as or different from each other.

In the present disclosure, when a single bond to which a substituent is attacned extends through a corresponding ring, it means that the substituent may be attached to any position of the ring. For example, in

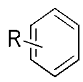,

R may be attached to any substitutable site of the phenyl ring; or in

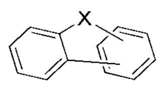,

it means that

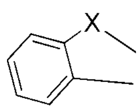

may be connected to any position of

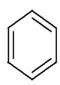

to form fused rings.

In the present disclosure, a cyclic alkyl and cycloalkyl group have the same meaning and are interchangeable.

In the present disclosure, a term "ortho groups" indicates that there is no additional substitutable site between two substituents.

In the present disclosure, "any adjacent two $R_1$, two $R_3$, or two $R_5$ form a ring with each other" indicates adjacent two $R_1$, two $R_3$, or two $R_5$ are connected to each other to form a ring system. The ring system may be selected from an aliphatic hydrocarbon ring, an aliphatic heterocyclic ring, an aromatic hydrocarbon ring, or an aromatic heterocyclic ring, preferably

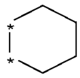, 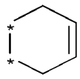, or 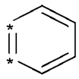.

An embodiment of the present disclosure provides an organic compound having a structure represented by a general formula (1) or (2):

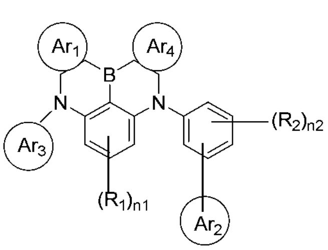 general formula (1) 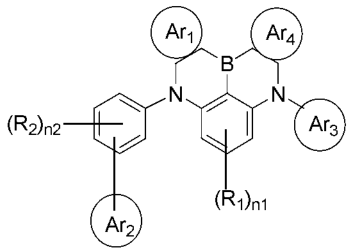 general formula (2).

$Ar_1$ is independently a structure represented by any one selected from the group consisting of formulae (X-1) to (X-3):

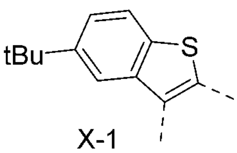
X-1

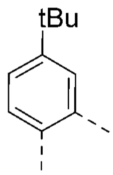
X-2

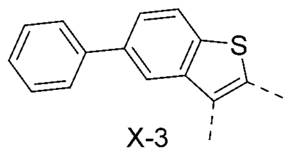
X-3

.

$Ar_3$ and $Ar_4$ are each independently a structure represented by any one selected from the group consisting of formulae (A-1) to (A-5):

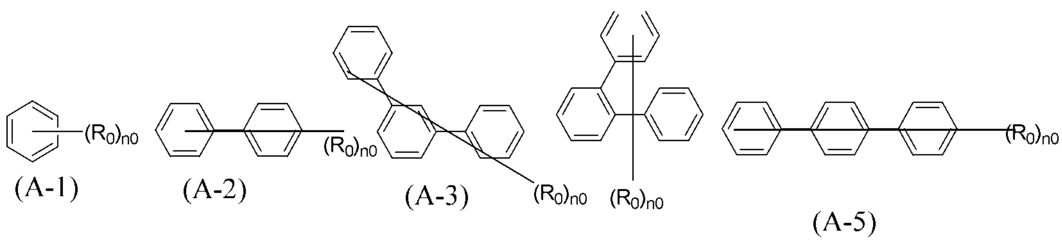
(A-1) (A-2) (A-3) (A-4) (A-5)

.

When $Ar_1$ is formula X-2, $Ar_4$ is independently a structure represented by any one selected from the group consisting of formulae (A-2) to (A-5).

A linkage site of $Ar_3$ is at a carbon atom of any phenyl ring in $Ar_3$, and fused sites of $Ar_4$ are at two ortho carbon atoms on the same phenyl ring.

$Ar_2$ is a structure represented by any one selected from the group consisting of formulae (B-1) to (B-4):

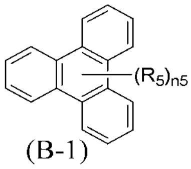
(B-1)
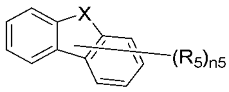
(B-2)
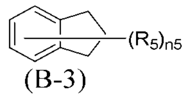
(B-3)
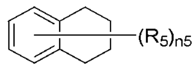
(B-4)
.

X is each independently selected from the group consisting of O, S, N-$CH_3$, N-Ph, and $C(CH_3)_2$.

$n_0$, $n_1$, $n_2$, and $n_5$ are each independently a positive integer selected from the group consisting of 0 to 14.

$R_0$, $R_1$, $R_2$, and $R_5$ are each independently selected from the group consisting of -H, -D, a linear alkyl group having 1 to 20 carbon atoms, a linear alkoxy group having 1 to 20 carbon atoms, a linear thioalkoxy group having 1 to 20 carbon atoms, a branched alkyl group having 3 to 20 carbon atoms, a cyclic alkyl group having 3 to 20 carbon atoms, a branched alkoxy group having 3 to 20 carbon atoms, a cyclic alkoxy group having 3 to 20 carbon atoms, a branched thioalkoxy group having 3 to 20 carbon atoms, a cyclic thioalkoxy group having 3 to 20 carbon atoms, a silyl group, a ketone group having 1 to 20 carbon atoms, an alkoxycarbonyl group having 2 to 20 carbon atoms, an aryloxycarbonyl group having 7 to 20 carbon atoms, an alkylene group having 1 to 20 carbon atoms, -CN, a carbamoyl group, a haloformyl group, a formyl group, an isocyano group, an isocyanate group, a thiocyanate group, an isothiocyanate group, a hydroxyl group, a nitro group, -$CF_3$, -Cl, -Br, -F, a substituted or unsubstituted aromatic group having 6 to 30 ring atoms, a substituted or unsubstituted heteroaromatic group having 5 to 30 ring atoms, a substituted or unsubstituted aryloxy group having 6 to 30 ring atoms, and a substituted or unsubstituted heteroaryloxy group having 5 to 30 ring atoms.

When $n_0$ is greater than or equal to 2, two adjacent $R_0$ radicals form a ring or do not form a ring with each other. When $n_1$ is greater than or equal to 2, two adjacent $R_1$ radicals form a ring or do not form a ring with each other. When $n_2$ is greater than or equal to 2, two adjacent $R_2$ radicals form a ring or do not form a ring with each other. When $n_5$ is greater than or equal to 2, two adjacent $R_5$ radicals form a ring or do not form a ring with each other.

Optionally, the organic compound has a structure represented by any one of general formulae (2-1) to (2-28):

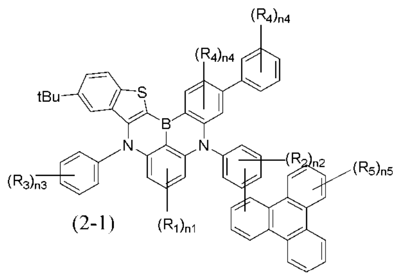
(2-1)
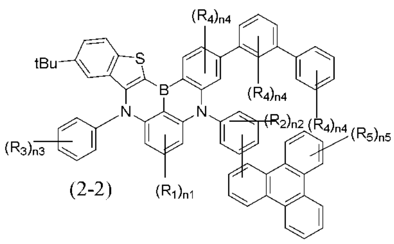
(2-2)

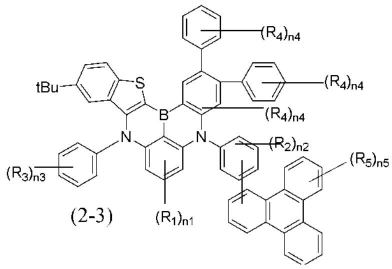
(2-3)
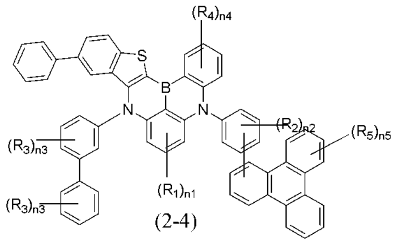
(2-4)

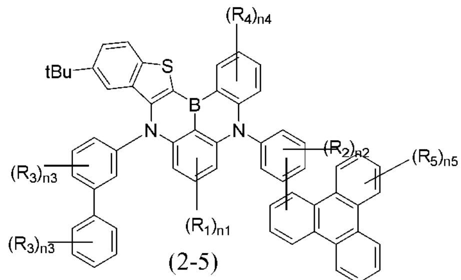

(2-5)

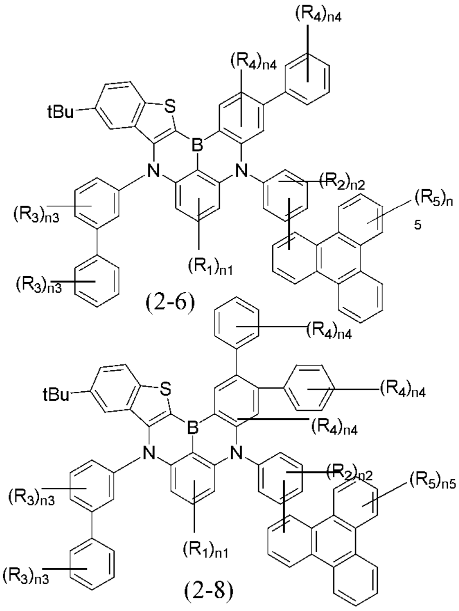

(2-6)

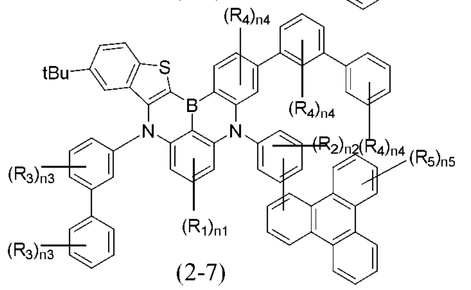

(2-7)

(2-8)

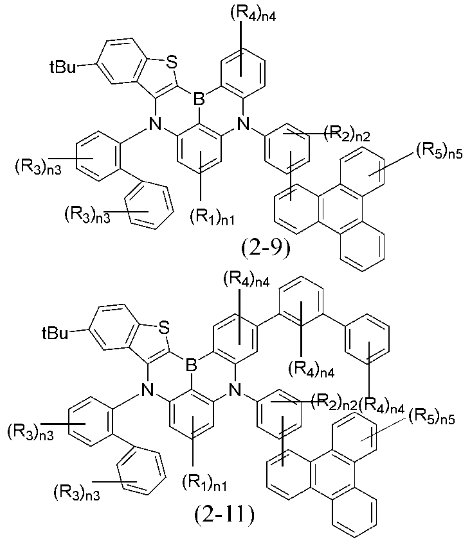

(2-9)

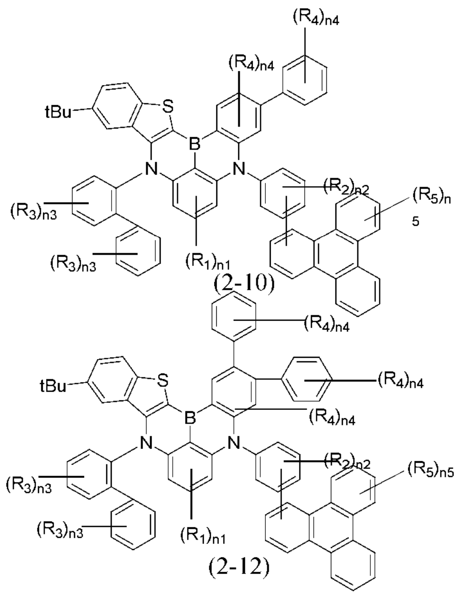

(2-10)

(2-11)

(2-12)

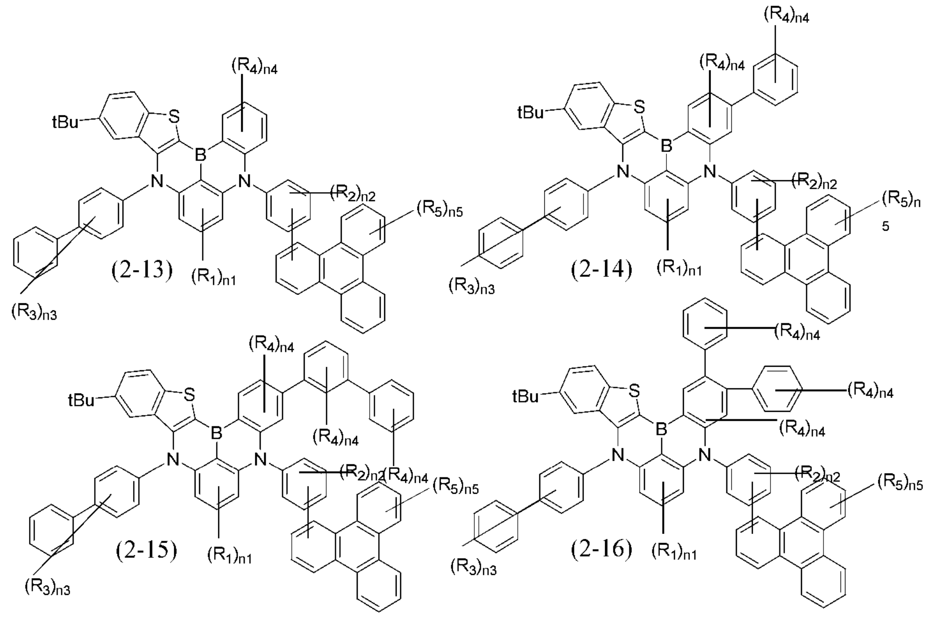

(2-13) (2-14) (2-15) (2-16)

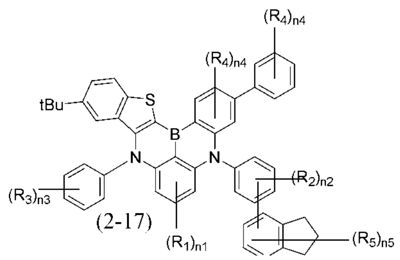

(2-17)

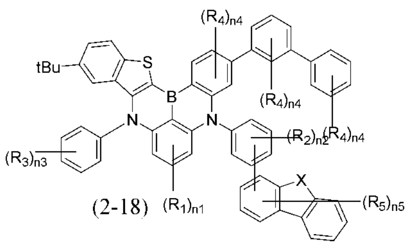

(2-18)

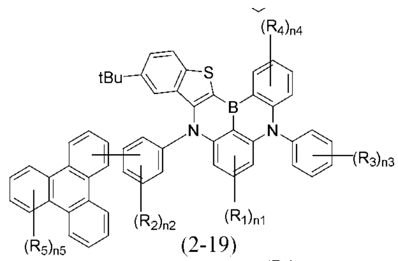

(2-19)

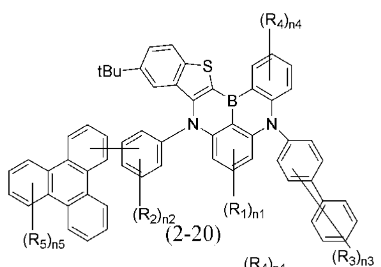

(2-20)

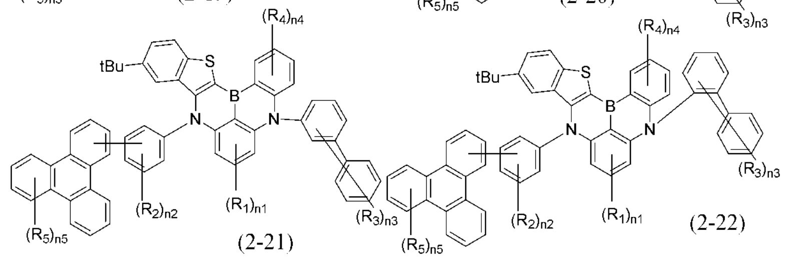

(2-21) (2-22)

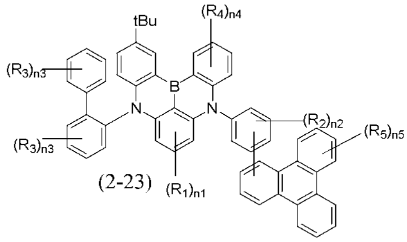

(2-23)

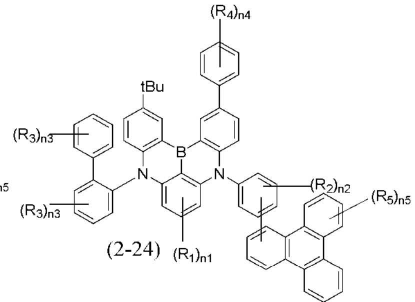

(2-24)

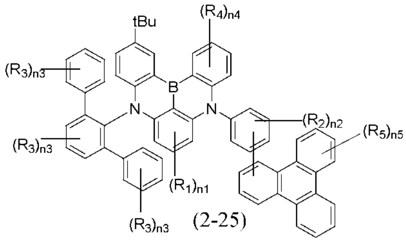

(2-25)

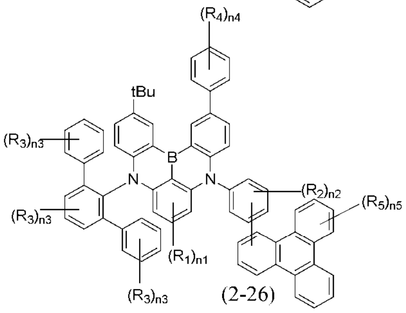

(2-26)

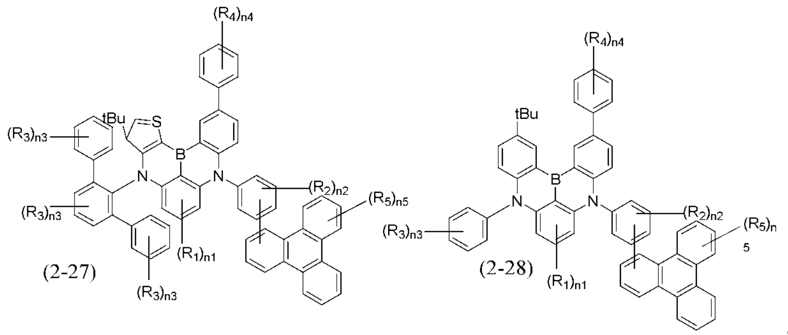

(2-27) (2-28)

.

$R_3$ and $R_4$ are each independently selected from the group consisting of -H, -D, a linear alkyl group having 1 to 20 carbon atoms, a linear alkoxy group having 1 to 20 carbon atoms, a linear thioalkoxy group having 1 to 20 carbon atoms, a branched alkyl group having 3 to 20 carbon atoms, a cyclic alkyl group having 3 to 20 carbon atoms, a branched alkoxy group having 3 to 20 carbon atoms, a cyclic alkoxy group having 3 to 20 carbon atoms, a branched thioalkoxy group having 3 to 20 carbon atoms, a cyclic thioalkoxy group having 3 to 20 carbon atoms, a silyl group, a ketone group having 1 to 20 carbon atoms, an alkoxycarbonyl group having 2 to 20 carbon atoms, an aryloxycarbonyl group having 7 to 20 carbon atoms, an alkylene group having 1 to 20 carbon atoms, -CN, a carbamoyl group, a haloformyl group, a formyl group, an isocyano group, an isocyanate group, a thiocyanate group, an isothiocyanate group, a hydroxyl group, a nitro group, - $CF_3$, -Cl, -Br, -F, a substituted or unsubstituted aromatic group having 6 to 30 ring atoms, a substituted or unsubstituted heteroaromatic group having 5 to 30 ring atoms, a substituted or unsubstituted aryloxy group having 6 to 30 ring atoms, and a substituted or unsubstituted heteroaryloxy group having 5 to 30 ring atoms.

$n_3$ is greater than or equal to 0 and less than or equal to 5.

When $n_3$ is greater than or equal to 2, two adjacent $R_3$ radicals form a ring or do not form a ring with each other.

$n_4$ is greater than or equal to 0 and less than or equal to 5.

When $n_4$ is greater than or equal to 2, two adjacent $R_4$ radicals form a ring or do not form a ring with each other.

Optionally, any one of $R_1$, $R_2$, $R_3$, $R_4$, or $R_5$ is independently selected from the group consisting of -H, -D, a linear alkyl group having 1 to 10 carbon atoms, a branched alkyl group having 3 to 10 carbon atoms, and a cyclic alkyl group having 3 to 10 carbon atoms.

Optionally, any one of $R_1$, $R_2$, $R_3$, $R_4$, or $R_5$ is independently selected from the group consisting of -H, -D, a linear alkyl group having 1 to 4 carbon atoms, and a branched alkyl group having 3 to 5 carbon atoms.

An alkyl group is introduced into the organic compound, allowing to improve the solubility of the organic compound during a process for ink-jet printing or the like, and to improve the product quality of an organic light-emitting device to which the organic compound is applied.

In some embodiments, two adjacent $R_1$ radicals form a ring with each other. Further, two adjacent $R_1$ radicals form a 6-membered aromatic or aliphatic ring. Still further, two adjacent $R_1$ radicals form

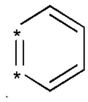

with each other, in which * denotes a linkage site.

In some embodiments, two adjacent $R_2$ radicals form a ring with each other. Further, two adjacent $R_2$ radicals form a 6-membered aromatic or aliphatic ring. Still further, two adjacent $R_2$ radicals form

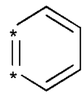

with each other, in which * denotes a linkage site.

In some embodiments, two adjacent $R_3$ radicals form a ring with one another. Further, two adjacent $R_3$ radicals form a 6-membered aromatic or aliphatic ring. Still further, two adjacent $R_3$ radicals form

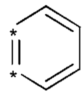

with each other, in which * denotes a linkage site.

In some embodiments, two adjacent $R_4$ radicals form a ring with each other. Further, two adjacent $R_4$ radicals form a 6-membered aromatic or aliphatic ring. Still further, two adjacent $R_4$ radicalsform

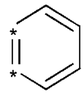

with each other, in which * denotes a linkage site.

In some embodiments, two adjacent $R_5$ radicals form a ring with each other. Further, two adjacent $R_5$ radicals form a 6-membered aromatic or aliphatic ring. Still further, two adjacent $R_5$ radicals form

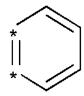

with each other, in which * denotes a linkage site.

In some embodiments, when $Ar_2$ is the structure represented by the formula (B-2), the structure represented by the formula (B-2) is preferably at least one selected from the group consisting of:

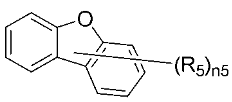 , 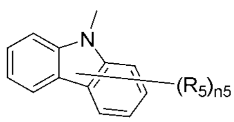 , and 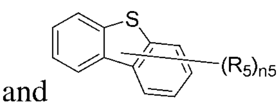 ,

which is advantageous in improving the luminous efficiency and lifetime of the organic light-emitting device to which the organic compound is applied.

In some embodiments, the organic compound is a blue light-emitting material.

In some embodiments, the organic compound is selected from the group consisting of the following compounds:

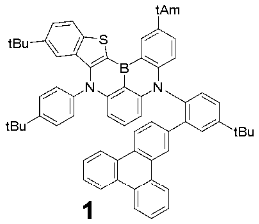
1

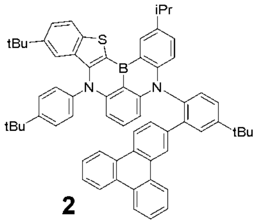
2

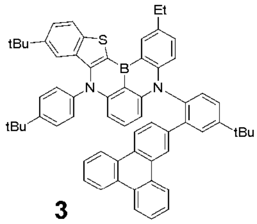
3

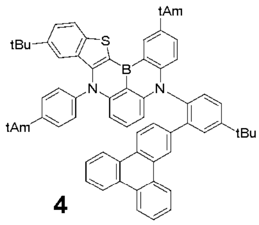
4

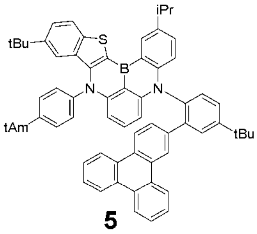
5

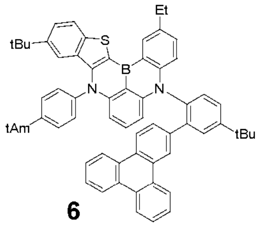
6

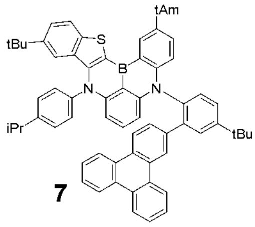
7

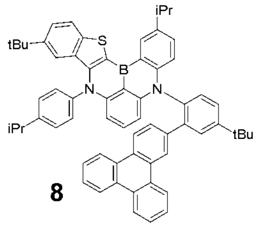
8

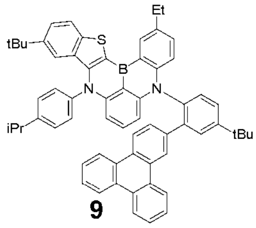
9

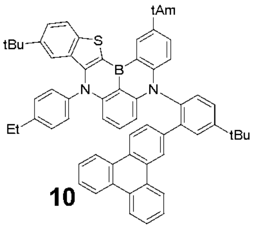
10

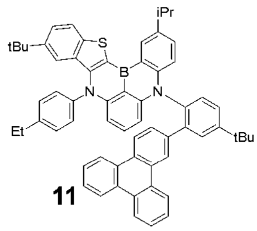
11

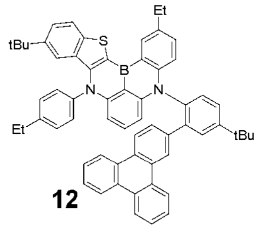
12

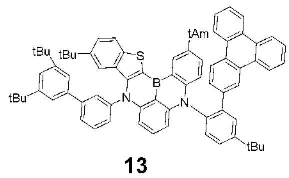
13

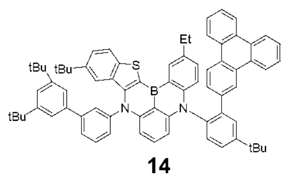
14

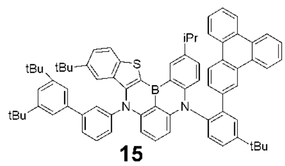
15

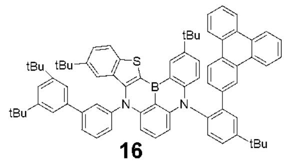
16

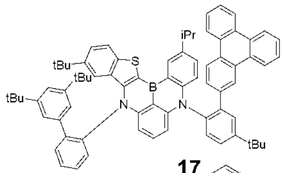
17

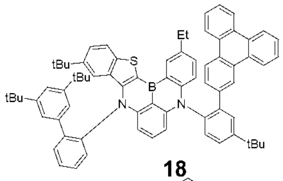
18

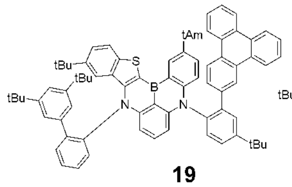
19

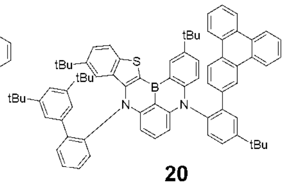
20

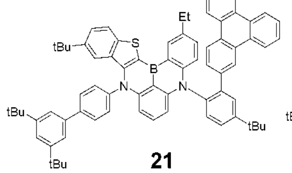
21

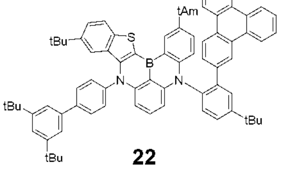
22

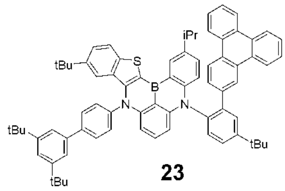
23

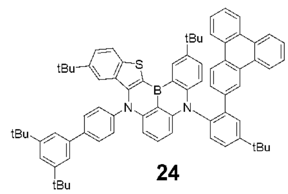
24

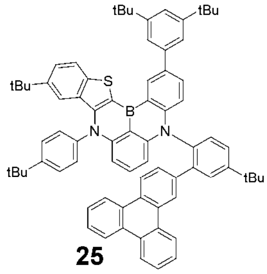
25

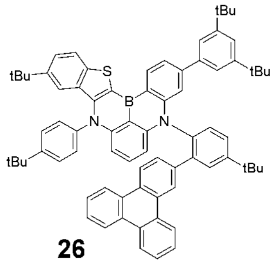
26

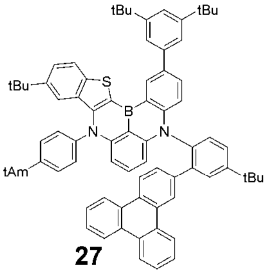
27

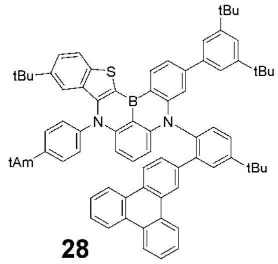
28

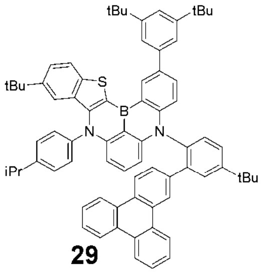
29
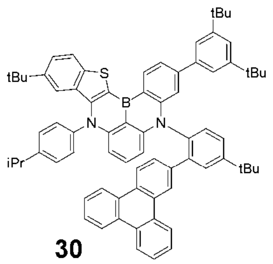
30
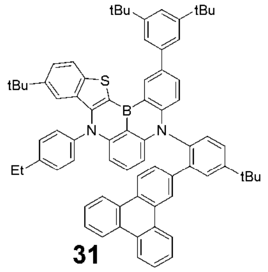
31
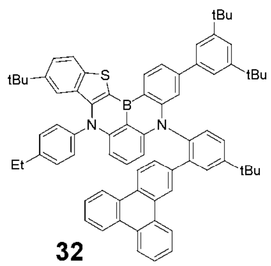
32

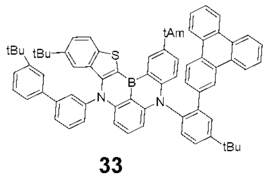
33
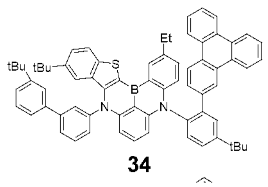
34
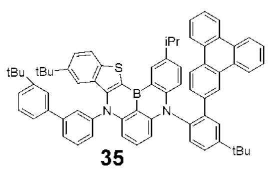
35
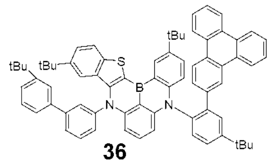
36

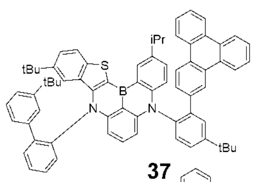
37
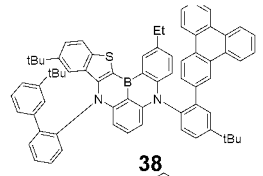
38
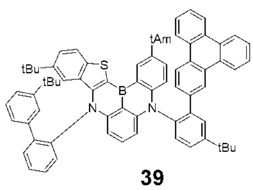
39
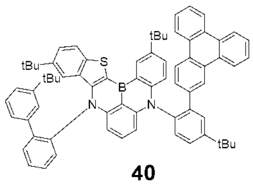
40

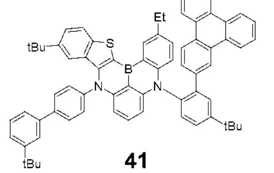
41
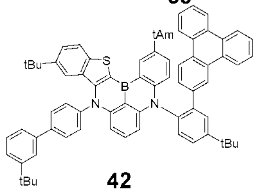
42
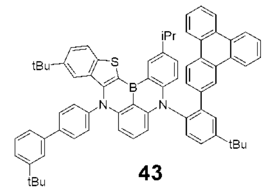
43
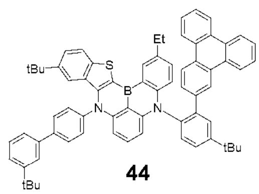
44

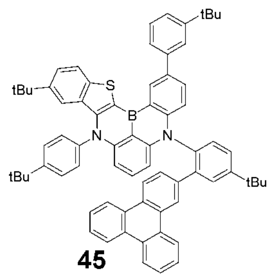
45
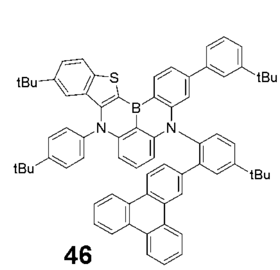
46
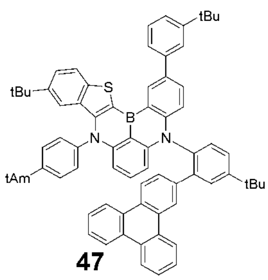
47
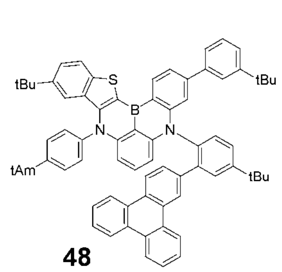
48

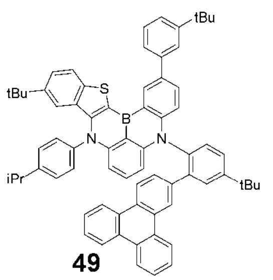
49
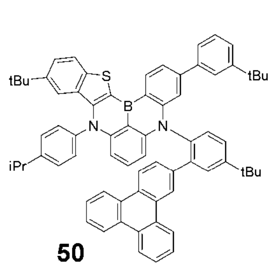
50
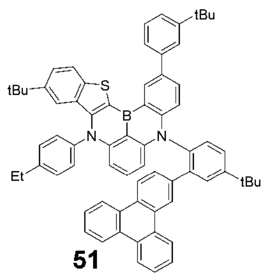
51
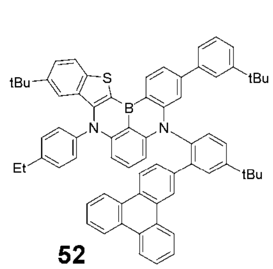
52

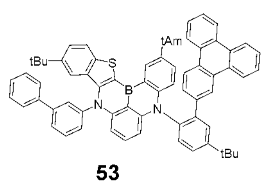
53
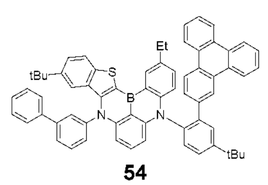
54
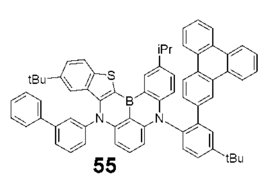
55
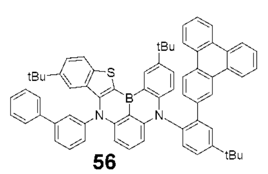
56

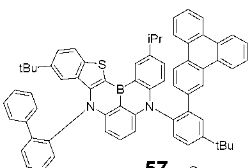
57

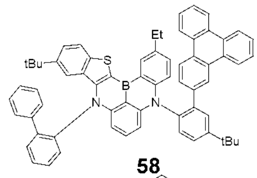
58

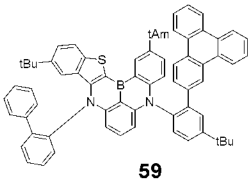
59

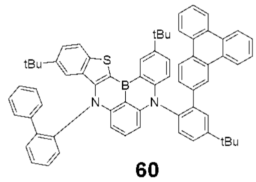
60

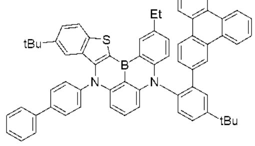
61

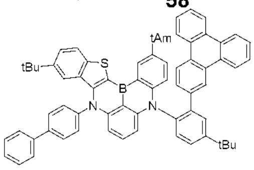
62

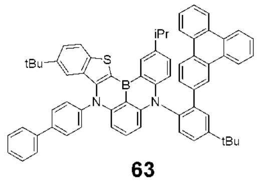
63

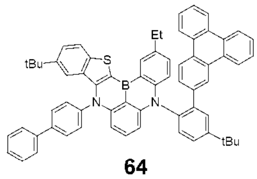
64

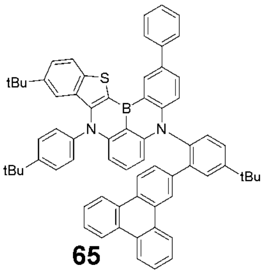
65

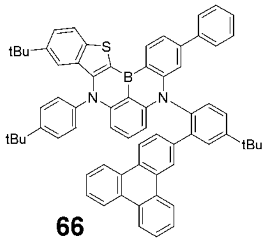
66

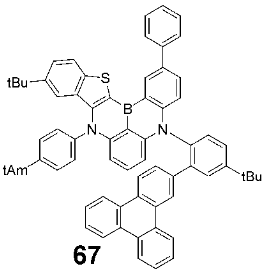
67

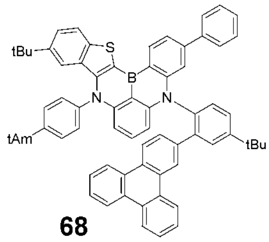
68

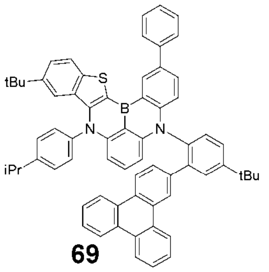
69

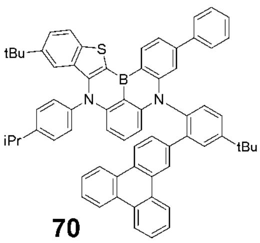
70

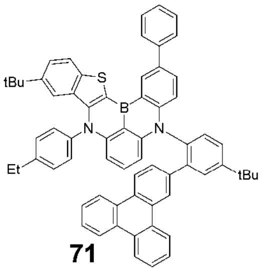
71

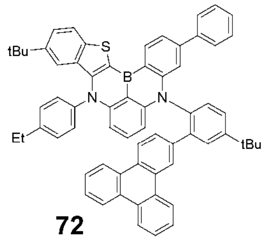
72

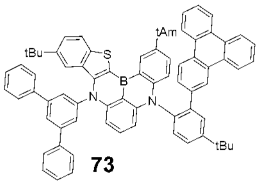
73

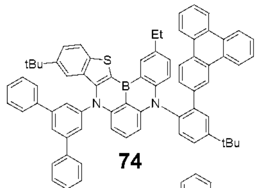
74

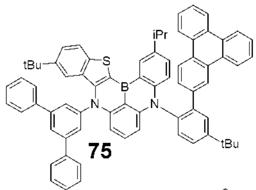
75

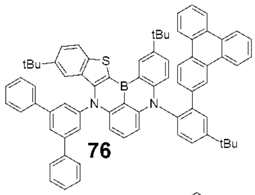
76

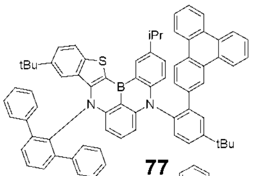
77

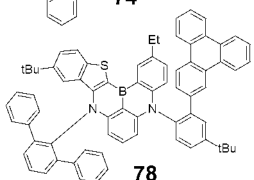
78

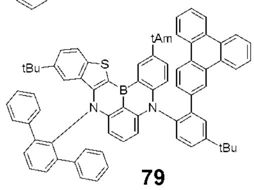
79

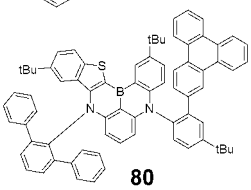
80

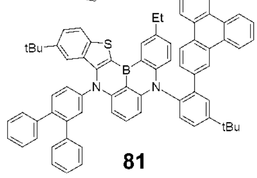
81

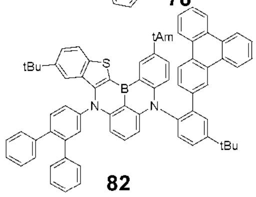
82

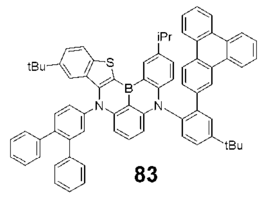
83

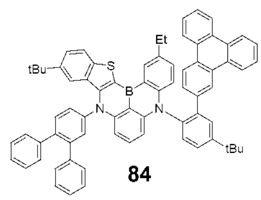
84

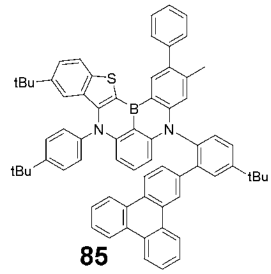
85

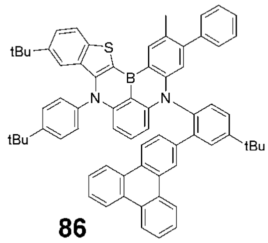
86

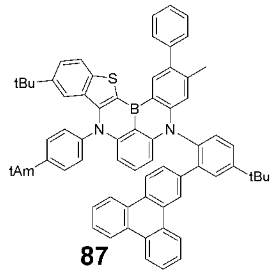
87

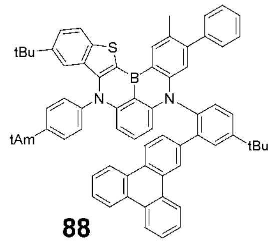
88

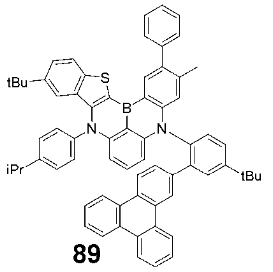
89

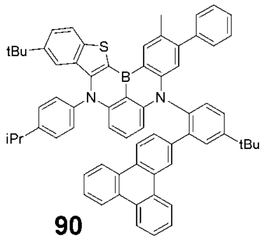
90

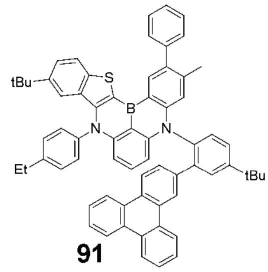
91

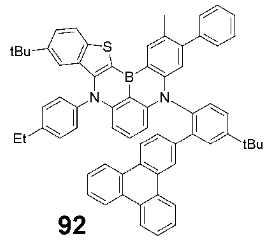
92

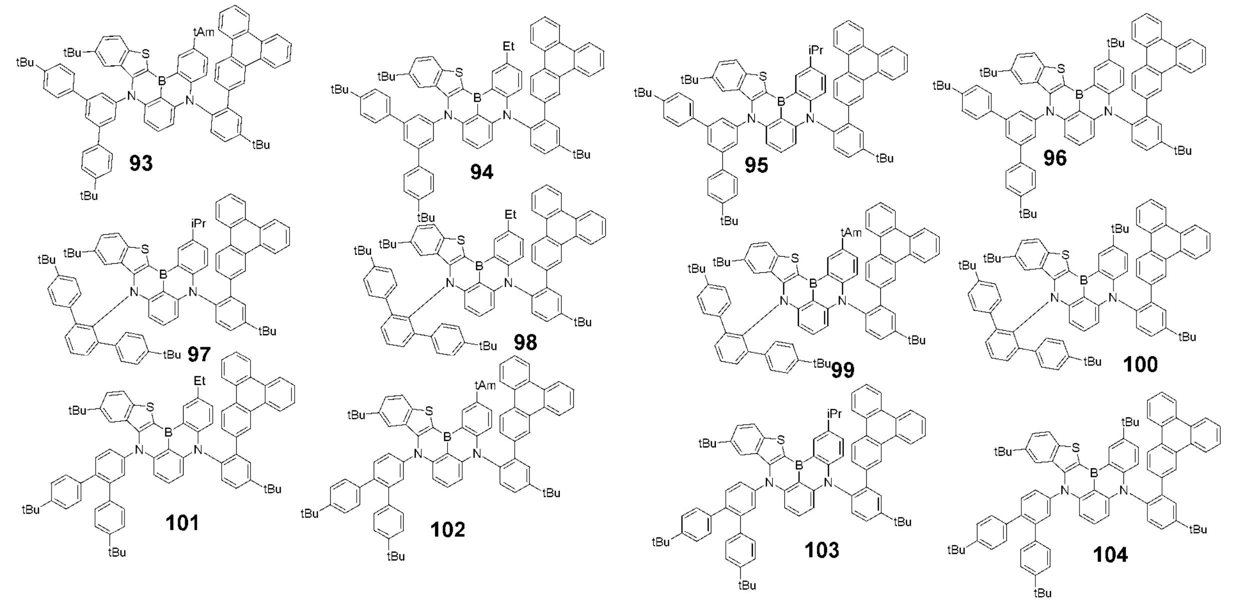
93

94

95

96

97

98

99

100

101

102

103

104

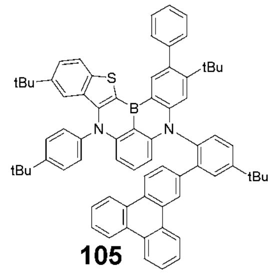
105

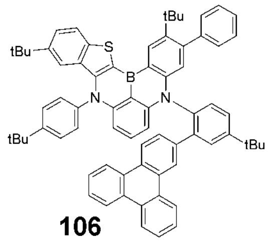
106

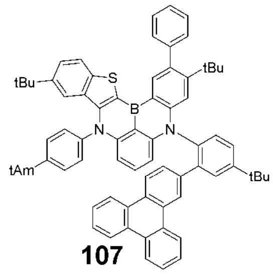
107

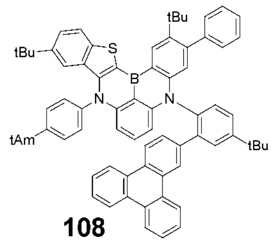
108

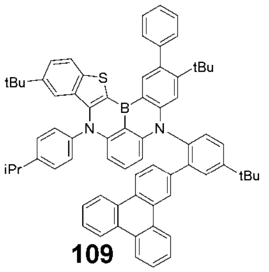
109

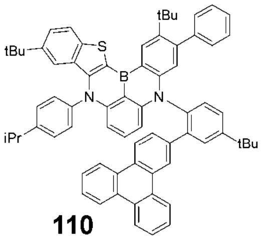
110

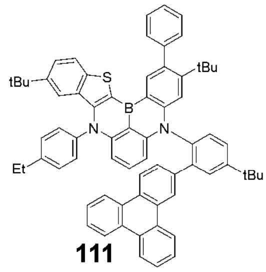
111

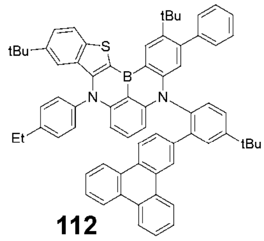
112

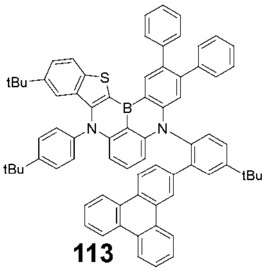
113

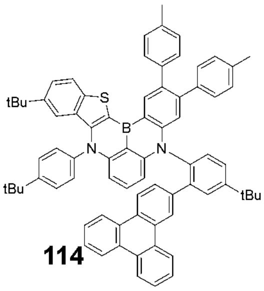
114

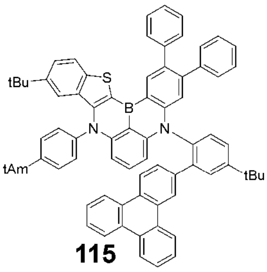
115

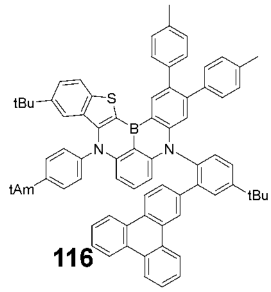
116

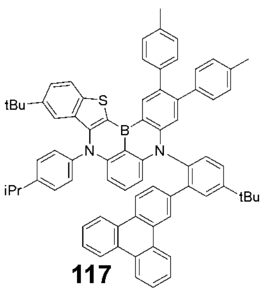
117

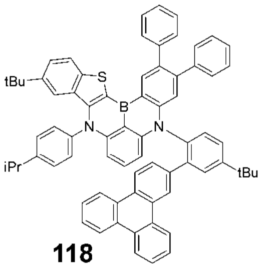
118

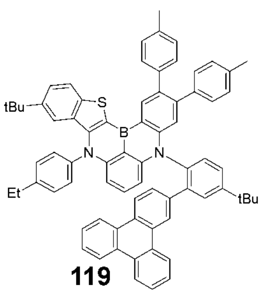
119

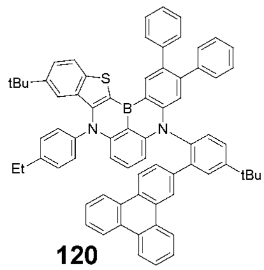
120

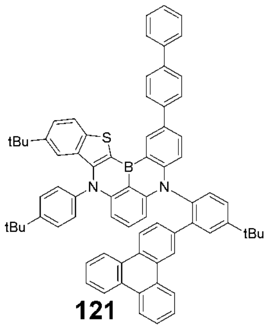
121

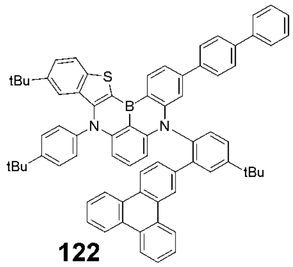
122

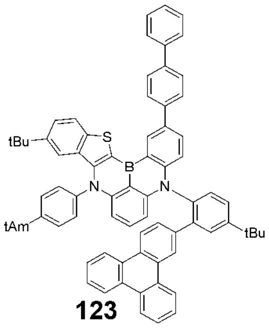
123

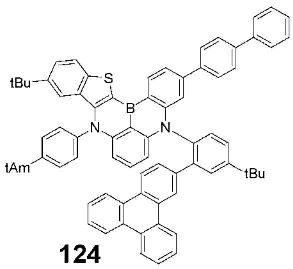
124

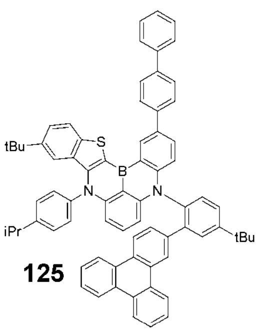
125

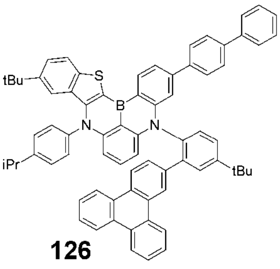
126

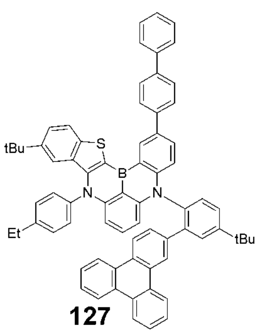
127

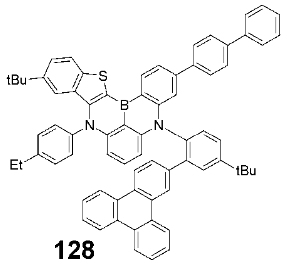
128

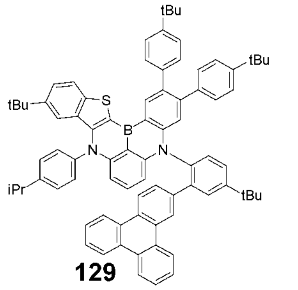
129

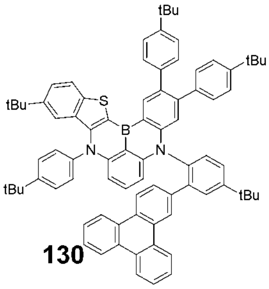
130

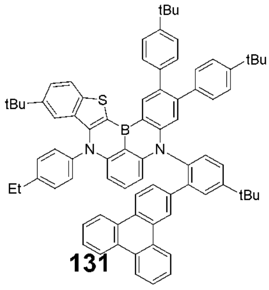
131

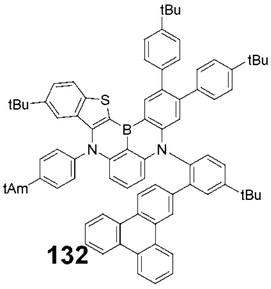
132

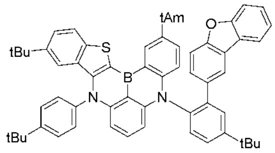
133

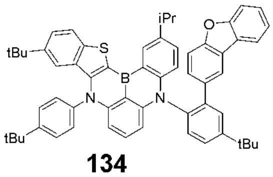
134

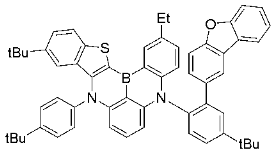
135

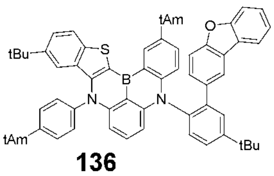
136

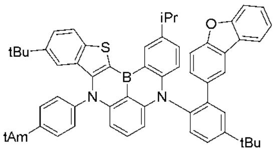
137

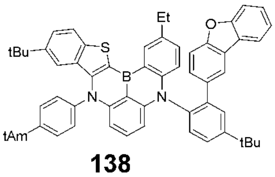
138

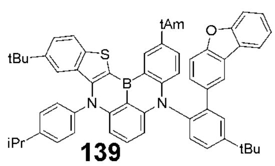
139

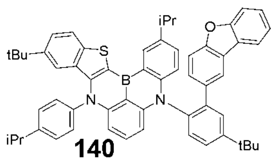
140

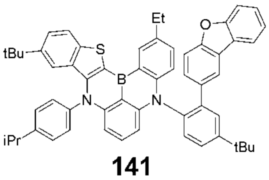
141

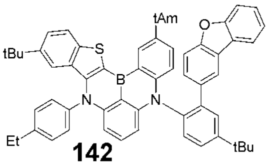
142

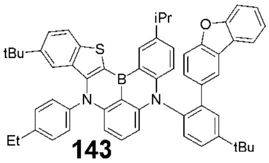
143

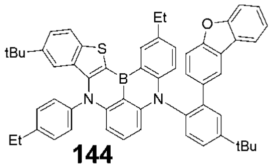
144

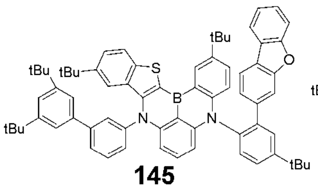
145

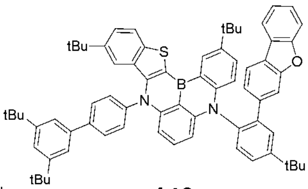
146

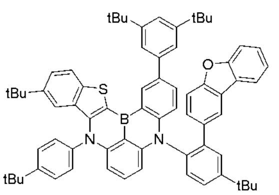
147

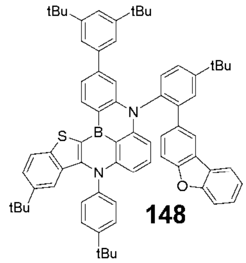
148

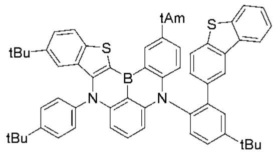
149

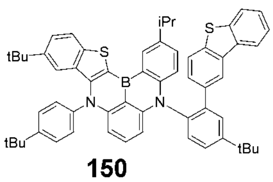
150

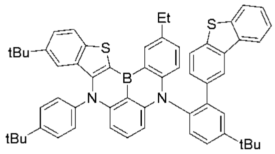
151

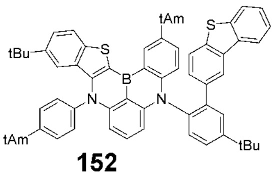
152

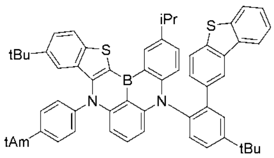
153

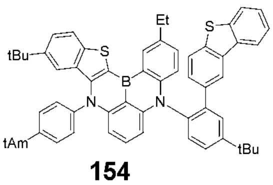
154

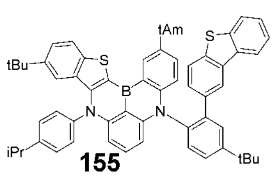
155

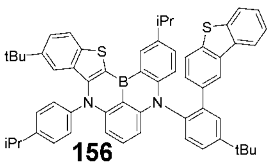
156

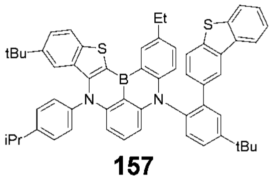
157

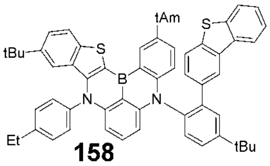
158

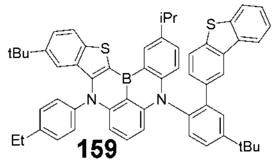
159

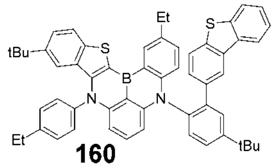
160

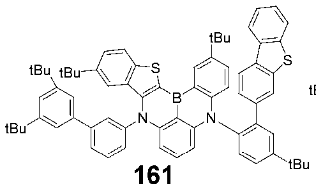
161

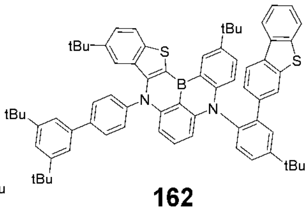
162

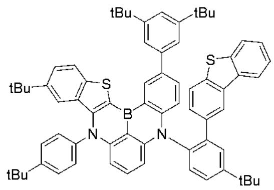
163

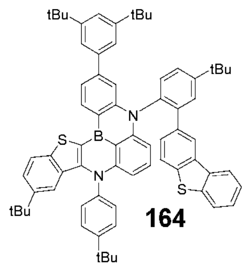
164

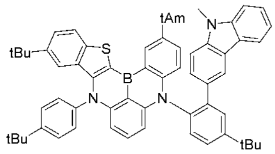
165

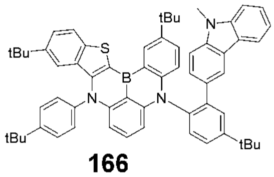
166

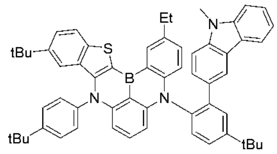
167

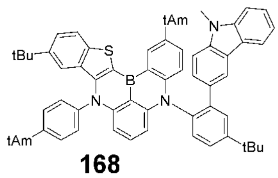
168

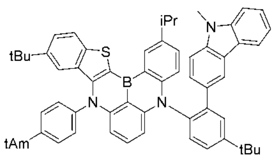
169

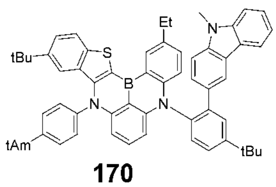
170

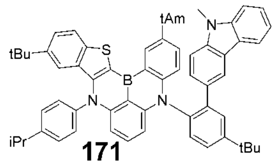
171

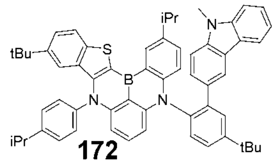
172

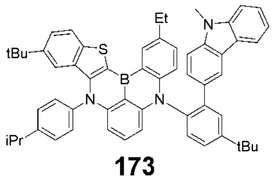
173

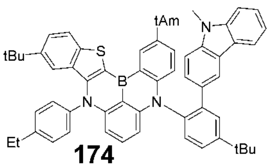
174

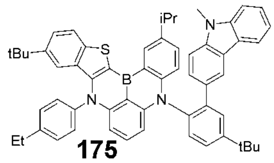
175

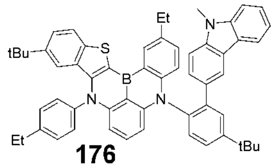
176

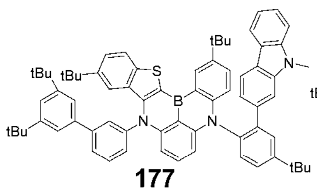
177

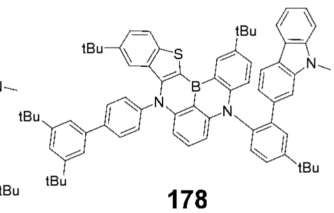
178

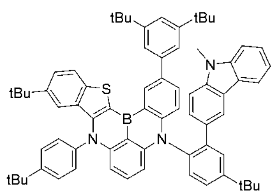
179

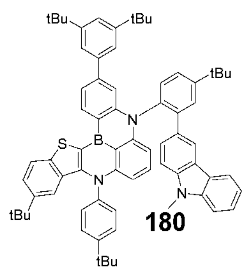
180

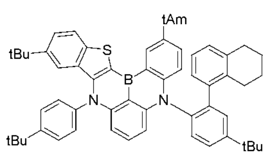
181

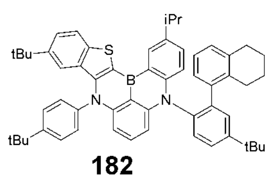
182

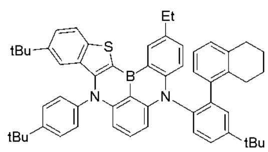
183

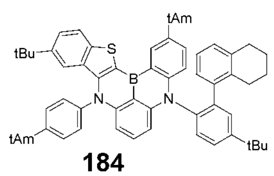
184

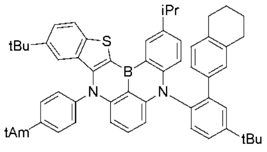
185

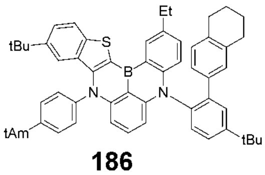
186

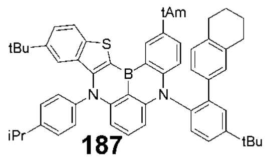
187

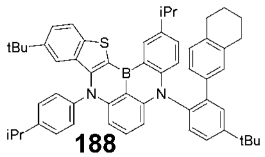
188

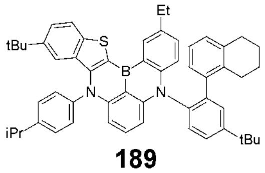
189

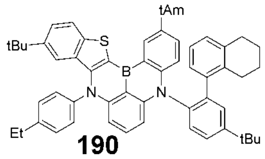
190

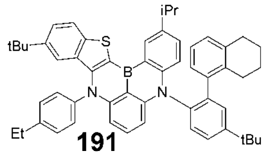
191

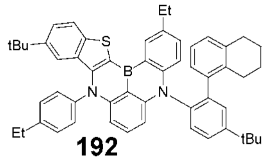
192

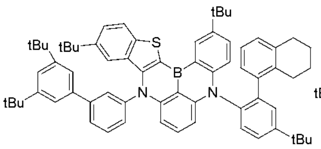
193

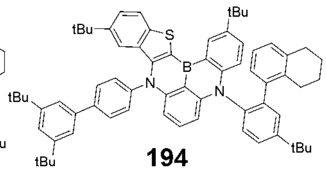
194

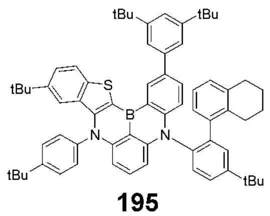
195

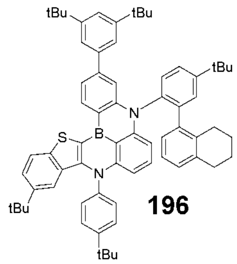
196

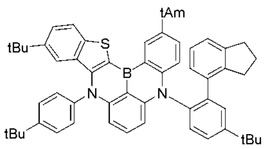
197

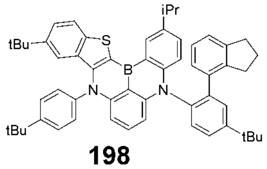
198

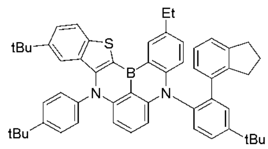
199

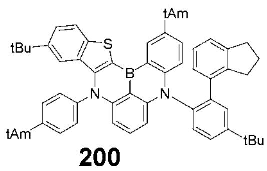
200

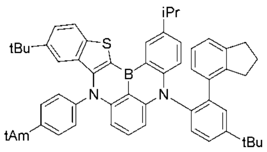
201

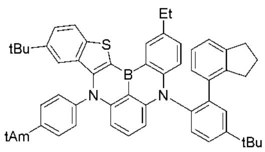
202

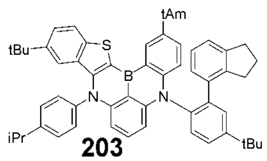
203

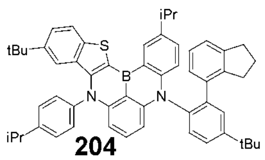
204

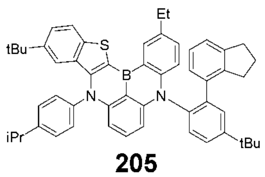
205

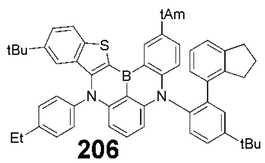
206

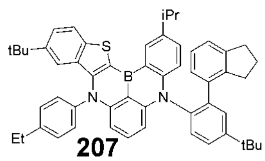
207

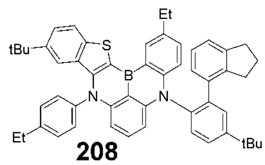
208

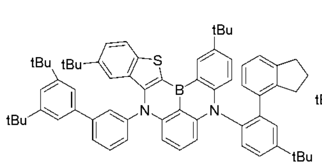
209

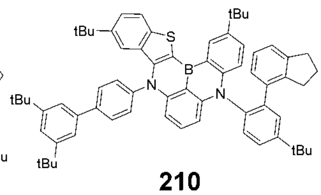
210

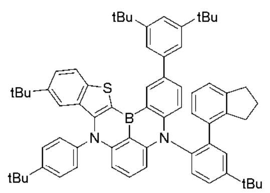
211

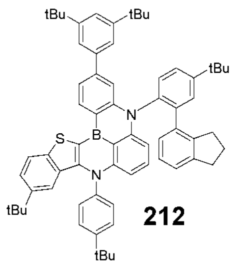
212

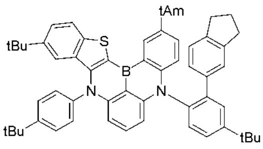
213
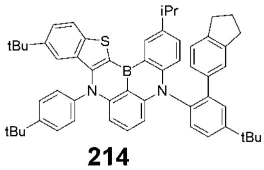
214
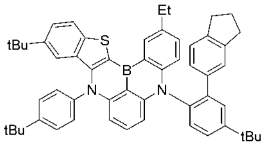
215
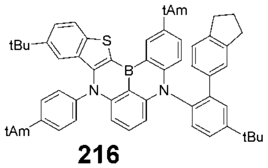
216
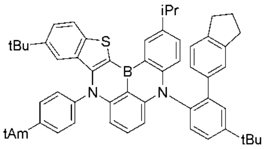
217
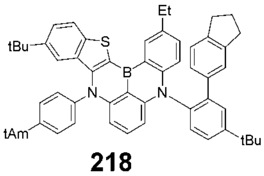
218
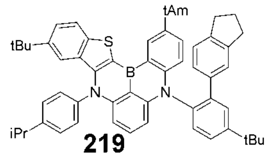
219
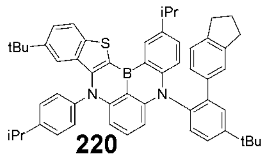
220
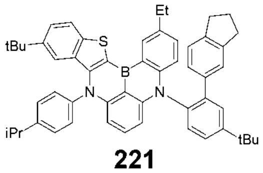
221
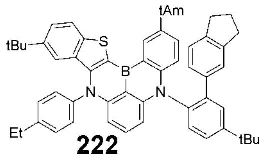
222
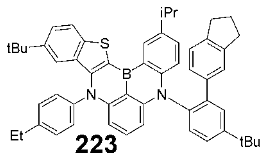
223
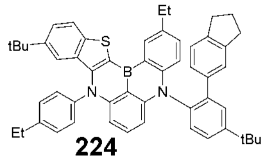
224
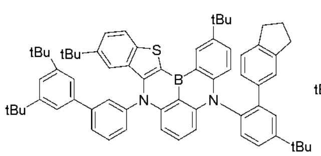
225
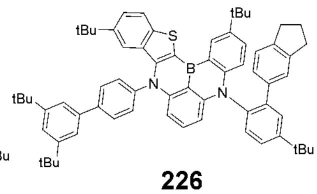
226
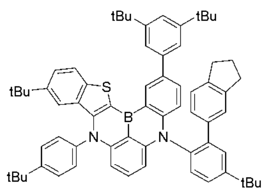
227
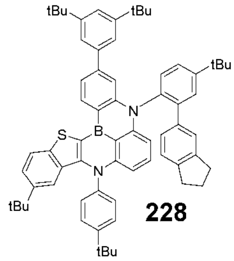
228
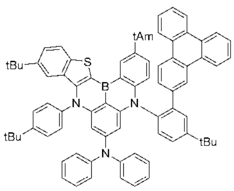
229
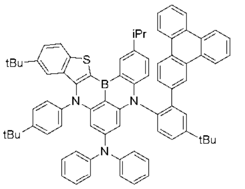
230
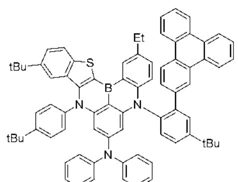
231
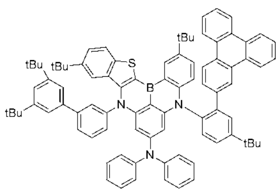
232
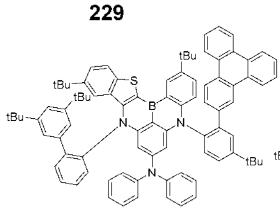
233
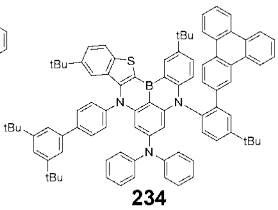
234
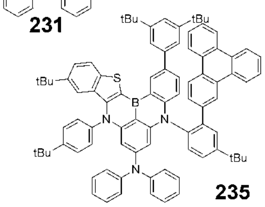
235
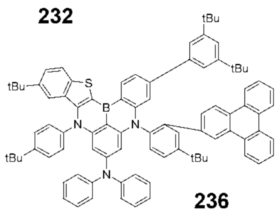
236
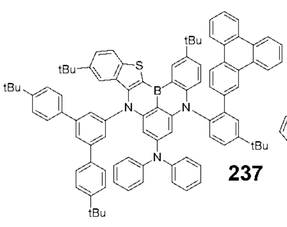
237
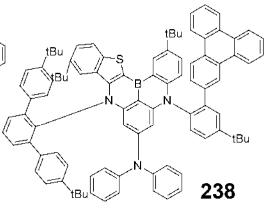
238
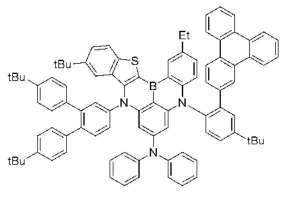
239
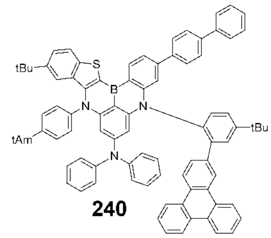
240

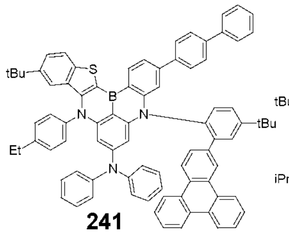
241

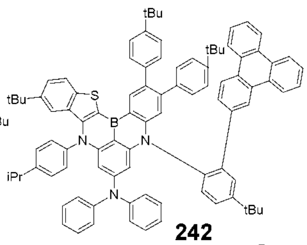
242

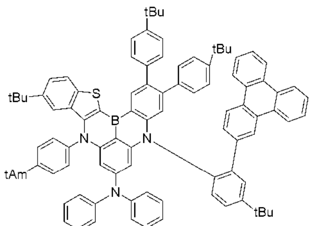
243

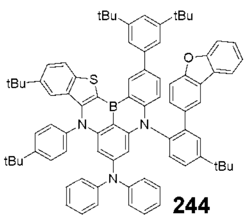
244

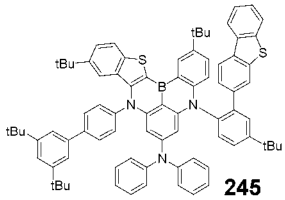
245

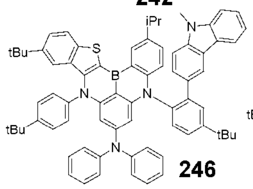
246

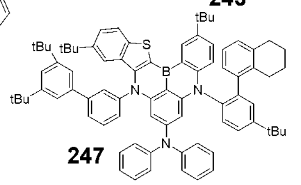
247

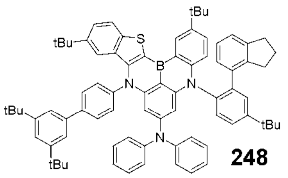
248

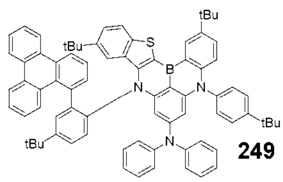
249

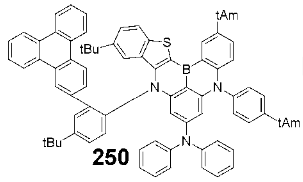
250

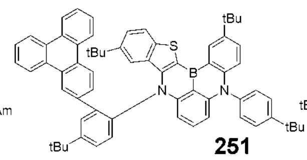
251

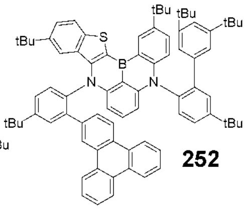
252

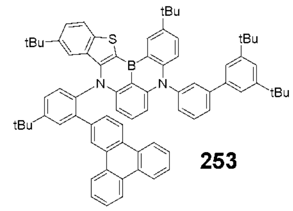
253

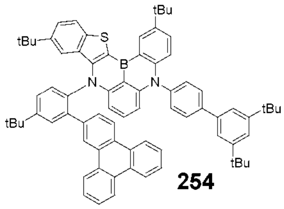
254

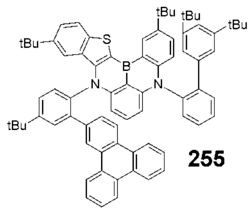
255

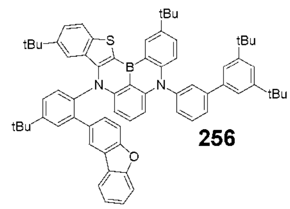
256

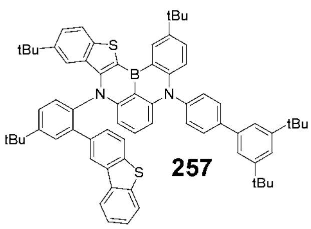
257

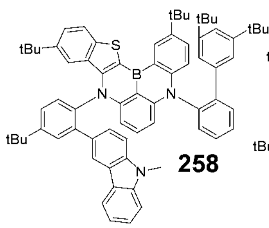
258

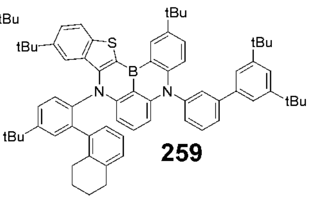
259

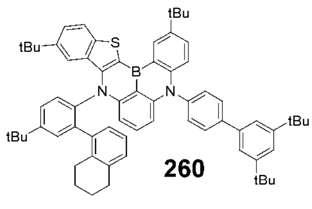
260

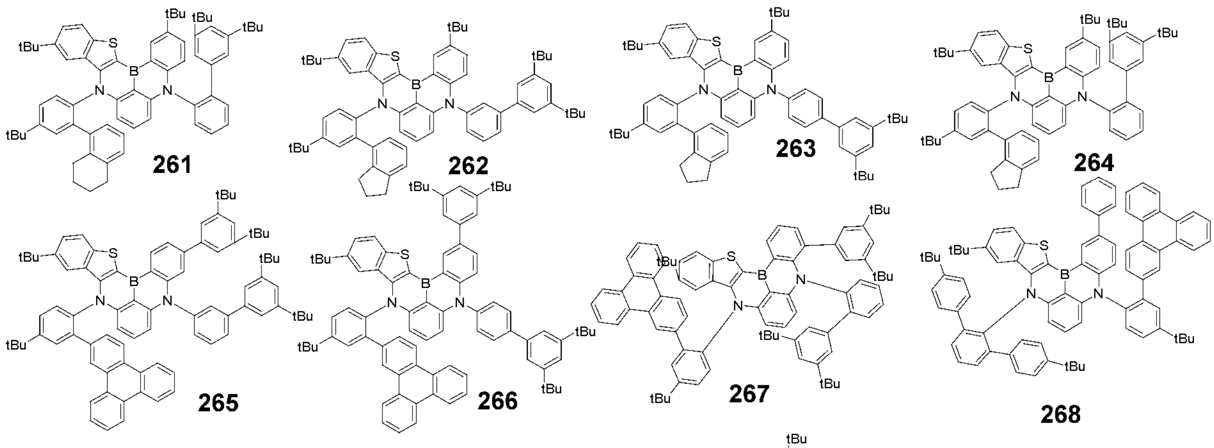

261 262 263 264

265 266 267 268

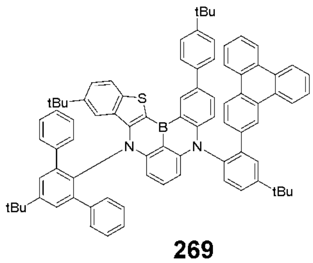

269

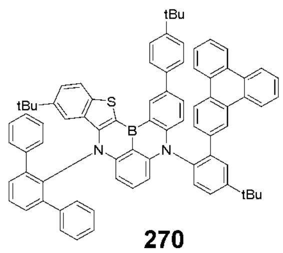

270

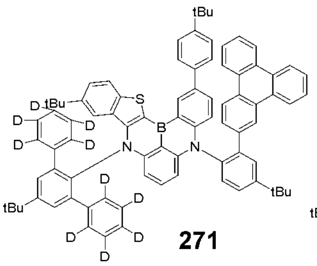

271

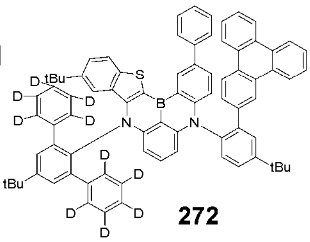

272

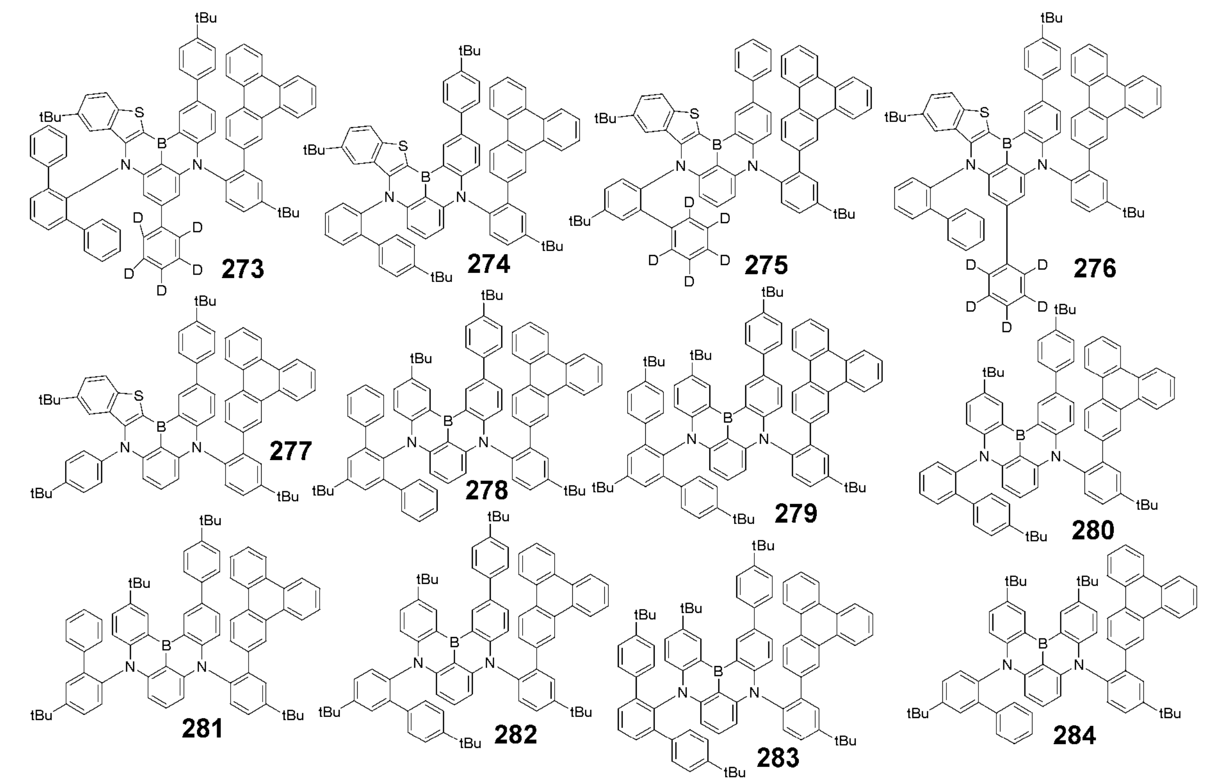

273 274 275 276

277 278 279 280

281 282 283 284

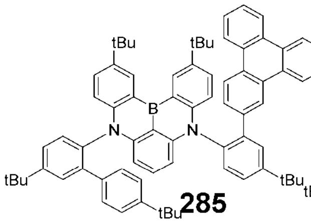

285

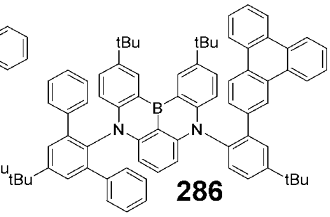

286

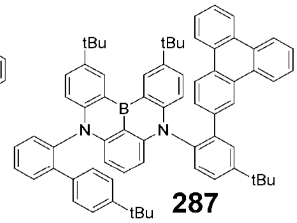

287

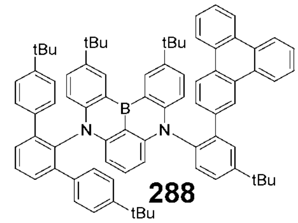

288

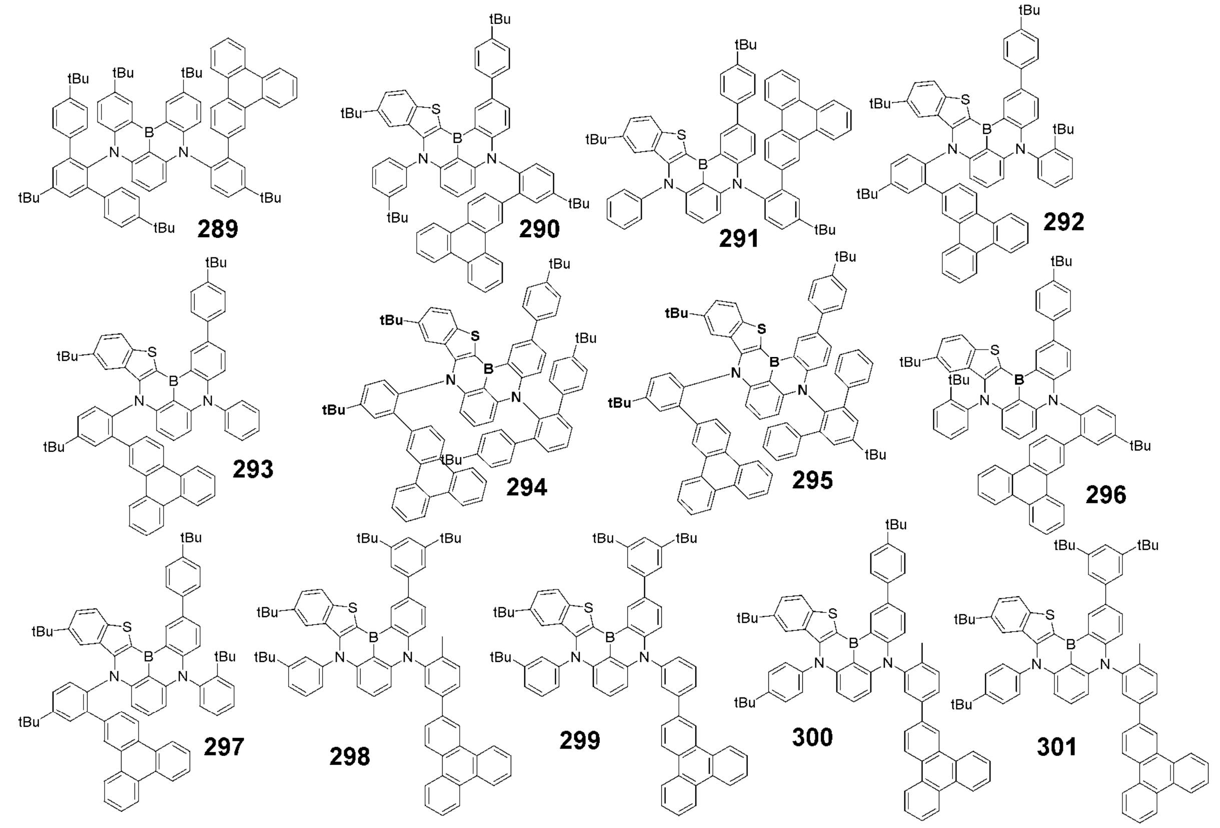

289 290 291 292

293 294 295 296

297 298 299 300 301

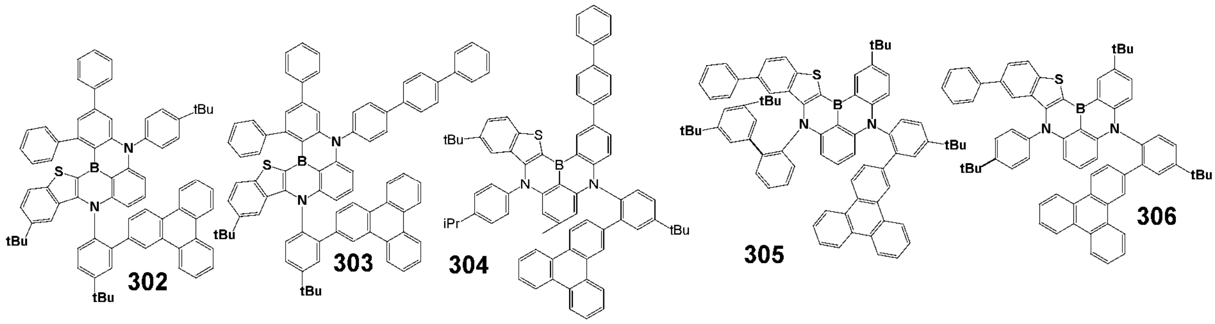

302 303 304 305 306

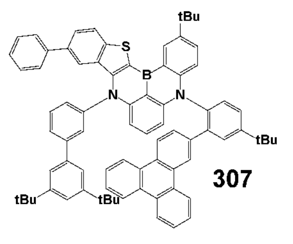

307

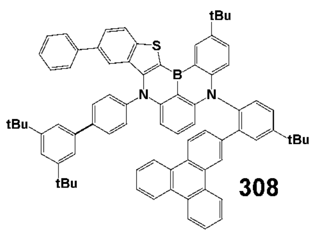

308

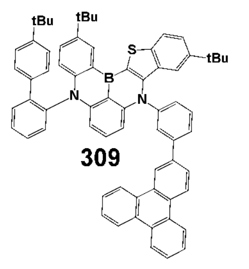

309

According to the embodiment of the present disclosure, a boron-containing biphenyl organic compound is provided, in which a structure such as dibenzofuran, dibenzothiophene, carbazole, benzo five-membered ring, triphenylene, and/or naphthalene, is introduced into the boron-nitrogen compound, so that the overall molecular conjugation is improved, and the luminous efficiency and lifetime of the organic light-emitting device to which the organic compound is applied are improved. In addition, a structure, such as tetrahydronaphthalene and/or indan, is introduced into the boron-nitrogen compound, allowing the molecule to have better solubility during a process such as ink-jet printing, and to be readily purified, thereby improving the purity of the organic compound and further improving the luminous efficiency and lifetime of the organic light-emitting device to which the organic compound is applied.

Referring to FIGs. 1 and 2, the present disclosure further provides an organic light-emitting device 100, including

a first electrode 101, a second electrode 102, and an organic functional layer 103 between the first electrode 101 and the second electrode 102. A material for the organic functional layer 103 includes one or more of the organic compounds as described above. The first electrode 101 may be an anode, and the second electrode 102 may be a cathode.

In some embodiments, the organic light-emitting device 100 may be used in an organic light-emitting diode, an organic photovoltaic cell, an organic light-emitting cell, an organic field effect transistor, an organic light-emitting field effect transistor, an organic laser, an organic spin electron device, an organic sensor, an organic plasmon-emitting diode, or the like, preferably an organic light-emitting diode, an organic light-emitting cell, or an organic light-emitting field effect transistor.

In some embodiments, the organic light-emitting device 100 may be applied in a variety of electronic devices, such as a display panel, a lighting device, a light source, and the like.

In some embodiments, the organic functional layer 103 may be of a monolayer strcutrue, in which case the organic functional layer 103 is a mixture-containing layer, in which the mixture includes a first compound and a second compound. The first compound is selected from one or more of the organic compounds described above, and the second compound is selected from one or more of a hole injection material, a hole transport material, an electron transport material, a hole blocking material, a light-emitting guest material, a light-emitting host material, or an organic dye. A detailed description of various organic functional materials included in the organic functional layer 103 can be found in WO2010135519A1, US20090134784A1, and WO 2011110277A1, the contents of which are incorporated herein by reference in their entireties.

The light-emitting guest material is selected from a singlet illuminant (fluorescent emitter), a triplet emitter (phosphorescent emitter), or a TADF material.

When the second compound is selected from one or more of the hole injection material, the hole transport material, the electron transport material, the hole blocking material, the light-emitting host material, or the organic dye, a mass ratio of the first compound to the second compound is 1:99 to 30:70, preferably 1:99 to 10:90.

When the second compound is the light-emitting guest material, a mass ratio of the first compound to the second compound is 99:1 to 70:30, preferably 99:1 to 90:10.

In some embodiments, the organic functional layer 103 may be of a multiple layer structure. When the organic functional layer 103 is a multilayer structure, the organic functional layer 103 includes at least a light-emitting layer 107. Preferably, the organic functional layer 103 includes a hole injection layer 104, a hole transport layer 105, the light-emitting layer 107, an electron blocking layer 106, an electron injection layer 109, an electron transport layer 108, or a hole blocking layer.

In some embodiments, the organic light-emitting device 100 may be a blue organic light-emitting device, a green organic light-emitting device, or a red organic light-emitting device. The light-emitting layer 107 may comprise a host material and a guest material, the guest material is one or more of the organic compounds described above, the host material includes a fused aromatic derivative or a heteroaromatic compound.

The organic light-emitting device 100 has a light-emitting wavelength between 300 nm to 1000 nm, further between 350 nm to 900 nm, still further between 400 nm to 800 nm, yet still further within the wavelength range of blue light.

In some embodiments, the host material includes at least one of an anthracene derivative, a pyrene derivative, a naphthalene derivative, a pentacene derivative, a phenanthrene compound, a fluoranthene compound, a carbazole derivative, a dibenzofuran derivative, a ladder-type furan compound, or a pyrimidine derivative. Preferably, the host material is a blue light host material applied in a blue organic light-emitting device. When the host material is the blue light host material, the host material is preferably an anthracene organic compound.

In some embodiments, a mass ratio of the host material to the guest material is 99:1 to 70:30, for example 90:10, 85:15, 80:20, 75:25, or the like, preferably 99:1 to 90:10, for example 97:3, 96:4, 95:5, 93:7, 92:8, or the like. The guest material is dispersed in the host material, and the mass ratio of the host material to the guest material is 99:1 to 70:30, which facilitates suppression of crystallization of the light-emitting layer 107 and suppression of concentration quenching of the guest material due to high concentration, thereby improving the luminous efficiency of the organic light-emitting device 100.

In some embodiments, the anode is an electrode used for injecting holes. The anode may inject holes into the organic functional layer 103, for example, into the hole injection layer, the hole transport layer, or the light-emitting layer. The anode may include at least one of a conductive metal, a conductive metal oxide, or a conductive polymer. In an embodiment, an absolute value of difference between the work function of the anode and the highest occupied molecular orbital (HOMO) energy level or valence band energy level of a p-type semiconductor material as the hole injection layer, or between the HOMO energy levels of the hole injection layer and the hole transport layer (or the electron blocking layer), is less than 0.5 eV, preferably less than 0.3 eV, more preferably less than 0.2 eV. A material for the anode includes, but is not limited to, at least one of Al, Cu, Au, Ag, Mg, Fe, Co, Ni, Mn, Pd, Pt, indium tin oxide (ITO), or aluminum-doped zinc oxide (AZO), or other suitable and known anode materials, which can be readily selected by one of ordinary skill in the art. The material for the anode may be deposited using any suitable technique, such as an appropriate physical vapor deposition method, including radio frequency magnetron sputtering, vacuum thermal evaporation, e-beam, and the like. In some

embodiments, the anode may be patterned. For example, the patterned ITO conductive substrates are commercially available and can be used to prepare the light-emitting device 100 of the present disclosure.

In some embodiments, the cathode is an electrode used for injecting electrons. The cathode may inject electrons into the organic functional layer, for example, into the electron injection layer, the electron transport layer, or the light-emitting layer. The cathode may include at least one of a conductive metal or a conductive metal oxide. In an embodiment, an absolute value of difference between the work function of the cathode and the lowest unoccupied molecular orbital (LUMO) energy level or conduction band energy level of a n-type semiconductor material as the electron injection layer, or between the LUMO energy levels of the electron injection layer and the electron transport layer (or the hole blocking layer), is less than 0.5 eV, preferably less than 0.3 eV, more preferably less than 0.2 eV. All materials that can be used as a cathode of an organic electronic device, including but not limited to at least one of Al, Au, Ag, Ca, Ba, Mg, LiF/Al, MgAg alloy, $BaF_2$/Al, Cu, Fe, Co, Ni, Mn, Pd, Pt, or ITO, may be used as the material for the cathode of the device of the present disclosure. The material for the cathode may be deposited using any suitable technique, such as an appropriate physical vapor deposition method, including radio frequency magnetron sputtering, vacuum thermal evaporation, and e-beam.

In some embodiments, the hole injection layer 104 is configured to facilitate hole injection from the anode into the light-emitting layer 107. The hole injection layer 104 includes a hole injection material, which is such a material that can receive holes injected from a positive electrode at a low voltage. Preferably, the highest occupied molecular orbital (HOMO) of the hole injection material is between the work function of the material for the anode and the HOMO of a functional material (e.g. the hole transport material of the hole transport layer) for a film layer, to which holes are injected, disposed on a side away from the anode. The hole injection material includes, but is not limited to, at least one of a metalloporphyrin, an oligomeric thiophene, an arylamine-based organic material, a hexanitrilehexaazatriphenylene-based organic material, a quinacridone-based organic material, a perylene-based organic material, an anthraquinone, a polyaniline-based and a polythiophene-based conductive polymer, or the like.

In some embodiments, the hole transport layer 105 may be configured to transport holes into the light-emitting layer 107. The hole transport layer 105 includes a hole transport material that receives holes transported from the anode or the hole injection layer and transfers the holes to the light-emitting layer. The hole transport material is a material known in the art to have a high hole mobility, including but not limited to, at least one of an arylamine-based organic material, a conductive polymer, a block copolymer having both a conjugated moiety and a non-conjugated moiety, or the like.

In some embodiments, the electron transport layer 108 is configured to transport electrons. The electron transport layer 108 includes an electron transport material that receives electrons injected from the negative electrode and transfers the electrons to the light-emitting layer 107. The electron transport material is a material known in the art to have a high electron mobility, including but not limited to, at least one of a 8-hydroxylquinoline complex with aluminum, a complex containing Alq3 (tris(8-hydroxyquinoline)aluminum), an organic radical compound, a hydroxylflavone-metal complex, 8-hydroxylquinolinato lithium (LiQ), or a benzimidazole-based compound.

In some embodiments, the electron injection layer 109 is configured to inject electrons. The electron injection layer 109 includes an electron injection material, which preferably is a material that has ability of transporting electrons, has an effect of injecting electrons from a negative electrode, has an excellent effect of injecting electrons into the light-emitting layer 107 or the light-emitting material, can prevent excitons generated by the light-emitting layer 107 from moving to the hole injection layer, and has an excellent ability to form a thin film. The electron injection material includes, but is not limited to, at least one of 8-hydroxylquinolinato lithium (LiQ), fluorenone, anthraquinone dimethane, diphenoquinone, thiopyran dioxide, pyrazole, diazole, triazole, imidazole, perylene tetracarboxylic acid, fluorenylidene methane, anthracenone, or derivatives, metal complex compounds, and nitrogen-containing five-membered ring derivatives thereof.

In some embodiments, the hole blocking layer is configured to block holes from reaching the negative electrode, and generally is formed in the same condition as that of the hole injection layer 104. The hole blocking layer includes a hole blocking material, which includes, but is not limited to, at least one of a diazole derivative or a triazole derivative, a phenanthroline derivative, BCP, an aluminum complex, or the like.

In some embodiments, the organic light-emitting device 100 further includes a substrate 110, on which the first electrode 101, the hole injection layer 104, the hole transport layer 105, the electron blocking layer 106, the light-emitting layer 107, the electron transport layer 108, the electron injection layer 109, and the second electrode 102 are sequentially stacked. The substrate 110 may be a transparent substrate or an opaque substrate. When the substrate 110 is a transparent substrate, a transparent light-emitting device 100 may be fabricated using this. The substrate 110 may be a rigid substrate, or a flexible substrate having elasticity. A material for the substrate 110 may include, but is not limited to, plastic, polymer, metal, semiconductor wafer, glass, or the like. Preferably, the substrate 110 at least includes a smooth surface on which the anode is formed. More preferably, the surface is free of surface defects. Preferably, the material of the substrate 110 is a polymer film or plastic, including but not limited to, polyethylene terephthalate (PET) or poly(ethylene 2,6-naphthalate) (PEN). The substrate 110 has a glass transition temperature greater than or equal to 150°C, preferably greater than or equal to 200°C, more preferably greater than or equal to 250°C, and most preferably greater than or equal to 300°C.

In some embodiments, the organic light-emitting device 100 may be an solution-processed organic light-emitting

device. That is, at least one of the organic functional layers is prepared by printing (e.g., inkjet printing).

In some embodiments, the mixture-containing layer or the light-emitting layer may be formed by a process for printing or coating a composition. The process for printing or coating includes inkjet printing, nozzle printing, typographic printing, screen printing, dip coating, spin coating, blade coating, roller printing, torsion roller printing, lithographic printing, flexographic printing, rotary printing, spray coating, brush coating or pad printing, slot-die coating, or the like, preferably gravure printing, nozzle printing or inkjet printing.

The composition may be in a form of solution or suspension. The composition may comprise a dispersate and a dispersant. The dispersate is one or more of the organic compounds as described above and at least one organic solvent, and the dispersant is used to disperse the dispersate.

In the composition, a mass fraction of the organic compounds as described above may be from 0.3% to 30%, preferably from 0.5% to 20%, more preferably from 0.5% to 15%, further preferably from 0.5% to 10%, most preferably from 1% to 5%.

When applying in a printing process, the composition may be an ink. Viscosity and surface tension for the ink are important parameters, and an appropriate surface tension of the ink is useful for a particular substrate and printing process. In some embodiments, the surface tension of the ink at an operating temperature or at 25°C is in a range of 19 dyne/cm to 50 dyne/cm, preferably 22 dyne/cm to 35 dyne/cm, more preferably 25 dyne/cm to 33 dyne/cm, which is advantageous in the inkjet printing process. In some embodiments, the viscosity of the ink at an operating temperature or 25°C is in a range of 1 cps to 100 cps, preferably 1 cps to 50 cps, more preferably 1.5 cps to 20 cps, most preferably 4.0 cps to 20 cps, which is advantageous in the inkjet printing process.

In some embodiments, Hansen solubility parameters of the dispersant are listed within the following ranges: $\delta d$ (dispersion force) of 17.0 to 23.2 $MPa^{1/2}$, preferably 18.5 to 21.0 $MPa^{1/2}$; $\delta p$ (polar force) of 0.2 to 12.5 $MPa^{1/2}$, preferably 2.0 to 6.0 $MPa^{1/2}$; $\delta h$ (hydrogen bonding force) of 0.9 to 14.2 $MPa^{1/2}$, preferably 2.0 to 6.0 $MPa^{1/2}$.

In some embodiments, the dispersant has a boiling point greater than or equal to 150°C, preferably greater than or equal to 180°C, more preferably greater than or equal to 200°C, more preferably greater than or equal to 250°C, further preferably greater than or equal to 275°C, most preferably greater than or equal to 300°C. The boiling point of the dispersant is at least greater than or equal to 150°C, preventing nozzles of the inkjet printing head from being clogged during inkjet printing. The higher the boiling point, the better it is for preventing clogging.

The dispersant may include at least one organic solvent, which can be evaporated from the solvent system to form a film containing the functional materials. The organic solvent may include at least one first organic solvent, which may be selected from aromatic or heteroaromatic coumpounds. Exemplarily, the first organic solvent may be selected from p-diisopropylbenzene, pentylbenzene, tetrahydronaphthalene, cyclohexylbenzene, chloronaphthalene, 1,4-dimethylnaphthalene, 3-isopropylbiphenyl, p-methyl isopropylbenzene, dipentylbenzene, tripentylbenzene, pentyltoluene, o-diethylbenzene, m-diethylbenzene, p-diethylbenzene, 1,2,3,4-tetramethylbenzene, 1,2,3,5-tetramethylbenzene, 1,2,4,5-tetramethylbenzene, butylbenzene, dodecylbenzene, dihexylbenzene, dibutylbenzene, p-diisopropylbenzene, cyclohexylbenzene, benzylbutylbenzene, dimethylnaphthalene, 3-isopropylbiphenyl, p-methyl isopropylbenzene, 1-methylnaphthalene, 1,2,4-trichlorobenzene, 4,4-difluorodiphenylmethane, 1,2-dimethoxy-4-(1-propenyl)benzene, diphenylmethane, 2-phenylpyridine, 3-phenylpyridine, N-methyldiphenylamine, 4-isopropylbiphenyl, $\alpha,\alpha$-dichlorodiphenylmethane, 4-(3-phenylpropyl)pyridine, benzyl benzoate, 1,1-bis(3,4-dimethylphenyl)ethane, 2-isopropylnaphthalene, quinoline, isoquinoline, methyl 2-furancarboxylate, ethyl 2-furancarboxylate.

The first organic solvent may also be selected from aromatic ketone-based solvents. Exemplarily, the first organic solvent may be selected from 1-tetralone, 2-tetralone, 2-(phenylepoxy)tetralone, 6-(methoxy)tetralone, acetophenone, propiophenone, benzophenone, or derivatives thereof, such as 4-methylacetophenone, 3-methylacetophenone, 2-methylacetophenone, 4-methylpropiophenone, 3-methylpropiophenone, and 2-methylpropiophenone.

The first organic solvent may also be selected from aromatic ether-based solvents. Exemplarily, the first organic solvent may be selected from 3-phenoxytoluene, butoxybenzene, p-anisaldehyde dimethyl acetal, tetrahydro-2-phenoxy-2H-pyran, 1,2-dimethoxy-4-(1-propenyl)benzene, 1,4-benzdioxan, 1,3-dipropylbenzene, 2,5-dimethoxytoluene, 4-ethylphenetole, 1,3-dipropoxybenzene, 1,2,4-trimethoxybenzene, 4-(1-propenyl)-1,2-dimethoxybenzene, 1,3-dimethoxybenzene, glycidyl phenyl ether, dibenzyl ether, 4-tert-butyl anisole, trans-p-propenyl anisole, 1,2-dimethoxybenzene, 1-methoxynaphthalene, diphenyl ether, 2-phenoxy methyl ether, 2-phenoxy tetrahydrofuran, ethyl-2-naphthyl ether.

The first organic solvent may also be selected from aliphatic ketones, for example, 2-nonanone, 3-nonanone, 5-nonanone, 2-decanone, 2,5-hexanedione, 2,6,8-trimethyl-4-nonanone, fenchone, phorone, isophorone, di-n-pentyl ketone; aliphatic ethers, for example, pentyl ether, hexyl ether, dioctyl ether, ethylene glycol dibutyl ether, diethylene glycol diethyl ether, diethylene glycol butyl methyl ether, diethylene glycol dibutyl ether, triethylene glycol dimethyl ether, triethylene glycol ethyl methyl ether, triethylene glycol butyl methyl ether, tripropylene glycol dimethyl ether, tetraethylene glycol dimethyl ether.

The first organic solvent may also be selected from organic ester solvents. Exemplarily, the first solvent may be selected from alkyl octanoate, alkyl sebacate, alkyl stearate, alkyl benzoate, alkyl phenylacetate, alkyl cinnamate, alkyl oxalate, alkyl maleate, alkyl lactone, alkyl oleate, preferably octyl octanoate, diethyl sebacate, diallyl phthalate, isononyl

isononanoate.

The organic solvent may also include a second organic solvent, which may be selected from one or more of methanol, ethanol, 2-methoxyethanol, dichloromethane, trichloromethane, chlorobenzene, o-dichlorobenzene, tetrahydrofuran, anisole, morpholine, toluene, o-xylene, m-xylene, p-xylene, 1,4-dioxane, acetone, methyl ethyl ketone, 1,2-dichloroethane, 3-phenoxytoluene, 1,1,1-trichloroethane, 1,1,2,2-tetrachloroethane, ethyl acetate, butyl acetate, dimethylformamide, dimethylacetamide, dimethylsulfoxide, tetrahydronaphthalene, decalin, indene.

The composition may further comprise, in addition to the dispersate and the dispersant, one or more components such as a surface active compound, a lubricant, a wetting agent, a dispersant, a hydrophobic agent, and an adhesive, which are used for adjusting viscosity, film-forming performance, improving adhesion, or the like.

According to an embodiment of the present disclosure, there is provided an exemplary method for preparing the organic compounds described above herein, as shown in Exemplary Examples 1 to 63 below.

Example 1

The synthetic route of organic compound M1 is shown as follows:

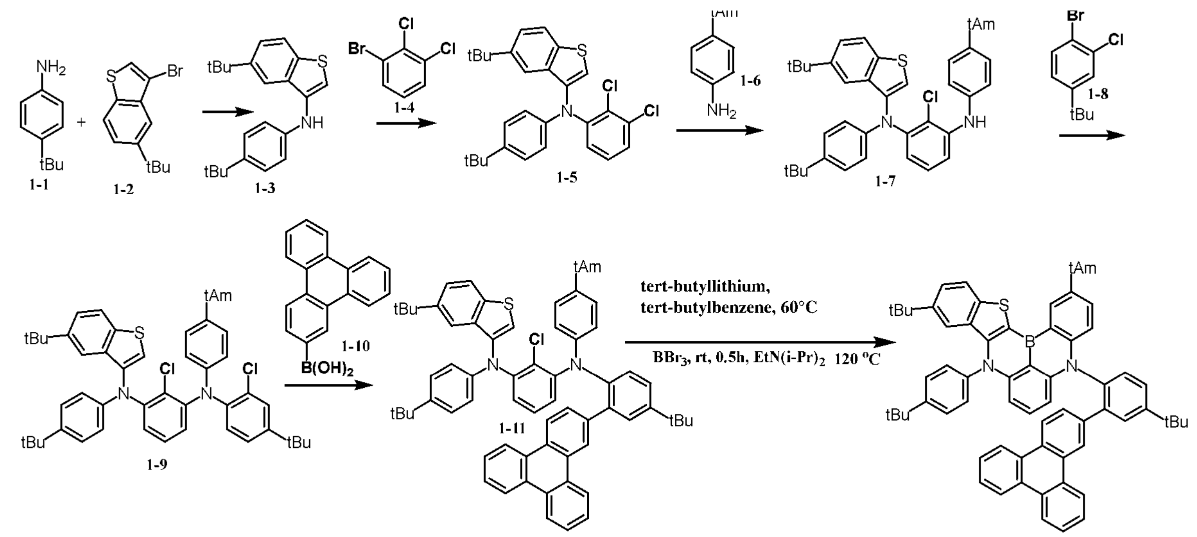


M1

Synthesis of Intermediate 1-3:

Compound 1-1 (10 mmol), compound 1-2 (10 mmol), bis(dibenzylideneacetone) ($Pd(dba)_2$, 0.1 mmol), tri-tert-butylphosphine (TTBP, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 8.21 mmol of Intermediate 1-3 in a yield of 82.1%. A result for the Intermediate 1-3 of Atmospheric Pressure Solids Analysis Probe Mass Spectrometry (ASAP-MS) was represented as MS (ASAP) =337.

Synthesis of Intermediate 1-5:

Compound 1-3 (10 mmol), compound 1-4 (10 mmol), bis(dibenzylideneacetone) palladium ($Pd(dba)_2$, 0.1 mmol), tri-tert-butylphosphine (TTBP, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 7.28 mmol of Intermediate 1-5 in a yield of 72.8%. A result for the Intermediate 1-5 of Atmospheric Pressure Solids Analysis Probe Mass Spectrometry (ASAP-MS) was represented as: MS (ASAP) =481.

Synthesis of Intermediate 1-7:

Intermediate 1-5 (10 mmol), compound 1-6 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 5.45 mmol of Intermediate 1-7 in a yield of 54.5%. A result for the Intermediate 1-7 of Atmospheric Pressure Solids Analysis Probe Mass Spectrometry (ASAP-MS) was represented as: MS (ASAP) =608.

Synthesis of Intermediate 1-9:

Intermediate 1-7 (10 mmol), compound 1-8 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 6.25 mmol of Intermediate 1-9 in a yield of 62.5%. A result for the Intermediate 1-9 of Atmospheric Pressure Solids Analysis Probe Mass Spectrometry (ASAP-MS) was represented as: MS (ASAP) =774.

Synthesis of Intermediate 1-11:

Intermediate 1-9 (10 mmol) and Intermediate 1-10 (10 mmol) were dissolved in a mixed solvent of 1,4-dioxane and water (21/2 ml), added $Pd(PPh_3)_4$ (0.1 mmol) and potassium carbonate (30 mmol) thereinto, and stirred at 100°C for 6 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 7.81 mmol of Intermediate 1-11 in a yield of 78.1 %. A result for the Intermediate 1-11 of Atmospheric Pressure Solids Analysis Probe Mass Spectrometry (ASAP-MS) was represented as: MS (ASAP) =966.

Synthesis of organic compound M1:

10 mmol of Intermediate 1-11 and 100 ml of dry tert-butylbenzene were added into a 250 ml three-necked flask under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. The reaction solution was then cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate, and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M1 as a pale yellow solid powder, in 38.9% yield. A result for the organic compound M1 of Atmospheric Pressure Solids Analysis Probe Mass Spectrometry (ASAP-MS) was represented as: MS (ASAP) =940.

Example 2

The synthetic route of organic compound M2 is shown as follows:

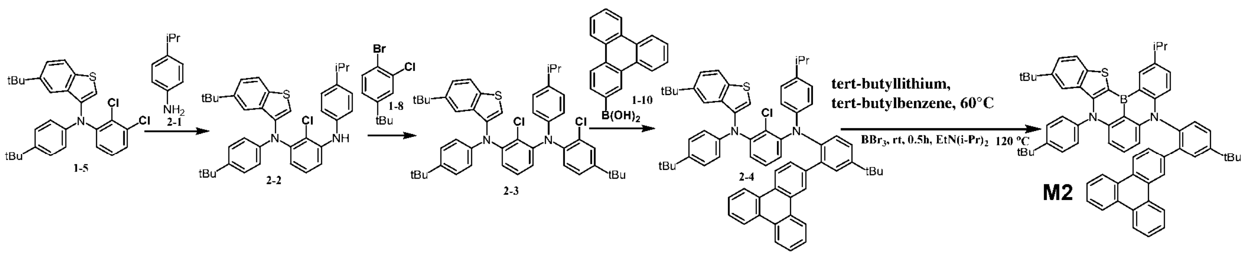

Synthesis of Intermediate 2-2:

Intermediate 1-5 (10 mmol), compound 2-1 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 6.47 mmol of Intermediate 2-2 in a yield of 64.7%. A result for the Intermediate 2-2 of Atmospheric Pressure Solids Analysis Probe Mass Spectrometry (ASAP-MS) was represented as: MS (ASAP) =580.

Synthesis of Intermediate 2-3:

Intermediate 2-2 (10 mmol), compound 1-8 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 8.36 mmol of Intermediate 2-3 in a yield of 83.6%. A result for the Intermediate 2-3 of Atmospheric Pressure Solids Analysis Probe Mass Spectrometry (ASAP-MS) was represented as: MS (ASAP) =746.

Synthesis of Intermediate 2-4:

Intermediate 2-3 (10 mmol) and Intermediate 1-10 (10 mmol) were dissolved in a mixed solvent of 1,4-dioxane and water (21/2 ml), added $Pd(PPh_3)_4$ (0.1 mmol) and potassium carbonate (30 mmol), and stirred at 100°C for 6 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 7.09 mmol of Intermediate 2-4 in a yield of 70.9%. A result for the Intermediate 2-4 of Atmospheric Pressure Solids Analysis Probe Mass Spectrometry (ASAP-MS) was represented as: MS (ASAP) =938.

Synthesis of organic compound M2:

10 mmol of Intermediate 2-4 and 100 ml of dry tert-butylbenzene were added into a 250 ml three-necked flask under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. The reaction solution was then cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M2 as a pale yellow solid powder in 36.7% yield. A result for the organic compound M2 of Atmospheric Pressure Solids Analysis Probe Mass Spectrometry (ASAP-MS) was represented as: MS (ASAP) =912.

Example 3

The synthetic route of organic compound M3 is shown as follows:

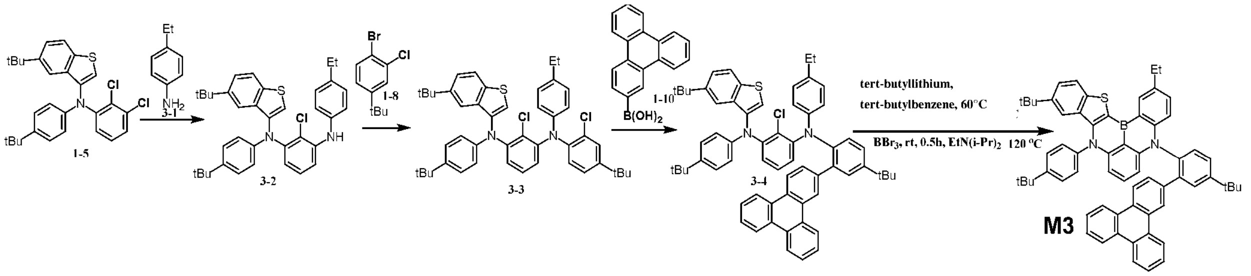


Synthesis of Intermediate 3-2:

Intermediate 1-5 (10 mmol), compound 3-1 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 7.83 mmol of Intermediate 3-2 in a yield of 78.3%. A result for the Intermediate 3-2 of Atmospheric Pressure Solids Analysis Probe Mass Spectrometry (ASAP-MS) was represented as: MS (ASAP) =566.

Synthesis of Intermediate 3-3:

Intermediate 3-2 (10 mmol), compound 1-8 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 8.51 mmol of Intermediate 3-3 in a yield of 85.1%. A result for the Intermediate 3-3 of Atmospheric Pressure Solids Analysis Probe Mass Spectrometry (ASAP-MS) was represented as: MS (ASAP) =732.

Synthesis of Intermediate 3-4:

Intermediate 3-3 (10 mmol) and Intermediate 1-10 (10 mmol) were dissolved in a mixed solvent of 1,4-dioxane and water (21/2 ml), and $Pd(PPh_3)_4$ (0.1 mmol) and potassium carbonate (30 mmol) were added thereinto and stirred at 100°C for 6 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 5.97 mmol of Intermediate 3-4 in a yield of 59.7%. A result for the Intermediate 3-4 of Atmospheric Pressure Solids Analysis Probe Mass Spectrometry (ASAP-MS) was represented as: MS (ASAP) =924.

Synthesis of organic compound M3:

10 mmol of Intermediate 2-4 and 100 ml of dry tert-butylbenzene were added into a 250 ml three-necked flask under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. Then, the reaction solution was cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M3 as a pale yellow solid powder in 40.6% yield. A result for the organic compound M3 of Atmospheric Pressure Solids Analysis Probe Mass Spectrometry (ASAP-MS) was represented as: MS (ASAP) =898.

Example 4

The synthetic route of organic compound M16 is shown as follows:

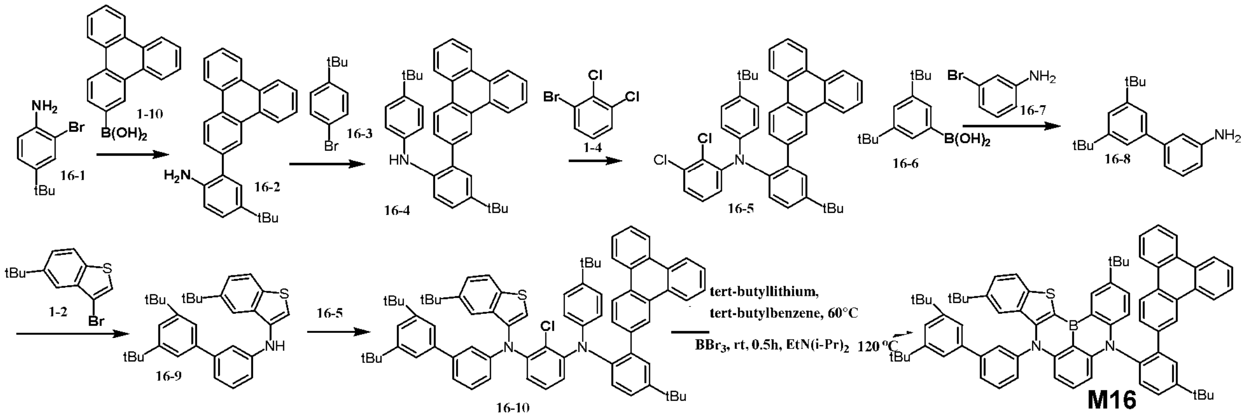


Synthesis of Intermediate 16-2:

Intermediate 16-1 (10 mmol) and Intermediate 1-10 (10 mmol) were dissolved in a mixed solvent of 1,4-dioxane and water (21/2 ml), and $Pd(PPh_3)_4$ (0.1 mmol) and potassium carbonate (30 mmol) were added thereinto and stirred at 100°C for 6 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 9.22 mmol of Intermediate 16-2 in a yield of 92.2%. A result for the Intermediate 16-2 of Atmospheric Pressure Solids Analysis Probe Mass Spectrometry (ASAP-MS) was represented as: MS (ASAP) =375.

Synthesis of Intermediate 16-4:

Compound 16-2 (10 mmol), compound 16-3 (10 mmol), bis(dibenzylideneacetone) ($Pd(dba)_2$, 0.1 mmol), tri-tert-butylphosphine (TTBP, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 7.68 mmol of Intermediate 16-4 in a yield of 76.8%. A result for the Intermediate 16-4 of Atmospheric Pressure Solids Analysis Probe Mass Spectrometry (ASAP-MS) was represented as: MS (ASAP) = 507.

Synthesis of Intermediate 16-5:

Compound 16-4 (10 mmol), compound 1-4 (10 mmol), bis(dibenzylideneacetone) ($Pd(dba)_2$, 0.1 mmol), tri-tert-butylphosphine (TTBP, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 6.97 mmol of Intermediate 16-5 in a yield of 69.7%. A result for the Intermediate 16-5 of Atmospheric Pressure Solids Analysis Probe Mass Spectrometry (ASAP-MS) was represented as: MS (ASAP) =651.

Synthesis of Intermediate 16-8:

Intermediate 16-6 (10 mmol), compound 16-7 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 5.42 mmol of Intermediate 16-8 in a yield of 54.2%. A result for the Intermediate 16-8 of Atmospheric Pressure Solids Analysis Probe Mass Spectrometry (ASAP-MS) was represented as: MS (ASAP) =281.

Synthesis of Intermediate 16-9:

Intermediate 16-8 (10 mmol), compound 1-2 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 5.97 mmol of Intermediate 16-9 in a yield of 59.7%. A result for the Intermediate 16-9 of Atmospheric Pressure Solids Analysis Probe Mass Spectrometry (ASAP-MS) was represented as: MS (ASAP) =469.

Synthesis of Intermediate 16-10:

Intermediate 16-9 (10 mmol), Intermediate 16-5 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 7.27 mmol of Intermediate 16-10 in a yield of 72.7%, A result for the Intermediate 16-10 of Atmospheric Pressure Solids Analysis Probe Mass Spectrometry (ASAP-MS) was represented as: MS (ASAP) =1084.

Synthesis of organic compound M16:

10 mmol of Intermediate 16-10 and 100 ml of dry tert-butylbenzene were added into a 250 ml three-necked flask under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. The reaction solution was then cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M16 as a pale yellow solid powder in 33.8% yield. A result for the organic compound M16 of Atmospheric Pressure Solids Analysis Probe Mass Spectrometry (ASAP-MS) was represented as: MS (ASAP) =1058. 1H NMR (400 MHz, CDCl3) δ 8.17 (d, J = 8.6 Hz, 6H), 8.02 (s, 6H), 7.87 (d, J = 13.4 Hz, 6H), 7.02 (t, J = 7.6 Hz, 6H), 6.73 (d, J = 17.7 Hz,6H), 6.38 (t, J = 7.5 Hz, 6H), 1.78 (s, 18H), 1.73 (s, 9H), 1.69 (s, 9H, 1.56 (s, 9H).

Example 5

The synthetic route of organic compound M20 is shown as follows:

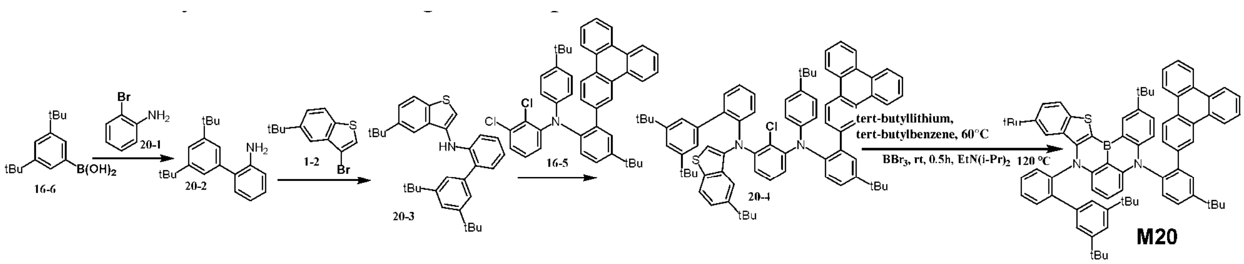


Synthesis of Intermediate 20-2:

Intermediate 16-6 (10 mmol), compound 20-1 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After

cooling, the solvent was removed by rotary evaporation, and the remaining mixture was extracted and washed with water to separate an inorganic phase and an organic phase. The organic phase was subjected to column chromatography to give 6.94 mmol of Intermediate 20-2 in a yield of 69.4%. A result for the Intermediate 20-2 of Atmospheric Pressure Solids Analysis Probe Mass Spectrometry (ASAP-MS) was represented as: MS (ASAP) =281.

Synthesis of Intermediate 20-3:

Intermediate 20-2 (10 mmol), compound 1-2 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred under a nitrogen atmosphere at 100°C for 6 h. After cooling, the solvent was removed by rotary evaporation, and the remaining mixture was extracted and washed with water to separate an inorganic phase and an organic phase. The organic phase was subjected to column chromatography to give 6.33 mmol of Intermediate 20-3 in a yield of 63.3%. A result for the Intermediate 20-3 of Atmospheric Pressure Solids Analysis Probe Mass Spectrometry (ASAP-MS) was represented as: MS (ASAP) =469.

Synthesis of Intermediate 20-4:

Intermediate 20-3 (10 mmol), Intermediate 16-5 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 5.47 mmol of Intermediate 20-4 in a yield of 54.7%. A result for the Intermediate 20-4 of Atmospheric Pressure Solids Analysis Probe Mass Spectrometry (ASAP-MS) was represented as: MS (ASAP) =1084.

Synthesis of organic compound M20:

10 mmol of Intermediate 20-4 and 100 ml of dry tert-butylbenzene were added into a 250 ml three-necked flask under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. The reaction solution was then cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M20 as a pale yellow solid powder in 31.9% yield. A result for the organic compound M20 of Atmospheric Pressure Solids Analysis Probe Mass Spectrometry (ASAP-MS) was represented as: MS (ASAP) =1058.

Example 6

The synthetic route of organic compound M24 is as follows:

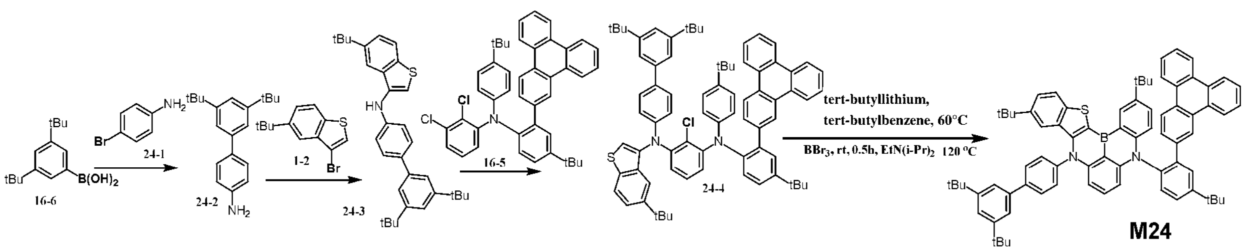


Synthesis of Intermediate 24-2:

Intermediate 16-6 (10 mmol), compound 24-1 (10 mmol), bis[di-tert-butyl(4-dimethylaminophenyl)phosphine]dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred under a nitrogen atmosphere at 100°C for 6 h. After cooling, the solvent was removed by rotary evaporation, and the remaining mixture was extracted and washed with water to separate an inorganic phase and an organic phase. The organic phase was subjected to column chromatography to give 7.63 mmol of Intermediate 24-2 in a yield of 76.3%. A result for the Intermediate 24-2 of Atmospheric Pressure Solids Analysis Probe Mass Spectrometry (ASAP-MS) was represented as: MS (ASAP) =281.

Synthesis of Intermediate 24-3:

Intermediate 24-2 (10 mmol), compound 1-2 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 6.55 mmol of Intermediate 24-3 in a yield of 65.5%. A result for the Intermediate 24-3 of Atmospheric Pressure Solids Analysis Probe Mass Spectrometry (ASAP-MS) was represented as: MS (ASAP) =469.

Synthesis of Intermediate 24-4:

Intermediate 24-3 (10 mmol), Intermediate 16-5 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 5.02 mmol of Intermediate 24-4 in a yield of 50.2%. A result for the Intermediate 24-4 of Atmospheric Pressure Solids Analysis Probe Mass Spectrometry (ASAP-MS) was represented as: MS (ASAP) =1084.

Synthesis of organic compound M24:

10 mmol of Intermediate 24-4 and 100 ml of dry tert-butylbenzene were added into a 250 ml three-necked flask under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. The reaction solution was then cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M24 as a pale yellow solid powder in 36.5% yield. A result for the organic compound M24 of Atmospheric Pressure Solids Analysis Probe Mass Spectrometry (ASAP-MS) was represented as: MS (ASAP) =1058.

Example 7

The synthetic route of organic compound M25 is shown as follows:

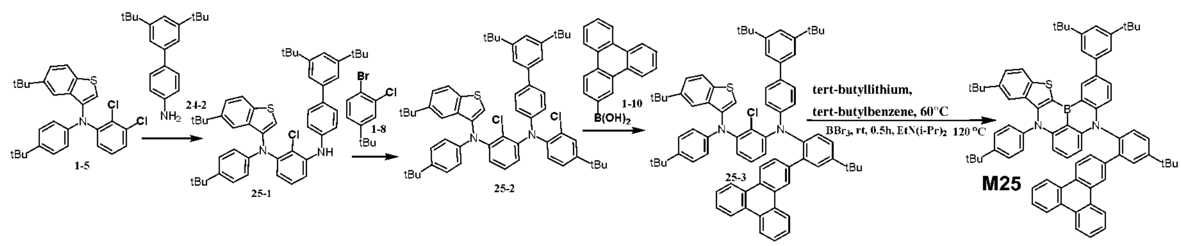

Synthesis of Intermediate 25-1:

Intermediate 1-5 (10 mmol), compound 24-2 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 8.47 mmol of Intermediate 25-1 in a yield of 84.7%. A result for the Intermediate 25-1 of Atmospheric Pressure Solids Analysis Probe Mass Spectrometry (ASAP-MS) was represented as: MS (ASAP) =726.

Synthesis of Intermediate 25-2:

Intermediate 25-1 (10 mmol), compound 1-8 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 6.48 mmol of Intermediate 25-2 in a yield of 64.8%. A result for the Intermediate 25-2 of Atmospheric Pressure Solids Analysis Probe Mass Spectrometry (ASAP-MS) was represented as: MS (ASAP) =892.

Synthesis of Intermediate 25-3:

Intermediate 25-2 (10 mmol) and Intermediate 1-10 (10 mmol) were dissolved in a mixed solvent of 1,4-dioxane and water (21/2 ml), and $Pd(PPh_3)_4$ (0.1 mmol) and potassium carbonate (30 mmol) were added thereinto and stirred at 100°C for 6 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 7.75 mmol of Intermediate 25-3 in a yield of 77.5%. A result for the Intermediate 25-3 of Atmospheric Pressure Solids Analysis Probe Mass Spectrometry (ASAP-MS) was represented as: MS (ASAP) =1084.

Synthesis of organic compound M25:

10 mmol of Intermediate 25-3 and 100 ml of dry tert-butylbenzene were added into a 250 ml three-necked flask under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. Then, the reaction solution was cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M25 as a pale yellow solid powder in a yield of 42.8%. A result for the organic compound M25 of Atmospheric Pressure Solids Analysis Probe Mass Spectrometry (ASAP-MS) was represented as: MS (ASAP) =1058. 1H NMR (400 MHz, CDCl3) δ 9.02 (s, 1H), 8.57 (s, 1H), 8.51 - 8.39 (m, 4H), 7.91 (s, 1H), 7.89 - 7.68 (m, 1H), 7.62 (d, J = 8.5 Hz, 7H), 7.52 (d, J = 9.1 Hz, 1H), 7.49 - 7.32 (m, 2H), 7.25 (d, J = 7.9 Hz, 8H), 7.26 (d, J = 13.4 Hz, 1H), 7.06 (d, J = 15.4 Hz, 1H), 6.49 (s, 1H), 6.44 (d, J = 8.1 Hz, 1H), 6.31 (d, J = 14.2 Hz, 1H), 1.58 (s, 9H), 1.50 (s, 9H), 1.47 (s, 18H), 1.06 (s, 9H).

Example 8

The synthetic route of organic compound M26 is shown as follows:

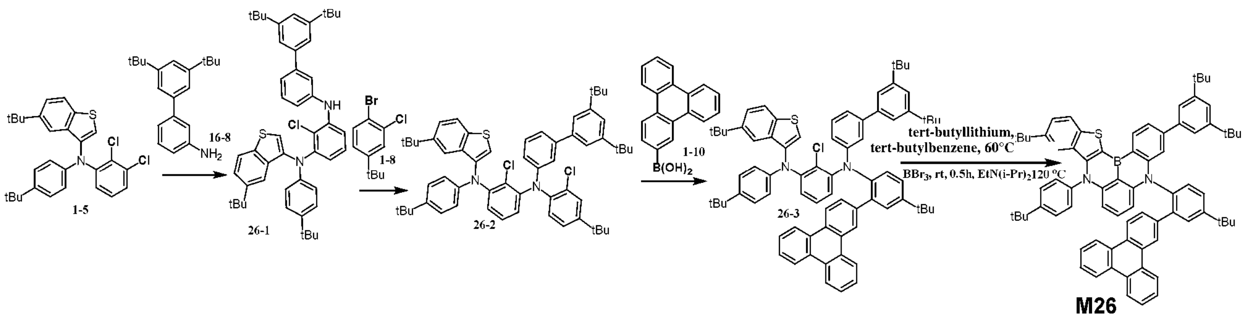


M26

Synthesis of Intermediate 26-1:

Intermediate 1-5 (10 mmol), compound 16-8 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 8.66 mmol of Intermediate 26-1 in a yield of 86.6%. A result for the Intermediate 26-1 of Atmospheric Pressure Solids Analysis Probe Mass Spectrometry (ASAP-MS) was represented as: MS (ASAP) =726.

Synthesis of Intermediate 26-2:

Intermediate 26-1 (10 mmol), compound 1-8 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 6.09 mmol of Intermediate 26-2 in a yield of 60.9%. A result for the Intermediate 26-2 of Atmospheric Pressure Solids Analysis Probe Mass Spectrometry (ASAP-MS) was represented as: MS (ASAP) =892.

Synthesis of Intermediate 26-3:

Intermediate 26-2 (10 mmol) and Intermediate 1-10 (10 mmol) were dissolved in a mixed solvent of 1,4-dioxane and water (21/2 ml), and $Pd(PPh_3)_4$ (0.1 mmol) and potassium carbonate (30 mmol) were added thereinto and stirred at 100°C for 6 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 7.54 mmol of Intermediate 26-3 in a yield of 75.4%. A result for the Intermediate 26-3 of Atmospheric Pressure Solids Analysis Probe Mass Spectrometry (ASAP-MS) was represented as: MS (ASAP) =1084.

Synthesis of organic compound M26:

10 mmol of Intermediate 26-3 and 100 ml of dry tert-butylbenzene were added into a 250 ml three-necked flask under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. The reaction solution was then cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M26 as a pale yellow solid powder in 39.6% yield. A result for the organic compound M26 of Atmospheric Pressure Solids Analysis Probe Mass Spectrometry (ASAP-MS) was represented as: MS (ASAP) =1058.

Example 9

The synthetic route of organic compound M96 is shown as follows:

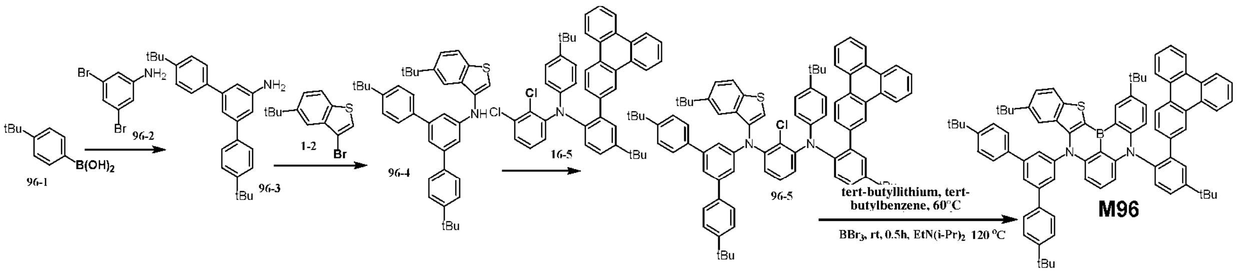


Synthesis of Intermediate 96-3:

Intermediate 96-1 (20 mmol) and compound 96-2 (10 mmol) were dissolved in a mixed solvent of 1,4-dioxane and water (21/2 ml), and $Pd(PPh_3)_4$ (0.1 mmol) and potassium carbonate (30 mmol) were added thereinto and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 7.29 mmol of Intermediate 96-3 in a yield of 72.9%. A result for the Intermediate 96-3 of Atmospheric Pressure Solids Analysis Probe Mass Spectrometry (ASAP-MS) was represented as: MS (ASAP) =357.

Synthesis of Intermediate 96-4:

Intermediate 96-3 (10 mmol), compound 1-2 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 6.12 mmol of Intermediate 96-4 in a yield of 61.2%. A result for the Intermediate 96-4 of Atmospheric Pressure Solids Analysis Probe Mass Spectrometry (ASAP-MS) was represented as: MS (ASAP) =545.

Synthesis of Intermediate 96-5:

Intermediate 96-4 (10 mmol), Intermediate 16-5 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 5.38 mmol of Intermediate 96-5 in a yield of 53.8%. A result for the Intermediate 96-5 of Atmospheric Pressure Solids Analysis Probe Mass Spectrometry (ASAP-MS) was represented as: MS (ASAP) =1160.

Synthesis of organic compound M96:

10 mmol of Intermediate 96-5 and 100 ml of dry tert-butylbenzene were added into a 250 ml three-necked flask under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. Then, the reaction solution was cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M96

as a pale yellow solid powder in 43.6% yield. A result for the organic compound M96 of Atmospheric Pressure Solids Analysis Probe Mass Spectrometry (ASAP-MS) was represented as: MS (ASAP) =1134.

Example 10

The synthetic route of organic compound M100 is shown as follows:

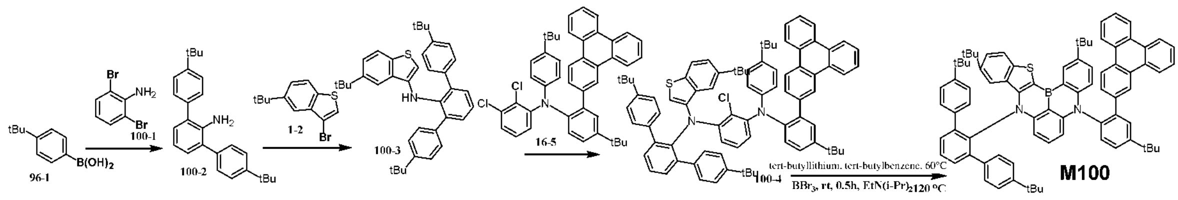


Synthesis of Intermediate 100-2:

Intermediate 96-1 (20 mmol) and compound 100-1 (10 mmol) were dissolved in a mixed solvent of 1,4-dioxane and water (21/2 ml), and $Pd(PPh_3)_4$ (0.1 mmol) and potassium carbonate (30 mmol) were added thereinto and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 7.67 mmol of Intermediate 100-2 in a yield of 76.7%. A result for the Intermediate 100-2 of Atmospheric Pressure Solids Analysis Probe Mass Spectrometry (ASAP-MS) was represented as: MS (ASAP) =357.

Synthesis of Intermediate 100-3:

Intermediate 100-2 (10 mmol), compound 1-2 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 6.59 mmol of Intermediate 100-3 in a yield of 65.9%. A result for the Intermediate 100-3 of Atmospheric Pressure Solids Analysis Probe Mass Spectrometry (ASAP-MS) was represented as: MS (ASAP) =545.

Synthesis of Intermediate 100-4:

Intermediate 100-3 (10 mmol), Intermediate 16-5 (10 mmol), bis[di-tert-butyl(4-dimethylaminophenyl)phosphine]dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 6.87 mmol of Intermediate 100-4 in a yield of 68.7%. A result for the Intermediate 100-4 of Atmospheric Pressure Solids Analysis Probe Mass Spectrometry (ASAP-MS) was represented as: MS (ASAP) =1160.

Synthesis of organic compound M100:

10 mmol of Intermediate 100-4 and 100 ml of dry tert-butylbenzene were added into a 250 ml three-necked flask under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. Then, the reaction solution was cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a

purified product. The purified product was recrystallized with toluene and ethyl acetate to give the organic compound M100 as a pale yellow solid powder in 41.4% yield. A result for the organic compound M100 of Atmospheric Pressure Solids Analysis Probe Mass Spectrometry (ASAP-MS) was represented as: MS (ASAP) =1134.

Example 11

The synthetic route of organic compound M104 is shown as follows:

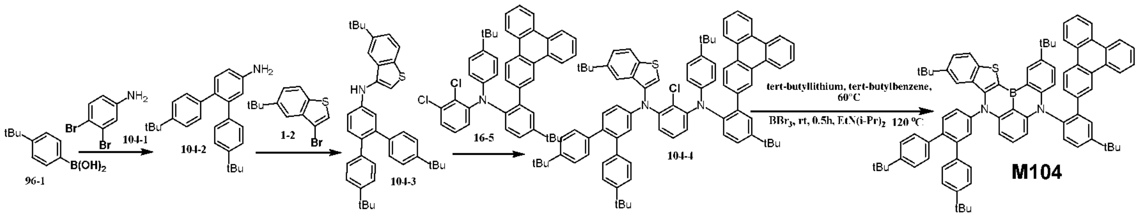


Synthesis of Intermediate 104-2:

Intermediate 96-1 (20 mmol) and compound 104-1 (10 mmol) were dissolved in a mixed solvent of 1,4-dioxane and water (21/2 ml), and $Pd(PPh_3)_4$ (0.1 mmol) and potassium carbonate (30 mmol) were added thereinto and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 7.11 mmol of Intermediate 104-2 in a yield of 71.1%. A result for the Intermediate 104-2 of Atmospheric Pressure Solids Analysis Probe Mass Spectrometry (ASAP-MS) was represented as: MS (ASAP) =357.

Synthesis of Intermediate 104-3:

Intermediate 104-2 (10 mmol), compound 1-2 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred under a nitrogen atmosphere at 100°C for 6 h. After cooling, the solvent was removed by rotary evaporation, and the remaining mixture was extracted and washed with water to separate an inorganic phase and an organic phase. The organic phase was subjected to column chromatography to give 5.71 mmol of Intermediate 104-3 in a yield of 57.1 %. A result for the Intermediate 104-3 of Atmospheric Pressure Solids Analysis Probe Mass Spectrometry (ASAP-MS) was represented as: MS (ASAP) =545.

Synthesis of Intermediate 104-4:

Intermediate 104-3 (10 mmol), Intermediate 16-5 (10 mmol), bis[di-tert-butyl(4-dimethylaminophenyl)phosphine]dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 6.57 mmol of Intermediate 104-4 in a yield of 65.7%. A result for the Intermediate 104-4 of Atmospheric Pressure Solids Analysis Probe Mass Spectrometry (ASAP-MS) was represented as: MS (ASAP) =1160.

Synthesis of organic compound M104:

10 mmol of Intermediate 104-4 and 100 ml of dry tert-butylbenzene were added into a 250 ml three-necked flask under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. Then, the reaction solution was cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined

organic phase by rotary evaporation to obtain a crude product, which was purified through flash silica gel column to obtain a purified product. The purified product was recrystallized with toluene and ethyl acetate to give the organic compound M104 as a pale yellow solid powder in a yield of 45.4%. A result for the organic compound M104 of Atmospheric Pressure Solids Analysis Probe Mass Spectrometry (ASAP-MS) was represented as: MS (ASAP) =1134.

Example 12

The synthetic route of organic compound M122 is shown as follows:

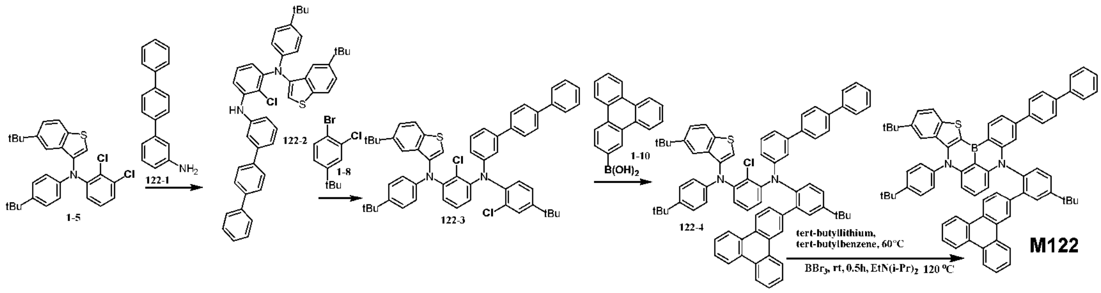


Synthesis of Intermediate 122-2:

Intermediate 1-5 (10 mmol), compound 122-1 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 8.36 mmol of Intermediate 122-2 in a yield of 83.6%. A result for the Intermediate 122-2 of Atmospheric Pressure Solids Analysis Probe Mass Spectrometry (ASAP-MS) was represented as: MS (ASAP) =690.

Synthesis of Intermediate 122-3:

Intermediate 122-2 (10 mmol), compound 1-8 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred under a nitrogen atmosphere at 100°C for 6 h. After cooling, the solvent was removed by rotary evaporation, and the remaining mixture was extracted and washed with water to separate an inorganic phase and an organic phase. The organic phase was subjected to column chromatography to give 54.9 mmol of Intermediate 122-3 in a yield of 54.9%. A result for the Intermediate 122-3 of Atmospheric Pressure Solids Analysis Probe Mass Spectrometry (ASAP-MS) was represented as: MS (ASAP) =856.

Synthesis of Intermediate 122-4:

Intermediate 122-3 (10 mmol) and Intermediate 1-10 (10 mmol) were dissolved in a mixed solvent of 1,4-dioxane and water (21/2 ml), and $Pd(PPh_3)_4$ (0.1 mmol) and potassium carbonate (30 mmol) were added thereinto and stirred at 100°C for 6 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 6.47 mmol of Intermediate 122-4 in a yield of 64.7%. A result for the Intermediate 122-4 of Atmospheric Pressure Solids Analysis Probe Mass Spectrometry (ASAP-MS) was represented as: MS (ASAP) =1048.

Synthesis of organic compound M122:

10 mmol of Intermediate 122-4 and 100 ml of dry tert-butylbenzene were added into a 250 ml three-necked flask under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. The reaction solution was then cooled to 0°C, and 42 mmol of N,N-diisopropylethylamine was added. Upon the completion of addition, the reaction solution was heated

to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M124 as a pale yellow solid powder in a yield of 31.8%. A result for the organic compound M124 of Atmospheric Pressure Solids Analysis Probe Mass Spectrometry (ASAP-MS) was represented as: MS (ASAP) =1022.

Example 13

The synthetic route of organic compound M128 is shown as follows:

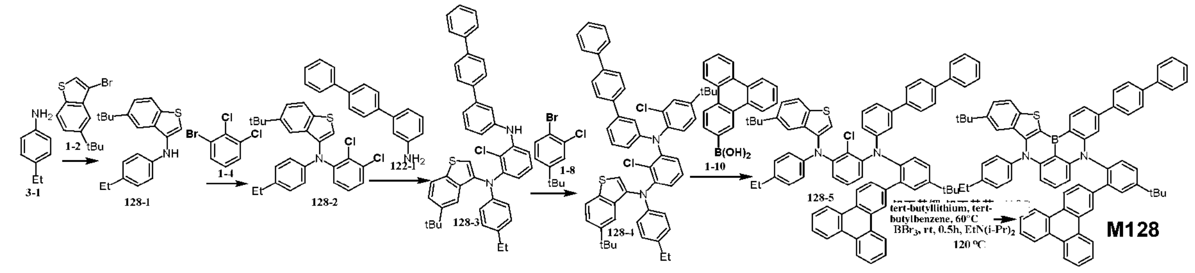


Synthesis of Intermediate 128-1:

Compound 3-1 (10 mmol), compound 1-2 (10 mmol), bis(dibenzylideneacetone) ($Pd(dba)_2$, 0.1 mmol), tri-tert-butylphosphine (TTBP, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 8.37 mmol of Intermediate 128-1 in a yield of 83.7%. A result for the Intermediate 128-1 of Atmospheric Pressure Solids Analysis Probe Mass Spectrometry (ASAP-MS) was represented as: MS (ASAP) =309.

Synthesis of Intermediate 128-2:

Compound 128-1 (10 mmol), compound 1-4 (10 mmol), bis(dibenzylideneacetone) ($Pd(dba)_2$, 0.1 mmol), tri-tert-butylphosphine (TTBP, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 7.05 mmol of Intermediate 128-2 in a yield of 70.5%. A result for the Intermediate 128-2 of Atmospheric Pressure Solids Analysis Probe Mass Spectrometry (ASAP-MS) was represented as: MS (ASAP) =453.

Synthesis of Intermediate 128-3:

Intermediate 128-2 (10 mmol), compound 122-1 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred under a nitrogen atmosphere at 100°C for 6 h. After cooling, the solvent was removed by rotary evaporation, and the remaining mixture was extracted and washed with water to separate an inorganic phase and an organic phase. The organic phase was subjected to column chromatography to give 6.83 mmol of Intermediate 128-3 in a yield of 68.3%. A result for the Intermediate 128-3 of Atmospheric Pressure Solids Analysis Probe Mass Spectrometry (ASAP-MS) was represented as: MS (ASAP) =662.

Synthesis of Intermediate 128-4:

Intermediate 128-3 (10 mmol), compound 1-8 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The

organic phase was subjected to column chromatography to obtain 6.68 mmol of Intermediate 128-4 in a yield of 66.8%. A result for the Intermediate 128-4 of Atmospheric Pressure Solids Analysis Probe Mass Spectrometry (ASAP-MS) was represented as: MS (ASAP) =828.

Synthesis of Intermediate 128-5:

Intermediate 128-4 (10 mmol) and Intermediate 1-10 (10 mmol) were dissolved in a mixed solvent of 1,4-dioxane and water (21/2 ml), and $Pd(PPh_3)_4$ (0.1 mmol) and potassium carbonate (30 mmol) were added thereinto and stirred at 100°C for 6 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 7.68 mmol of Intermediate 128-5 in a yield of 76.8%. A result for the Intermediate 128-5 of Atmospheric Pressure Solids Analysis Probe Mass Spectrometry (ASAP-MS) was represented as: MS (ASAP) =1020.

Synthesis of organic compound M128:

10 mmol of Intermediate 128-5 and 100 ml of dry tert-butylbenzene were added into a 250 ml three-necked flask under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. Then, the reaction solution was cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M128 as a pale yellow solid powder in 40.7% yield. A result for the organic compound M128 of Atmospheric Pressure Solids Analysis Probe Mass Spectrometry (ASAP-MS) was represented as: MS (ASAP) =994.

Example 14

The synthetic route of organic compound M129 is shown as follows:

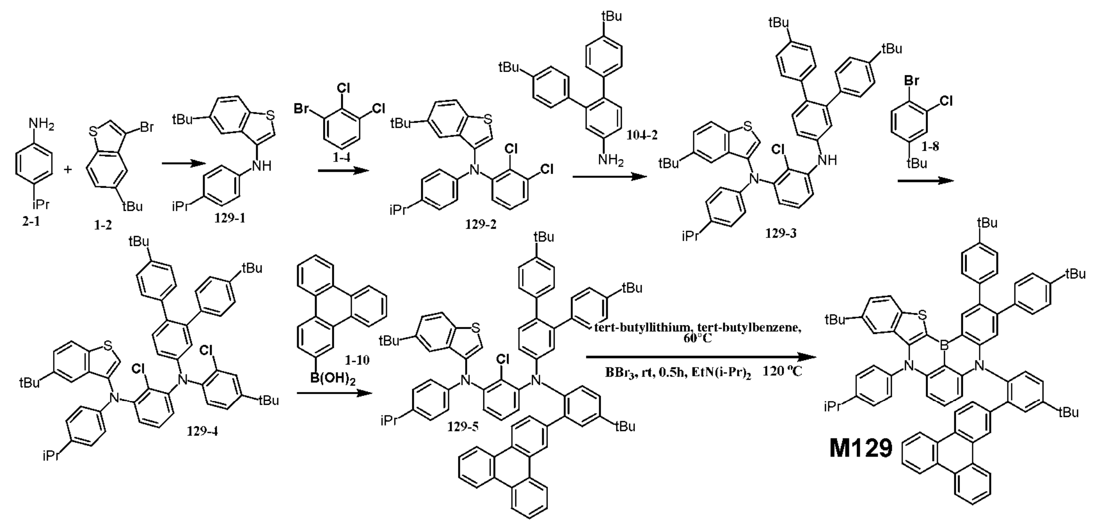


Synthesis of Intermediate 129-1:

Compound 2-1 (10 mmol), compound 1-2 (10 mmol), bis(dibenzylideneacetone) ($Pd(dba)_2$, 0.1 mmol), tri-tert-butylphosphine (TTBP, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was

subjected to column chromatography to give 7.69 mmol of Intermediate 129-1 in a yield of 76.9%. A result for the Intermediate 129-1 of Atmospheric Pressure Solids Analysis Probe Mass Spectrometry (ASAP-MS) was represented as: MS (ASAP) =323.

Synthesis of Intermediate 129-2:

Compound 129-1 (10 mmol), compound 1-4 (10 mmol), bis(dibenzylideneacetone) ($Pd(dba)_2$, 0.1 mmol), tri-tert-butylphosphine (TTBP, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 7.59 mmol of Intermediate 129-2 in a yield of 75.9%. A result for the Intermediate 129-2 of Atmospheric Pressure Solids Analysis Probe Mass Spectrometry (ASAP-MS) was represented as: MS (ASAP) =467.

Synthesis of Intermediate 129-3:

Intermediate 129-2 (10 mmol), compound 104-2 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 6.12 mmol of Intermediate 129-3 in a yield of 61.2%. A result for the Intermediate 129-3 of Atmospheric Pressure Solids Analysis Probe Mass Spectrometry (ASAP-MS) was represented as: MS (ASAP) =788.

Synthesis of Intermediate 129-4:

Intermediate 129-3 (10 mmol), compound 1-8 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 6.51 mmol of Intermediate 129-4 in a yield of 65.1%. A result for the Intermediate 129-4 of Atmospheric Pressure Solids Analysis Probe Mass Spectrometry (ASAP-MS) was represented as: MS (ASAP) =954.

Synthesis of Intermediate 129-5:

Intermediate 129-4 (10 mmol) and Intermediate 1-10 (10 mmol) were dissolved in a mixed solvent of 1,4-dioxane and water (21/2 ml), and $Pd(PPh_3)_4$ (0.1 mmol) and potassium carbonate (30 mmol) were added thereinto and stirred at 100°C for 6 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 7.34 mmol of Intermediate 129-5 in a yield of 73.4%. A result for the Intermediate 129-5 of Atmospheric Pressure Solids Analysis Probe Mass Spectrometry (ASAP-MS) was represented as: MS (ASAP) =1146.

Synthesis of organic compound M129:

10 mmol of Intermediate 129-5 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. Then, the reaction solution was cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M129 as a pale yellow solid powder in 29.7% yield. A result for the organic compound M129 of Atmospheric Pressure Solids

Analysis Probe Mass Spectrometry (ASAP-MS) was represented as: MS (ASAP) =1120.

Example 15

The synthetic route of organic compound M132 is shown as follows:

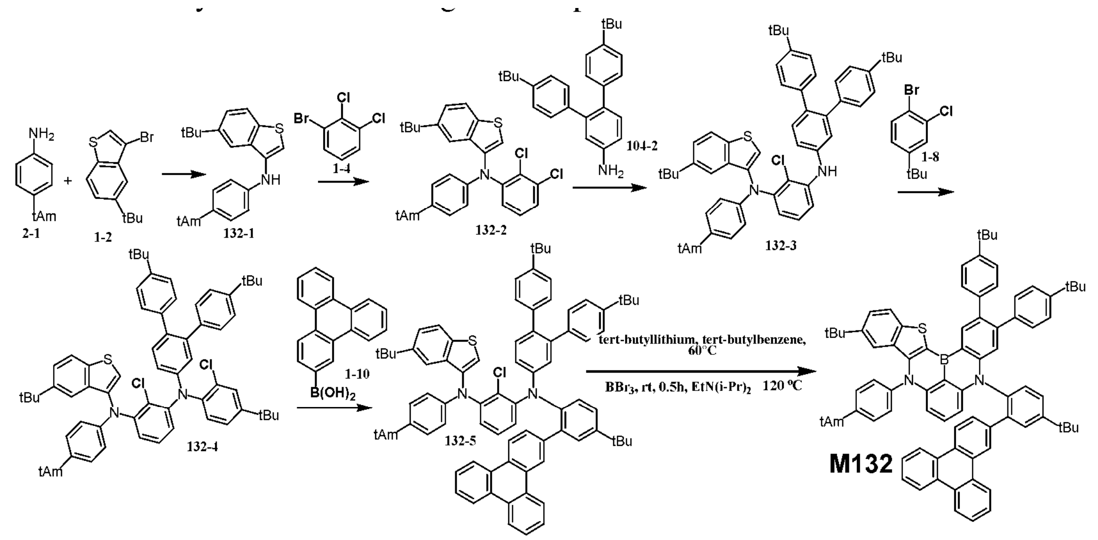


Synthesis of Intermediate 132-1:

Compound 2-1 (10 mmol), compound 1-2 (10 mmol), bis(dibenzylideneacetone) ($Pd(dba)_2$, 0.1 mmol), tri-tert-butylphosphine (TTBP, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 8.41 mmol of Intermediate 132-1 in a yield of 84.1%. A result for the Intermediate 132-1 of Atmospheric Pressure Solids Analysis Probe Mass Spectrometry (ASAP-MS) was represented as: MS (ASAP) =351.

Synthesis of Intermediate 132-2:

Compound 132-1 (10 mmol), compound 1-4 (10 mmol), bis(dibenzylideneacetone)palladium ($Pd(dba)_2$, 0.1 mmol), tri-tert-butylphosphine (TTBP, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 6.79 mmol of Intermediate 132-2 in a yield of 67.9%. A result for the Intermediate 132-2 of Atmospheric Pressure Solids Analysis Probe Mass Spectrometry (ASAP-MS) was represented as: MS (ASAP) =495.

Synthesis of Intermediate 132-3:

Intermediate 132-2 (10 mmol), compound 104-2 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 7.84 mmol of Intermediate 132-3 in a yield of 78.4%. A result for the Intermediate 132-3 of Atmospheric Pressure Solids Analysis Probe Mass Spectrometry (ASAP-MS) was represented as: MS (ASAP) =816.

Synthesis of Intermediate 132-4:

Intermediate 132-3 (10 mmol), compounds 1 to 8 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and

stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 5.96 mmol of Intermediate 132-4 in a yield of 59.6%. A result for the Intermediate 132-4 of Atmospheric Pressure Solids Analysis Probe Mass Spectrometry (ASAP-MS) was represented as: MS (ASAP) =982.

Synthesis of Intermediate 132-5:

Intermediate 132-4 (10 mmol) and Intermediate 1-10 (10 mmol) were dissolved in a mixed solvent of 1,4-dioxane and water (21/2 ml), and $Pd(PPh_3)_4$ (0.1 mmol) and potassium carbonate (30 mmol) were added thereinto and stirred at 100°C for 6 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 6.47 mmol of Intermediate 132-5 in a yield of 64.7%. A result for the Intermediate 132-5 of Atmospheric Pressure Solids Analysis Probe Mass Spectrometry (ASAP-MS) was represented as: MS (ASAP) =1174.

Synthesis of organic compound M132:

10 mmol of Intermediate 132-5 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. Then, the reaction solution was cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M132 as a pale yellow solid powder in 33.7% yield. A result for the organic compound M132 of Atmospheric Pressure Solids Analysis Probe Mass Spectrometry (ASAP-MS) was represented as: MS (ASAP) =1148.

Example 16

The synthetic route of organic compound M147 is shown as follows:

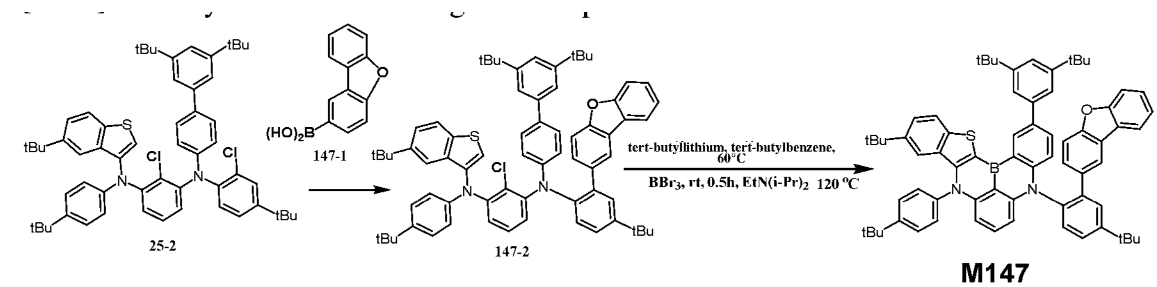

25-2 147-1 147-2

M147

Synthesis of Intermediate 147-2:

Intermediate 25-2 (10 mmol) and Intermediate 147-1 (10 mmol) were dissolved in a mixed solvent of 1,4-dioxane and water (21/2 ml), and $Pd(PPh_3)_4$ (0.1 mmol) and potassium carbonate (30 mmol) were added thereinto and stirred at 100°C for 6 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 7.36 mmol of Intermediate 147-2 in a yield of 73.6%. A result for the Intermediate 147-2 of Atmospheric Pressure Solids Analysis Probe Mass Spectrometry (ASAP-MS) was represented as: MS (ASAP) =1024.

Synthesis of organic compound M147:

10 mmol of Intermediate 147-2 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. Then, the reaction solution was cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M147 as a pale yellow solid powder in a yield of 34.7%. A result for the organic compound M147 of Atmospheric Pressure Solids Analysis Probe Mass Spectrometry (ASAP-MS) was represented as: MS (ASAP) =998.

Example 17

The synthetic route of organic compound M162 is shown as follows:

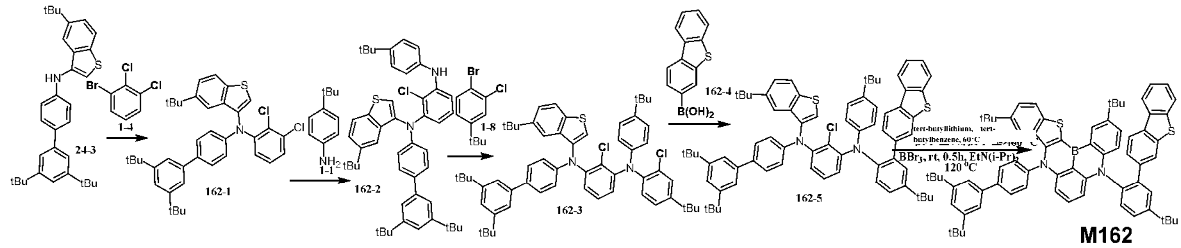


Synthesis of Intermediate 162-1:

Intermediate 24-3 (10 mmol), Intermediate 1-4 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 5.35 mmol of Intermediate 162-1 in a yield of 53.5%. A result for the Intermediate 162-1 of Atmospheric Pressure Solids Analysis Probe Mass Spectrometry (ASAP-MS) was represented as: MS (ASAP) =613.

Synthesis of Intermediate 162-2:

Intermediate 162-1 (10 mmol), compound 1-1 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 7.34 mmol of Intermediate 162-2 in a yield of 73.4%. A result for the Intermediate 162-2 of Atmospheric Pressure Solids Analysis Probe Mass Spectrometry (ASAP-MS) was represented as: MS (ASAP) =726.

Synthesis of Intermediate 162-3:

Intermediate 162-2 (10 mmol), compound 1 to 8 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 5.78 mmol of Intermediate 162-3 in a yield of 57.8%. A result for the Intermediate 162-3 of Atmospheric Pressure Solids Analysis Probe Mass Spectrometry (ASAP-MS) was

represented as: MS (ASAP) =896.

Synthesis of Intermediate 162-5:

Intermediate 162-3 (10 mmol) and Intermediate 162-4 (10 mmol) were dissolved in a mixed solvent of 1,4-dioxane and water (21/2 ml), and $Pd(PPh_3)_4$ (0.1 mmol) and potassium carbonate (30 mmol) were added thereinto and stirred at 100°C for 6 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 6.17 mmol of Intermediate 162-5 in a yield of 61.7%. A result for the Intermddiate 162-5 of Atmospheric Pressure Solids Analysis Probe Mass Spectrometry (ASAP-MS) was represented as: MS (ASAP) =1040.

Synthesis of organic compound M162:

10 mmol of Intermediate 162-5 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. The reaction solution was then cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M162 as a pale yellow solid powder in 35.7% yield. A result for the organic compound M162 of Atmospheric Pressure Solids Analysis Probe Mass Spectrometry (ASAP-MS) was represented as: MS (ASAP) =1014.

Example 18

The synthetic route of organic compound M165 is shown as follows:

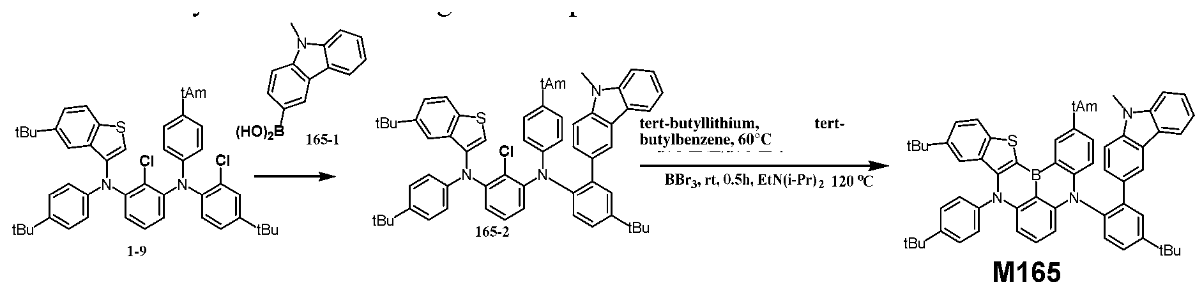


Synthesis of Intermediate 165-2:

Intermediate 1-9 (10 mmol) and Intermediate 165-1 (10 mmol) were dissolved in a mixed solvent of 1,4-dioxane and water (21/2 ml), and $Pd(PPh_3)_4$ (0.1 mmol) and potassium carbonate (30 mmol) were added thereinto and stirred at 100°C for 6 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 7.38 mmol of Intermediate 165-2 in a yield of 73.8%. A result for the Intermediate 165-2 of Atmospheric Pressure Solids Analysis Probe Mass Spectrometry (ASAP-MS) was represented as: MS (ASAP) =919.

Synthesis of organic compound M165:

10 mmol of Intermediate 165-2 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting

reaction solution was heated to room temperature and stirred for 0.5 hours. Then, the reaction solution was cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M165 as a pale yellow solid powder in 29.6% yield. A result for the organic compound M165 of Atmospheric Pressure Solids Analysis Probe Mass Spectrometry (ASAP-MS) was represented as: MS (ASAP) =893.

Example 19

The synthetic route of organic compound M193 is shown as follows:

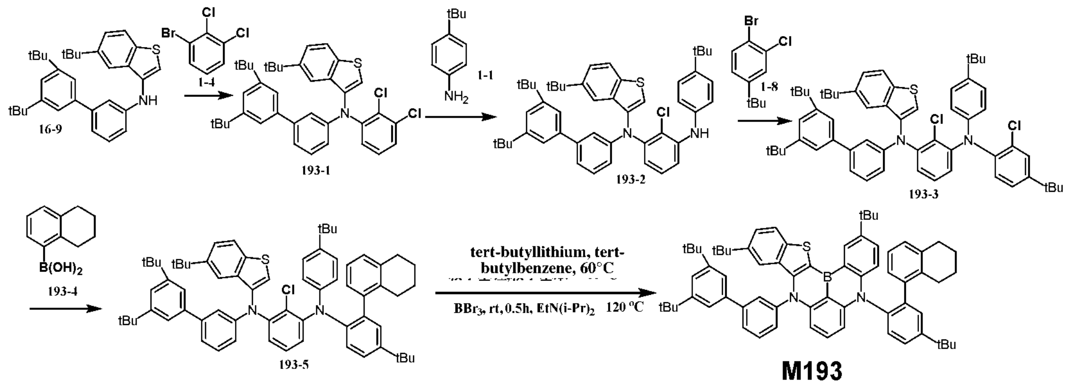


Synthesis of Intermediate 193-1:

Intermediate 16-9 (10 mmol), Intermediate 1-4 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 7.56 mmol of Intermediate 193-1 in a yield of 75.6%. A result for the Intermediate 193-1 of Atmospheric Pressure Solids Analysis Probe Mass Spectrometry (ASAP-MS) was represented as: MS (ASAP) =613.

Synthesis of Intermediate 193-2:

Intermediate 193-1 (10 mmol), Intermediate 1-1 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 7.13 mmol of Intermediate 193-2 in a yield of 71.3%. A result for the Intermediate 193-2 of Atmospheric Pressure Solids Analysis Probe Mass Spectrometry (ASAP-MS) was represented as: MS (ASAP) =726.

Synthesis of Intermediate 193-3:

Intermediate 193-2 (10 mmol), compound 1-8 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 5.29 mmol of Intermediate 193-3 in a yield of 52.9%. A result for the Intermediate 193-3 of Atmospheric Pressure Solids Analysis Probe Mass Spectrometry (ASAP-MS) was

represented as: MS (ASAP) =892.

Synthesis of Intermediate 193-5:

Intermediate 193-3 (10 mmol) and Intermediate 193-4 (10 mmol) were dissolved in a mixed solvent of 1,4-dioxane and water (21/2 ml), and $Pd(PPh_3)_4$ (0.1 mmol) and potassium carbonate (30 mmol) were added thereinto and stirred at 100°C for 6 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 6.56 mmol of Intermediate 193-5 in a yield of 65.6%. A result for the Intermediate 193-5 of Atmospheric Pressure Solids Analysis Probe Mass Spectrometry (ASAP-MS) was represented as: MS (ASAP) =988.

Synthesis of organic compound M193:

10 mmol of Intermediate 193-5 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. Then, the reaction solution was cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M193 as a pale yellow solid powder in 29.6% yield. A result for the organic compound M193 of Atmospheric Pressure Solids Analysis Probe Mass Spectrometry (ASAP-MS) was represented as: MS (ASAP) =962.

Example 20

The synthetic route of organic compound M210 is shown as follows:

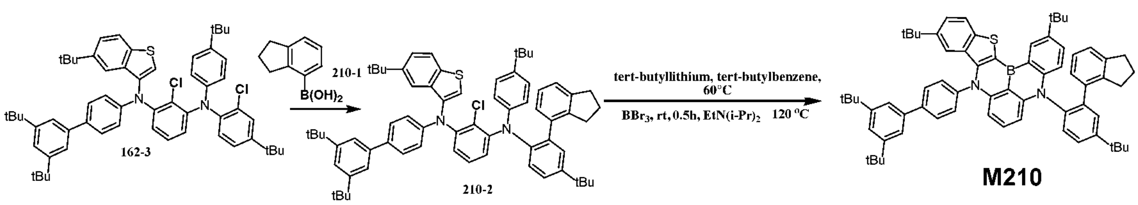


Synthesis of Intermediate 210-2:

Intermediate 162-3 (10 mmol) and Intermediate 210-1 (10 mmol) were dissolved in a mixed solvent of 1,4-dioxane and water (21/2 ml), and $Pd(PPh_3)_4$ (0.1 mmol) and potassium carbonate (30 mmol) were added thereinto and stirred at 100°C for 6 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 7.38 mmol of Intermediate 210-2 in a yield of 73.8%. A result for the Intermediate 210-2 of Atmospheric Pressure Solids Analysis Probe Mass Spectrometry (ASAP-MS) was represented as: MS (ASAP) =974.

Synthesis of organic compound M210:

10 mmol of Intermediate 210-2 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. Then, the reaction solution was cooled to 0°C, and 42 mmol of N,N-diisopropylethylamine was added. Upon the completion of addition, the reaction solution was heated

to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M210 as a pale yellow solid powder in 32.8% yield. A result for the organic compound M210 of Atmospheric Pressure Solids Analysis Probe Mass Spectrometry (ASAP-MS) was represented as: MS (ASAP) =948.

Example 21

The synthetic route of organic compound M234 is shown as follows:

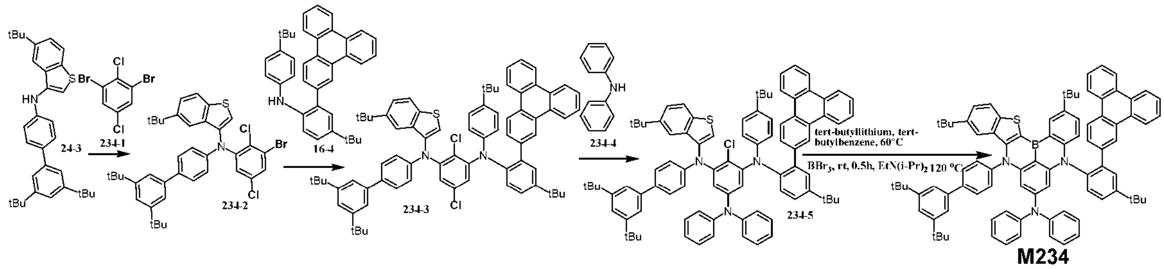


Synthesis of Intermediate 234-2:

Intermediate 24-3 (10 mmol), Intermediate 234-1 (10 mmol), bis[di-tert-butyl(4-dimethylaminophenyl)phosphine]dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 6.58 mmol of Intermediate 234-2 in a yield of 65.8%. A result for the Intermediate 234-2 of Atmospheric Pressure Solids Analysis Probe Mass Spectrometry (ASAP-MS) was represented as: MS (ASAP) =691.

Synthesis of Intermediate 234-3:

Intermediate 234-2 (10 mmol), compound 16-4 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 7.07 mmol of Intermediate 234-3 in a yield of 70.7%. A result for the Intermediate 234-3 of Atmospheric Pressure Solids Analysis Probe Mass Spectrometry (ASAP-MS) was represented as: MS (ASAP) =1118.

Synthesis of Intermediate 234-5:

Intermediate 234-3 (10 mmol), compound 234-4 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 5.06 mmol of Intermediate 234-5 in a yield of 50.6%. A result for the Intermediate 234-5 of Atmospheric Pressure Solids Analysis Probe Mass Spectrometry (ASAP-MS) was represented as: MS (ASAP) =1251.

Synthesis of organic compound M234:

10 mmol of Intermediate 234-5 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced

pressure. The reaction solution was cooled to -30°C again, and added boron tribromide (21 mmol) thereinto. The resulting reaction solution was heated to room temperature and stirred for 0.5 hours. The reaction solution was then cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M234 as a pale yellow solid powder in 22.6% yield. A result for the organic compound M234 of Atmospheric Pressure Solids Analysis Probe Mass Spectrometry (ASAP-MS) was represented as: MS (ASAP) =1225.

Example 22

The synthetic route of organic compound M253 is shown as follows:

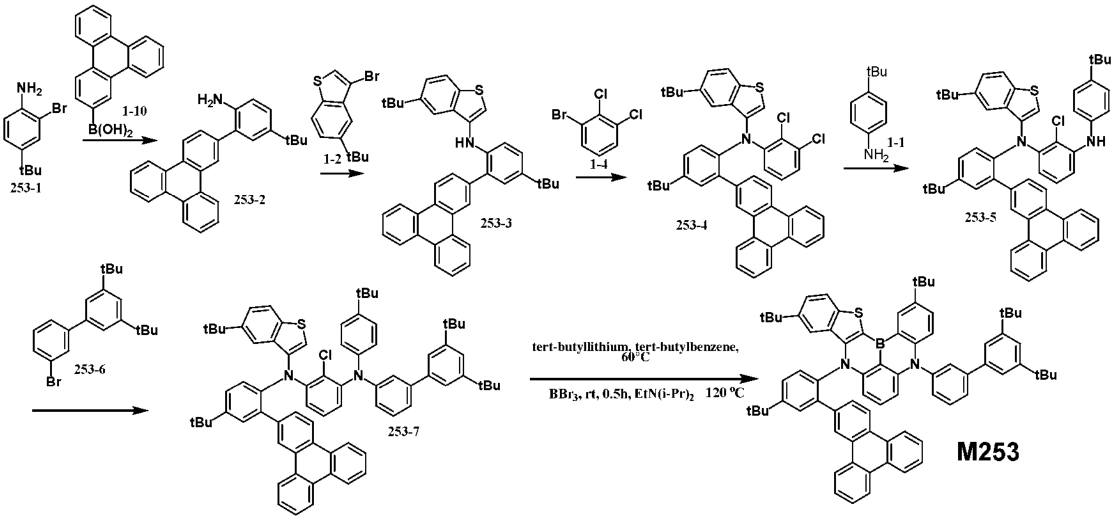

253-1
253-2
253-3
253-4
253-5
253-6
253-7
M253

Synthesis of Intermediate 253-2:

Intermediate 253-1 (10 mmol) and Intermediate 1-10 (10 mmol) were dissolved in a mixed solvent of 1,4-dioxane and water (21/2 ml), and $Pd(PPh_3)_4$ (0.1 mmol) and potassium carbonate (30 mmol) were added thereinto and stirred at 100°C for 6 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 7.69 mmol of Intermediate 253-2 in a yield of 76.9%. A result for the Intermediate 253-2 of Atmospheric Pressure Solids Analysis Probe Mass Spectrometry (ASAP-MS) was represented as: MS (ASAP) =375.

Synthesis of Intermediate 253-3:

Compound 253-2 (10 mmol), compound 1-2 (10 mmol), bis(dibenzylideneacetone) ($Pd(dba)_2$, 0.1 mmol), tri-tert-butylphosphine (TTBP, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 8.33 mmol of Intermediate 253-3 in a yield of 83.3%. A result for the Intermediate 253-3 of Atmospheric Pressure Solids Analysis Probe Mass Spectrometry (ASAP-MS) was represented as: MS (ASAP) =563.

Synthesis of Intermediate 253-4:

Compound 253-3 (10 mmol), compound 1-4 (10 mmol), bis(dibenzylideneacetone) ($Pd(dba)_2$, 0.1 mmol), tri-tert-butylphosphine (TTBP, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture

was extracted and washed with water to separate an inorganic phase and an organic phase. The organic phase was subjected to column chromatography to give 6.75 mmol of Intermediate 253-4 in a yield of 67.5%. A result for the Intermediate 253-4 of Atmospheric Pressure Solids Analysis Probe Mass Spectrometry (ASAP-MS) was represented as: MS (ASAP) =707.

Synthesis of Intermediate 253-5:

Intermediate 253-4 (10 mmol), compound 1-1 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 7.24 mmol of Intermediate 253-5 in a yield of 72.4%. A result for the Intermediate 253-5 of Atmospheric Pressure Solids Analysis Probe Mass Spectrometry (ASAP-MS) was represented as: MS (ASAP) =820.

Synthesis of Intermediate 253-7:

Intermediate 253-5 (10 mmol), compound 253-6 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 5.38 mmol of Intermediate 253-7 in a yield of 53.8%. A result for the Intermediate 253-7 of Atmospheric Pressure Solids Analysis Probe Mass Spectrometry (ASAP-MS) was represented as: MS (ASAP) =1084.

Synthesis of organic compound M253:

10 mmol of Intermediate 253-7 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. The reaction solution was then cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M253 as a pale yellow solid powder in 38.6% yield. A result for the organic compound M253 of Atmospheric Pressure Solids Analysis Probe Mass Spectrometry (ASAP-MS) was represented as: MS (ASAP) =1058.

Example 23

The synthetic route of organic compound M254 is shown as follows:

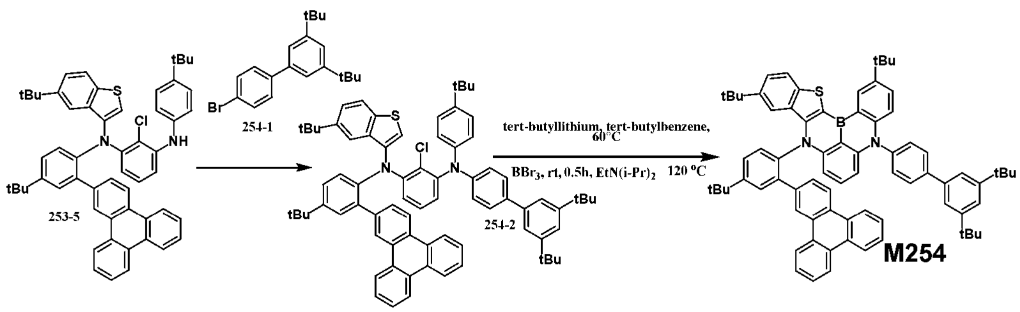

Synthesis of Intermediate 254-2:

Intermediate 253-5 (10 mmol), compound 254-1 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 5.19 mmol of Intermediate 254-2 in a yield of 51.9%. A result for the Intermediate 254-2 of Atmospheric Pressure Solids Analysis Probe Mass Spectrometry (ASAP-MS) was represented as: MS (ASAP) =1084.

Synthesis of organic compound M254:

10 mmol of Intermediate 254-2 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. The reaction solution was then cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M254 as a pale yellow solid powder in 42.5% yield. A result for the organic compound M254 of Atmospheric Pressure Solids Analysis Probe Mass Spectrometry (ASAP-MS) was represented as: MS (ASAP) =1058.

Example 24

The synthetic route of organic compound M255 is shown as follows:

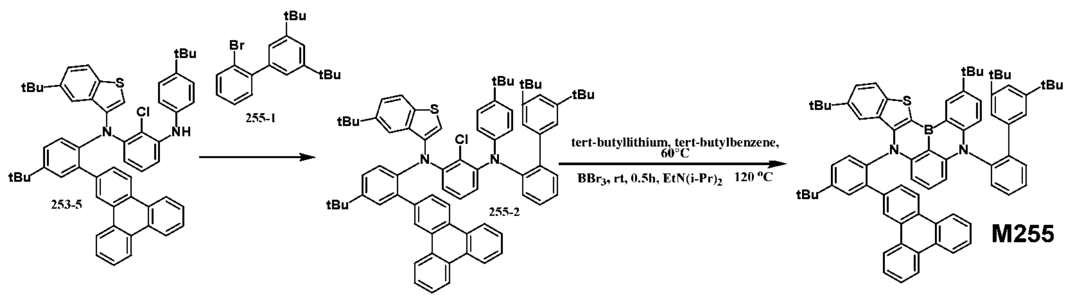


Synthesis of Intermediate 255-2:

Intermediate 253-5 (10 mmol), compound 255-1 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 6.28 mmol of Intermediate 255-2 in a yield of 62.8%. A result for the Intermediate 255-2 of Atmospheric Pressure Solids Analysis Probe Mass Spectrometry (ASAP-MS) was represented as: MS (ASAP) =1084.

Synthesis of organic compound M255:

10 mmol of Intermediate 255-2 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. The reaction solution was then cooled to 0°C,

and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M255 as a pale yellow solid powder in 47.3% yield. A result for the organic compound M255 of Atmospheric Pressure Solids Analysis Probe Mass Spectrometry (ASAP-MS) was represented as: MS (ASAP) =1058.

Example 25

The synthetic route of organic compound M266 is shown as follows:

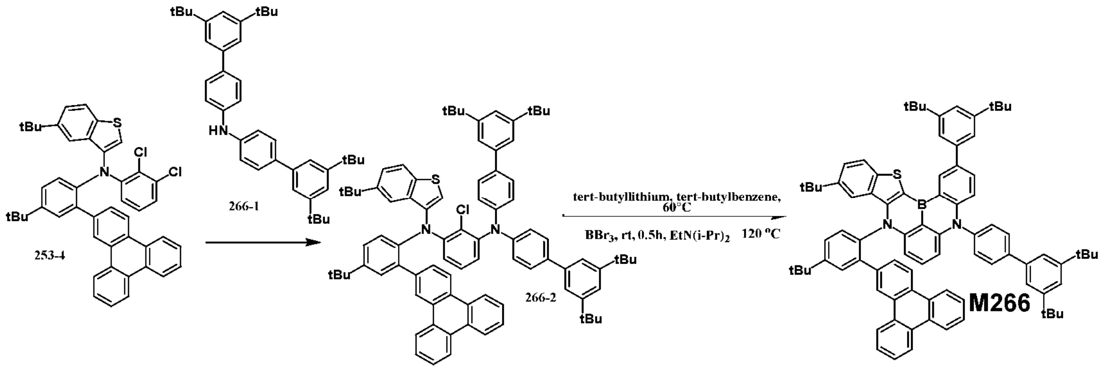


Synthesis of Intermediate 266-2:

Intermediate 253-4 (10 mmol), compound 266-1 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 6.37 mmol of Intermediate 266-2 in a yield of 63.7%. A result for the Intermediate 266-2 of Atmospheric Pressure Solids Analysis Probe Mass Spectrometry (ASAP-MS) was represented as: MS (ASAP) =1216.

Synthesis of organic compound M266:

10 mmol of Intermediate 266-2 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. The reaction solution was then cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified by flash silica gel column to obtain a purified product. The purified product was recrystallized with toluene and ethyl acetate to give the organic compound M266 as a pale yellow solid powder in 36.4% yield. A result for the organic compound M266 of Atmospheric Pressure Solids Analysis Probe Mass Spectrometry (ASAP-MS) was represented as: MS (ASAP) =1190.

Example 26

The synthetic route of organic compound M268 is shown as follows:

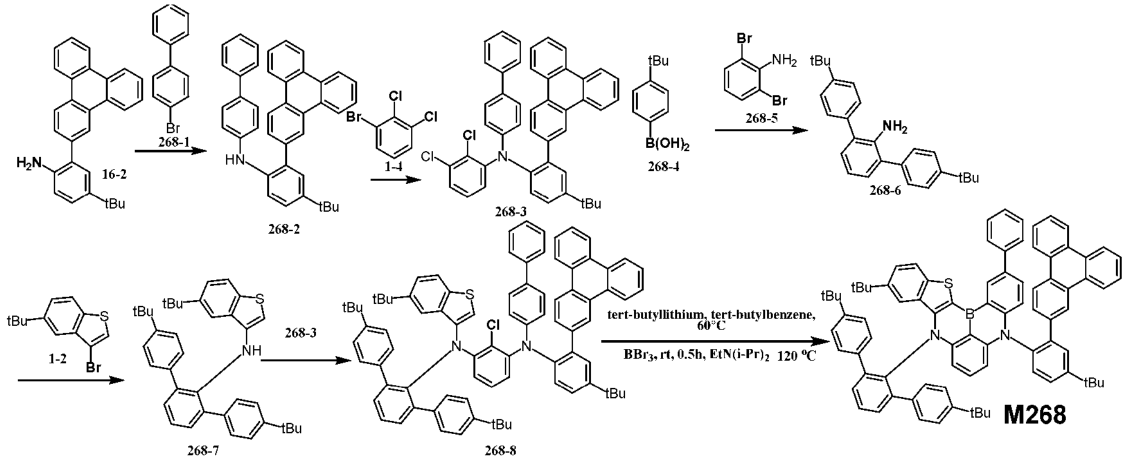


Synthesis of Intermediate 268-2:

Compound 16-2 (10 mmol), compound 268-1 (10 mmol), bis(dibenzylideneacetone) (Pd(dba)$_2$, 0.1 mmol), tri-tert-butylphosphine (TTBP, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 7.32 mmol of Intermediate 268-2 in a yield of 73.2%. A result for the Intermediate 268-2 of Atmospheric Pressure Solids Analysis Probe Mass Spectrometry (ASAP-MS) was represented as: MS (ASAP) = 527.

Synthesis of Intermediate 268-3:

Compound 268-2 (10 mmol), compound 1-4 (10 mmol), bis(dibenzylideneacetone) (Pd(dba)$_2$, 0.1 mmol), tri-tert-butylphosphine (TTBP, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 6.51 mmol of Intermediate 268-3 in a yield of 65.1%. A result for the Intermediate 268-3 of Atmospheric Pressure Solids Analysis Probe Mass Spectrometry (ASAP-MS) was represented as: MS (ASAP) =671.

Synthesis of Intermediate 268-6:

Intermediate 268-4 (20 mmol), compound 268-5 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred under a nitrogen atmosphere at 100°C for 6 h. After cooling, the solvent was removed by rotary evaporation, and the remaining mixture was extracted and washed with water to separate an inorganic phase and an organic phase. The organic phase was subjected to column chromatography to give 5.27 mmol of Intermediate 268-6 in a yield of 52.7%. A result for the Intermediate 268-6 of Atmospheric Pressure Solids Analysis Probe Mass Spectrometry (ASAP-MS) was represented as: MS (ASAP) =357.

Synthesis of Intermediate 268-7:

Intermediate 268-6 (10 mmol), compound 1-2 (10 mmol), Pd$_2$(dba)$_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 5.17 mmol of Intermediate 268-7 in a yield of 51.7%. A result for the Intermediate 268-7 of Atmospheric Pressure Solids Analysis Probe Mass Spectrometry (ASAP-MS) was represented as: MS (ASAP) =545.

Synthesis of Intermediate 268-8:

Intermediate 268-7 (10 mmol), Intermediate 268-3 (10 mmol), bis[di-tert-butyl(4-dimethylaminophenyl)phosphine]dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 7.02 mmol of Intermediate 268-8 in a yield of 70.2%. A result for the Intermediate 268-8 of Atmospheric Pressure Solids Analysis Probe Mass Spectrometry (ASAP-MS) was represented as: MS (ASAP) =1180.

Synthesis of organic compound M268:

10 mmol of Intermediate 268-8 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. The reaction solution was then cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M268 as a pale yellow solid powder in 30.1 % yield. A result for the organic compound M268 of Atmospheric Pressure Solids Analysis Probe Mass Spectrometry (ASAP-MS) was represented as: MS (ASAP) =1154.

Example 27

The synthetic route of organic compound M269 is shown as follows:

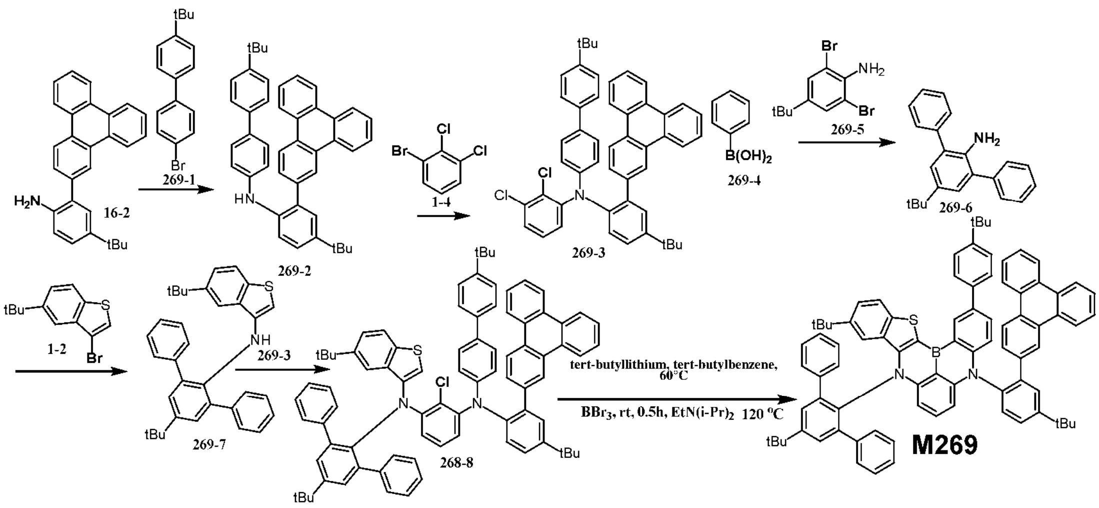


Synthesis of Intermediate 269-2:

Compound 16-2 (10 mmol), compound 269-1 (10 mmol), bis(dibenzylideneacetone) ($Pd(dba)_2$, 0.1 mmol), tri-tert-butylphosphine (TTBP, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 6.45 mmol of Intermediate 269-2 in a yield of 64.5%. A result for the Intermediate 269-2 of Atmospheric Pressure Solids Analysis Probe Mass Spectrometry (ASAP-MS) was represented as: MS (ASAP) = 583.

Synthesis of Intermediate 269-3:

Compound 269-2 (10 mmol), compound 1-4 (10 mmol), bis(dibenzylideneacetone) (Pd(dba)$_2$, 0.1 mmol), tri-tert-butylphosphine (TTBP, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 6.91 mmol of Intermediate 269-3 in a yield of 69.1%. A result for the the Intermediate 269-3 of Atmospheric Pressure Solids Analysis Probe Mass Spectrometry (ASAP-MS) was represented as: MS (ASAP) =727.

Synthesis of Intermediate 269-6:

Intermediate 269-4 (20 mmol), compound 269-5 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 5.54 mmol of Intermediate 269-6 in a yield of 55.4%. A result for the Intermediate 269-6 of Atmospheric Pressure Solids Analysis Probe Mass Spectrometry (ASAP-MS) was represented as: MS (ASAP) =301.

Synthesis of Intermediate 269-7:

Intermediate 269-6 (10 mmol), compound 1-2 (10 mmol), Pd$_2$(dba)$_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 5.49 mmol of Intermediate 268-7 in a yield of 54.9%. A result for the Intermediate 269-7 of Atmospheric Pressure Solids Analysis Probe Mass Spectrometry (ASAP-MS) was represented as: MS (ASAP) =489.

Synthesis of Intermediate 269-8:

Intermediate 269-7 (10 mmol), Intermediate 269-3 (10 mmol), bis[di-tert-butyl(4-dimethylaminophenyl)phosphine]dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 7.55 mmol of Intermediate 269-8 in a yield of 75.5%. A result for the Intermediate 269-8 of Atmospheric Pressure Solids Analysis Probe Mass Spectrometry (ASAP-MS) was represented as: MS (ASAP) =1180.

Synthesis of organic compound M269:

10 mmol of Intermediate 269-8 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. Then, the reaction solution was cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M269 as a pale yellow solid powder in 29.6% yield. A result for the organic compound M269 of Atmospheric Pressure Solids Analysis Probe Mass Spectrometry (ASAP-MS) was represented as: MS (ASAP) =1154.

Example 28

The synthetic route of organic compound M270 is shown as follows:

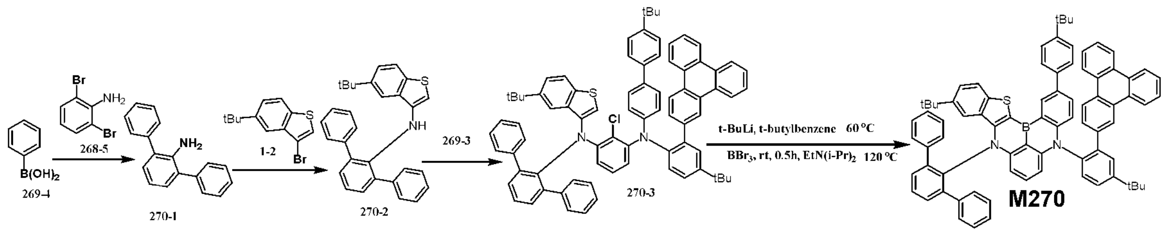


Synthesis of Intermediate 270-1:

Intermediate 269-4 (20 mmol), compound 268-5 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 5.76 mmol of Intermediate 269-6 in a yield of 57.6%. A result for the Intermediate 269-6 of Atmospheric Pressure Solids Analysis Probe Mass Spectrometry (ASAP-MS) was represented as: MS (ASAP) =245.

Synthesis of Intermediate 270-2:

Intermediate 269-7 (10 mmol), compound 1-2 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 4.97 mmol of Intermediate 270-2 in a yield of 49.7%. A result for the Intermediate 270-2 of Atmospheric Pressure Solids Analysis Probe Mass Spectrometry (ASAP-MS) was represented as: MS (ASAP) =433.

Synthesis of Intermediate 270-3:

Intermediate 269-7 (10 mmol), Intermediate 269-3 (10 mmol), bis[di-tert-butyl(4-dimethylaminophenyl)phosphine]dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 8.47 mmol of Intermediate 270-3 in a yield of 84.7%. A result for the Intermediate 270-3 of Atmospheric Pressure Solids Analysis Probe Mass Spectrometry (ASAP-MS) was represented as: MS (ASAP) =1124.

Synthesis of organic compound M270:

10 mmol of Intermediate 270-3 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. Then, the reaction solution was cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M270 as a pale yellow solid powder in 35.7% yield. A result for the organic compound M270 of Atmospheric Pressure Solids

Analysis Probe Mass Spectrometry (ASAP-MS) was represented as: MS (ASAP) =1098.

Example 29

The synthetic route of organic compound M271 is shown as follows:

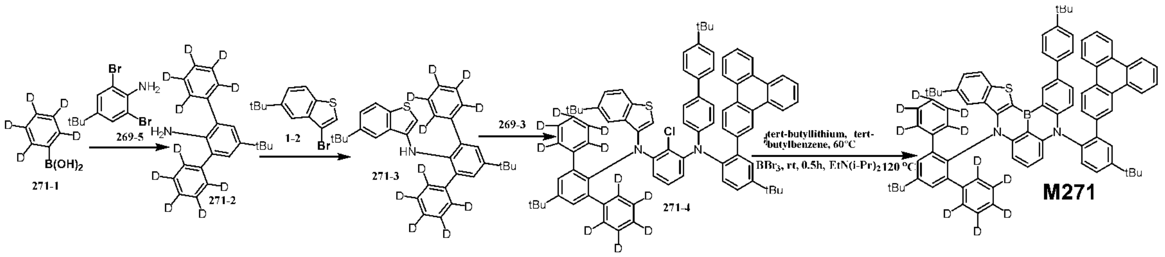


Synthesis of Intermediate 271-2:

Intermediate 271-1 (20 mmol), compound 269-5 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 5.87 mmol of Intermediate 271-2 in a yield of 58.7%. A result for the Intermediate 271-2 of Atmospheric Pressure Solids Analysis Probe Mass Spectrometry (ASAP-MS) was represented as: MS (ASAP) =311.

Synthesis of Intermediate 271-3:

Intermediate 271-2 (10 mmol), compound 1-2 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 6.78 mmol of Intermediate 271-3 in a yield of 67.8%. A result for the Intermediate 271-3 of Atmospheric Pressure Solids Analysis Probe Mass Spectrometry (ASAP-MS) was represented as: MS (ASAP) =499.

Synthesis of Intermediate 271-4:

Intermediate 271-3 (10 mmol), Intermediate 269-3 (10 mmol), bis[di-tert-butyl(4-dimethylaminophenyl)phosphine]dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 8.09 mmol of Intermediate 271-4 in a yield of 80.9%. A result for the Intermediate 271-4 of Atmospheric Pressure Solids Analysis Probe Mass Spectrometry (ASAP-MS) was represented as: MS (ASAP) =1190.

Synthesis of organic compound M271:

10 mmol of Intermediate 271-4 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. The reaction solution was then cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined

organic phase by rotary evaporation to obtain a crude product, which was purified through flash silica gel column to obtain a purified product. The purified product was recrystallized with toluene and ethyl acetate to give the organic compound M271 as a pale yellow solid powder in 37.1% yield. A result for the organic compound M271 of Atmospheric Pressure Solids Analysis Probe Mass Spectrometry (ASAP-MS) was represented as: MS (ASAP) =1164.

Example 30

The synthetic route of organic compound M274 is shown as follows:

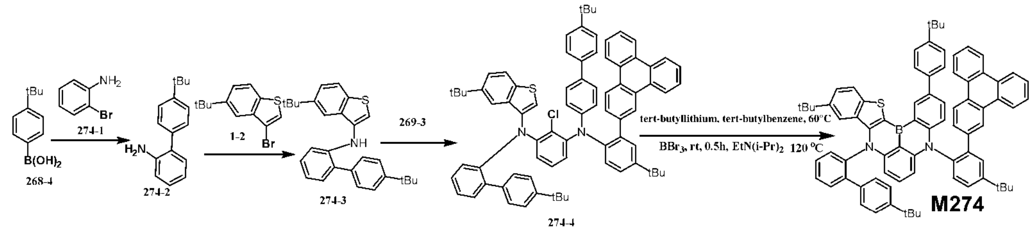


Synthesis of Intermediate 274-2:

Intermediate 268-4 (10 mmol), compound 274-1 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 6.34 mmol of Intermediate 274-2 in a yield of 63.4%. A result for the Intermediate 274-2 of Atmospheric Pressure Solids Analysis Probe Mass Spectrometry (ASAP-MS) was represented as: MS (ASAP) =225.

Synthesis of Intermediate 274-3:

Intermediate 274-2 (10 mmol), compound 1-2 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 6.18 mmol of Intermediate 274-3 in a yield of 61.8%. A result for the Intermediate 274-3 of Atmospheric Pressure Solids Analysis Probe Mass Spectrometry (ASAP-MS) was represented as: MS (ASAP) =413.

Synthesis of Intermediate 274-4:

Intermediate 274-3 (10 mmol), Intermediate 269-3 (10 mmol), bis[di-tert-butyl(4-dimethylaminophenyl)phosphine]dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 8.39 mmol of Intermediate 274-4 in a yield of 83.9%. A result for the Intermediate 274-4 of Atmospheric Pressure Solids Analysis Probe Mass Spectrometry (ASAP-MS) was represented as: MS (ASAP) =1104.

Synthesis of organic compound M274:

10 mmol of Intermediate 274-4 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. The reaction solution was then cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room

temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M274 as a pale yellow solid powder in 32.1% yield. A result for the organic compound M274 of Atmospheric Pressure Solids Analysis Probe Mass Spectrometry (ASAP-MS) was represented as: MS (ASAP) =1078.

Example 31

The synthetic route of organic compound M277 is shown as follows:

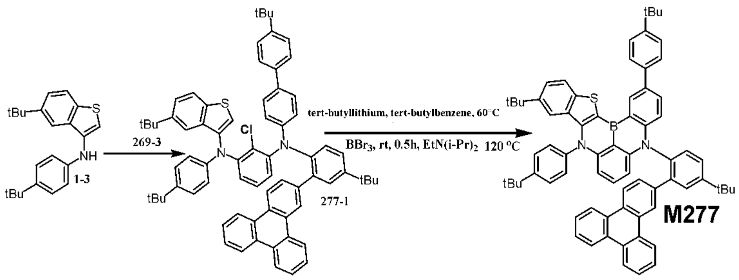


Synthesis of Intermediate 277-1:

Intermediate 1-3 (10 mmol), Intermediate 269-3 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 8.15 mmol of Intermediate 277-1 in a yield of 81.5%. A result for the Intermediate 277-1 of Atmospheric Pressure Solids Analysis Probe Mass Spectrometry (ASAP-MS) was represented as: MS (ASAP) =1028.

Synthesis of organic compound M277:

10 mmol of Intermediate 277-1 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. The reaction solution was then cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M277 as a pale yellow solid powder in 32.7% yield. A result for the organic compound M277 of Atmospheric Pressure Solids Analysis Probe Mass Spectrometry (ASAP-MS) o was represented as: MS (ASAP) =1002. 1H NMR (400 MHz, CDCl3) δ 9.01 (s, 1H), 8.55 (s, 1H), 8.42 (dd, J = 19.1, 9.7 Hz, 4H), 7.91 (s, 1H), 7.78 (dt, J = 19.1, 10.1 Hz, 7H), 7.59 (t, J = 10.3 Hz, 3H), 7.55 - 7.33 (m, 9H), 7.23 (t, J = 7.4 Hz, 1H), 7.04 (d, J = 8.8 Hz, 1H), 6.49 (s, 1H), 6.42 (d, J = 7.9 Hz, 1H), 6.31 (d, J = 8.5 Hz, 1H), 1.58 (s, 9H), 1.50 (s, 9H), 1.44 (s, 9H), 1.07 (s, 9H).

Example 32

The synthetic route of organic compound M278 is shown as follows:

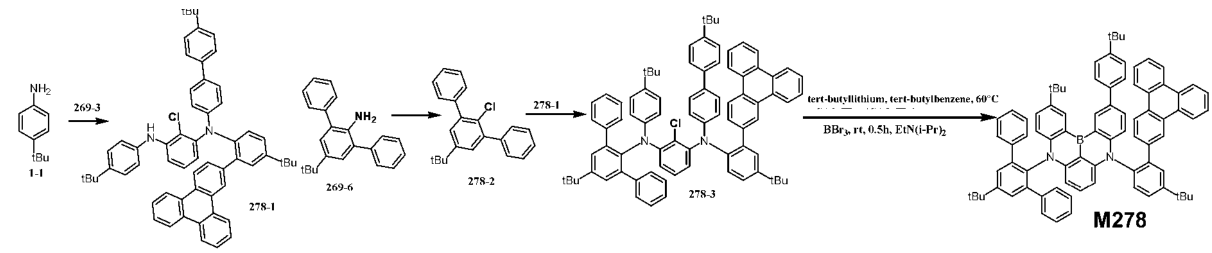


Synthesis of Intermediate 278-1:

Intermediate 1-1 (10 mmol), Intermediate 269-3 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 8.33 mmol of Intermediate 278-1 in a yield of 83.3%. A result for the Intermediate 278-1 of Atmospheric Pressure Solids Analysis Probe Mass Spectrometry (ASAP-MS) was represented as: MS (ASAP) =840.

Synthesis of Intermediate 278-2:

Intermediate 278-1 (10 mmol) and 50 mL of acetonitrile were added to a three-necked flask. 20 mmol of CuCl and 30 mmol of tert-butyl nitrite (t-BuONO) were added thereinto at 65°C, observing gas evolution. Upon the completion of addition, gas evolution was stopped. The mixture was cooled to room temperature and stirred for 1 hour. Then, the mixture was extracted with dichloromethane. After dichloromethane was removed by rotary evaporation, the resulting mixture was dissolved with petroleum ether and then passed through silica gel to give 8.76 mmol of Intermediate 278-2 in a yield of 87.6%. A result for the Intermediate 278-2 of Atmospheric Pressure Solids Analysis Probe Mass Spectrometry (ASAP-MS) was represented as: MS (ASAP) =320.

Synthesis of Intermediate 278-3:

Intermediate 278-1 (10 mmol), Intermediate 278-2 (10 mmol), bis[di-tert-butyl(4-dimethylaminophenyl)phosphine]dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 7.54 mmol of Intermediate 278-3 in a yield of 75.4%. A result for the Intermediate 278-3 of Atmospheric Pressure Solids Analysis Probe Mass Spectrometry (ASAP-MS) was represented as: MS (ASAP) =1124.

Synthesis of organic compound M278:

10 mmol of Intermediate 278-3 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. Then, the reaction solution was cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M278 as a pale yellow solid powder in 37.6% yield. A result for the organic compound M278 of Atmospheric Pressure Solids Analysis Probe Mass Spectrometry (ASAP-MS) was represented as: MS (ASAP) =1098.

Example 33

The synthetic route of organic compound M279 is shown as follows:

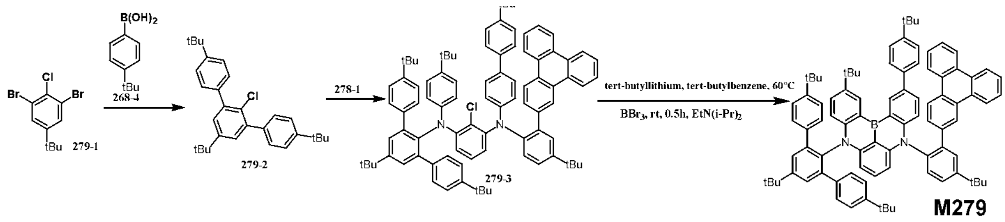


Synthesis of Intermediate 279-2:

Intermediate 279-1 (10 mmol), Intermediate 268-4 (20 mmol), bis[di-tert-butyl(4-dimethylaminophenyl)phosphine]dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 8.09 mmol of Intermediate 279-2 in a yield of 80.9%. A result for the Intermediate 279-2 of Atmospheric Pressure Solids Analysis Probe Mass Spectrometry (ASAP-MS) was represented as: MS (ASAP) =432.

Synthesis of Intermediate 279-3:

Intermediate 279-2 (10 mmol), Intermediate 278-1 (10 mmol), bis[di-tert-butyl(4-dimethylaminophenyl)phosphine]dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 7.33 mmol of Intermediate 279-3 in a yield of 73.3%. A result for the Intermediate 279-3 of Atmospheric Pressure Solids Analysis Probe Mass Spectrometry (ASAP-MS) was represented as: MS (ASAP) =1236.

Synthesis of organic compound M279:

10 mmol of Intermediate 279-3 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. The reaction solution was then cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M279 as a pale yellow solid powder in 45.7% yield. A result for the organic compound M279 of Atmospheric Pressure Solids Analysis Probe Mass Spectrometry (ASAP-MS) was represented as: MS (ASAP) =1210.

Example 34

The synthetic route of organic compound M280 is shown as follows:

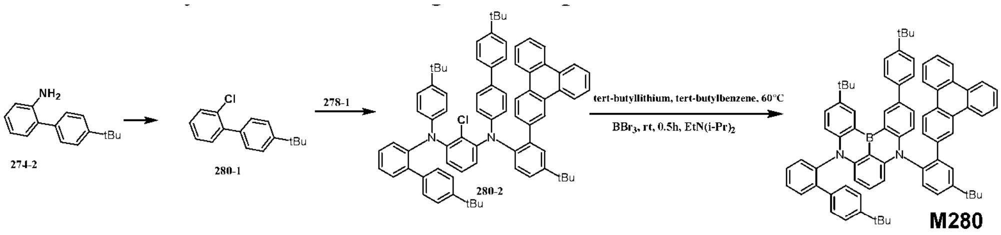


Synthesis of Intermediate 280-1:

Intermediate 274-2 (10 mmol) and 50 mL of acetonitrile were added to a three-necked flask. 20 mmol of CuCl and 30 mmol of tert-butyl nitrite (t-BuONO) were added thereinto at 65°C, observing gas evolution. Upon the completion of addition, gas evolution was stopped. The mixture was cooled to room temperature and stirred for 1 hour. Then, the mixture was extracted with dichloromethane. After dichloromethane was removed by rotary evaporation, the resulting mixture was dissolved with petroleum ether and then passed through silica gel column to give 8.92 mmol of Intermediate 280-1 in a yield of 89.2%. A result for the Intermediate 280-1 of Atmospheric Pressure Solids Analysis Probe Mass Spectrometry (ASAP-MS) was represented as: MS (ASAP) =244.

Synthesis of Intermediate 280-2:

Intermediate 280-1 (10 mmol), Intermediate 278-1 (10 mmol), bis[di-tert-butyl(4-dimethylaminophenyl)phosphine]dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 7.13 mmol of Intermediate 280-2 in a yield of 71.3%. A result for the Intermediate 280-2 of Atmospheric Pressure Solids Analysis Probe Mass Spectrometry (ASAP-MS) was represented as: MS (ASAP) =1048.

Synthesis of organic compound M280:

10 mmol of Intermediate 280-2 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. The reaction solution was then cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M280 as a pale yellow solid powder in a yield of 34.8%. A result for the organic compound M280 of Atmospheric Pressure Solids Analysis Probe Mass Spectrometry (ASAP-MS) was represented as: MS (ASAP) =1022.

Example 35

The synthetic route of organic compound M281 is shown as follows:

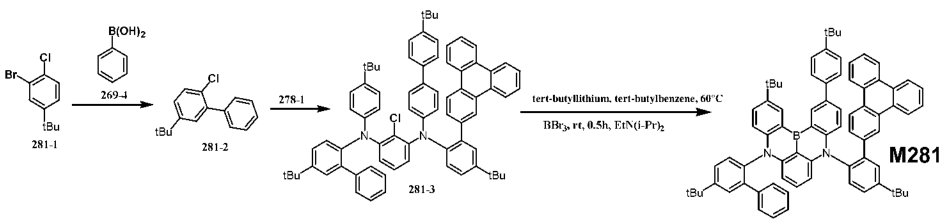

Synthesis of Intermediate 281-2:

Intermediate 281-1 (10 mmol), Intermediate 269-4 (20 mmol), bis[di-tert-butyl(4-dimethylaminophenyl)phosphine]dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 8.38 mmol of Intermediate 281-2 in a yield of 83.8%. A result for the Intermediate 281-2 of Atmospheric Pressure Solids Analysis Probe Mass Spectrometry (ASAP-MS) was represented as: MS (ASAP) =244.

Synthesis of Intermediate 281-3:

Intermediate 281-2 (10 mmol), Intermediate 278-1 (10 mmol), bis[di-tert-butyl(4-dimethylaminophenyl)phosphine]dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 6.79 mmol of Intermediate 281-3 in a yield of 67.9%. A result for the Intermediate 281-3 of Atmospheric Pressure Solids Analysis Probe Mass Spectrometry (ASAP-MS) was represented as: MS (ASAP) =1048.

Synthesis of organic compound M281:

10 mmol of Intermediate 281-3 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. The reaction solution was then cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M281 as a pale yellow solid powder in a yield of 42.8%. A result for the organic compound M281 of Atmospheric Pressure Solids Analysis Probe Mass Spectrometry (ASAP-MS) was represented as: MS (ASAP) =1022.

Example 36

The synthetic route of organic compound M282 is shown as follows:

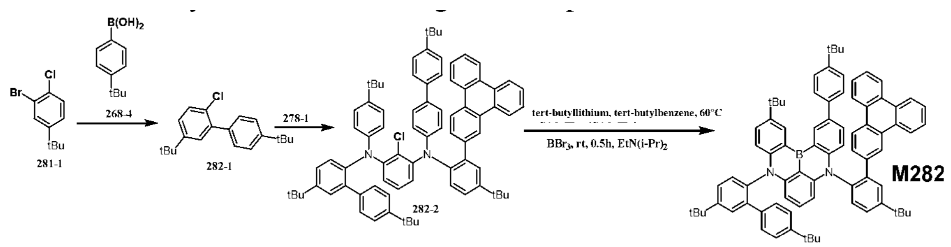


Synthesis of Intermediate 282-1:

Intermediate 281-1 (10 mmol), Intermediate 268-4 (20 mmol), bis[di-tert-butyl(4-dimethylaminophenyl)phosphine]dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected

to column chromatography and recrystallized to give 7.46 mmol of Intermediate 282-1 in a yield of 74.6%. A result for the Intermediate 282-1 of Atmospheric Pressure Solids Analysis Probe Mass Spectrometry (ASAP-MS) was represented as: MS (ASAP) =300.

Synthesis of Intermediate 282-2:

Intermediate 281-2 (10 mmol), Intermediate 278-1 (10 mmol), bis[di-tert-butyl(4-dimethylaminophenyl)phosphine]dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 6.13 mmol of Intermediate 282-2 in a yield of 61.3%. A result for the Intermediate 282-2 of Atmospheric Pressure Solids Analysis Probe Mass Spectrometry (ASAP-MS) was represented as: MS (ASAP) =1104.

Synthesis of organic compound M282:

10 mmol of Intermediate 282-2 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. The reaction solution was then cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M282 as a pale yellow solid powder in 33.7% yield. A result for the organic compound M282 of Atmospheric Pressure Solids Analysis Probe Mass Spectrometry (ASAP-MS) was represented as: MS (ASAP) =1078.

Example 37

The synthetic route of organic compound M283 is shown as follows:

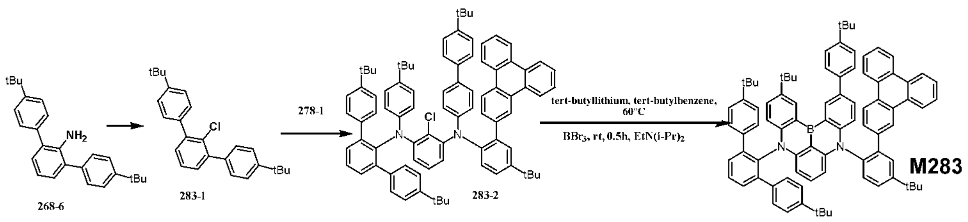


Synthesis of Intermediate 283-1:

Intermediate 268-6 (10 mmol) and 50 mL of acetonitrile were added to a three-necked flask. 20 mmol of CuCl and 30 mmol of tert-butyl nitrite (t-BuONO) were added thereinto at 65°C, observing gas evolution.Upon the completion of addition, gas evolution was stopped. The mixture was cooled to room temperature and stirred for 1 hour. Then, the mixture was extracted with dichloromethane. After dichloromethane was removed by rotary evaporation, the resulting mixture was dissolved with petroleum ether and then passed through silica gel column to give 9.02 mmol of Intermediate 283-1 in a yield of 90.2%. A result for the Intermediate 283-1 of Atmospheric Pressure Solids Analysis Probe Mass Spectrometry (ASAP-MS) was represented as: MS (ASAP) = 376.

Synthesis of Intermediate 283-2:

Intermediate 283-1 (10 mmol), Intermediate 278-1 (10 mmol), bis[di-tert-butyl(4-dimethylaminophenyl)phosphine]dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen

atmosphere. After cooling, most of the solvent was removed by rotary evaporation, then the remaining mixture was extracted and washed with water to separate an inorganic phase and an organic phase. The organic phase was subjected to column chromatography and recrystallized to give 6.97 mmol of Intermediate 283-2 in a yield of 69.7%. A result for the Intermediate 283-2 of Atmospheric Pressure Solids Analysis Probe Mass Spectrometry (ASAP-MS) was represented as: MS (ASAP) =1180.

Synthesis of organic compound M283:

10 mmol of Intermediate 283-2 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. The reaction solution was then cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M283 as a pale yellow solid powder in 36.8% yield. A result for the organic compound M283 of Atmospheric Pressure Solids Analysis Probe Mass Spectrometry (ASAP-MS) was represented as: MS (ASAP) =1154.

Example 38

The synthetic route of organic compound M284 is shown as follows:

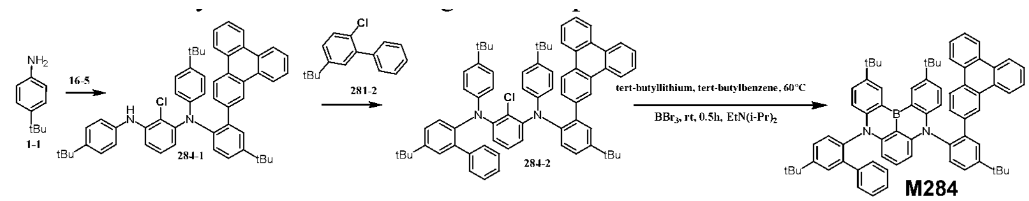


Synthesis of Intermediate 284-1:

Intermediate 1-1 (10 mmol), Intermediate 16-5 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 8.25 mmol of Intermediate 284-1 in a yield of 82.5%. A result for the Intermediate 284-1 of Atmospheric Pressure Solids Analysis Probe Mass Spectrometry (ASAP-MS) was represented as: MS (ASAP) =764.

Synthesis of Intermediate 284-2:

Intermediate 284-1 (10 mmol), Intermediate 281-2 (10 mmol), bis[di-tert-butyl(4-dimethylaminophenyl)phosphine]dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 7.31 mmol of Intermediate 284-2 in a yield of 73.1%. A result for the Intermediate 284-2 of Atmospheric Pressure Solids Analysis Probe Mass Spectrometry (ASAP-MS) was represented as: MS (ASAP) =972.

Synthesis of organic compound M284:

10 mmol of Intermediate 284-2 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. Then, the reaction solution was cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M284 as a pale yellow solid powder, in a yield of 47.1%. A result for the organic compound M284 of Atmospheric Pressure Solids Analysis Probe Mass Spectrometry (ASAP-MS) was represented as: MS (ASAP) =946.

Example 39

The synthetic route of organic compound M285 is shown as follows:

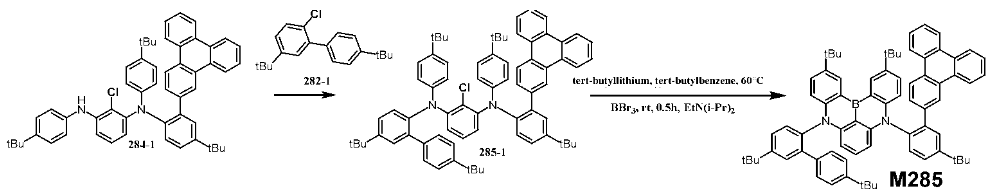


Synthesis of Intermediate 285-1:

Intermediate 284-1 (10 mmol), Intermediate 282-1 (10 mmol), bis[di-tert-butyl(4-dimethylaminophenyl)phosphine]dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 8.97 mmol of Intermediate 285-1 in a yield of 89.7%. A result for the Intermediate 285-1 of Atmospheric Pressure Solids Analysis Probe Mass Spectrometry (ASAP-MS) was represented as: MS (ASAP) =1028.

Synthesis of organic compound M285:

10 mmol of Intermediate 285-1 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. Then, the reaction solution was cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M285 as a pale yellow solid powder in 40.8% yield. A result for the organic compound M285 of Atmospheric Pressure Solids Analysis Probe Mass Spectrometry (ASAP-MS) was represented as: MS (ASAP) =1002.

Example 40

The synthetic route of organic compound M286 is shown as follows:

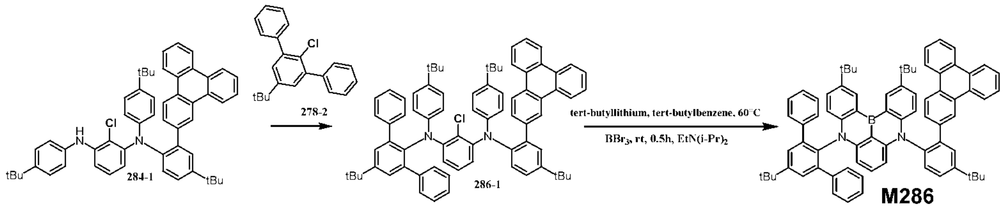


Synthesis of Intermediate 286-1:

Intermediate 284-1 (10 mmol), Intermediate 278-2 (10 mmol), bis[di-tert-butyl(4-dimethylaminophenyl)phosphine]dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 8.45 mmol of Intermediate 286-1 in a yield of 84.5%. A result for the Intermediate 286-1 of Atmospheric Pressure Solids Analysis Probe Mass Spectrometry (ASAP-MS) was represented as: MS (ASAP) =1048.

Synthesis of organic compound M286:

10 mmol of Intermediate 286-1 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. The reaction solution was then cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M286 as a pale yellow solid powder in a yield of 47.3%. A result for the organic compound M286 of Atmospheric Pressure Solids Analysis Probe Mass Spectrometry (ASAP-MS) was represented as: MS (ASAP) =1022.

Example 41

The synthetic route of organic compound M287 is shown as follows:

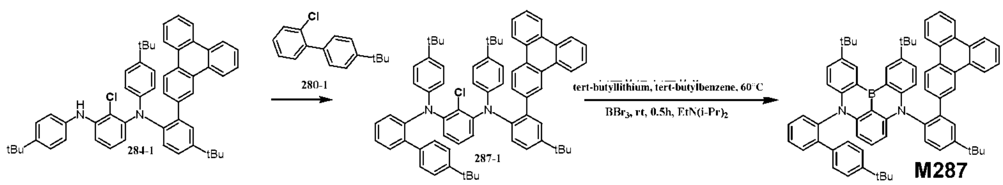


Synthesis of Intermediate 287-1:

Intermediate 284-1 (10 mmol), Intermediate 280-1 (10 mmol), bis[di-tert-butyl(4-dimethylaminophenyl)phosphine]dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 8.22 mmol of Intermediate 287-1 in a yield of 82.2%. A result for the Intermediate 287-1 of Atmospheric Pressure Solids Analysis Probe Mass Spectrometry (ASAP-MS) was represented as: MS (ASAP) =972.

Synthesis of organic compound M287:

10 mmol of Intermediate 287-1 and 100 ml of dry tert-butylbenzene were added into a 250 ml three-necked flask under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. The reaction solution was then cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified by flash silica gel column to obtain a purified product. The purified product was recrystallized with toluene and ethyl acetate to give the organic compound M287 as a pale yellow solid powder in 36.7% yield. A result for the organic compound M287 of Atmospheric Pressure Solids Analysis Probe Mass Spectrometry (ASAP-MS) was represented as: MS (ASAP) =946.

Example 42

The synthetic route of organic compound M288 is shown as follows:

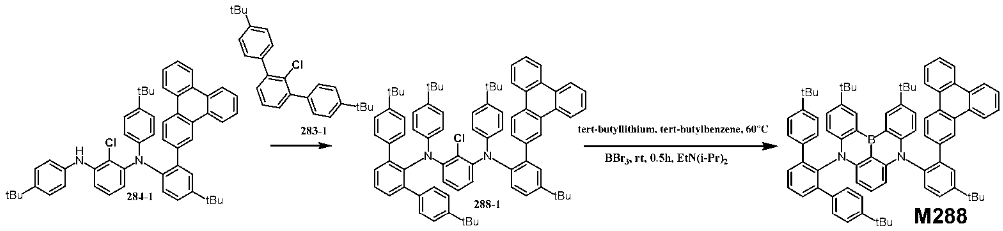


Synthesis of Intermediate 288-1:

Intermediate 284-1 (10 mmol), Intermediate 283-1 (10 mmol), bis[di-tert-butyl(4-dimethylaminophenyl)phosphine]dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 9.12 mmol of Intermediate 288-1 in a yield of 91.2%. A result for the Intermediate 288-1 of Atmospheric Pressure Solids Analysis Probe Mass Spectrometry (ASAP-MS) was represented as: MS (ASAP) =1104.

Synthesis of organic compound M288:

10 mmol of Intermediate 288-1 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. Then, the reaction solution was cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified by flash silica gel column to obtain a purified product. The purified product was recrystallized with toluene and ethyl acetate to give the organic compound M288 as a pale yellow solid powder in 35.1% yield. A result for the organic compound M288 of Atmospheric pressure solid phase analysis probe mass spectrometry (ASAP-MS) was represented as: MS (ASAP) =1078.

Example 43

The synthetic route of organic compound M289 is shown as follows:

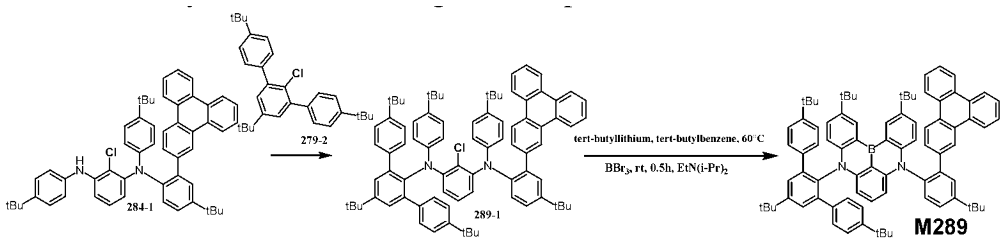


Synthesis of Intermediate 289-1:

Intermediate 284-1 (10 mmol), Intermediate 279-2 (10 mmol), bis[di-tert-butyl(4-dimethylaminophenyl)phosphine]dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 8.06 mmol of Intermediate 289-1 in a yield of 80.6%. A result for the Intermediate 289-1 of Atmospheric Pressure Solids Analysis Probe Mass Spectrometry (ASAP-MS) was represented as: MS (ASAP) =1160.

Synthesis of organic compound M289:

10 mmol of Intermediate 288-1 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. The reaction solution was then cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M289 as a pale yellow solid powder in 33.6% yield. A result for the organic compound M289 of Atmospheric Pressure Solids Analysis Probe Mass Spectrometry (ASAP-MS) was represented as: MS (ASAP) =1134.

Example 44

The synthetic route of organic compound M290 is shown as follows:

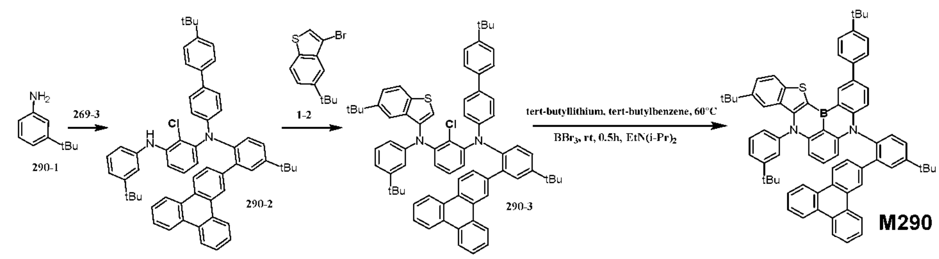


Synthesis of Intermediate 290-2:

Intermediate 290-1 (10 mmol), Intermediate 269-3 (10 mmol), bis[di-tert-butyl(4-dimethylaminophenyl)phosphine]dichloropalladium (Pd-132, 0.1 mmol), 2-dicyclohexylphosphino-2',6'-dimethoxy-1',1'-biphenyl (S-Phos, 0.2

mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 8.15 mmol of Intermediate 290-2 in a yield of 81.5%. A result for the Intermediate 290-2 of Atmospheric Pressure Solids Analysis Probe Mass Spectrometry (ASAP-MS) was represented as: MS (ASAP) =840.

Synthesis of Intermediate 290-3:

Intermediate 290-2 (10 mmol), Intermediate 1-2 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 7.39 mmol of Intermediate 290-3 in a yield of 73.9%. A result for the Intermediate 290-3 of Atmospheric Pressure Solids Analysis Probe Mass Spectrometry (ASAP-MS) was represented as: MS (ASAP) =1028.

Synthesis of organic compound M290:

10 mmol of Intermediate 290-3 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. The reaction solution was then cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M290 as a pale yellow solid powder in 33.7% yield. A result for the organic compound M290 of Atmospheric Pressure Solids Analysis Probe Mass Spectrometry (ASAP-MS) was represented as: MS (ASAP) =1002. 1H NMR (400 MHz, CDCl3) δ 9.02 (s, 1H), 8.57 (d, J = 18.8 Hz, 1H), 8.48 - 8.36 (m, 4H), 7.92 (s, 1H), 7.87 - 7.75 (m, 5H), 7.72 (d, J = 7.8 Hz, 6H), 7.69 - 7.61 (m, 4H), 7.53 - 7.32 (m, 4H), 7.20 (d, J = 16.8 Hz, 1H), 7.09 - 6.96 (m, 1H), 6.51 - 6.26 (m, 3H), 1.58 (s, 9H), 1.44 (s, 9H), 1.39 (s, 9H), 1.06 (s, 9H).

Example 45

The synthetic route of organic compound M291 is shown as follows:

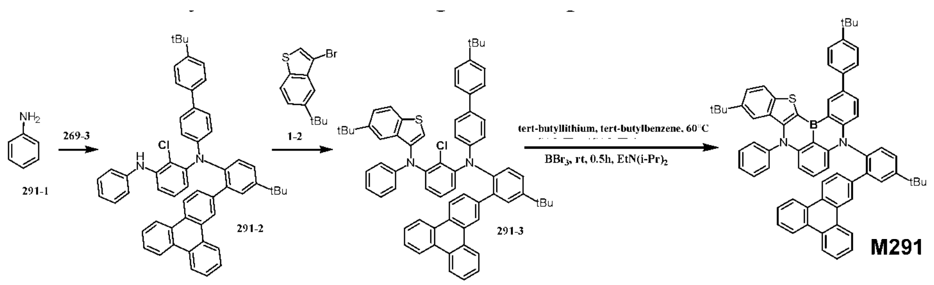


Synthesis of Intermediate 291-2:

Intermediate 291-1 (10 mmol), Intermediate 269-3 (10 mmol), bis[di-tert-butyl(4-dimethylaminophenyl)phosphine]dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected

to column chromatography and recrystallized to give 8.84 mmol of Intermediate 291-2 in a yield of 88.4%. A result for the Intermediate 291-2 of Atmospheric Pressure Solids Analysis Probe Mass Spectrometry (ASAP-MS) was represented as: MS (ASAP) =784.

Synthesis of Intermediate 291-3:

Intermediate 291-2 (10 mmol), Intermediate 1-2 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 7.22 mmol of Intermediate 291-3 in a yield of 72.2%. A result for the Intermediate 291-3 of Atmospheric Pressure Solids Analysis Probe Mass Spectrometry (ASAP-MS) was represented as: MS (ASAP) =972.

Synthesis of organic compound M291:

10 mmol of Intermediate 291-3 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. The reaction solution was then cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M291 as a pale yellow solid powder in 38.9% yield. A result for the organic compound M291 of Atmospheric Pressure Solids Analysis Probe Mass Spectrometry (ASAP-MS) was represented as: MS (ASAP) =946.

Example 46

The synthetic route of organic compound M292 is shown as follows:

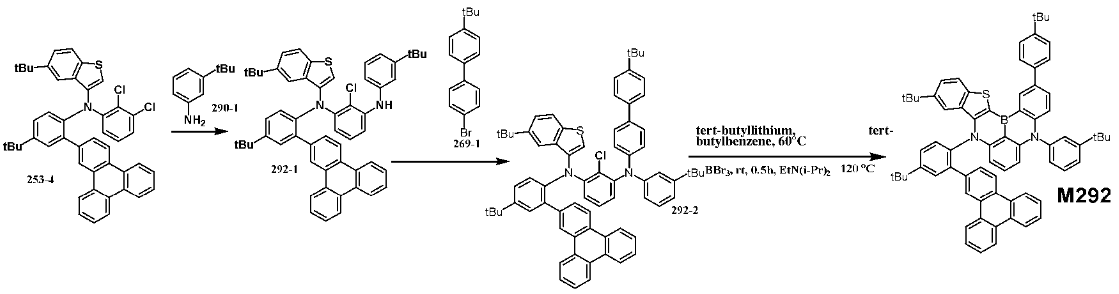


Synthesis of Intermediate 292-1:

Intermediate 253-4 (10 mmol), compound 290-1 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 7.38 mmol of Intermediate 292-1 in a yield of 73.8%. A result for the Intermediate 292-1 of Atmospheric Pressure Solids Analysis Probe Mass Spectrometry (ASAP-MS) was represented as: MS (ASAP) =820.

Synthesis of Intermediate 292-2:

Intermediate 292-1 (10 mmol), compound 269-1 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 6.62 mmol of Intermediate 292-2 in a yield of 66.2%. A result for the Intermediate 292-2 of Atmospheric Pressure Solids Analysis Probe Mass Spectrometry (ASAP-MS) was represented as: MS (ASAP) =1028.

Synthesis of organic compound M292:

10 mmol of Intermediate 292-2 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. Then, the reaction solution was cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M292 as a pale yellow solid powder in 43.6% yield. A result for the organic compound M292 of Atmospheric Pressure Solids Analysis Probe Mass Spectrometry (ASAP-MS) was represented as: MS (ASAP) =1002.

Example 47

The synthetic route of organic compound M293 is shown as follows:

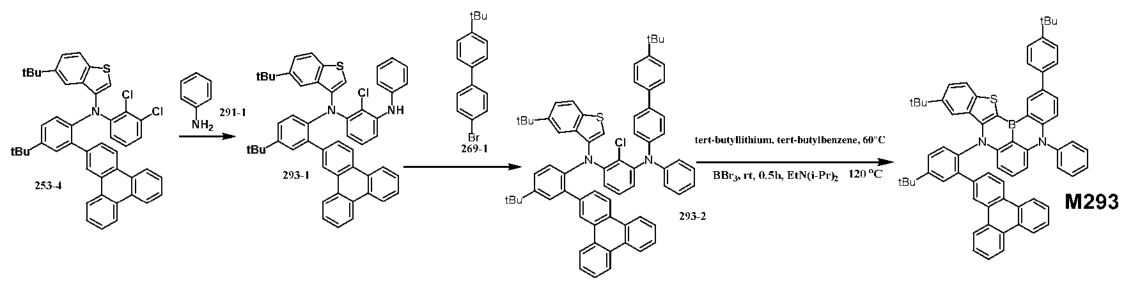


Synthesis of Intermediate 293-1:

Intermediate 253-4 (10 mmol), compound 291-1 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 7.08 mmol of Intermediate 293-1 in a yield of 70.8%. A result for the Intermediate 293-1 of Atmospheric Pressure Solids Analysis Probe Mass Spectrometry (ASAP-MS) was represented as: MS (ASAP) =764.

Synthesis of Intermediate 293-2:

Intermediate 293-1 (10 mmol), compound 269-1 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred under a nitrogen atmosphere at 100°C for 6 h. After cooling, the solvent was removed by rotary evaporation, and the remaining mixture was extracted and washed with water to separate an inorganic phase and an organic phase. The organic phase was subjected to column chromatography to give 6.51 mmol of Intermediate 293-2 in a yield of 65.1 %. A result for the Intermediate 293-2 of Atmospheric Pressure Solids Analysis Probe Mass Spectrometry (ASAP-MS) was

represented as: MS (ASAP) =972.

Synthesis of organic compound M293:

10 mmol of Intermediate 293-2 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. Then, the reaction solution was cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M293 as a pale yellow solid powder in 41.1% yield. A result for the organic compound M293 of Atmospheric Pressure Solids Analysis Probe Mass Spectrometry (ASAP-MS) was represented as: MS (ASAP) =946.

Example 48

The synthetic route of organic compound M294 is shown as follows:

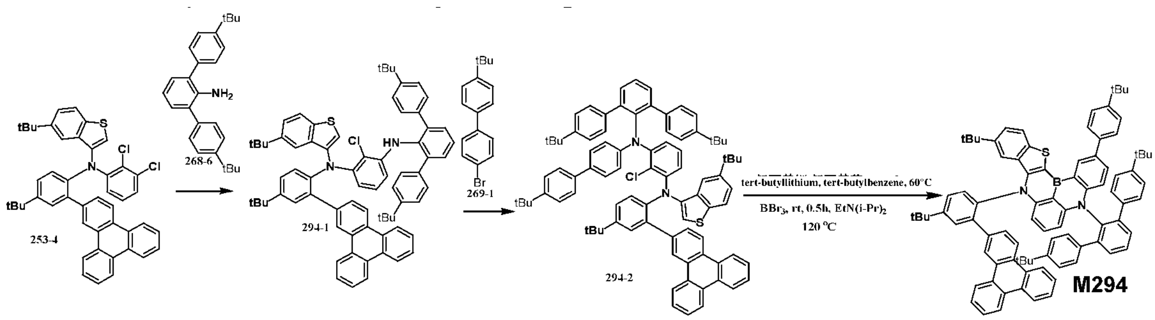


Synthesis of Intermediate 294-1:

Intermediate 253-4 (10 mmol), compound 268-6 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred under a nitrogen atmosphere at 100°C for 6 h. After cooling, the solvent was removed by rotary evaporation, and the remaining mixture was extracted and washed with water to separate an inorganic phase and an organic phase. The organic phase was subjected to column chromatography to give 7.37 mmol of Intermediate 294-1 in a yield of 73.7%. A result for the Intermediate 294-1 of Atmospheric Pressure Solids Analysis Probe Mass Spectrometry (ASAP-MS) was represented as: MS (ASAP) =1028.

Synthesis of Intermediate 294-2:

Intermediate 294-1 (10 mmol), compound 269-1 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred under a nitrogen atmosphere at 100°C for 6 h. After cooling, the solvent was removed by rotary evaporation, and the remaining mixture was extracted and washed with water to separate an inorganic phase and an organic phase. The organic phase was subjected to column chromatography to give 6.89 mmol of Intermediate 294-2 in a yield of 68.9%. A result for the Intermediate 294-2 of Atmospheric Pressure Solids Analysis Probe Mass Spectrometry (ASAP-MS) was represented as: MS (ASAP) =1236.

Synthesis of organic compound M294:

10 mmol of Intermediate 294-2 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced

pressure. The reaction solution was cooled to -30°C again, and added boron tribromide (21 mmol) thereinto. The resulting reaction solution was heated to room temperature and stirred for 0.5 hours. The reaction solution was then cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified by flash silica gel column to obtain a purified product. The purified product was recrystallized with toluene and ethyl acetate to give the organic compound M294 as a pale yellow solid powder in a yield of 43.7%. A result for the organic compound M294 of Atmospheric Pressure Solids Analysis Probe Mass Spectrometry (ASAP-MS) was represented as: MS (ASAP) =1210.

Example 49

The synthetic route of organic compound M295 is shown as follows:

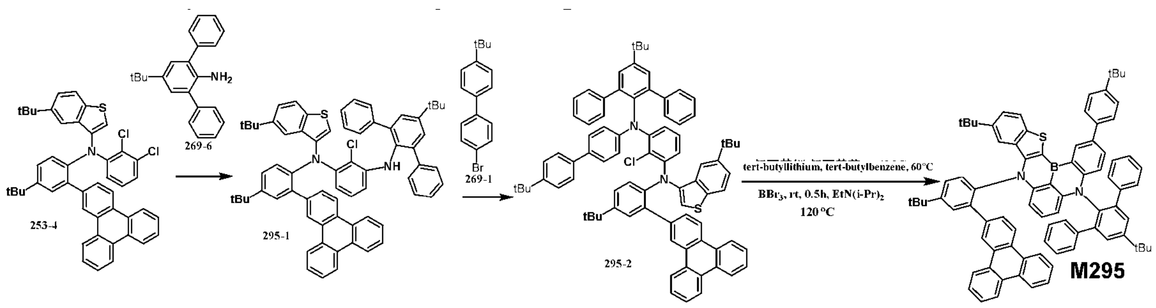


Synthesis of Intermediate 295-1:

Intermediate 253-4 (10 mmol), compound 269-6 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 8.23 mmol of Intermediate 295-1 in a yield of 82.3%. A result for the Intermediate 295-1 of Atmospheric Pressure Solids Analysis Probe Mass Spectrometry (ASAP-MS) was represented as: MS (ASAP) =972.

Synthesis of Intermediate 295-2:

Intermediate 295-1 (10 mmol), compound 269-1 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 7.46 mmol of Intermediate 295-2 in a yield of 74.6%. A result for the Intermediate 295-2 of Atmospheric Pressure Solids Analysis Probe Mass Spectrometry (ASAP-MS) was represented as: MS (ASAP) =1180.

Synthesis of organic compound M295:

10 mmol of Intermediate 295-2 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. Then, the reaction solution was cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a

purified product. The purified product was recrystallized with toluene and ethyl acetate to give the organic compound M295 as a pale yellow solid powder in 36.1% yield. A result for the organic compound M295 of Atmospheric Pressure Solids Analysis Probe Mass Spectrometry (ASAP-MS) was represented as: MS (ASAP) =1154.

Example 50

The synthetic route of organic compound M296 is shown as follows:

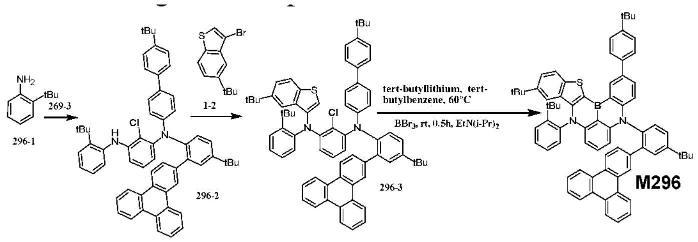


Synthesis of Intermediate 296-2:

Intermediate 296-1 (10 mmol), Intermediate 269-3 (10 mmol), bis[di-tert-butyl(4-dimethylaminophenyl)phosphine]dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 8.89 mmol of Intermediate 296-2 in a yield of 88.9%. A result for the Intermediate 296-2 of Atmospheric Pressure Solids Analysis Probe Mass Spectrometry (ASAP-MS) was represented as: MS (ASAP) =840.

Synthesis of Intermediate 296-3:

Intermediate 296-2 (10 mmol), Intermediate 1-2 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 7.97 mmol of Intermediate 296-3 in a yield of 79.7%. A result for the Intermediate 296-3 of Atmospheric Pressure Solids Analysis Probe Mass Spectrometry (ASAP-MS) was represented as: MS (ASAP) =1028.

Synthesis of organic compound M296:

10 mmol of Intermediate 296-3 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. Then, the reaction solution was cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M296 as a pale yellow solid powder in 39.2% yield. A result for the organic compound M296 of Atmospheric Pressure Solids Analysis Probe Mass Spectrometry (ASAP-MS) was represented as: MS (ASAP) =1002.

Example 51

The synthetic route of organic compound M297 is shown as follows:

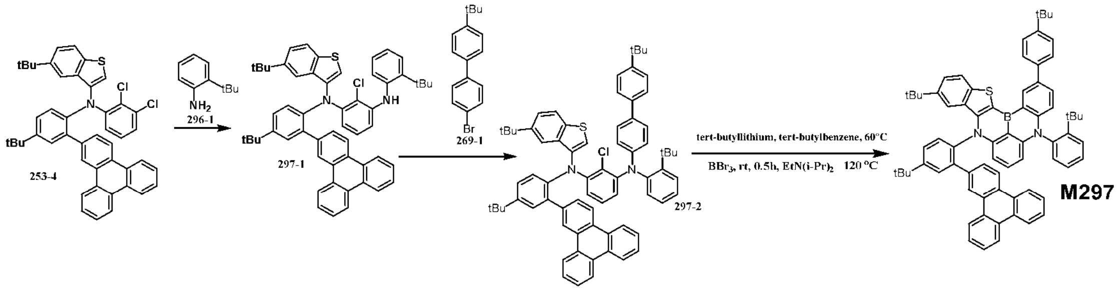


Synthesis of Intermediate 297-1:

Intermediate 253-4 (10 mmol), compound 296-1 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 7.81 mmol of Intermediate 297-1 in a yield of 78.1%. A result for the Intermediate 297-1 of Atmospheric Pressure Solids Analysis Probe Mass Spectrometry (ASAP-MS) was represented as: MS (ASAP) =820.

Synthesis of Intermediate 297-2:

Intermediate 297-1 (10 mmol), compound 269-1 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred under a nitrogen atmosphere at 100°C for 6 h. After cooling, the solvent was removed by rotary evaporation, and the remaining mixture was extracted and washed with water to separate an inorganic phase and an organic phase. The organic phase was subjected to column chromatography to give 6.81 mmol of Intermediate 297-2 in a yield of 68.1%. A result for the Intermediate 297-2 of Atmospheric Pressure Solids Analysis Probe Mass Spectrometry (ASAP-MS) was represented as: MS (ASAP) =1028.

Synthesis of organic compound M297:

10 mmol of Intermediate 297-2 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. Then, the reaction solution was cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M297 as a pale yellow solid powder in 39.5% yield. A result for the organic compound M297 of Atmospheric Pressure Solids Analysis Probe Mass Spectrometry (ASAP-MS) was represented as: MS (ASAP) =1002.

Example 52

The synthetic route of organic compound M298 is shown as follows:

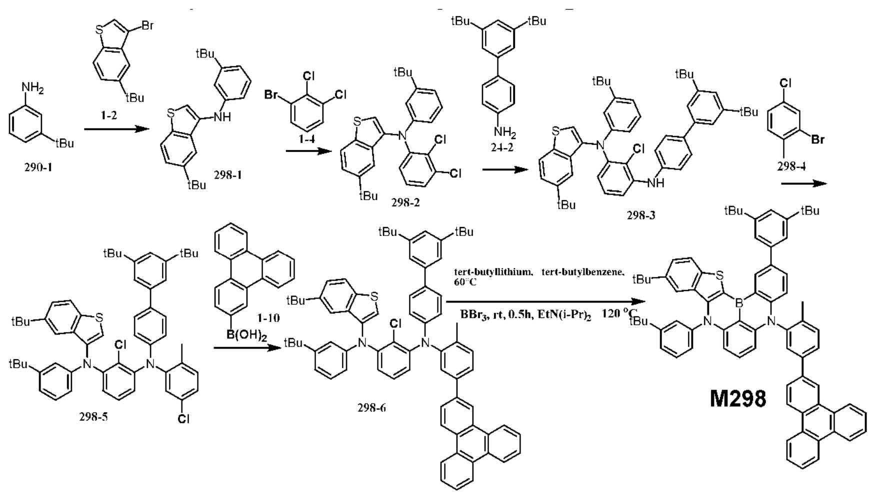


Synthesis of Intermediate 298-1:

Compound 290-1 (10 mmol), compound 1-2 (10 mmol), bis(dibenzylideneacetone) ($Pd(dba)_2$, 0.1 mmol), tri-tert-butylphosphine (TTBP, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 7.33 mmol of Intermediate 298-1 in a yield of 73.3%. A result for the Intermediate 298-1 of Atmospheric Pressure Solids Analysis Probe Mass Spectrometry (ASAP-MS) was represented as: MS (ASAP) =337.

Synthesis of Intermediate 298-2:

Compound 298-1 (10 mmol), compound 1-4 (10 mmol), bis(dibenzylideneacetone) ($Pd(dba)_2$, 0.1 mmol), tri-tert-butylphosphine (TTBP, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 8.25 mmol of Intermediate 298-2 in a yield of 82.5%. A result for the Intermediate 298-2 of Atmospheric Pressure Solids Analysis Probe Mass Spectrometry (ASAP-MS) was represented as: MS (ASAP) =481.

Synthesis of Intermediate 298-3:

Intermediate 298-2 (10 mmol), compound 24-2 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 6.54 mmol of Intermediate 298-3 in a yield of 65.4%. A result for the Intermediate 298-3 of Atmospheric Pressure Solids Analysis Probe Mass Spectrometry (ASAP-MS) was represented as: MS (ASAP) =726.

Synthesis of Intermediate 298-5:

Intermediate 298-3 (10 mmol), compound 298-4 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 7.38 mmol of Intermediate 298-5 in a yield of 73.8%. A result for the Intermediate 298-5 of Atmospheric Pressure Solids Analysis Probe Mass Spectrometry (ASAP-MS) was represented as: MS (ASAP) =850.

Synthesis of Intermediate 298-6:

Intermediate 298-5 (10 mmol) and Intermediate 1-10 (10 mmol) were dissolved in a mixed solvent of 1,4-dioxane and water (21/2 ml), and $Pd(PPh_3)_4$ (0.1 mmol) and potassium carbonate (30 mmol) were added thereinto and stirred at 100°C for 6 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 8.76 mmol of Intermediate 298-6 in a yield of 87.6%. A result for the Intermediate 298-6 of Atmospheric Pressure Solids Analysis Probe Mass Spectrometry (ASAP-MS) was represented as: MS (ASAP) =1042.

Synthesis of organic compound M298:

10 mmol of Intermediate 298-6 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. The reaction solution was then cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M298 as a pale yellow solid powder in 33.7% yield. A result for the organic compound M298 of Atmospheric Pressure Solids Analysis Probe Mass Spectrometry (ASAP-MS) was represented as: MS (ASAP) =1016.

Example 53

The synthetic route of organic compound M299 is shown as follows:

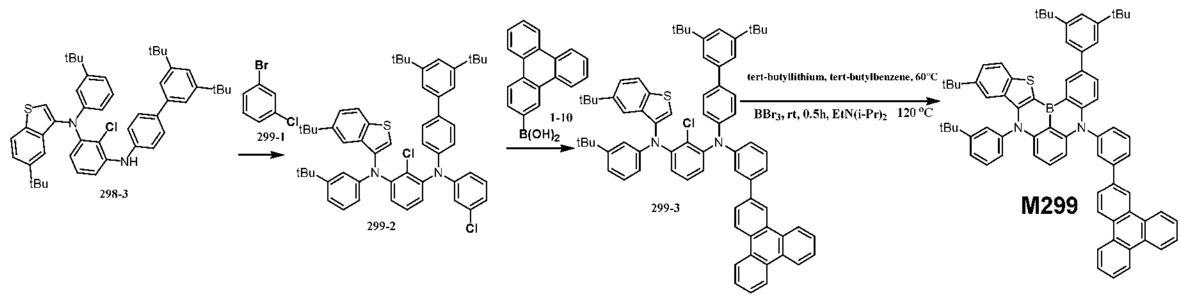


Synthesis of Intermediate 299-2:

Intermediate 298-3 (10 mmol), compound 299-1 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 7.10 mmol of Intermediate 299-2 in a yield of 71.0%. A result for the Intermediate 299-2 of Atmospheric Pressure Solids Analysis Probe Mass Spectrometry (ASAP-MS) was represented as: MS (ASAP) =836.

Synthesis of Intermediate 299-3:

Intermediate 299-2 (10 mmol) and Intermediate 1-10 (10 mmol) were dissolved in a mixed solvent of 1,4-dioxane and water (21/2 ml), and $Pd(PPh_3)_4$ (0.1 mmol) and potassium carbonate (30 mmol) were added thereinto and stirred at 100°C for 6 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 8.11 mmol of Intermediate 299-3 in a

yield of 81.1%. A result for the Intermediate 299-3 of Atmospheric Pressure Solids Analysis Probe Mass Spectrometry (ASAP-MS) was represented as: MS (ASAP) =1028.

Synthesis of organic compound M299:

10 mmol of Intermediate 299-3 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. Then, the reaction solution was cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M299 as a pale yellow solid powder in 39.6% yield. A result for the organic compound M299 of Atmospheric Pressure Solids Analysis Probe Mass Spectrometry (ASAP-MS) was represented as: MS (ASAP) =1002.

Example 54

The synthetic route of organic compound M300 is shown as follows:

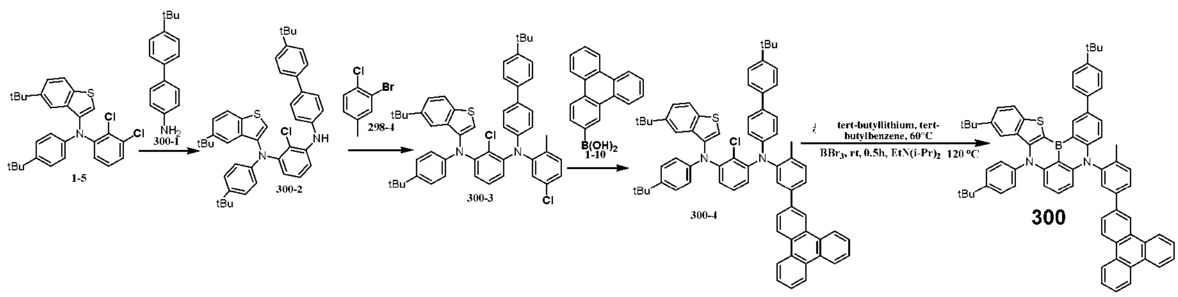


Synthesis of Intermediate 300-2:

Intermediate 1-5 (10 mmol), compound 300-1 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 7.26 mmol of Intermediate 300-2 in a yield of 72.6%. A result for the Intermediate 300-2 of Atmospheric Pressure Solids Analysis Probe Mass Spectrometry (ASAP-MS) was represented as: MS (ASAP) =670.

Synthesis of Intermediate 300-3:

Intermediate 300-2 (10 mmol), compound 298-4 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 6.85 mmol of Intermediate 300-3 in a yield of 68.5%. A result for the Intermediate 300-3 of Atmospheric Pressure Solids Analysis Probe Mass Spectrometry (ASAP-MS) was represented as: MS (ASAP) =794.

Synthesis of Intermediate 300-4:

Intermediate 300-3 (10 mmol) and Intermediate 1-10 (10 mmol) were dissolved in a mixed solvent of 1,4-dioxane and water (21/2 ml), and $Pd(PPh_3)_4$ (0.1 mmol) and potassium carbonate (30 mmol) were added thereinto and stirred at

100°C for 6 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 7.79 mmol of Intermediate 300-4 in a yield of 77.9%. A result for the Intermediate 300-4 of Atmospheric Pressure Solids Analysis Probe Mass Spectrometry (ASAP-MS) was represented as: MS (ASAP) =986.

Synthesis of organic compound M300:

10 mmol of Intermediate 300-4 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. Then, the reaction solution was cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M300 as a pale yellow solid powder in 36.7% yield. A result for the organic compound M300 of Atmospheric Pressure Solids Analysis Probe Mass Spectrometry (ASAP-MS) was represented as: MS (ASAP) =960.

Example 55

The synthetic route of organic compound M301 is shown as follows:

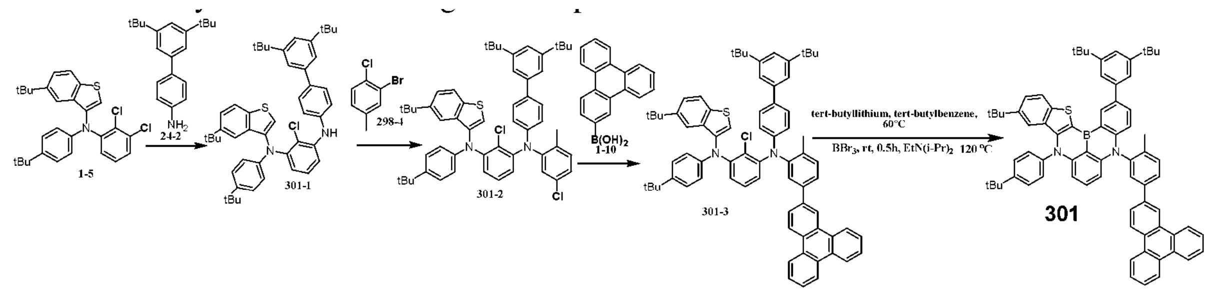


Synthesis of Intermediate 301-1:

Intermediate 1-5 (10 mmol), compound 24-2 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 7.88 mmol of Intermediate 301-1 in a yield of 78.8%. A result for the Intermediate 301-1 of Atmospheric Pressure Solids Analysis Probe Mass Spectrometry (ASAP-MS) was represented as: MS (ASAP) =726.

Synthesis of Intermediate 301-2:

Intermediate 301-1 (10 mmol), compound 298-4 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 6.21 mmol of Intermediate 301-2 in a yield of 62.1%. A result for the Intermediate 301-2 of Atmospheric Pressure Solids Analysis Probe Mass Spectrometry (ASAP-MS) was represented as: MS (ASAP) =850.

Synthesis of Intermediate 301-3:

Intermediate 301-2 (10 mmol) and Intermediate 1-10 (10 mmol) were dissolved in a mixed solvent of 1,4-dioxane and water (21/2 ml), and $Pd(PPh_3)_4$ (0.1 mmol) and potassium carbonate (30 mmol) were added thereinto and stirred at 100°C for 6 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 7.53 mmol of Intermediate 301-3 in a yield of 75.3%. A result for the Intermediate 301-3 of Atmospheric Pressure Solids Analysis Probe Mass Spectrometry (ASAP-MS) was represented as: MS (ASAP) =1042.

Synthesis of organic compound M301:

10 mmol of Intermediate 301-3 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. The reaction solution was then cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M301 as a pale yellow solid powder in 37.9% yield. A result for the organic compound M301 of Atmospheric Pressure Solids Analysis Probe Mass Spectrometry (ASAP-MS) was represented as: MS (ASAP) =1016.

Example 56

The synthetic route of organic compound M302 is shown as follows:

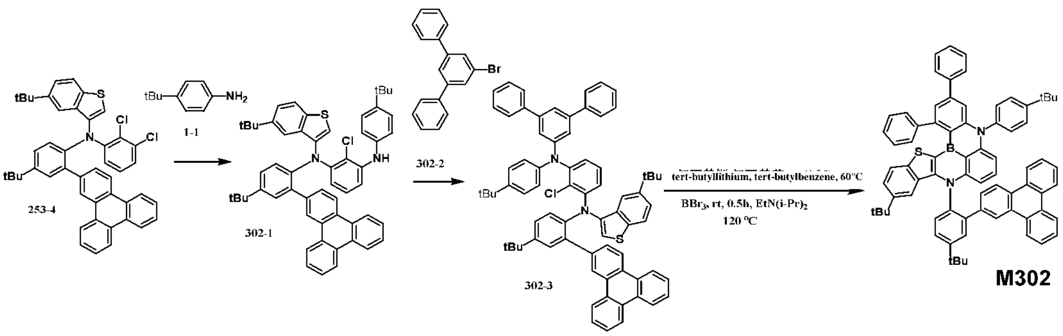


Synthesis of Intermediate 302-1:

Intermediate 253-4 (10 mmol), compound 1-1 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 8.45 mmol of Intermediate 302-1 in a yield of 84.5%. A result for the Intermediate 302-1 of Atmospheric Pressure Solids Analysis Probe Mass Spectrometry (ASAP-MS) was represented as: MS (ASAP) =820.

Synthesis of Intermediate 302-3:

Intermediate 302-1 (10 mmol), compound 302-2 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The

organic phase was subjected to column chromatography to give 7.59 mmol of Intermediate 302-3 in a yield of 75.9%. A result for the Intermediate 302-3 of Atmospheric Pressure Solids Analysis Probe Mass Spectrometry (ASAP-MS) was represented as: MS (ASAP) =1048.

Synthesis of organic compound M302:

10 mmol of Intermediate 302-3 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. The reaction solution was then cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified by flash silica gel column to obtain a purified product. The purified product was recrystallized with toluene and ethyl acetate to give the organic compound M302 as a pale yellow solid powder in 36.3% yield. A result for the organic compound M302 of Atmospheric Pressure Solids Analysis Probe Mass Spectrometry (ASAP-MS) was represented as: MS (ASAP) =1022.

Example 57

The synthetic route of organic compound M303 is shown as follows:

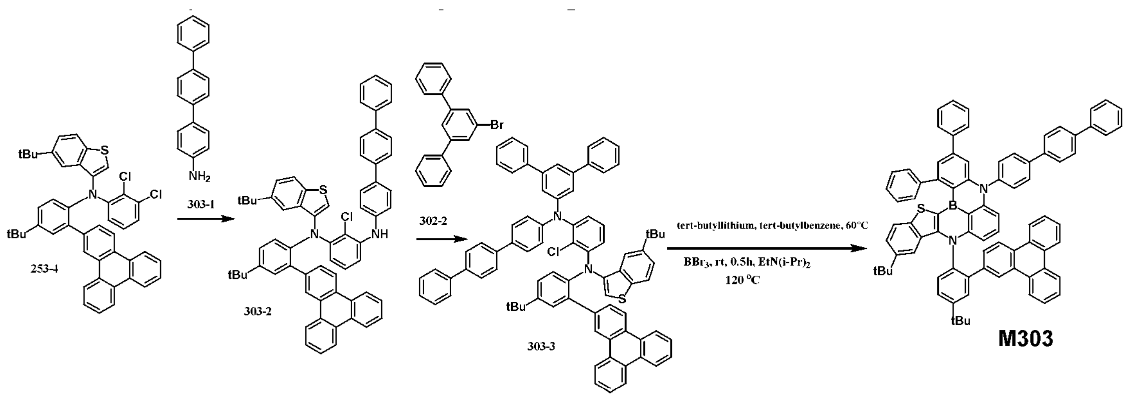


Synthesis of Intermediate 303-2:

Intermediate 253-4 (10 mmol), compound 303-1 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 8.31 mmol of Intermediate 303-2 in a yield of 83.1%. A result for the Intermediate 303-2 of Atmospheric Pressure Solids Analysis Probe Mass Spectrometry (ASAP-MS) was represented as: MS (ASAP) =916.

Synthesis of Intermediate 303-3:

Intermediate 303-2 (10 mmol), compound 302-2 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred under a nitrogen atmosphere at 100°C for 6 h. After cooling, the solvent was removed by rotary evaporation, and the remaining mixture was extracted and washed with water to separate an inorganic phase and an organic phase. The organic phase was subjected to column chromatography to give 7.17 mmol of Intermediate 303-3 in a yield of 71.7%. A result for the Intermediate 303-3 of Atmospheric Pressure Solids Analysis Probe Mass Spectrometry (ASAP-MS) was represented as: MS (ASAP) =1144.

Synthesis of organic compound M303:

10 mmol of Intermediate 303-3 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. Then, the reaction solution was cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M303 as a pale yellow solid powder in 37.4% yield. A result for the organic compound M303 of Atmospheric Pressure Solids Analysis Probe Mass Spectrometry (ASAP-MS) was represented as: MS (ASAP) =1118.

Example 58

The synthetic route of organic compound M304 is shown as follows:

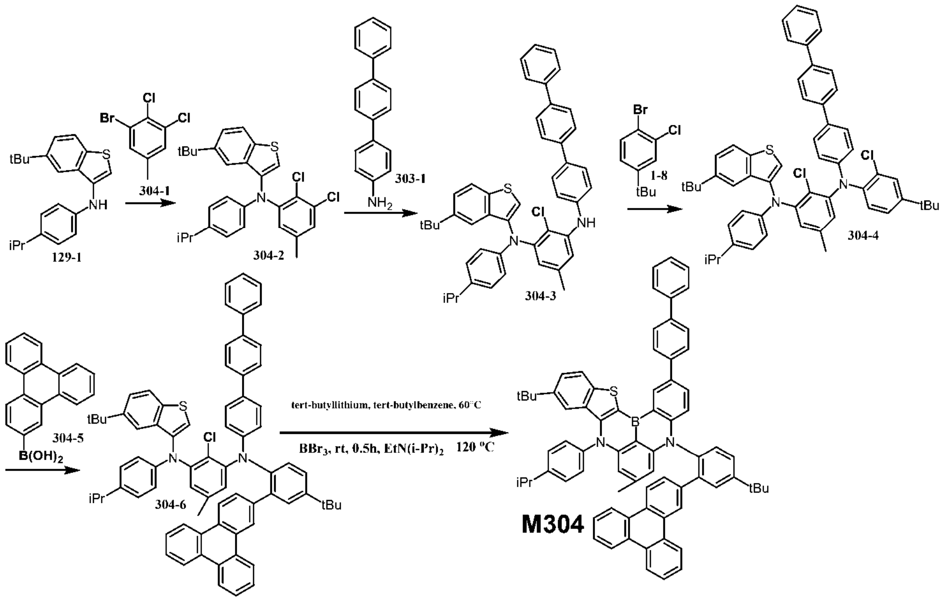


Synthesis of Intermediate 304-2:

Compound 129-1 (10 mmol), compound 304-1 (10 mmol), bis(dibenzylideneacetone) ($Pd(dba)_2$, 0.1 mmol), tri-tert-butylphosphine (TTBP, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 7.03 mmol of Intermediate 304-2 in a yield of 70.3%. A result for the Intermediate 304-2 of Atmospheric Pressure Solids Analysis Probe Mass Spectrometry (ASAP-MS) was represented as: MS (ASAP) =481.

Synthesis of Intermediate 304-3:

Intermediate 304-2 (10 mmol), compound 303-1 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give

6.87 mmol of Intermediate 304-3 in a yield of 68.7%. A result for the Intermediate 304-3 of Atmospheric Pressure Solids Analysis Probe Mass Spectrometry (ASAP-MS) was represented as: MS (ASAP) =690.

Synthesis of Intermediate 304-4:

Intermediate 304-3 (10 mmol), compound 1-8 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 6.87 mmol of Intermediate 304-4 in a yield of 68.7%. A result for the Intermediate 304-4 of Atmospheric Pressure Solids Analysis Probe Mass Spectrometry (ASAP-MS) was represented as: MS (ASAP) =856.

Synthesis of Intermediate 304-6:

Intermediate 304-4 (10 mmol) and Intermediate 304-5 (10 mmol) were dissolved in a mixed solvent of 1,4-dioxane and water (21/2 ml), and $Pd(PPh_3)_4$ (0.1 mmol) and potassium carbonate (30 mmol) were added thereinto and stirred at 100°C for 6 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 7.22 mmol of Intermediate 304-6 in a yield of 72.2%. A result for the Intermediate 304-6 of Atmospheric Pressure Solids Analysis Probe Mass Spectrometry (ASAP-MS) was represented as: MS (ASAP) =1048.

Synthesis of organic compound M304:

10 mmol of Intermediate 304-6 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. Then, the reaction solution was cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M304 as a pale yellow solid powder in a yield of 34.8%. A result for the organic compound M304 of Atmospheric Pressure Solids Analysis Probe Mass Spectrometry (ASAP-MS) was represented as: MS (ASAP) =1022.

Example 59

The synthetic route of organic compound M305 is shown as follows:

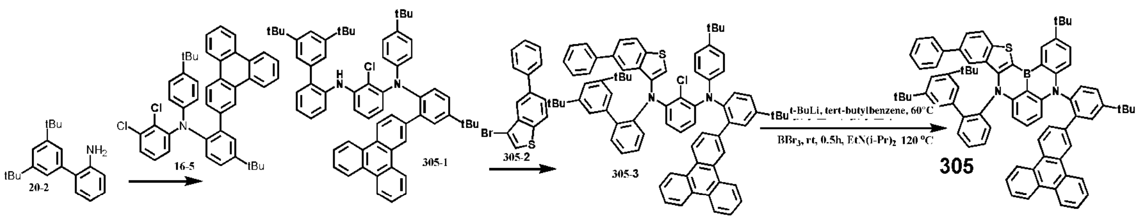


Synthesis of Intermediate 305-1:

Intermediate 20-2 (10 mmol) and compound 16-5 (10 mmol) were dissolved in a mixed solvent of 1,4-dioxane and water (21/2 ml), and $Pd(PPh_3)_4$ (0.1 mmol) and potassium carbonate (30 mmol) were added thereinto and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 8.27 mmol of Intermediate 305-1 in a yield of 82.7%. A result for the

Intermediate 305-1 of Atmospheric Pressure Solids Analysis Probe Mass Spectrometry (ASAP-MS) was represented as: MS (ASAP) =896.

Synthesis of Intermediate 305-3:

Intermediate 305-1 (10 mmol), compound 305-2 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 7.69 mmol of Intermediate 305-3 in a yield of 76.9%. A result for the Intermediate 305-3 of Atmospheric Pressure Solids Analysis Probe Mass Spectrometry (ASAP-MS) was represented as: MS (ASAP) =1104.

Synthesis of organic compound M305:

10 mmol of Intermediate 305-3 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. The reaction solution was then cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M305 as a pale yellow solid powder in 51.2% yield. A result for the organic compound M305 of Atmospheric pressure solid phase analysis probe mass spectrometry (ASAP-MS) was represented as: MS (ASAP) =1078.

Example 60

The synthetic route of organic compound M306 is shown as follows:

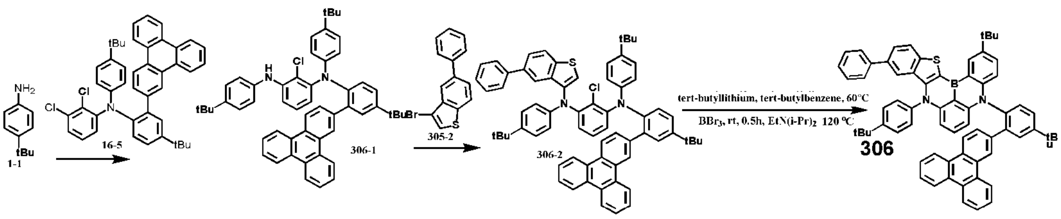


Synthesis of Intermediate 306-1:

Intermediate 1-1 (10 mmol) and compound 16-5 (10 mmol) were dissolved in a mixed solvent of 1,4-dioxane and water (21/2 ml), and $Pd(PPh_3)_4$ (0.1 mmol) and potassium carbonate (30 mmol) were added thereinto and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 8.89 mmol of Intermediate 306-1 in a yield of 88.9%. A result for the Intermediate 306-1 of Atmospheric Pressure Solids Analysis Probe Mass Spectrometry (ASAP-MS) was represented as: MS (ASAP) =764.

Synthesis of Intermediate 306-2:

Intermediate 306-1 (10 mmol), compound 305-2 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 7.33 mmol of Intermediate 306-2 in a yield of 73.3%. A

result for the Intermediate 306-2 of Atmospheric Pressure Solids Analysis Probe Mass Spectrometry (ASAP-MS) was represented as: MS (ASAP) =972

Synthesis of organic compound M306:

10 mmol of Intermediate 306-2 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. Then, the reaction solution was cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M306 as a pale yellow solid powder in 46.4% yield. A result for the organic compound M306 of Atmospheric Pressure Solids Analysis Probe Mass Spectrometry (ASAP-MS) was represented as: MS (ASAP) =946.

Example 61

The synthetic route of organic compound M307 is shown as follows:

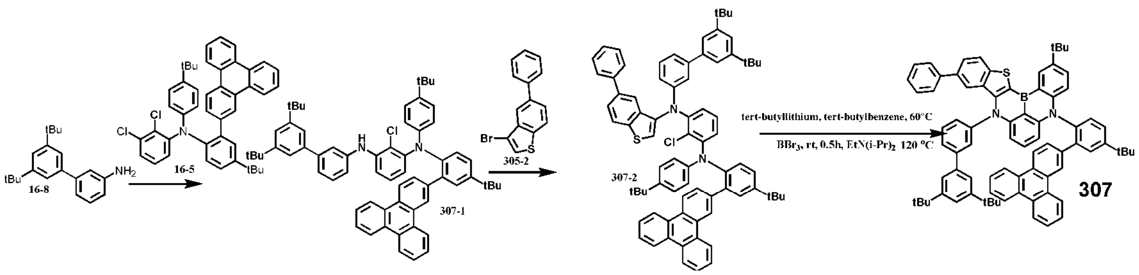


Synthesis of Intermediate 307-1:

Intermediate 16-8 (10 mmol) and compound 16-5 (10 mmol) were dissolved in a mixed solvent of 1,4-dioxane and water (21/2 ml), and $Pd(PPh_3)_4$ (0.1 mmol) and potassium carbonate (30 mmol) were added thereinto and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 8.41 mmol of Intermediate 307-1 in a yield of 84.1%. A result for the Intermediate 307-1 of Atmospheric Pressure Solids Analysis Probe Mass Spectrometry (ASAP-MS) was represented as: MS (ASAP) =896.

Synthesis of Intermediate 307-2:

Intermediate 307-1 (10 mmol), compound 305-2 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred under a nitrogen atmosphere at 100°C for 6 h. After cooling, the solvent was removed by rotary evaporation, and the remaining mixture was extracted and washed with water to separate an inorganic phase and an organic phase. The organic phase was subjected to column chromatography to give 7.89 mmol of Intermediate 307-2 in a yield of 78.9%. A result for the Intermediate 307-2 of Atmospheric Pressure Solids Analysis Probe Mass Spectrometry (ASAP-MS) was represented as: MS (ASAP) =1104.

Synthesis of organic compound M307:

10 mmol of Intermediate 307-2 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced

pressure. The reaction solution was cooled to -30°C again, and added boron tribromide (21 mmol) thereinto. The resulting reaction solution was heated to room temperature and stirred for 0.5 hours. Then, the reaction solution was cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M307 as a pale yellow solid powder in a yield of 44.1%. A result for the organic compound M307 of Atmospheric Pressure Solids Analysis Probe Mass Spectrometry (ASAP-MS) was represented as: MS (ASAP) =1078.

Example 62

The synthetic route of organic compound M308 is shown as follows:

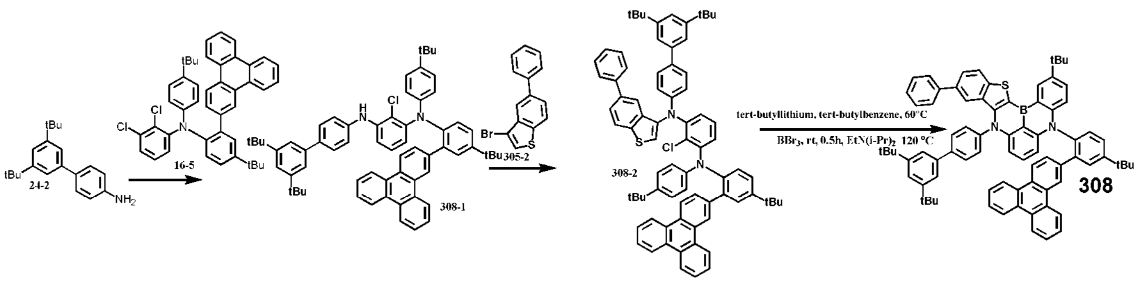


Synthesis of Intermediate 308-1:

Intermediate 24-2 (10 mmol) and compound 16-5 (10 mmol) were dissolved in a mixed solvent of 1,4-dioxane and water (21/2 ml), and $Pd(PPh_3)_4$ (0.1 mmol) and potassium carbonate (30 mmol) were added thereinto and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 8.33 mmol of Intermediate 308-1 in a yield of 83.3%. A result for the Intermediate 308-1 of Atmospheric Pressure Solids Analysis Probe Mass Spectrometry (ASAP-MS) was represented as: MS (ASAP) =896.

Synthesis of Intermediate 308-2:

Intermediate 308-1 (10 mmol), compound 305-2 (10 mmol), $Pd_2(dba)_3$ (0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 100°C for 6 h under a nitrogen atmosphere. After cooling, the solvent was removed by rotary evaporation, and the remaining mixture was extracted and washed with water to separate an inorganic phase and an organic phase. The organic phase was subjected to column chromatography to give 7.93 mmol of Intermediate 308-2 in a yield of 79.3%. A result for the Intermediate 308-2 of Atmospheric Pressure Solids Analysis Probe Mass Spectrometry (ASAP-MS) was represented as: MS (ASAP) =1104.

Synthesis of organic compound M308:

10 mmol of Intermediate 308-2 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. Then, the reaction solution was cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M308

as a pale yellow solid powder in 41.6% yield. A result for the organic compound M308 of Atmospheric Pressure Solids Analysis Probe Mass Spectrometry (ASAP-MS) was represented as: MS (ASAP) =1078.

Example 63

The synthetic route of organic compound M309 is shown as follows:

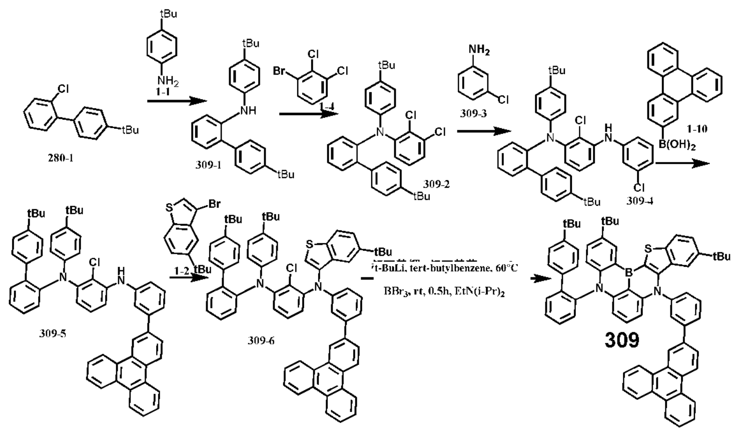


Synthesis of Intermediate 309-1:

Intermediate 280-1 (10 mmol), Intermediate 1-1 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 7.89 mmol of Intermediate 309-1 in a yield of 78.9%. A result for the Intermediate 309-1 of Atmospheric Pressure Solids Analysis Probe Mass Spectrometry (ASAP-MS) was represented as: MS (ASAP) =357.

Synthesis of Intermediate 309-2:

Intermediate 309-1 (10 mmol), Intermediate 1-4 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 7.56 mmol of Intermediate 309-2 in a yield of 75.6%. A result for the Intermediate 309-2 of Atmospheric Pressure Solids Analysis Probe Mass Spectrometry (ASAP-MS) was represented as: MS (ASAP) =501.

Synthesis of Intermediate 309-4:

Intermediate 309-2 (10 mmol), Intermediate 309-3 (10 mmol), bis[di-tert-butyl(4-dimethylaminophenyl)phosphine]dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 7.11 mmol of Intermediate 309-4 in a yield of 71.1%. A result for the Intermediate 309-4 of Atmospheric Pressure Solids Analysis Probe Mass Spectrometry (ASAP-MS) was represented as: MS (ASAP) =592.

Synthesis of Intermediate 309-5:

Intermediate 309-4 (10 mmol) and Intermediate 1-10 (10 mmol) were dissolved in a mixed solvent of 1,4-dioxane

and water (21/2 ml), and $Pd(PPh_3)_4$ (0.1 mmol) and potassium carbonate (30 mmol) were added thereinto and stirred at 100°C for 6 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 6.87 mmol of Intermediate 309-5 in a yield of 68.7%. A result for the Intermediate 309-5 of Atmospheric Pressure Solids Analysis Probe Mass Spectrometry (ASAP-MS) was represented as: MS (ASAP) =784.

Synthesis of Intermediate 309-6:

Intermediate 309-5 (10 mmol), Intermediate 1-2 (10 mmol), bis[di-tert-butyl(4-dimethylaminophenyl)phosphine] dichloropalladium (Pd-132, 0.1 mmol), 2-dicyclohexylphosphino-2',6'-dimethoxy-1',1'-biphenyl (S-Phos, 0.2 mmol) and sodium tert-butoxide (30 mmol) were dissolved in toluene and stirred at 120°C for 3 h under a nitrogen atmosphere. After cooling, most of the solvent was removed by rotary evaporation, then the remaining mixture was extracted and washed with water to separate an inorganic phase and an organic phase. The organic phase was subjected to column chromatography and recrystallized to give 7.97 mmol of Intermediate 309-6 in a yield of 79.7%. A result for the Intermediate 309-6 of Atmospheric Pressure Solids Analysis Probe Mass Spectrometry (ASAP-MS) was represented as: MS (ASAP) =972.

Synthesis of organic compound M309:

10 mmol of Intermediate 309-6 and 100 ml of dry tert-butylbenzene were added into a 250 ml three-necked flask, under $N_2$ atmosphere, cooled to -30°C, and added a solution of tert-butyllithium (t-BuLi, 21 mmol) in n-hexane dropwise. The mixture was heated to 60°C and reacted for 2 hours. The n-hexane solvent was then evaporated under reduced pressure. The reaction solution was cooled to -30°C again, and added boron tribromide (21 mmol) thereinto. The resulting reaction solution was heated to room temperature and stirred for 0.5 hours. The reaction solution was then cooled to 0°C, and 42 mmol of N,N-diisopropylethylamine was added. Upon the completion of addition, the reaction solution was heated to room temperature with stirring, and then to 120°C with stirring for 3 hours. Then, the reaction solution was cooled to room temperature, and quenched with aqueous sodium carbonate solution and ethyl acetate. The aqueous phase was extracted with ethyl acetate and the organic phases were combined. The solvent was removed from the combined organic phase by rotary evaporation to obtain a crude product, which was purified through flash silica gel column to obtain a purified product. The purified product was recrystallized with toluene and ethyl acetate to give the organic compound M309 as a pale yellow solid powder in 42.5% yield. A result for the organic compound M309 of Atmospheric Pressure Solids Analysis Probe Mass Spectrometry (ASAP-MS) was represented as: MS (ASAP) =946.

Comparative Example 1

Comparative Compound 1 having the following structural formula was used as a Comparative Example from Examples 1 to 63 above:

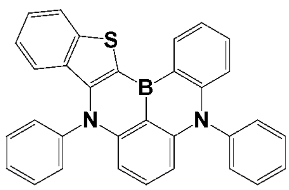

Comparative Compound 1.

The highest occupied molecular orbital (HOMO) energy level, lowest unoccupied molecular orbital (LUMO) energy level, first excited triplet state (T1) energy level, first excited singlet state (S1) energy level of the compounds M1 to M309 generated in Examples 1 to 63 and the comparative compound 1 in Comparative Example 1 can be obtained by quantum calculation, as shown in Table 1. Specifically, time-dependent density-functional theory (TD-DFT) is applied in combination with $Gaussian_0$9W software (Gaussian Inc.). Specific simulation methods can be found in WO2011141110. In these methods, the molecular geometry is optimized by means of a semi-empirical method "Ground State/Semi-empirical/Default Spin/AM1" (Charge 0/Spin Singlet), and then the energy calculations for the organic molecules is carried out by the TD-DFT with "TD-SCF/DFT/Default Spin/B3PW91" and the base set "6-31G(d)" (Charge 0/Spin Singlet). The HOMO and LUMO energy levels are calculated according to the following calibration equations, and the S1

and T1 energy levels are used as it is.

$$HOMO\ (eV) = ((HOMO(G) \times 27.212) - 0.9899)/1.1206$$

$$LUMO\ (eV) = ((LUMO(G) \times 27.212) - 2.0041)/1.385$$

Results for the HOMO, LUMO, T1, and S1 are directly calculated by means of Gaussian 09W, with a unit of Hartree.

Table 1: Calculation Results for the HOMO, LUMO, S1, and T1 Energy Levels of Organic Compounds M1 to M309 and Comparative Compound 1

| | Compound | HOMO[eV] | LUMO [eV] | T1[eV] | S1[eV] |
|---|---|---|---|---|---|
| Example 1 | Organic compound M1 | -5.03 | -2.31 | 2.39 | 3.01 |
| Example 2 | Organic compound M2 | -5.02 | -2.29 | 2.40 | 3.01 |
| Example 3 | Organic compound M3 | -5.02 | -2.28 | 2.41 | 3.00 |
| Example 4 | Organic compound M16 | -5.04 | -2.30 | 2.41 | 3.03 |
| Example 5 | Organic compound M20 | -5.01 | -2.30 | 2.41 | 3.01 |
| Example 6 | Organic compound M24 | -5.09 | -2.31 | 2.43 | 3.05 |
| Example 7 | Organic compound M25 | -4.99 | -2.28 | 2.39 | 2.99 |
| Example 8 | Organic compound M26 | -5.05 | -2.28 | 2.38 | 2.99 |
| Example 9 | Organic compound M96 | -5.07 | -2.30 | 2.41 | 3.01 |
| Example 10 | Organic compound M100 | -5.08 | -2.29 | 2.41 | 3.01 |
| Example 11 | Organic compound M104 | -5.08 | -2.29 | 2.42 | 3.04 |
| Example 12 | Organic compound M122 | -4.99 | -2.31 | 2.38 | 3.01 |
| Example 13 | Organic compound M128 | -4.99 | -2.32 | 2.40 | 3.00 |
| Example 14 | Organic compound M129 | -5.03 | -2.29 | 2.39 | 3.00 |
| Example 15 | Organic compound M132 | -5.02 | -2.29 | 2.39 | 2.99 |
| Example 16 | Organic compound M147 | -5.07 | -2.30 | 2.41 | 3.03 |
| Example 17 | Organic compound M162 | -5.04 | -2.28 | 2.41 | 3.05 |
| Example 18 | Organic compound M165 | -4.97 | -2.29 | 2.40 | 3.07 |
| Example 19 | Organic compound M193 | -5.00 | -2.31 | 2.42 | 3.07 |
| Example 20 | Organic compound M210 | -5.03 | -2.31 | 2.40 | 3.08 |
| Example 21 | Organic compound M234 | -5.03 | -2.30 | 2.38 | 3.14 |
| Example 22 | Organic compound M253 | -5.01 | -2.30 | 2.41 | 3.04 |
| Example 23 | Organic compound M254 | -5.04 | -2.28 | 2.43 | 3.03 |
| Example 24 | Organic compound M255 | -5.01 | -2.31 | 2.39 | 3.08 |
| Example 25 | Organic compound M266 | -5.03 | -2.29 | 2.35 | 3.01 |
| Example 26 | Organic compound M268 | -4.94 | -2.30 | 2.41 | 3.04 |
| Example 27 | Organic compound M269 | -4.94 | -2.31 | 2.41 | 3.01 |
| Example 28 | Organic compound M270 | -4.95 | -2.31 | 2.38 | 3.03 |
| Example 29 | Organic compound M271 | -4.99 | -2.29 | 2.39 | 3.03 |
| Example 30 | Organic compound M274 | -4.94 | -2.30 | 2.41 | 3.02 |
| Example 31 | Organic compound | -4.98 | -2.32 | 2.47 | 3.01 |

(continued)

| | Compound | HOMO[eV] | LUMO [eV] | T1[eV] | S1[eV] |
|---|---|---|---|---|---|
| | M277 | | | | |
| Example 32 | Organic compound M278 | -5.01 | -2.30 | 2.41 | 3.01 |
| Example 33 | Organic compound M279 | -5.00 | -2.28 | 2.39 | 3.03 |
| Example 34 | Organic compound M280 | -4.96 | -2.29 | 2.43 | 2.99 |
| Example 35 | Organic compound M281 | -4.98 | -2.31 | 2.45 | 2.93 |
| Example 36 | Organic compound M282 | -5.03 | -2.35 | 2.50 | 2.98 |
| Example 37 | Organic compound M283 | -5.07 | -2.26 | 2.46 | 3.03 |
| Example 38 | Organic compound M284 | -4.91 | -2.27 | 2.43 | 3.01 |
| Example 39 | Organic compound M285 | -5.03 | -2.29 | 2.45 | 3.04 |
| Example 40 | Organic compound M286 | -4.91 | -2.33 | 2.42 | 3.05 |
| Example 41 | Organic compound M287 | -4.97 | -2.33 | 2.39 | 3.01 |
| Example 42 | Organic compound M288 | -5.04 | -2.31 | 2.43 | 3.03 |
| Example 43 | Organic compound M289 | -5.06 | -2.30 | 2.44 | 2.97 |
| Example 44 | Organic compound M290 | -4.93 | -2.27 | 2.41 | 3.01 |
| Example 45 | Organic compound M291 | -5.07 | -2.31 | 2.35 | 3.00 |
| Example 46 | Organic compound M292 | -5.01 | -2.33 | 2.38 | 3.01 |
| Example 47 | Organic compound M293 | -4.99 | -2.29 | 2.41 | 2.97 |
| Example 48 | Organic compound M294 | -4.95 | -2.33 | 2.37 | 2.95 |
| Example 49 | Organic compound M295 | -4.96 | -2.31 | 2.41 | 2.97 |
| Example 50 | Organic compound M296 | -4.99 | -2.31 | 2.39 | 2.97 |
| Example 51 | Organic compound M297 | -4.96 | -2.29 | 2.42 | 2.99 |
| Example 52 | Organic compound M298 | -5.02 | -2.33 | 2.37 | 2.98 |
| Example 53 | Organic compound M299 | -5.01 | -2.30 | 2.39 | 2.94 |
| Example 54 | Organic compound M300 | -4.98 | -2.33 | 2.39 | 2.98 |
| Example 55 | Organic compound M301 | -4.99 | -2.31 | 2.41 | 3.01 |
| Example 56 | Organic compound M302 | -5.03 | -2.33 | 2.36 | 2.97 |
| Example 57 | Organic compound M303 | -4.99 | -2.33 | 2.37 | 2.99 |
| Example 58 | Organic compound M304 | -5.02 | -2.35 | 2.40 | 3.03 |
| Example 59 | Organic compound M305 | -4.95 | -2.31 | 2.37 | 3.01 |
| Example 60 | Organic compound M306 | -4.93 | -2.29 | 2.37 | 3.03 |
| Example 61 | Organic compound M307 | -4.97 | -2.31 | 2.38 | 2.99 |
| Example 62 | Organic compound M308 | -4.93 | -2.31 | 2.39 | 2.99 |
| Example 63 | Organic compound M309 | -4.99 | -2.32 | 2.41 | 3.01 |
| Comparative Example 1 | Comparative Compound 1 | -5.10 | -2.35 | 2.33 | 2.91 |

From the results of Table 1, it can be seen that the T1 and S1 energy levels of the organic compounds M1 to M309 provided in Examples 1 to 63 of the present disclosure are shown to be higher than those of the comparative compound 1, indicating that the organic compounds M1 to M309 more tend to emit dark blue light compared to the comparative compound 1. This is advantageous for a blue organic light-emitting device to which the organic compounds M1 to M309 are applied as guest materials of a light-emitting layer to obtain better color coordinates.

According to an embodiment of the present disclosure, there is provided an exemplary method for manufacturing

the organic light-emitting device 100, as shown in the following Exemplary Example 1.

Example 1

In the organic light-emitting device provided in this embodiment, indium tin oxide (ITO) was used as an anode, polyethylenedioxythiophene (PEDOT, Clevios™ AI4083) as a material of a hole injection layer, poly(9-vinylcarbazole) (PVK, Sigma Aldrich, with an average Mn of 25,000-50,000) as a material of a hole transport layer, each of BH-1 to BH-3 having the following structural formulae as a host material in a light-emitting layer of respective organic light-emitting device, each of the organic compounds M1 to M309 in Examples 1 to 67 and the comparative compound 1 in Comparative Example 1 as a guest material in the light-emitting layer of respective organic light-emitting device, ET and 8-hydroxyquinolinolato-lithium (Liq) having the following structural formulae as a material of an electron transport layer, and Al as a cathode. The specific manufacture method was carried out as follows:

Step a. Cleaning the ITO anode: the ITO conductive glass was cleaned with chloroform, acetone and/or isopropanol, and treated by UV ozone.
Step b. Forming the hole injection layer: the material PEDOT (Clevios™ AI4083) for the hole injection layer was spin-coated on the ITO anode, and treated on a hot plate at 180°C for 10 minutes to form the hole injection layer having a thickness of 40 nm.
Step c. Forming the hole transport layer: a solution of PVK (Sigma Aldrich, Mn of 25,000-50,000) in toluene at a concentration of 5mg/ml was spin-coated on the hole injection layer, and treated on a hot plate at 180°C for 60 minutes to form the hole transport layer having a thickness of 20 nm.
Step d. Forming the light-emitting layer: a material for the light-emitting layer was spin-coated on the hole transport layer in a nitrogen glove box, and subsequently treated on a hot plate at 140°C for 10 minutes. In the material for the light-emitting layer, the host material of the light-emitting layer of respective organic light-emitting device corresponds to BH-1, BH-2, or BH-3, the guest material of the light-emitting layer of respective organic light-emitting device corresponds to one of the organic compounds M1 to M309, methyl benzoate solution was used as a solvent, a mass ratio of the host material to the guest material was 95:5, and a concentration of the material for the light-emitting layer was 15mg/ml. The finished light-emitting layer has a thickness of 40 nm.
Setp e. Forming the electron transport layer: ET and Liq were placed in different evaporation units in a vacuum chamber, respectively, and co-deposited at a weight ratio of 50:50 under a high vacuum ($1\times10^{-6}$ mbar) on the light-emitting layer to form the electron transport layer having a thickness of 20 nm.
Step f. Forming the cathode layer: Al was deposited on the electron transport layer to obtain the Al cathode having a thickness of 100 nm.
Step g. Encapsulation: The device was encapsulated in a nitrogen glove box with a UV-curable resin.

Specifically, according to the present embodiment, organic light-emitting devices 1 to 67 and comparative devices 1 to 3 were obtained by the above steps. For the organic light-emitting devices 1 to 63, the guest materials used were the organic compounds M1 to M309, respectively, and the host material was BH-1. For the organic light-emitting devices 64 and 66, the guest materials used were the organic compound M20, and the host materials were BH-2 and BH-3, respectively. For the organic light-emitting devices 65 and 67, the guest materials used were the organic compound M234, and the host materials were BH-2 and BH-3, respectively. For the comparative devices 1 to 3, the guest materials used were the comparative compound 1, and the host material were BH-1, BH-2, and BH-3, respectively.
Specifically, the chemical structures of BH-1, BH-2, BH-3, ET, and Liq were shown as follows:

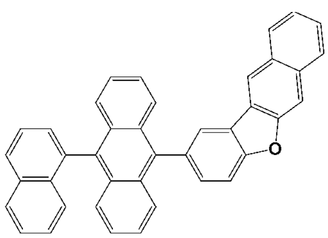
BH-1

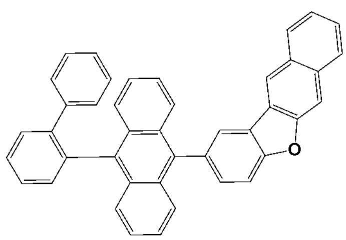
BH-2

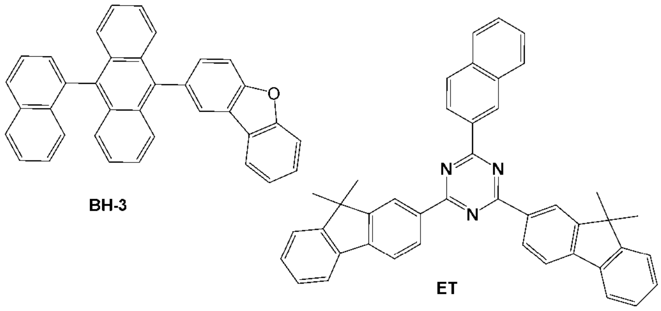

BH-3

ET

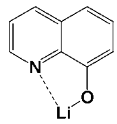

Liq

.

In this embodiments, current-voltage (J-V) characteristics of the organic light-emitting devices 1 to 67 and the comparative devices 1 to 3 were tested to obtain the CIE color coordinate (x, y), the driving voltage (voltage @ 1knits[V]) at the luminance of 1knits, the luminous efficiency (CE@ 1knits[cd/A]) at a current density of 10 mA/cm$^2$, and the time (LT90@ 1knits[h]) taken from the initial brightness of 1knits to 90% of the initial brightness, as shown in Table 2.

Table 2: Performance Data of Organic light-emitting devices 1 to 67 and Comparative Device 1 to 3

| | Guest | Host | CIE(x,y) | V@1knits[V] | CE@1knits[cd/A] | LT90 @ 1knits[h] |
|---|---|---|---|---|---|---|
| organic light-emitting device 1 | Organic comound M1 | BH-1 | 0.141,0.089 | 5.5 | 5.7 | 131 |
| organic light-emitting device 2 | Organic comound M2 | BH-1 | 0.141,0.087 | 5.5 | 5.8 | 141 |
| organic light-emitting device 3 | Organic comound M3 | BH-1 | 0.143,0.087 | 5.5 | 5.7 | 136 |
| organic light-emitting device 4 | Organic comound M16 | BH-1 | 0.143,0.081 | 5.5 | 6.4 | 173 |
| organic light-emitting device 5 | Organic comound M20 | BH-1 | 0.141,0.083 | 5.5 | 6.5 | 171 |
| organic light-emitting device 6 | Organic comound M24 | BH-1 | 0.143,0.081 | 5.5 | 6.6 | 177 |
| organic light-emitting device 7 | Organic comound M25 | BH-1 | 0.142,0.083 | 5.6 | 5.9 | 137 |
| organic light-emitting device 8 | Organic comound M26 | BH-1 | 0.141,0.086 | 5.5 | 5.8 | 136 |
| organic light-emitting device 9 | Organic comound M96 | BH-1 | 0.141,0.086 | 5.5 | 5.9 | 138 |
| organic light-emitting device 10 | Organic comound M100 | BH-1 | 0.142,0.088 | 5.7 | 5.9 | 141 |
| organic light-emitting device 11 | Organic comound M104 | BH-1 | 0.141,0.087 | 5.5 | 5.8 | 144 |

(continued)

| | Guest | Host | CIE(x,y) | V@1knits[V] | CE@1knits[cd/A] | LT90 @ 1knits[h] |
|---|---|---|---|---|---|---|
| organic light-emitting device 12 | Organic comound M122 | BH-1 | 0.141,0.089 | 5.5 | 5.8 | 139 |
| organic light-emitting device 13 | Organic comound M128 | BH-1 | 0.141,0.088 | 5.5 | 6.0 | 141 |
| organic light-emitting device 14 | Organic comound M129 | BH-1 | 0.141,0.089 | 5.5 | 6.0 | 135 |
| organic light-emitting device 15 | Organic comound M132 | BH-1 | 0.141,0.087 | 5.5 | 5.8 | 138 |
| organic light-emitting device 16 | Organic comound M147 | BH-1 | 0.141,0.088 | 5.5 | 5.9 | 139 |
| organic light-emitting device 17 | Organic comound M162 | BH-1 | 0.141,0.086 | 5.5 | 6.0 | 141 |
| organic light-emitting device 18 | Organic comound M165 | BH-1 | 0.143,0.086 | 5.5 | 5.7 | 149 |
| organic light-emitting device 19 | Organic comound M193 | BH-1 | 0.143,0.093 | 5.5 | 5.7 | 148 |
| organic light-emitting device 20 | Organic comound M210 | BH-1 | 0.143,0.087 | 5.5 | 5.8 | 142 |
| organic light-emitting device 21 | Organic comound M234 | BH-1 | 0.143,0.087 | 5.5 | 6.4 | 169 |
| organic light-emitting device 22 | Organic comound M253 | BH-1 | 0.141,0.087 | 5.5 | 6.4 | 173 |
| organic light-emitting device 23 | Organic comound M254 | BH-1 | 0.141,0.086 | 5.5 | 6.5 | 175 |
| organic light-emitting device 24 | Organic comound M255 | BH-1 | 0.141,0.086 | 5.5 | 6.3 | 171 |
| organic light-emitting device 25 | Organic comound M266 | BH-1 | 0.141,0.083 | 5.5 | 6.5 | 176 |
| organic light-emitting device 26 | Organic comound M268 | BH-1 | 0.141,0.085 | 5.5 | 6.4 | 171 |
| organic light-emitting device 27 | Organic comound M269 | BH-1 | 0.141,0.085 | 5.5 | 6.3 | 162 |

(continued)

| | Guest | Host | CIE(x,y) | V@1knits[V] | CE@1knits[cd/A] | LT90 @ 1knits[h] |
|---|---|---|---|---|---|---|
| organic light-emitting device 28 | Organic comound M270 | BH-1 | 0.141,0.087 | 5.5 | 6.3 | 169 |
| organic light-emitting device 29 | Organic comound M271 | BH-1 | 0.141,0.086 | 5.5 | 6.4 | 175 |
| organic light-emitting device 30 | Organic comound M274 | BH-1 | 0.141,0.087 | 5.5 | 6.3 | 176 |
| organic light-emitting device 31 | Organic comound M277 | BH-1 | 0.141,0.086 | 5.5 | 6.4 | 178 |
| organic light-emitting device 32 | Organic comound M278 | BH-1 | 0.141,0.083 | 5.5 | 6.1 | 174 |
| organic light-emitting device 33 | Organic comound M279 | BH-1 | 0.141,0.086 | 5.5 | 6.3 | 173 |
| organic light-emitting device 34 | Organic comound M280 | BH-1 | 0.141,0.086 | 5.5 | 6.3 | 173 |
| organic light-emitting device 35 | Organic comound M281 | BH-1 | 0.141,0.087 | 5.5 | 6.2 | 171 |
| organic light-emitting device 36 | Organic comound M282 | BH-1 | 0.141,0.086 | 5.5 | 6.3 | 171 |
| organic light-emitting device 37 | Organic comound M283 | BH-1 | 0.141,0.083 | 5.5 | 6.2 | 177 |
| organic light-emitting device 38 | Organic comound M284 | BH-1 | 0.141,0.085 | 5.5 | 6.2 | 179 |
| organic light-emitting device 39 | Organic comound M285 | BH-1 | 0.141,0.085 | 5.5 | 6.1 | 170 |
| organic light-emitting device 40 | Organic comound M286 | BH-1 | 0.141,0.086 | 5.5 | 6.4 | 173 |
| organic light-emitting device 41 | Organic comound M287 | BH-1 | 0.141,0.085 | 5.5 | 6.3 | 173 |
| organic light-emitting device 42 | Organic comound M288 | BH-1 | 0.141,0.086 | 5.5 | 6.4 | 175 |
| organic light-emitting device 43 | Organic comound M289 | BH-1 | 0.141,0.087 | 5.5 | 6.3 | 171 |

(continued)

| | Guest | Host | CIE(x,y) | V@1knits[V] | CE@1knits[cd/A] | LT90 @ 1knits[h] |
|---|---|---|---|---|---|---|
| organic light-emitting device 44 | Organic comound M290 | BH-1 | 0.141,0.083 | 5.5 | 6.3 | 175 |
| organic light-emitting device 45 | Organic comound M291 | BH-1 | 0.141,0.086 | 5.5 | 6.4 | 177 |
| organic light-emitting device 46 | Organic comound M292 | BH-1 | 0.141,0.086 | 5.5 | 6.4 | 171 |
| organic light-emitting device 47 | Organic comound M293 | BH-1 | 0.141,0.086 | 5.5 | 6.4 | 171 |
| organic light-emitting device 48 | Organic comound M294 | BH-1 | 0.141,0.083 | 5.5 | 6.3 | 170 |
| organic light-emitting device 49 | Organic comound M295 | BH-1 | 0.141,0.086 | 5.5 | 6.3 | 172 |
| organic light-emitting device 50 | Organic comound M296 | BH-1 | 0.141,0.085 | 5.5 | 6.3 | 175 |
| organic light-emitting device 51 | Organic comound M297 | BH-1 | 0.141,0.085 | 5.5 | 6.4 | 171 |
| organic light-emitting device 52 | Organic comound M298 | BH-1 | 0.141,0.083 | 5.5 | 6.2 | 170 |
| organic light-emitting device 53 | Organic comound M299 | BH-1 | 0.141,0.083 | 5.5 | 6.3 | 171 |
| organic light-emitting device 54 | Organic comound M300 | BH-1 | 0.141,0.083 | 5.5 | 6.2 | 171 |
| organic light-emitting device 55 | Organic comound M301 | BH-1 | 0.141,0.085 | 5.5 | 6.2 | 170 |
| organic light-emitting device 56 | Organic comound M302 | BH-1 | 0.141,0.081 | 5.5 | 5.7 | 131 |
| organic light-emitting device 57 | Organic comound M303 | BH-1 | 0.141,0.085 | 5.5 | 5.8 | 138 |
| organic light-emitting device 58 | Organic comound M304 | BH-1 | 0.141,0.085 | 5.5 | 5.7 | 141 |
| organic light-emitting device 59 | Organic comound M305 | BH-1 | 0.141,0.081 | 5.5 | 6.1 | 171 |

(continued)

| | Guest | Host | CIE(x,y) | V@1knits[V] | CE@1knits[cd/A] | LT90 @ 1knits[h] |
|---|---|---|---|---|---|---|
| organic light-emitting device 60 | Organic comound M306 | BH-1 | 0.141,0.083 | 5.5 | 6.3 | 173 |
| organic light-emitting device 61 | Organic comound M307 | BH-1 | 0.141,0.083 | 5.5 | 6.2 | 175 |
| organic light-emitting device 62 | Organic comound M308 | BH-1 | 0.141,0.083 | 5.5 | 6.4 | 169 |
| organic light-emitting device 63 | Organic comound M309 | BH-1 | 0.141,0.085 | 5.5 | 6.3 | 171 |
| organic light-emitting device 64 | Organic comound M20 | BH-2 | 0.143,0.112 | 5.5 | 5.7 | 145 |
| organic light-emitting device 65 | Organic comound M234 | BH-2 | 0.143,0.108 | 5.5 | 5.6 | 139 |
| organic light-emitting device 66 | Organic comound M20 | BH-3 | 0.143,0.117 | 5.6 | 5.7 | 143 |
| organic light-emitting device 67 | Organic comound M234 | BH-3 | 0.143,0.119 | 5.6 | 5.9 | 138 |
| Comparative device 1 | Comparative compound 1 | BH-1 | 0.152,0.135 | 6.0 | 2.9 | 97 |
| Comparative device 2 | Comparative compound 1 | BH-2 | 0.154,0138 | 5.8 | 2.5 | 85 |
| Comparative device 3 | Comparative compound 1 | BH-3 | 0.157,0167 | 6.0 | 2.6 | 87 |

As can be seen from Table 2, the organic light-emitting devices 1 to 67 according to the present disclosure, which are obtained by applying the guest materials M1 to M309 in the light-emitting layer, have superior color coordinates compared with the comparative devices 1 to 3. Further, the luminous efficiency of each of the organic light-emitting devices 1 to 63 is in a range of 5.7 to 6.6 cd/A, which is much higher than that of the comparative devices 1 to 3. Still further, the time taken from the initial brightness of 1knits to 90% of the initial brightness for the organic light-emitting devices 1 to 67 is in a range of 135 to 179 h, which is extended for 50% to 100% compared with that of the comparative devices 1 to 3, indicating that the organic light-emitting devices 1 to 67 has a significantly improved lifetime.

Compared with Comparative Example 1, the organic compounds M1 to M309 have better entire molecular solubility by the introduction of biphenyl and aromatic rings, and the compounds are therefore readily purified, thereby improving the purity thereof and further improving the efficiency and lifetime of the organic light-emitting device.

In addition, the luminous efficiencies of the organic light-emitting devices 4, 5, 6, 21-55, and 59-63 are in the range of 6.4 to 6.6 cd/A, and the lifetime thereof is around 170 h. This is because the guest materials in these organic light-emitting devices have a greater molecular conjugation than that of other organic light-emitting devices, the arylamine formed from a combination of benzothiophene and biphenyl has a significantly improved lifetime than that of the arylamine formed from a combination of benzothiophene and benzene, and the guest materials in these organic light-emitting devices have more solubilizing groups, which in turn improves the solubility of the guest materials, thereby improves the luminous efficiency and lifetime of these organic light-emitting devices.

According to the embodiment of the present embodiment, the organic light-emitting devices employ the boron-nitrogen compound, in which an arylamine group containing biphenyl and benzothiophene that may allow the overall compound conjugation to be greater is introduced, thereby improving the material performance, improving the luminous efficiency of the organic light-emitting device, and prolonging the lifetime of the organic light-emitting device.

An embodiment of the present disclosure further discloses a display panel including any one of the organic light-emitting devices as described above.

The display panel further includes an array substrate located on a side of the organic light-emitting device, and an encapsulation layer on a side of the organic light-emitting device away from the array substrate and covering the organic light-emitting device. The display panel further includes a polarizer layer on a side of the encapsulation layer away from the organic light-emitting device, and a cover layer on a side of the polarizer layer away from the organic light-emitting device. The polarizer layer may be replaced with a color film layer, and the color film layer may include a plurality of color resistors and black matrixes located on two sides of the color resistors.

According to the embodiment of the present disclosure, the display panel employs the organic light-emitting device containing the boron-nitrogen compound, in which a group that allows the overall compound conjugation to be greater is introduced, thereby enhancing the conjugation effect of a material applied to the organic light-emitting device, improving the material performance, improving the luminous efficiency of the display panel, and prolonging the lifetime of the display panel.

An embodiment of the present disclosure provides an organic compound having a structure as shown in general formula (1) or (2), an organic light-emitting device , and a display panel.

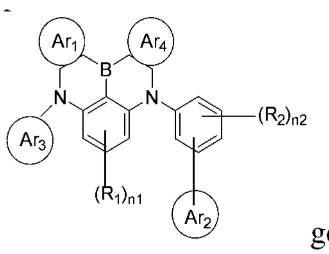
general formula (1)
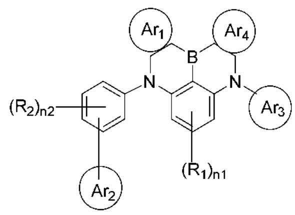
general formula (2)

According to the present disclosure, a group that allows the overall compound conjugation to be greater is introduced in the boron-nitrogen compound, so as to improve the material performance, improve the luminous efficiency of the organic light-emitting device, and prolong the lifetime of the organic light-emitting device.

It is to be appreciated by those of ordinary skill in the art that equivalent substitutions or variations can be made in accordance with the technical solutions of the present disclosure and its inventive concept, and all such variations or substitutions shall fall within the scope of the claims appended hereto.

## Claims

**1.** An organic compound having a structure represented by a general formula (1) or (2):

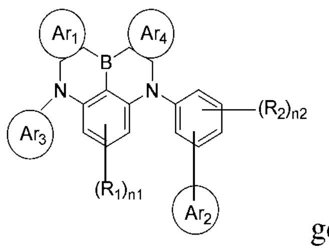
general formula (1)
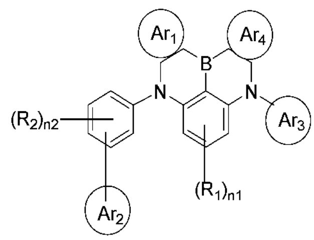
general formula (2),

wherein $Ar_1$ is independently a structure represented by any one selected from the group consisting of formulae (X-1) to (X-3):

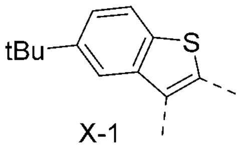
X-1
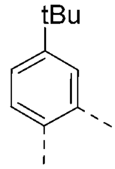
X-2
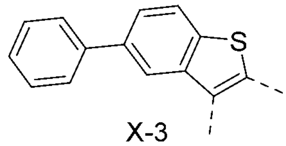
X-3
,

$Ar_3$ and $Ar_4$ are each independently a structure represented by any one selected from the group consisting of formulae (A-1) to (A-5):

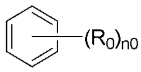
(A-1)
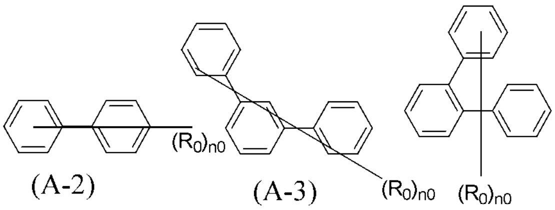
(A-2) (A-3) (A-4)
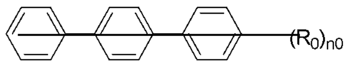
(A-5)
,

when $Ar_1$ is formula X-2, $Ar_4$ is independently a structure represented by any one selected from the group consisting of formulae (A-2) to (A-5),
A linkage site of $Ar_3$ is at a carbon atom of any phenyl ring in $Ar_3$, and fused sites of $Ar_4$ are at two ortho carbon atoms of a same phenyl ring in $Ar_4$,
$Ar_2$ is a structure represented by any one selected from the group consisting of formulae (B-1) to (B-4):

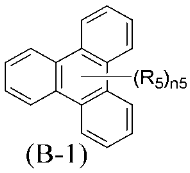
(B-1)
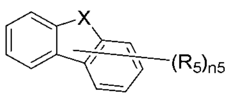
(B-2)
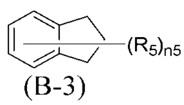
(B-3)
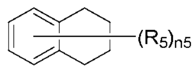
(B-4)
,

X is each independently selected from the group consisting of O, S, N-$CH_3$, N-Ph, and $C(CH_3)_2$;
$n_0$, $n_1$, $n_2$, and $n_5$ are each independently a positive integer selected from the group consisting of 0 to 14;
$R_0$, $R_1$, $R_2$, and $R_5$ are each independently selected from the group consisting of -H, -D, a linear alkyl group having 1 to 20 carbon atoms, a linear alkoxy group having 1 to 20 carbon atoms, a linear thioalkoxy group having 1 to 20 carbon atoms, a branched alkyl group having 3 to 20 carbon atoms, a cyclic alkyl group having 3 to 20 carbon atoms, a branched alkoxy group having 3 to 20 carbon atoms, a cyclic alkoxy group having 3 to 20 carbon atoms, a branched thioalkoxy group having 3 to 20 carbon atoms, a cyclic thioalkoxy group having 3 to 20 carbon atoms, a silyl group, a ketone group having 1 to 20 carbon atoms, an alkoxycarbonyl group having 2 to 20 carbon atoms, an aryloxycarbonyl group having 7 to 20 carbon atoms, an alkylene group having 1 to 20 carbon atoms, -CN, a carbamoyl group, a haloformyl group, a formyl group, an isocyano group, an isocyanate group, a thiocyanate group, an isothiocyanate group, a hydroxyl group, a nitro group, -$CF_3$, -Cl, -Br, -F, a substituted or unsubstituted aromatic group having 6 to 30 ring atoms, a substituted or unsubstituted heteroaromatic group having 5 to 30 ring atoms, a substituted or unsubstituted aryloxy group having 6 to 30 ring atoms, and a substituted or unsubstituted heteroaryloxy group having 5 to 30 ring atoms; and
when $n_0$ is greater than or equal to 2, two adjacent $R_0$ radicals form a ring or do not form a ring with each other, when $n_1$ is greater than or equal to 2, two adjacent $R_1$ radicals form a ring or do not form a ring with each other; when $n_2$ is greater than or equal to 2, two adjacent $R_2$ radicals form a ring or do not form a ring with each other; and when $n_5$ is greater than or equal to 2, two adjacent $R_5$ radicals form a ring or do not form a ring with each other.

**2.** The organic compound according to claim 1, wherein the organic compound has a structure represented by any one of general formulae (2-1) to (2-28):

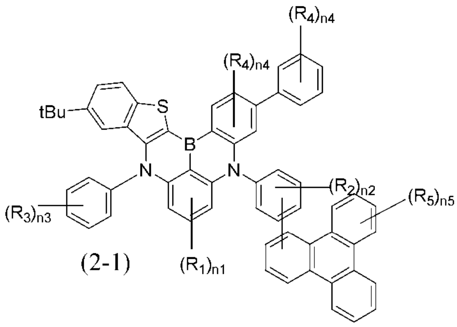
(2-1)

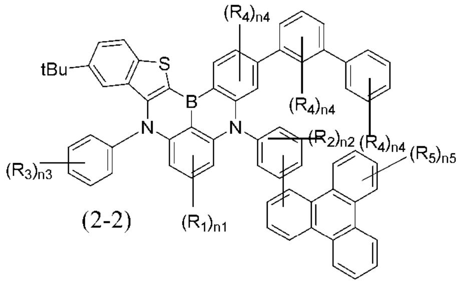
(2-2)

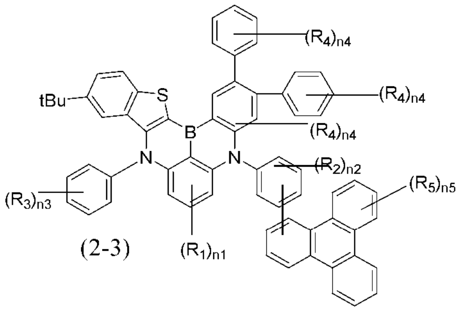
(2-3)

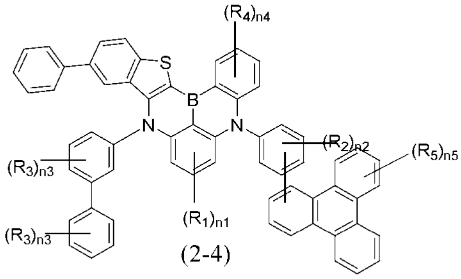
(2-4)

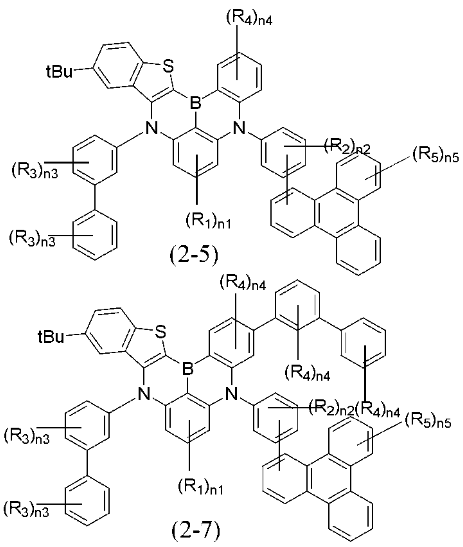
(2-5)

(2-7)

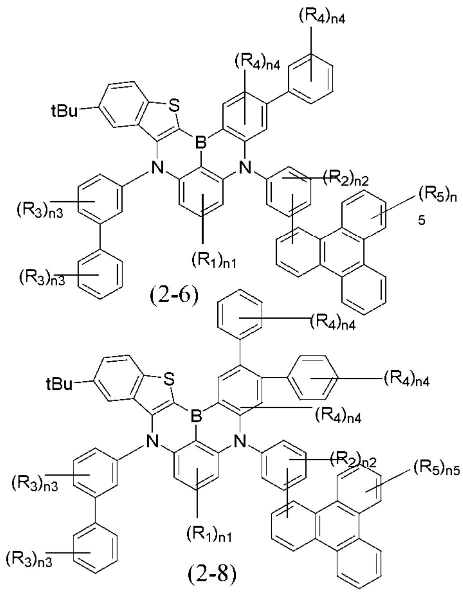
(2-6)

(2-8)

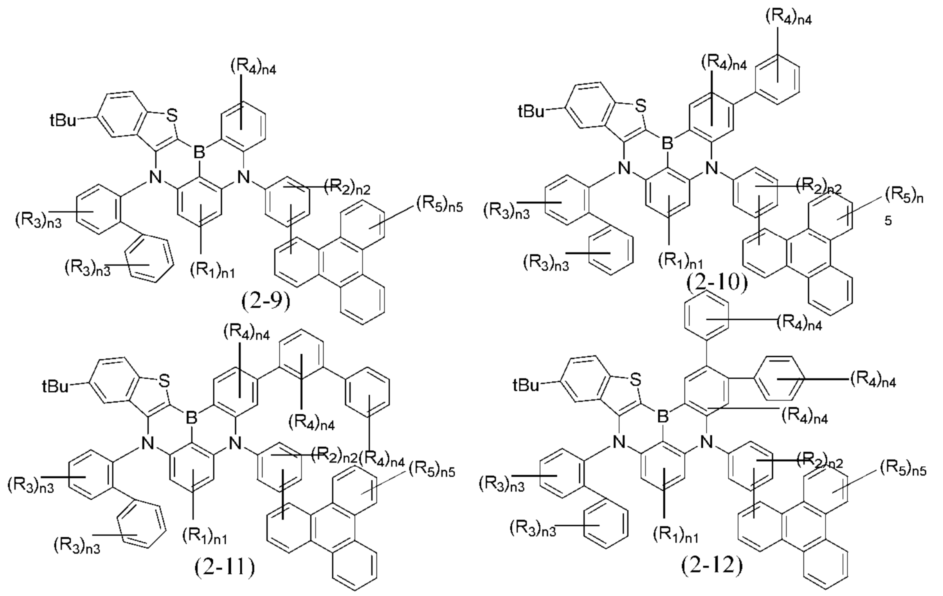

(2-9) (2-10) (2-11) (2-12)

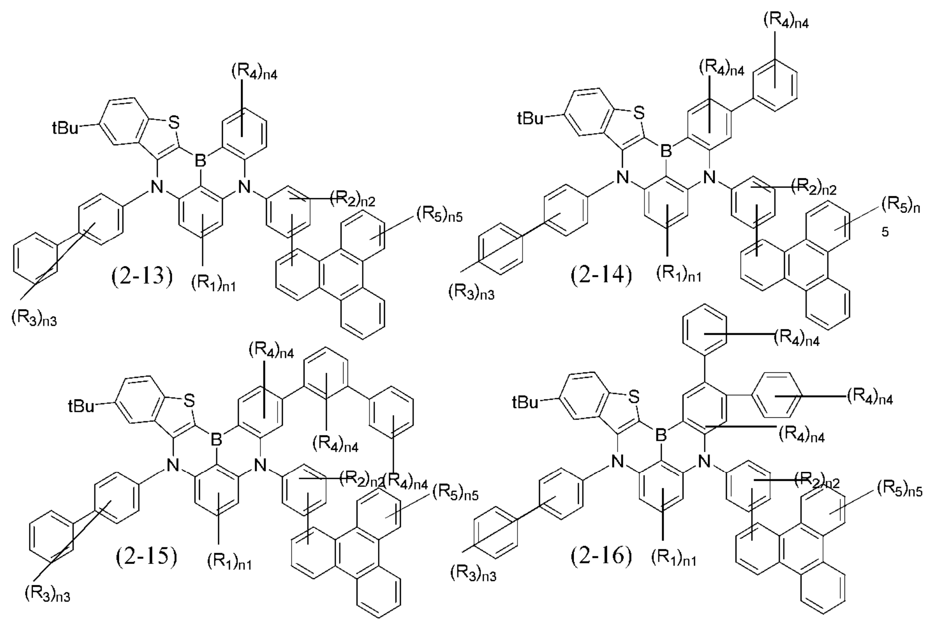

(2-13) (2-14) (2-15) (2-16)

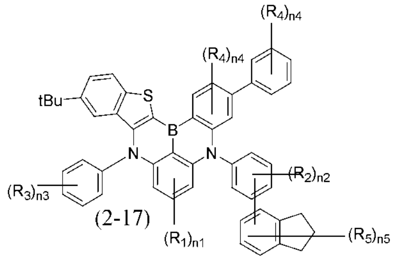

(2-17)

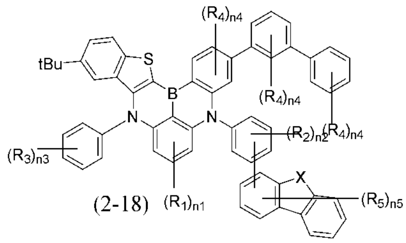

(2-18)

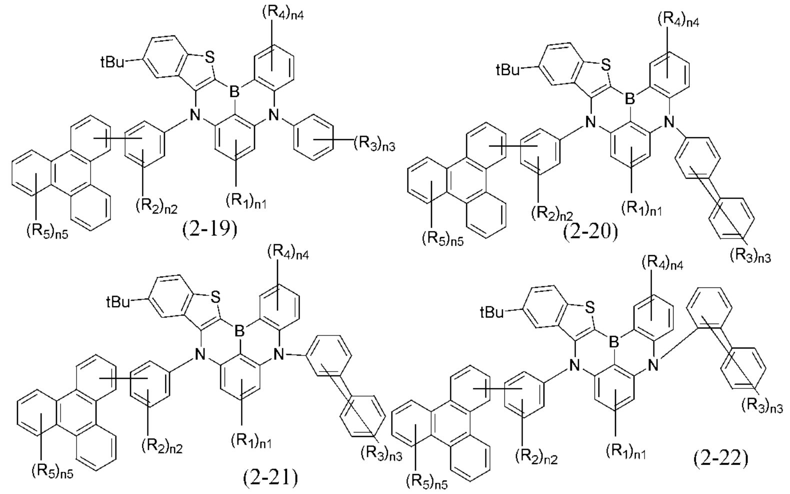

(2-19) (2-20) (2-21) (2-22)

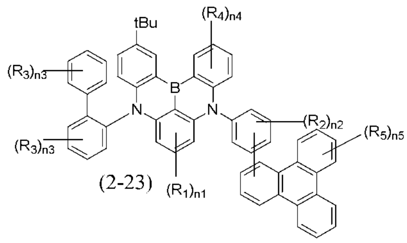

(2-23)

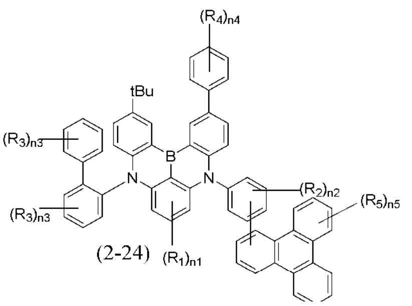

(2-24)

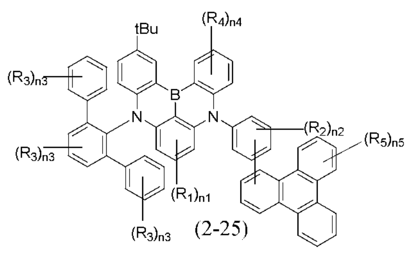

(2-25)

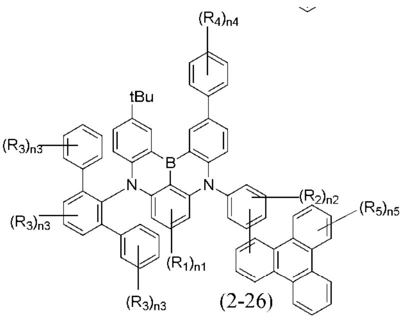

(2-26)

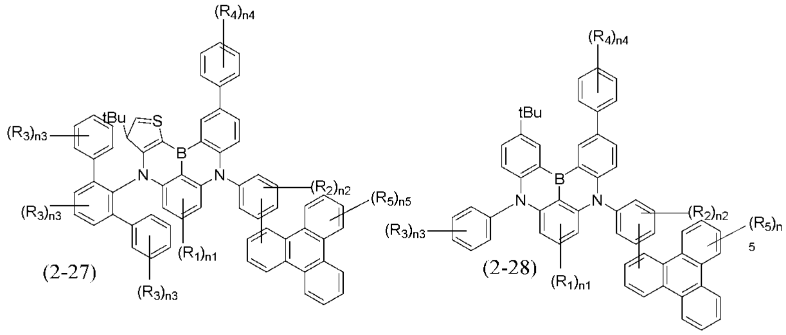

(2-27) (2-28) ,

$R_3$ and $R_4$ are each independently selected from the group consisting of -H, -D, a linear alkyl group having 1 to 20 carbon atoms, a linear alkoxy group having 1 to 20 carbon atoms, a linear thioalkoxy group having 1 to 20 carbon atoms, a branched alkyl group having 3 to 20 carbon atoms, a cyclic alkyl group having 3 to 20 carbon atoms, a branched alkoxy group having 3 to 20 carbon atoms, a cyclic alkoxy group having 3 to 20 carbon atoms, a branched thioalkoxy group having 3 to 20 carbon atoms, a cyclic thioalkoxy group having 3 to 20 carbon atoms, a silyl group, a ketone group having 1 to 20 carbon atoms, an alkoxycarbonyl group having 2 to 20 carbon atoms, an aryloxycarbonyl group having 7 to 20 carbon atoms, an alkylene group having 1 to 20 carbon atoms, -CN, a carbamoyl group, a haloformyl group, a formyl group, an isocyano group, an isocyanate group, a thiocyanate group, an isothiocyanate group, a hydroxyl group, a nitro group, - $CF_3$, -Cl, -Br, -F, a substituted or unsubstituted aromatic group having 6 to 30 ring atoms, a substituted or unsubstituted heteroaromatic group having 5 to 30 ring atoms, a substituted or unsubstituted aryloxy group having 6 to 30 ring atoms, and a substituted or unsubstituted heteroaryloxy group having 5 to 30 ring atoms;

$n_3$ is greater than or equal to 0 and less than or equal to 5;

when $n_3$ is greater than or equal to 2, two adjacent $R_3$ radicals form a ring or do not form a ring with each other;

$n_4$ is greater than or equal to 0 and less than or equal to 5;

when $n_4$ is greater than or equal to 2, two adjacent $R_4$ radicals form a ring or do not form a ring with each other.

**3.** The organic compound according to claim 2, wherein any one of $R_1$, $R_2$, $R_3$, $R_4$, or $R_5$ is independently selected from the group consisting of -H, -D, a linear alkyl group having 1 to 10 carbon atoms, a branched alkyl group having 3 to 10 carbon atoms, and a cyclic alkyl group having 3 to 10 carbon atoms.

**4.** The organic compound according to claim 3, wherein any one of $R_1$, $R_2$, $R_3$, $R_4$, or $R_5$ is independently selected from the group consisting of -H, -D, a linear alkyl group having 1 to 4 carbon atoms, and a branched alkyl group having 3 to 5 carbon atoms.

**5.** The organic compound according to claim 1, wherein when $Ar_2$ is the structure represented by the formula (B-2), the structure represented by the formula (B-2) is at least one selected from the group consisting of:

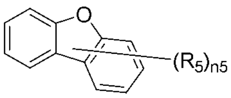 , 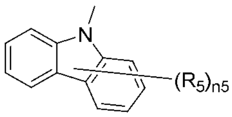 , and 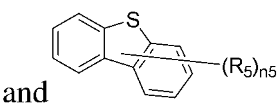 .

**6.** The organic compound according to claim 1, wherein the organic compound is a blue light-emitting material.

**7.** The organic compound according to claim 1, wherein the organic compound is selected from the group consisting of the following compounds:

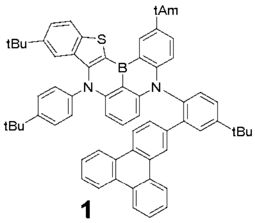
1

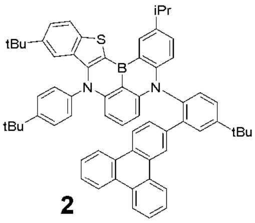
2

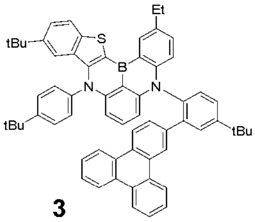
3

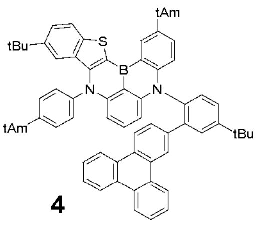
4

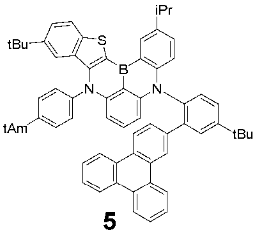
5

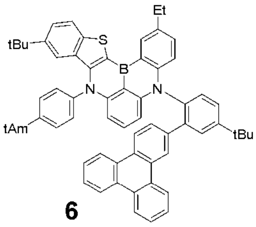
6

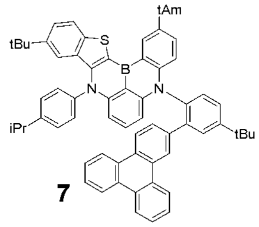
7

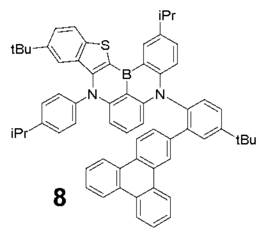
8

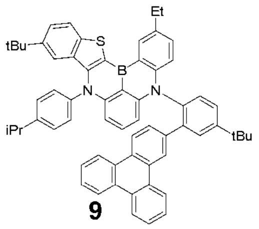
9

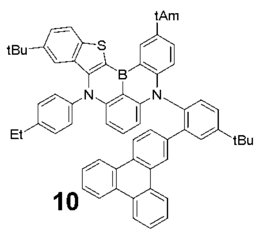
10

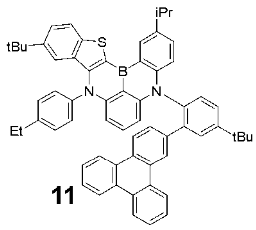
11

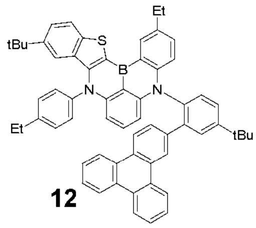
12

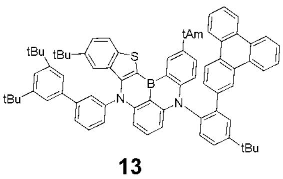
13

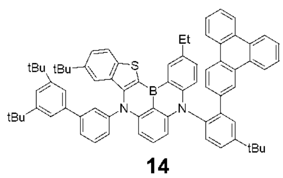
14

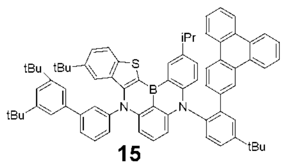
15

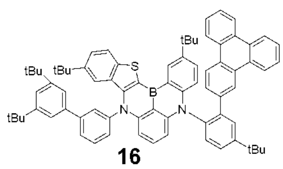
16

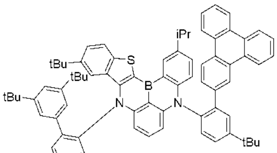
17

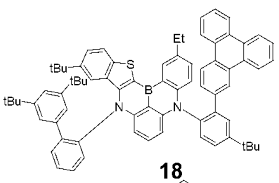
18

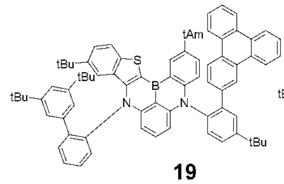
19

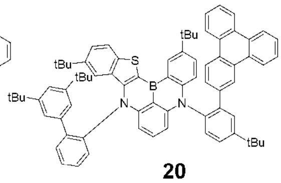
20

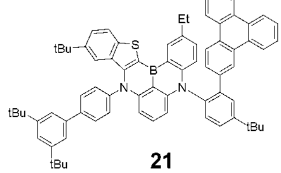
21

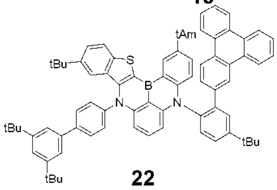
22

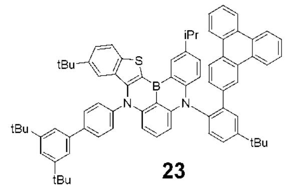
23

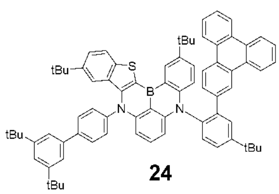
24

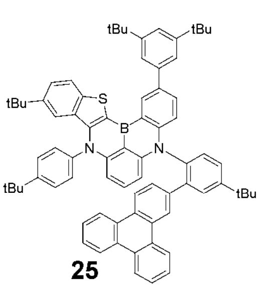
25

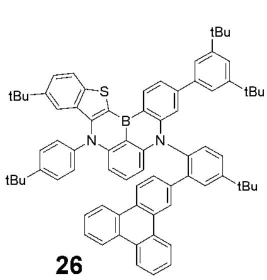
26

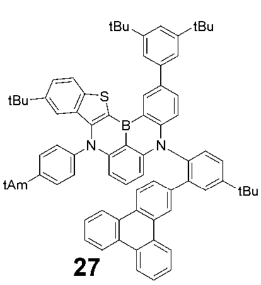
27

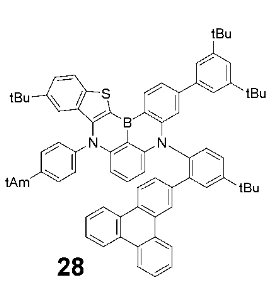
28

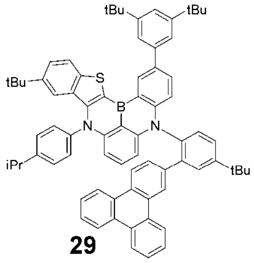
29

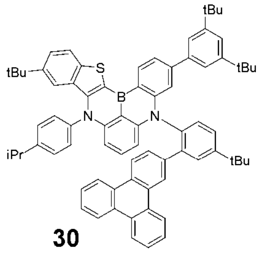
30

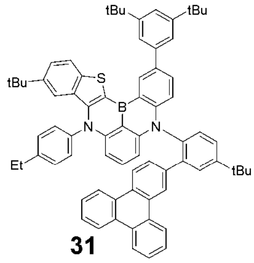
31

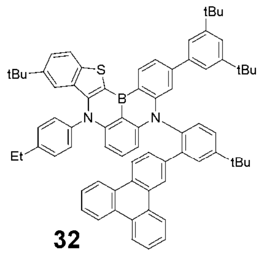
32

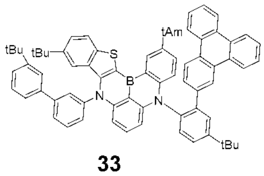
33

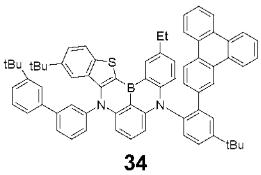
34

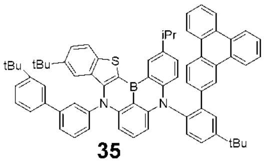
35

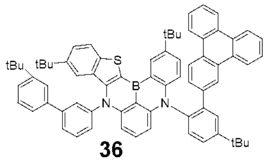
36

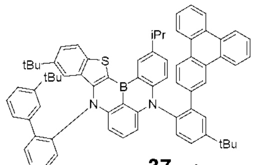
37

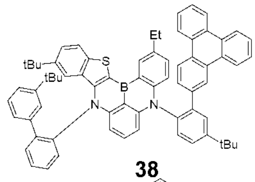
38

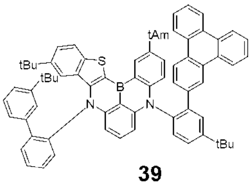
39

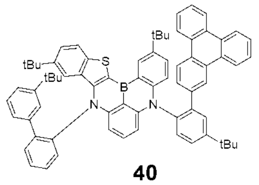
40

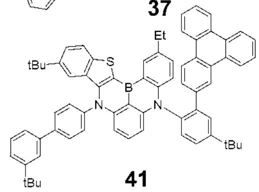
41

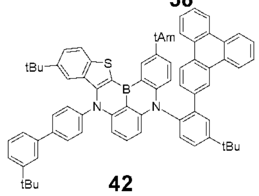
42

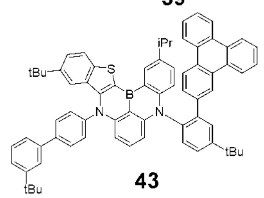
43

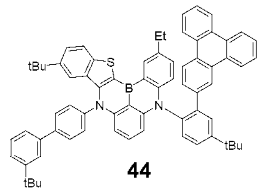
44

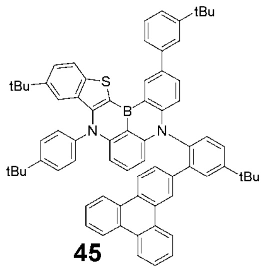
45

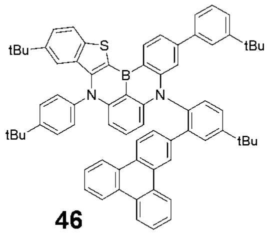
46

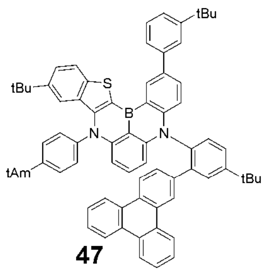
47

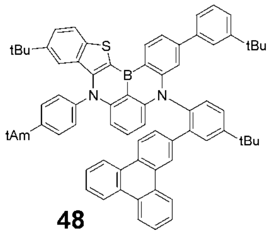
48

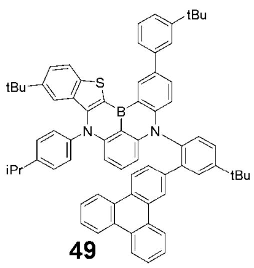
49

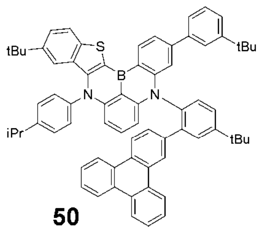
50

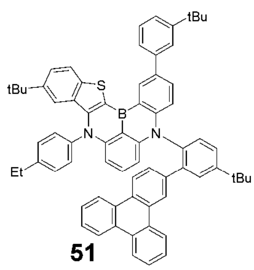
51

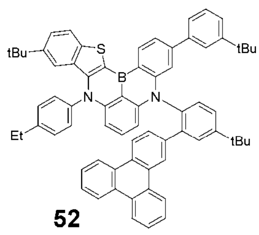
52

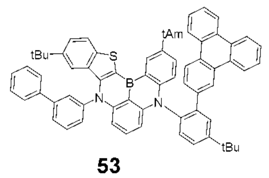
53

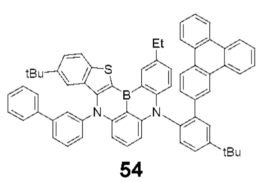
54

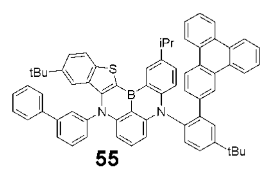
55

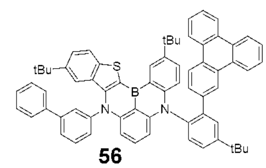
56

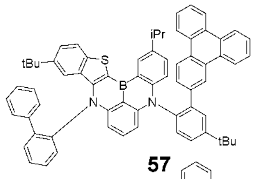
57

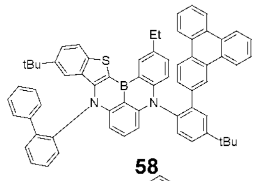
58

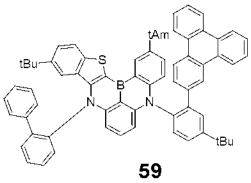
59

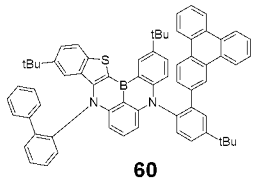
60

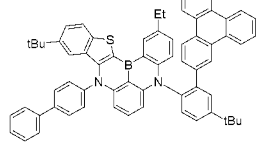
61

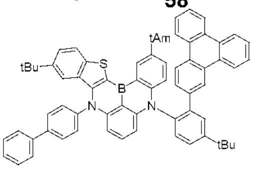
62

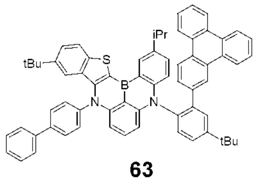
63

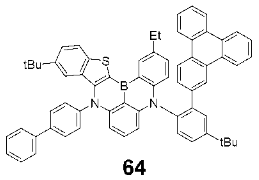
64

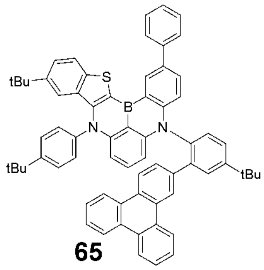
65

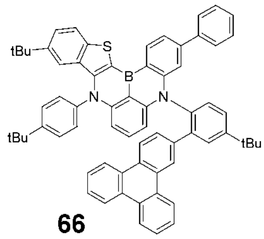
66

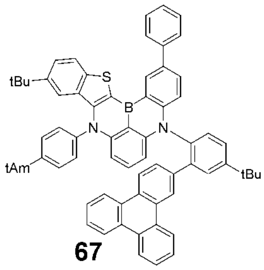
67

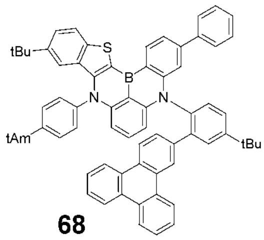
68

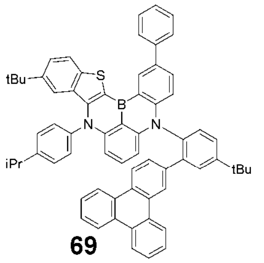
69

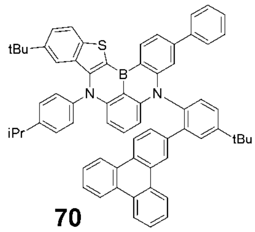
70

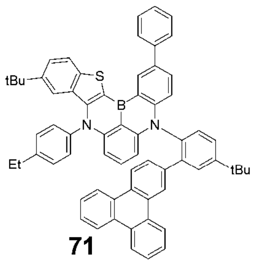
71

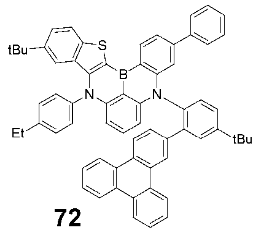
72

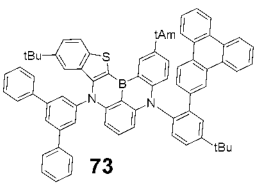
73

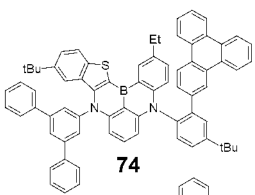
74

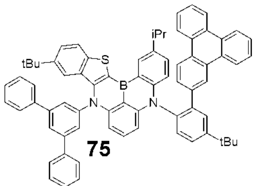
75

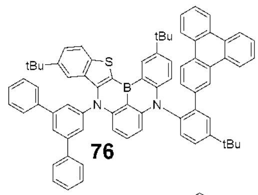
76

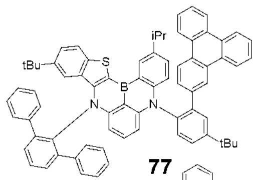
77

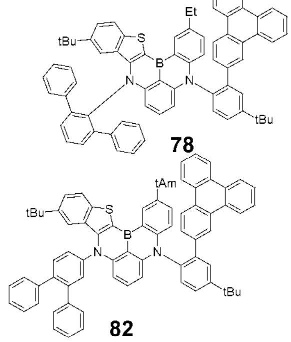
78

82

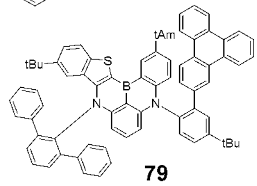
79

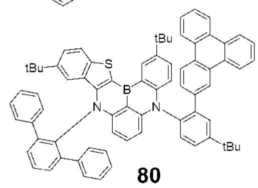
80

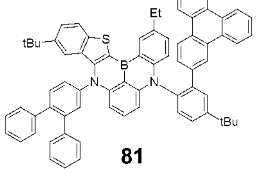
81

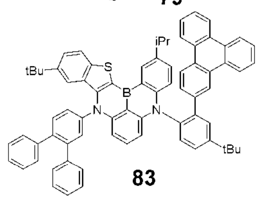
83

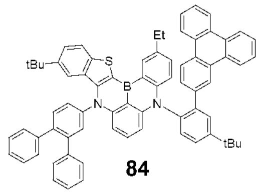
84

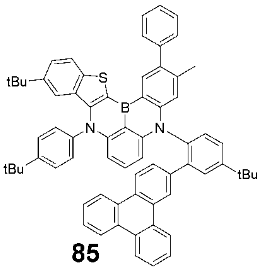
85

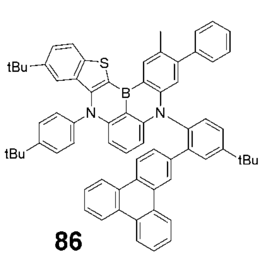
86

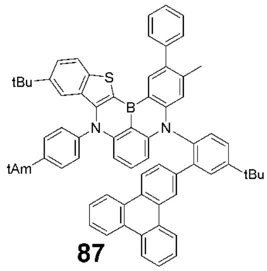
87

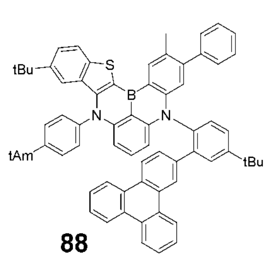
88

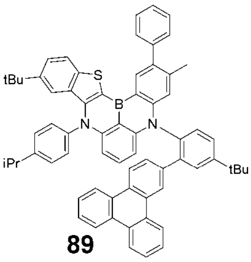
89

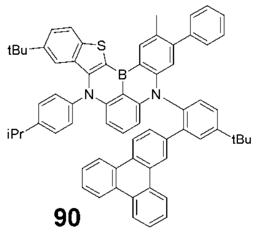
90

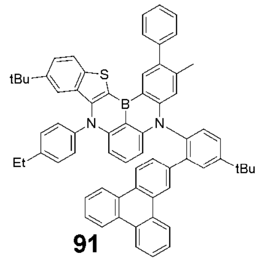
91

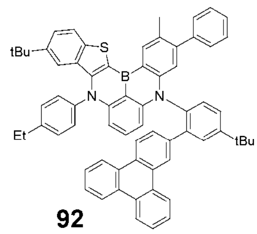
92

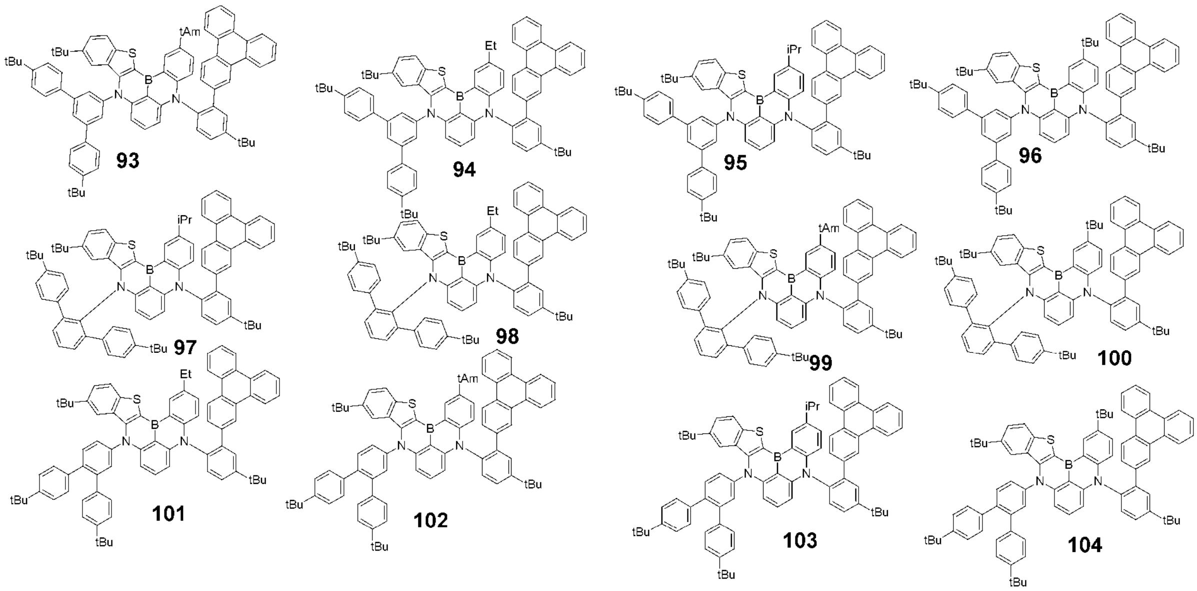
93

94

95

96

97

98

99

100

101

102

103

104

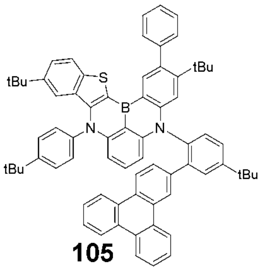
105

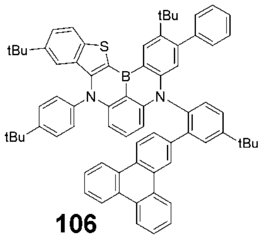
106

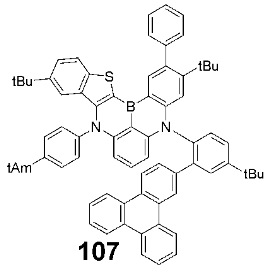
107

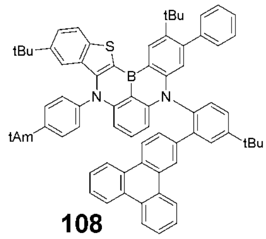
108

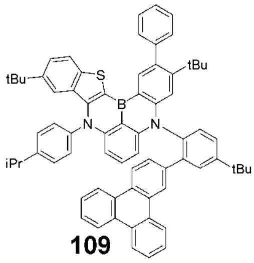
109

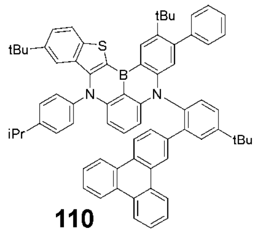
110

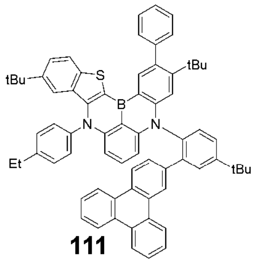
111

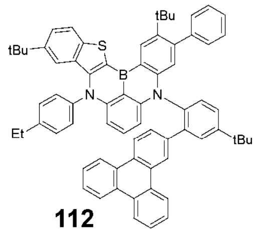
112

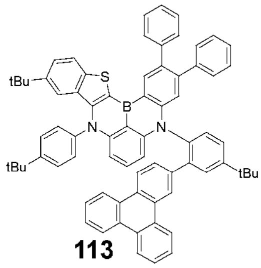
113

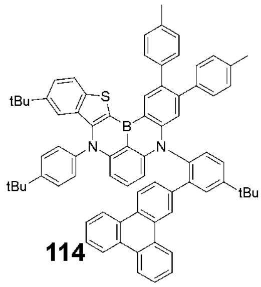
114

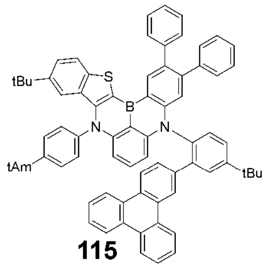
115

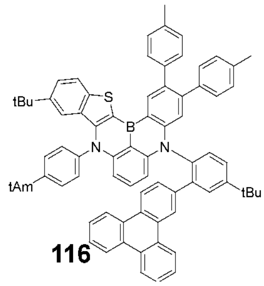
116

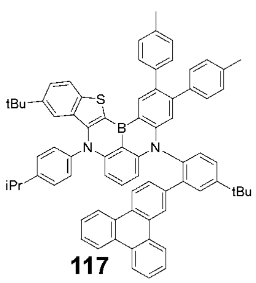
117

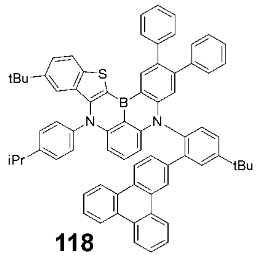
118

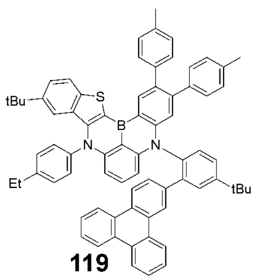
119

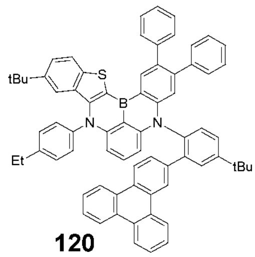
120

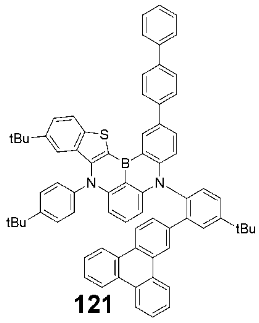
121

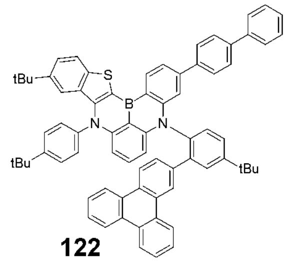
122

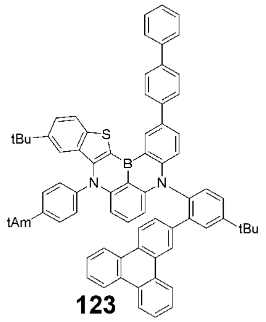
123

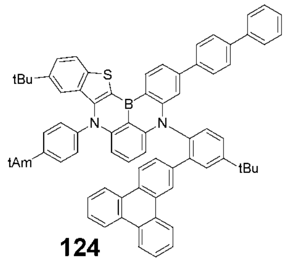
124

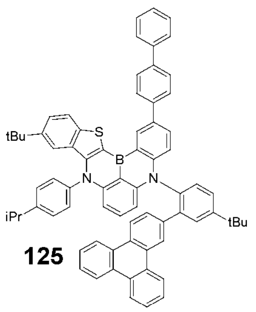
125

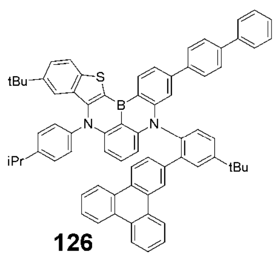
126

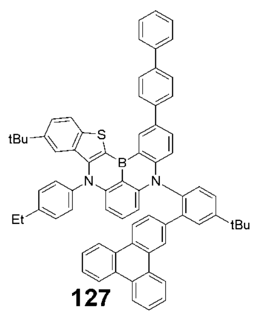
127

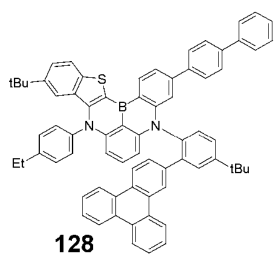
128

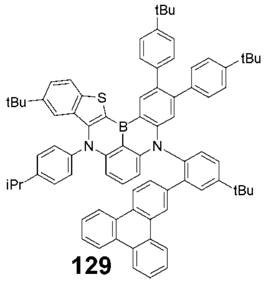
129

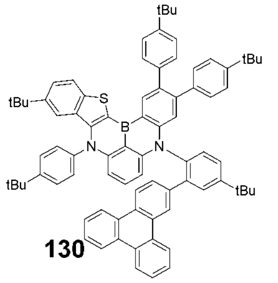
130

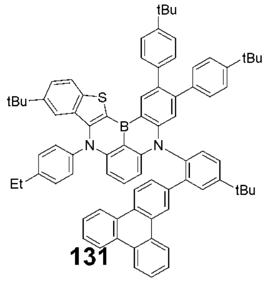
131

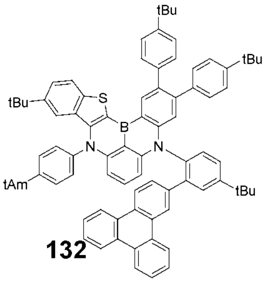
132

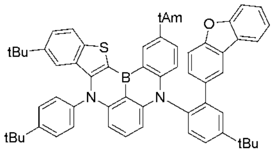
133

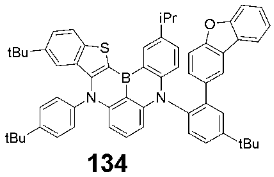
134

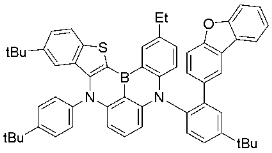
135

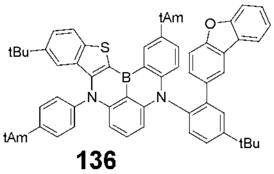
136

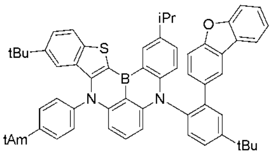
137

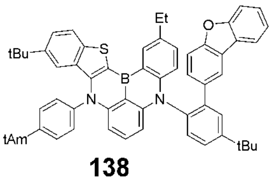
138

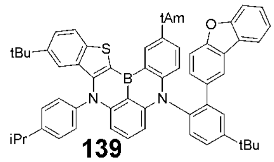
139

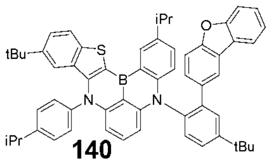
140

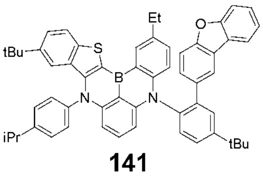
141

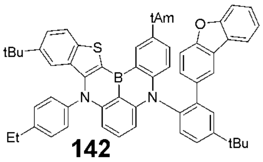
142

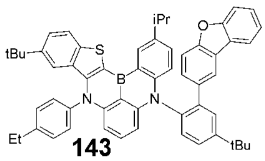
143

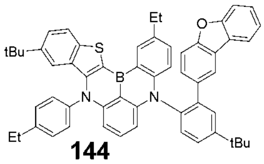
144

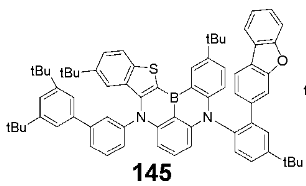
145

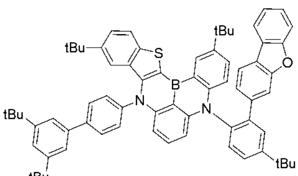
146

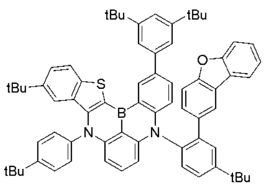
147

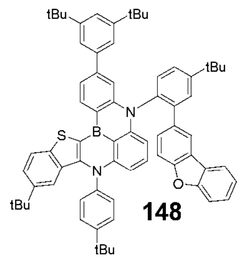
148

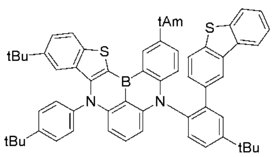
149

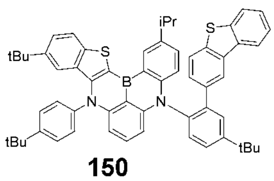
150

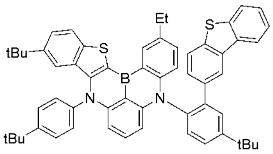
151

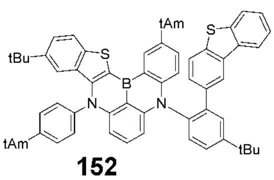
152

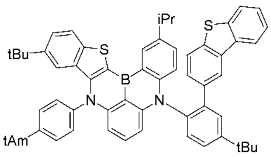
153

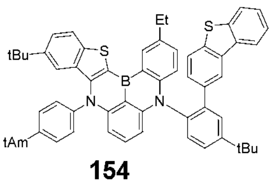
154

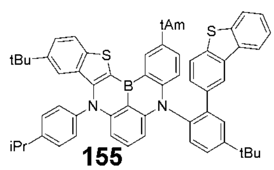
155

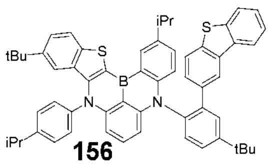
156

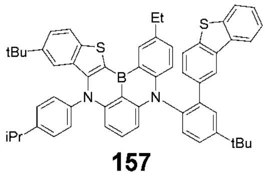
**157**

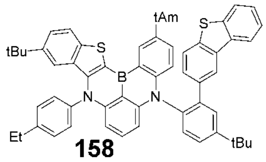
**158**

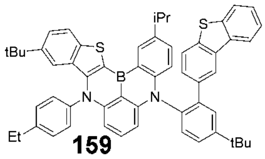
**159**

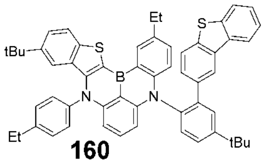
**160**

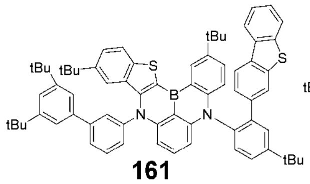
**161**

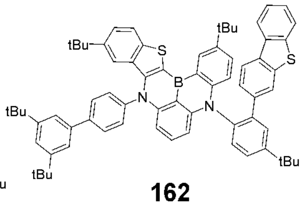
**162**

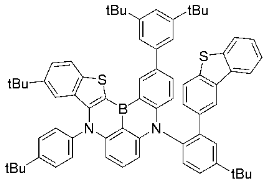
**163**

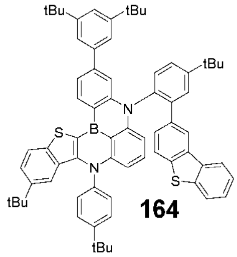
**164**

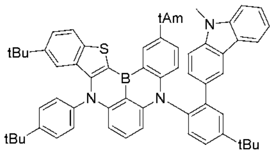
**165**

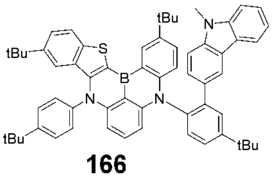
**166**

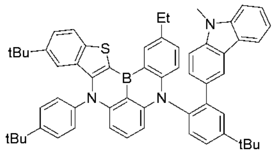
**167**

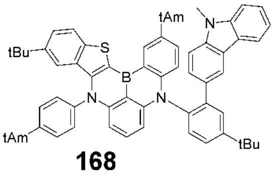
**168**

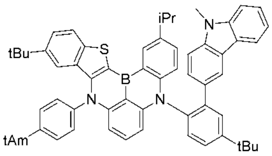
**169**

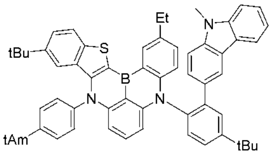
**170**

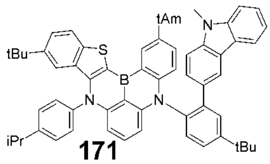
**171**

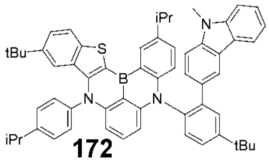
**172**

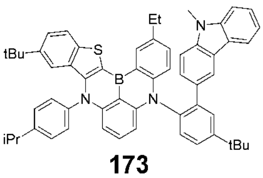
**173**

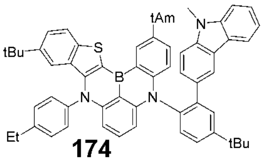
**174**

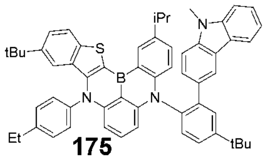
**175**

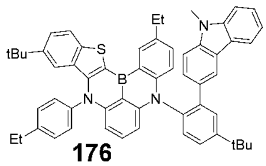
**176**

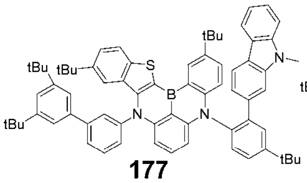
**177**

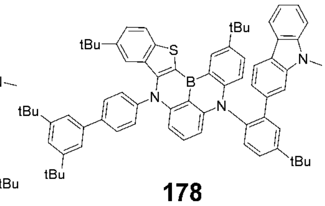
**178**

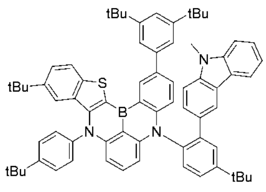
**179**

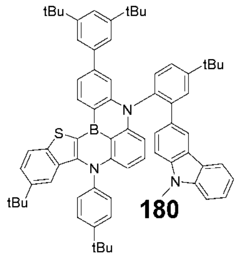
**180**

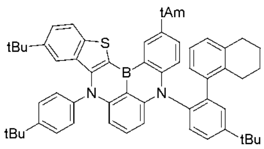
**181**

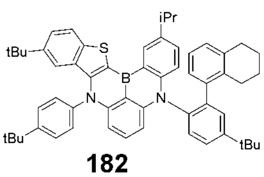
**182**

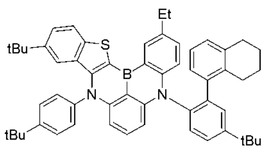
**183**

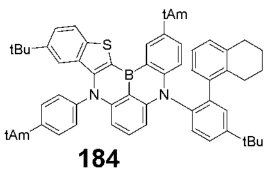
**184**

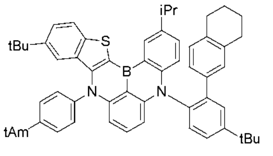
185
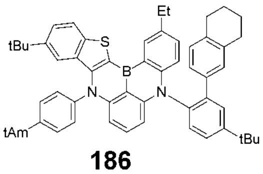
186
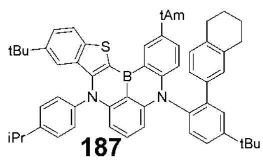
187
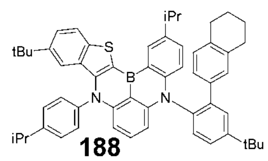
188

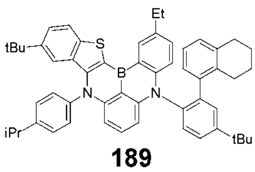
189
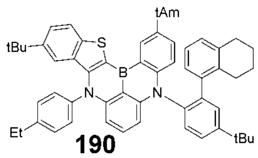
190
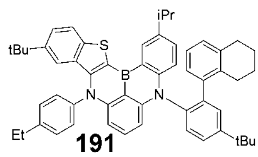
191
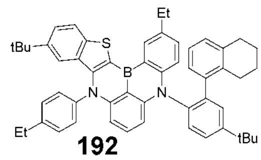
192

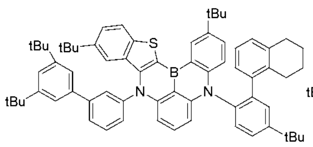
193
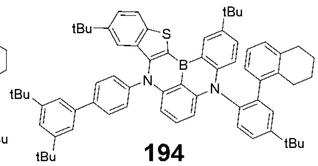
194
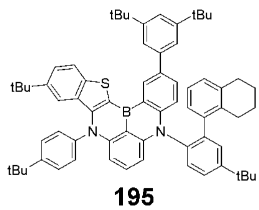
195
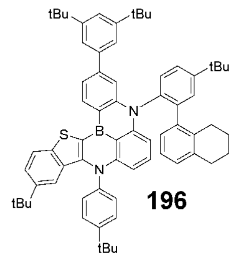
196

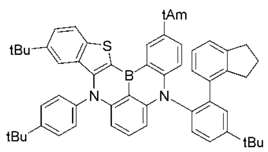
197
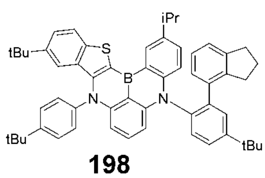
198
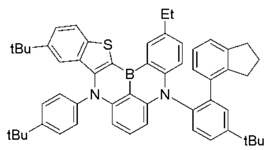
199
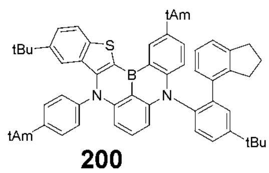
200

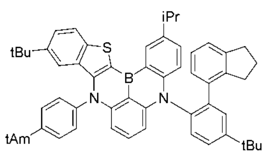
201
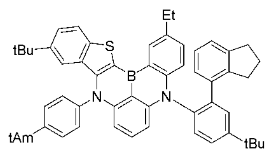
202
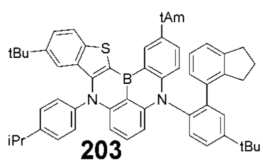
203
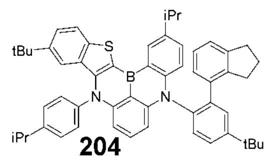
204

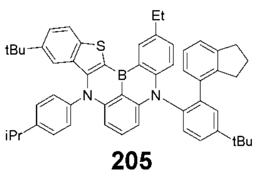
205
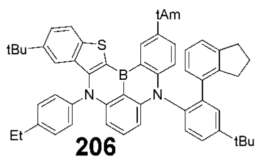
206
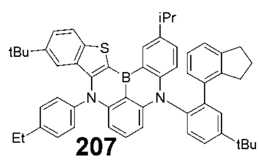
207
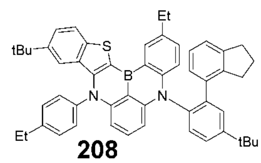
208

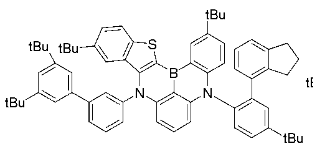
209
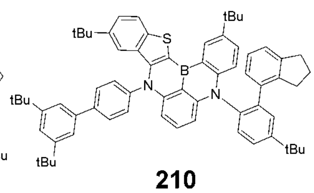
210
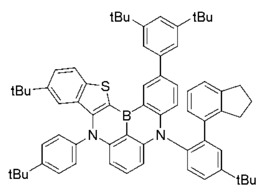
211
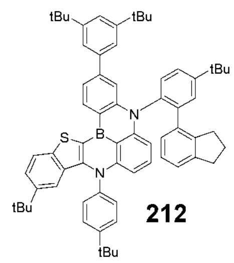
212

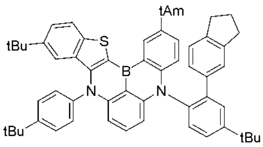
213
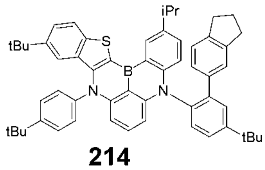
214
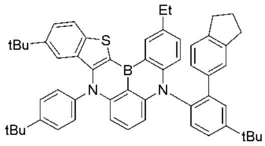
215
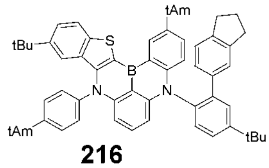
216

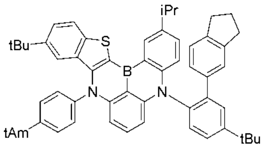
217
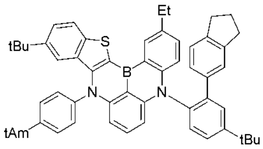
218
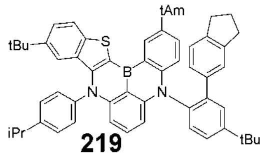
219
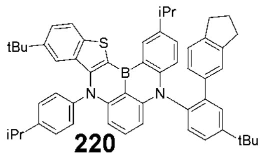
220

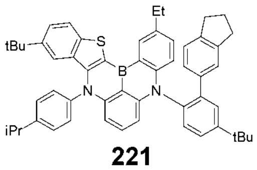
221
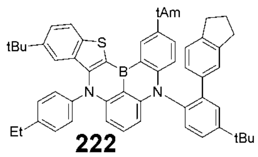
222
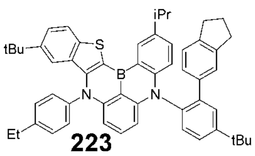
223
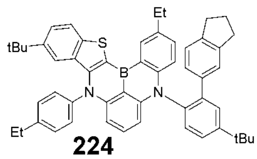
224

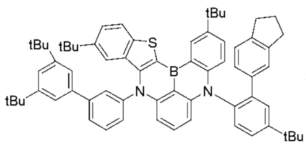
225
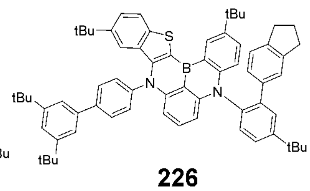
226
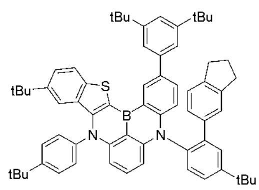
227
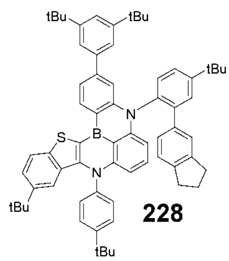
228

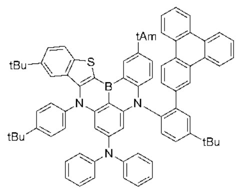
229
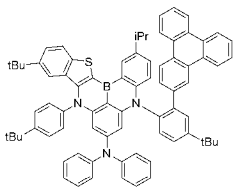
230
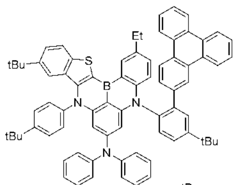
231
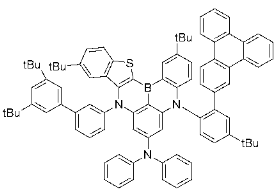
232

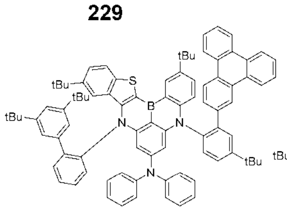
233
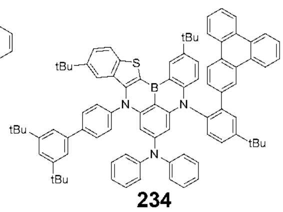
234
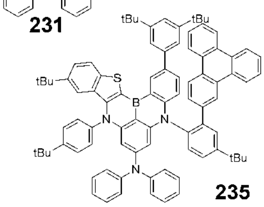
235
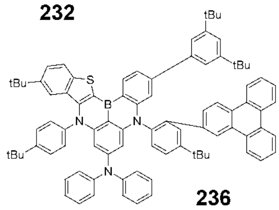
236

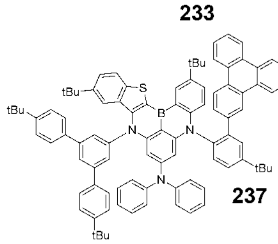
237
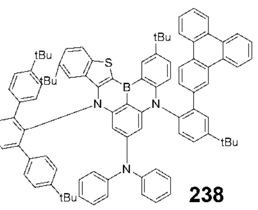
238
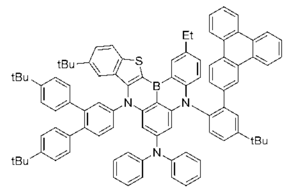
239
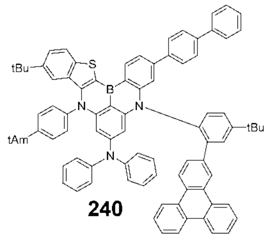
240

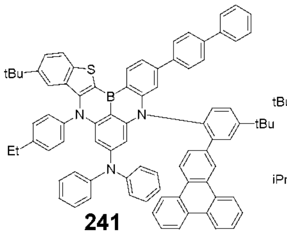
241

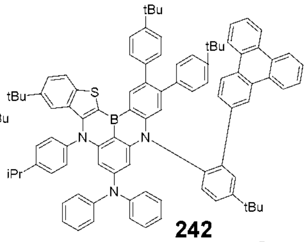
242

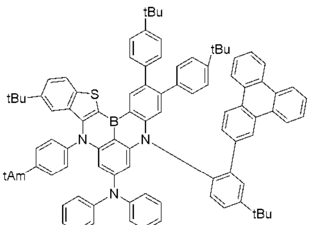
243

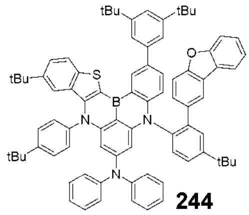
244

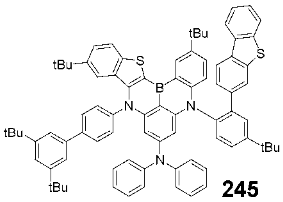
245

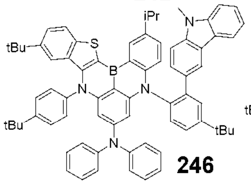
246

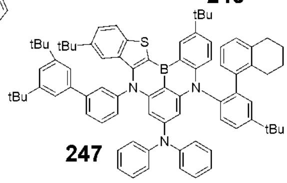
247

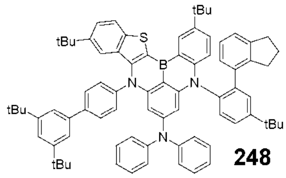
248

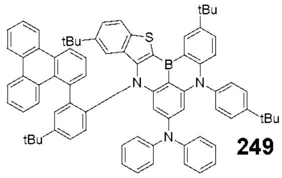
249

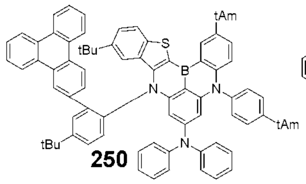
250

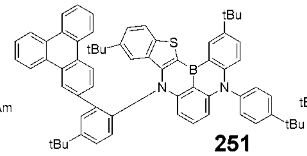
251

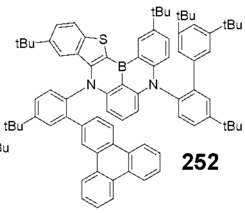
252

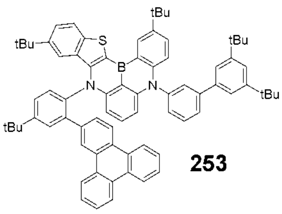
253

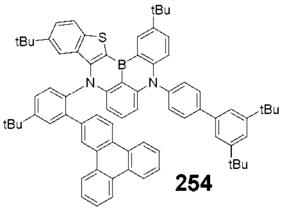
254

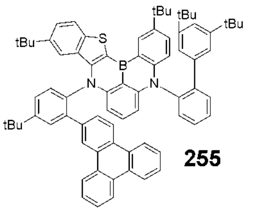
255

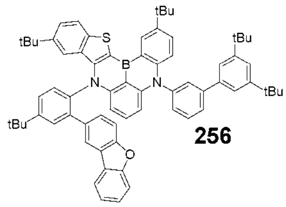
256

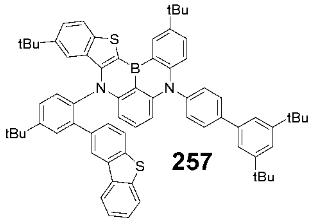
257

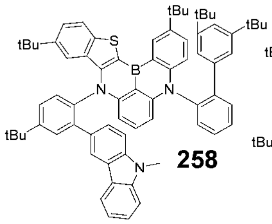
258

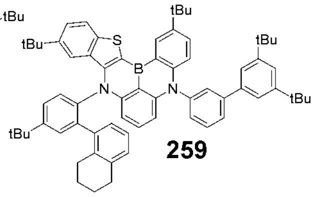
259

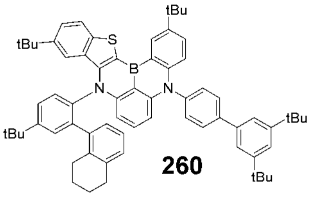
260

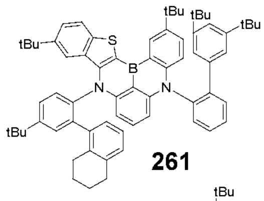
261

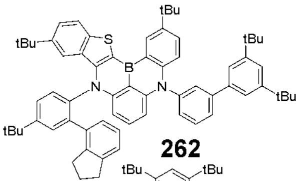
262

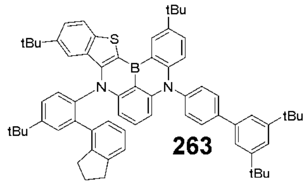
263

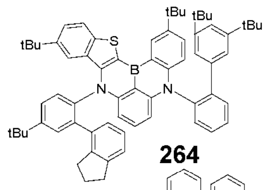
264

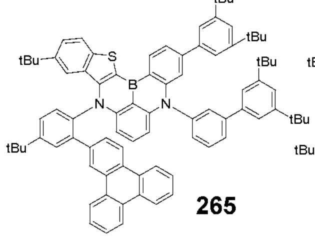
265

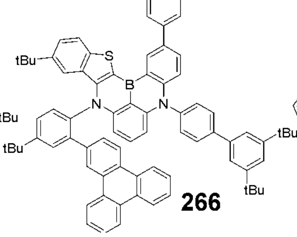
266

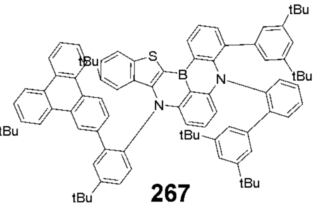
267

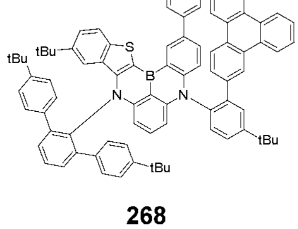
268

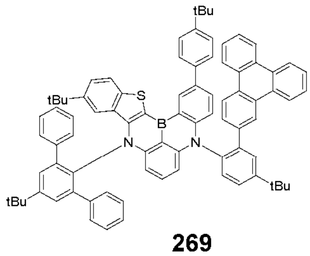

269

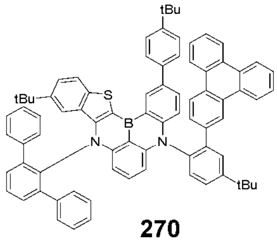

270

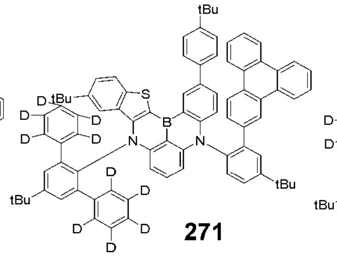

271

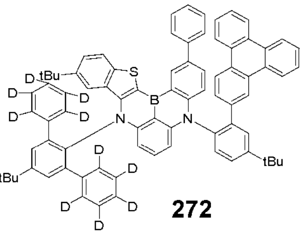

272

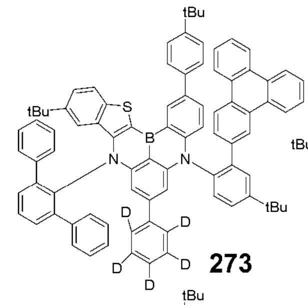

273

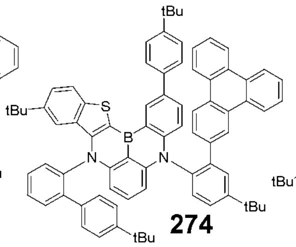

274

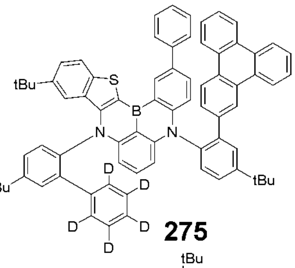

275

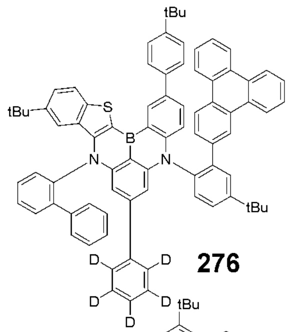

276

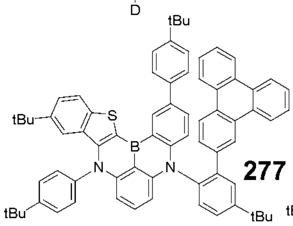

277

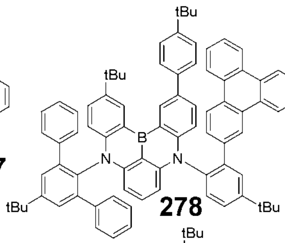

278

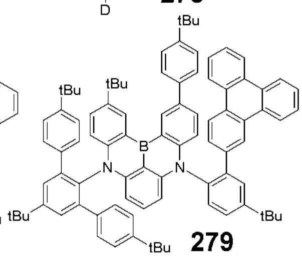

279

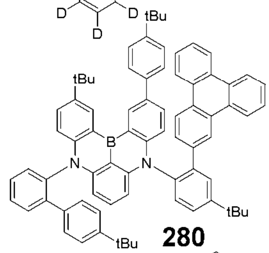

280

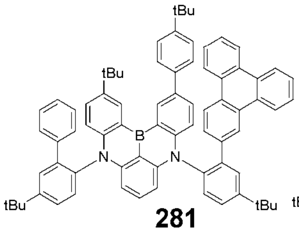

281

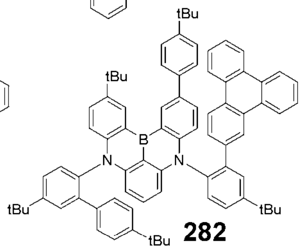

282

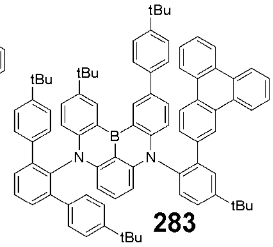

283

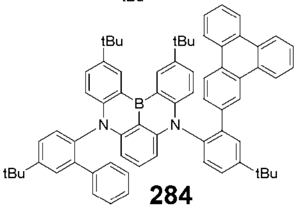

284

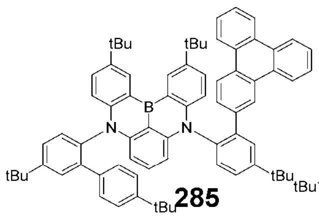

285

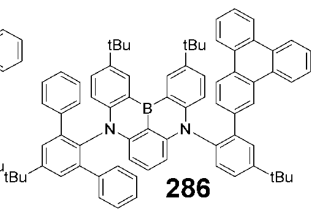

286

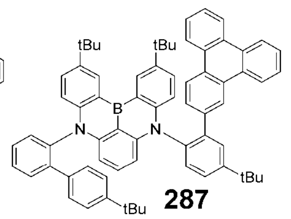

287

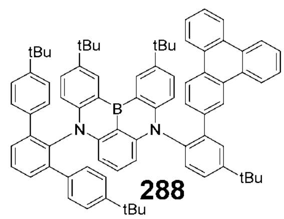

288

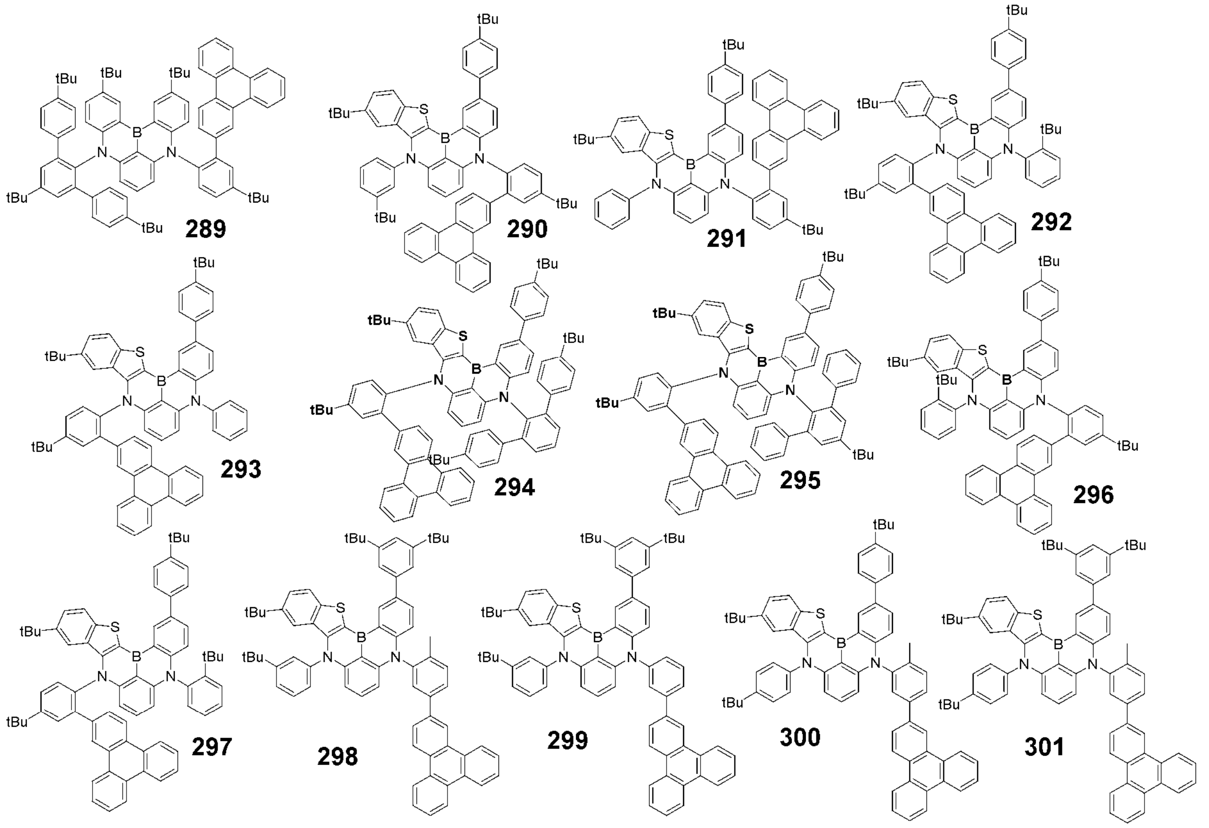

289 290 291 292 293 294 295 296 297 298 299 300 301

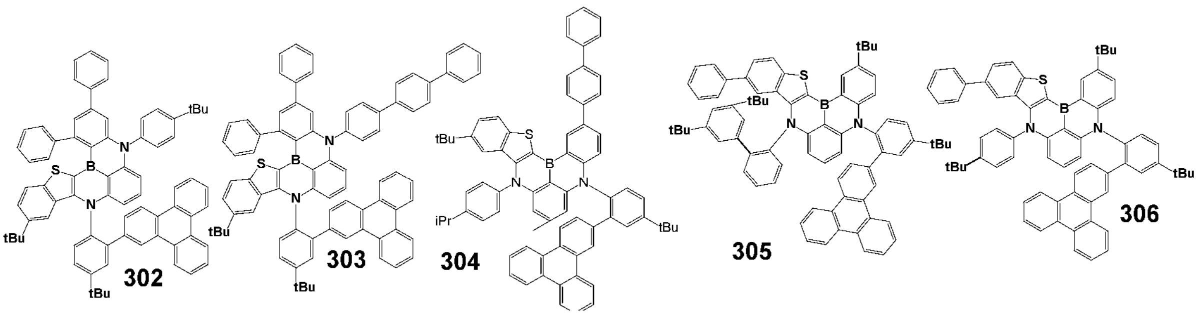

302 303 304 305 306

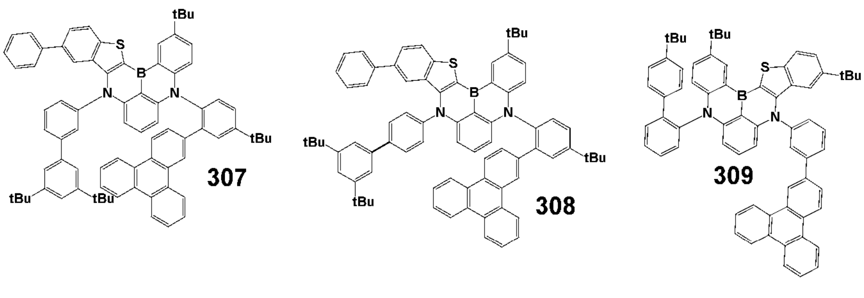

307 308 309

8. A mixture comprising an organic compound and at least one organic functional material, the organic functional material being selected from a hole injection material, a hole transport material, an electron transport material, an electron injection material, an electron blocking material, a hole blocking material, a light-emitting material, a host material, or an organic dye,

wherein the organic compound has a structure represented by a general formula (1) or (2):

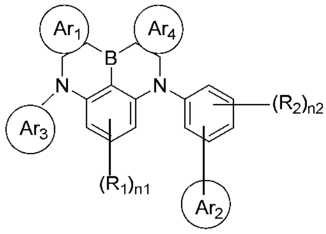
general formula (1)
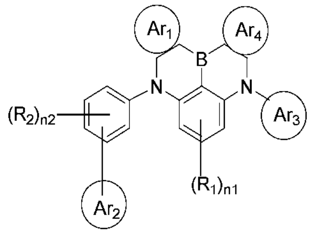
general formula (2),

$Ar_1$ is independently a structure represented by any one selected from the group consisting of formulae (X-1) to (X-3):

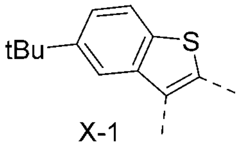
X-1
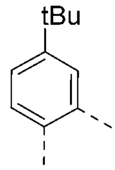
X-2
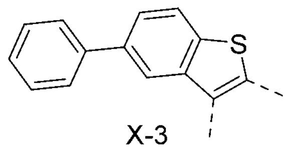
X-3
,

$Ar_3$ and $Ar_4$ are each independently a structure represented by any one selected from the group consisting of formulae (A-1) to (A-5):

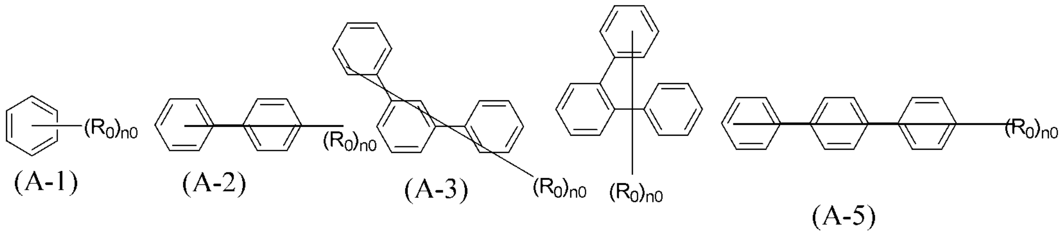
(A-1) (A-2) (A-3) (A-4) (A-5)
,

when $Ar_1$ is formula X-2, $Ar_4$ is independently a structure represented by any one selected from the group consisting of formulae (A-2) to (A-5),
a linkage site of $Ar_3$ is at a carbon atom of any phenyl ring in $Ar_3$, and fused sites of $Ar_4$ are at two ortho carbon atoms of a same phenyl ring in $Ar_4$,
$Ar_2$ is a structure represented by any one selected from the group consisting of formulae (B-1) to (B-4):

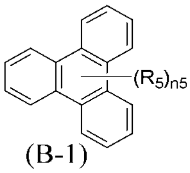
(B-1)
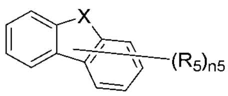
(B-2)
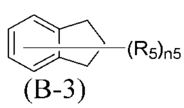
(B-3)
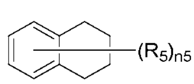
(B-4)
,

X is each independently selected from the group consisting of O, S, N-$CH_3$, N-Ph, and $C(CH_3)_2$,
$n_0$, $n_1$, $n_2$, and $n_5$ are each independently a positive integer selected from the group consisting of 0 to 14,
$R_0$, $R_1$, $R_2$, and $R_5$ are each independently selected from the group consisting of -H, -D, a linear alkyl group having 1 to 20 carbon atoms, a linear alkoxy group having 1 to 20 carbon atoms, a linear thioalkoxy group having 1 to 20 carbon atoms, a branched alkyl group having 3 to 20 carbon atoms, a cyclic alkyl group having 3 to 20 carbon atoms, a branched alkoxy group having 3 to 20 carbon atoms, a cyclic alkoxy group having 3 to 20 carbon atoms, a branched thioalkoxy group having 3 to 20 carbon atoms, a cyclic thioalkoxy group having 3 to 20 carbon atoms, a silyl group, a ketone group having 1 to 20 carbon atoms, an alkoxycarbonyl group having 2 to 20 carbon atoms, an aryloxycarbonyl group having 7 to 20 carbon atoms, an alkylene group having 1 to 20 carbon atoms, -CN, a carbamoyl group, a haloformyl group, a formyl group, an isocyano group, an isocyanate group, a thiocyanate group, an isothiocyanate group, a hydroxyl group, a nitro group, $-CF_3$, -Cl, -Br, -F, a substituted or unsubstituted aromatic group having 6 to 30 ring atoms, a substituted or unsubstituted heteroaromatic group having 5 to 30 ring

atoms, a substituted or unsubstituted aryloxy group having 6 to 30 ring atoms, and a substituted or unsubstituted heteroaryloxy group having 5 to 30 ring atoms, and
when $n_0$ is greater than or equal to 2, two adjacent $R_0$ radicals form a ring or do not form a ring with each other;
when $n_1$ is greater than or equal to 2, two adjacent $R_1$ radicals form a ring or do not form a ring with each other;
when $n_2$ is greater than or equal to 2, two adjacent $R_2$ radicals form a ring or do not form a ring with each other; and
when $n_5$ is greater than or equal to 2, two adjacent $R_5$ radicals form a ring or do not form a ring with each other.

**9.** A composition comprising an organic compound or a mixture, and at least one organic solvent,

wherein the mixture comprises the organic compound and at least one organic functional material,and the organic functional material is selected from a hole injection material, a hole transport material, an electron transport material, an electron injection material, an electron blocking material, a hole blocking material, a light-emitting material, a host material, or an organic dye,
the organic compound has a structure represented by a general formula (1) or (2):

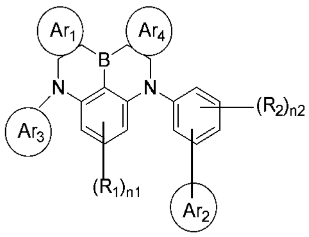
general formula (1)
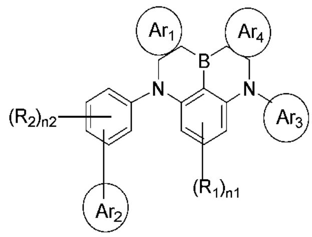
general formula (2),

$Ar_1$ is independently a structure represented by any one selected from the group consisting of formulae (X-1) to (X-3):

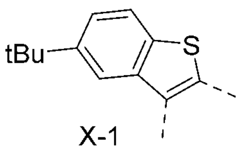
X-1
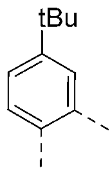
X-2
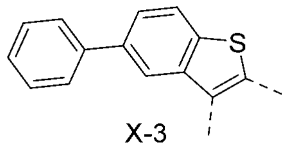
X-3
,

$Ar_3$ and $Ar_4$ are each independently a structure represented by any one selected from the group consisting of formulae (A-1) to (A-5):

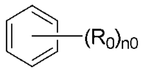
(A-1)
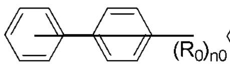
(A-2)
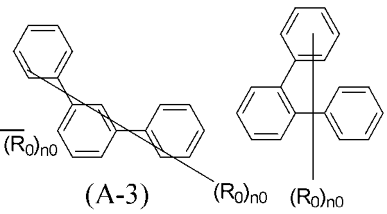
(A-3)
(A-4)
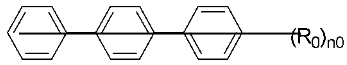
(A-5)
,

when $Ar_1$ is formula X-2, $Ar_4$ is independently a structure represented by any one selected from the group consisting of formulae (A-2) to (A-5),
a linkage site of $Ar_3$ is at a carbon atom of any phenyl ring in $Ar_3$, and fused sites of $Ar_4$ are at two ortho carbon atoms of a same phenyl ring in $Ar_4$,
$Ar_2$ is a structure represented by any one selected from the group consisting of formulae (B-1) to (B-4):

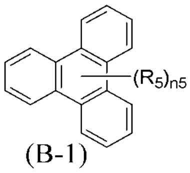 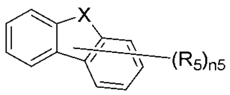 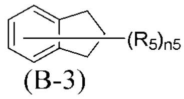 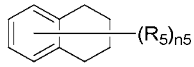

(B-1) (B-2) (B-3) (B-4) ,

X is each independently selected from the group consisting of O, S, N-$CH_3$, N-Ph, and $C(CH_3)_2$,
$n_0$, $n_1$, $n_2$, and $n_5$ are each independently a positive integer selected from the group consisting of 0 to 14,
$R_0$, $R_1$, $R_2$, and $R_5$ are each independently selected from the group consisting of -H, -D, a linear alkyl group having 1 to 20 carbon atoms, a linear alkoxy group having 1 to 20 carbon atoms, a linear thioalkoxy group having 1 to 20 carbon atoms, a branched alkyl group having 3 to 20 carbon atoms, a cyclic alkyl group having 3 to 20 carbon atoms, a branched alkoxy group having 3 to 20 carbon atoms, a cyclic alkoxy group having 3 to 20 carbon atoms, a branched thioalkoxy group having 3 to 20 carbon atoms, a cyclic thioalkoxy group having 3 to 20 carbon atoms, a silyl group, a ketone group having 1 to 20 carbon atoms, an alkoxycarbonyl group having 2 to 20 carbon atoms, an aryloxycarbonyl group having 7 to 20 carbon atoms, an alkylene group having 1 to 20 carbon atoms, -CN, a carbamoyl group, a haloformyl group, a formyl group, an isocyano group, an isocyanate group, a thiocyanate group, an isothiocyanate group, a hydroxyl group, a nitro group, -$CF_3$, -Cl, -Br, -F, a substituted or unsubstituted aromatic group having 6 to 30 ring atoms, a substituted or unsubstituted heteroaromatic group having 5 to 30 ring atoms, a substituted or unsubstituted aryloxy group having 6 to 30 ring atoms, and a substituted or unsubstituted heteroaryloxy group having 5 to 30 ring atoms, and
when $n_0$ is greater than or equal to 2, two adjacent $R_0$ radicals form a ring or do not form a ring with each other;
when $n_1$ is greater than or equal to 2, two adjacent $R_1$ radicals form a ring or do not form a ring with each other;
when $n_2$ is greater than or equal to 2, two adjacent $R_2$ radicals form a ring or do not form a ring with each other; and
when $n_5$ is greater than or equal to 2, two adjacent $R_5$ radicals form a ring or do not form a ring with each other.

**10.** An organic light-emitting device comprising:

a first electrode;
a second electrode disposed opposite to the first electrode; and
an organic functional layer between the first electrode and the second electrode,
wherein a material for the organic functional layer comprises at least one organic compound, or a mixture, or is one prepared from a composition,
the composition comprises the organic compound or the mixture, and at least one organic solvent,
the mixture comprises the organic compound and at least one organic functional material, and the organic functional material is selected from a hole injection material, a hole transport material, an electron transport material, an electron injection material, an electron blocking material, a hole blocking material, a light-emitting material, a host material, or an organic dye,
the organic compound has a structure represented by a general formula (1) or (2):

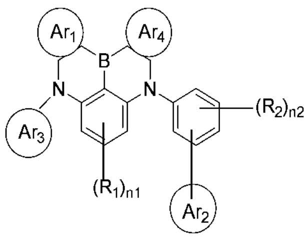
general formula (1)

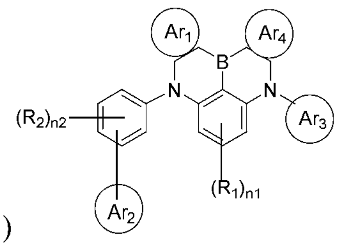
general formula (2),

$Ar_1$ is independently a structure represented by any one selected from the group consisting of formulae (X-1) to (X-3):

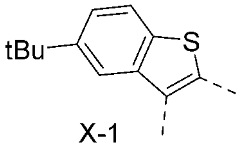
X-1
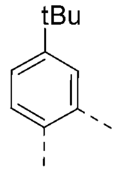
X-2
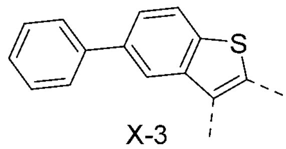
X-3
,

$Ar_3$ and $Ar_4$ are each independently a structure represented by any one selected from the group consisting of formulae (A-1) to (A-5):

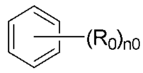
(A-1)
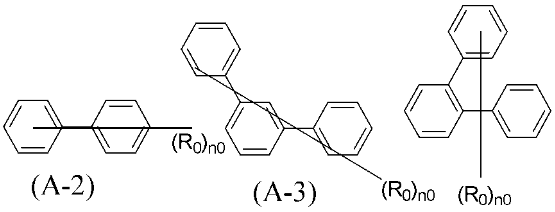
(A-2) (A-3) (A-4)
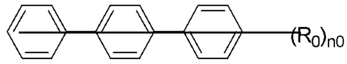
(A-5)
,

when $Ar_1$ is formula X-2, $Ar_4$ is independently a structure represented by any one selected from the group consisting of formulae (A-2) to (A-5),
a linkage site of $Ar_3$ is at a carbon atom of any phenyl ring in $Ar_3$, and fused sites of $Ar_4$ are at two ortho carbon atoms of a same phenyl ring in $Ar_4$,
$Ar_2$ is a structure represented by any one selected from the group consisting of formulae (B-1) to (B-4):

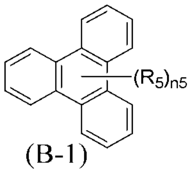
(B-1)
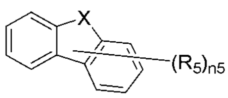
(B-2)
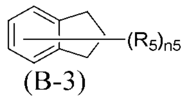
(B-3)
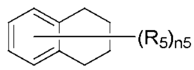
(B-4)
,

X is each independently selected from the group consisting of O, S, N-$CH_3$, N-Ph, and $C(CH_3)_2$,
$n_0$, $n_1$, $n_2$, and $n_5$ are each independently a positive integer selected from the group consisting of 0 to 14,
$R_0$, $R_1$, $R_2$, and $R_5$ are each independently selected from the group consisting of -H, -D, a linear alkyl group having 1 to 20 carbon atoms, a linear alkoxy group having 1 to 20 carbon atoms, a linear thioalkoxy group having 1 to 20 carbon atoms, a branched alkyl group having 3 to 20 carbon atoms, a cyclic alkyl group having 3 to 20 carbon atoms, a branched alkoxy group having 3 to 20 carbon atoms, a cyclic alkoxy group having 3 to 20 carbon atoms, a branched thioalkoxy group having 3 to 20 carbon atoms, a cyclic thioalkoxy group having 3 to 20 carbon atoms, a silyl group, a ketone group having 1 to 20 carbon atoms, an alkoxycarbonyl group having 2 to 20 carbon atoms, an aryloxycarbonyl group having 7 to 20 carbon atoms, an alkylene group having 1 to 20 carbon atoms, -CN, a carbamoyl group, a haloformyl group, a formyl group, an isocyano group, an isocyanate group, a thiocyanate group, an isothiocyanate group, a hydroxyl group, a nitro group, $-CF_3$, -Cl, -Br, -F, a substituted or unsubstituted aromatic group having 6 to 30 ring atoms, a substituted or unsubstituted heteroaromatic group having 5 to 30 ring atoms, a substituted or unsubstituted aryloxy group having 6 to 30 ring atoms, and a substituted or unsubstituted heteroaryloxy group having 5 to 30 ring atoms, and
when $n_0$ is greater than or equal to 2, two adjacent $R_0$ radicals form a ring or do not form a ring with each other;
when $n_1$ is greater than or equal to 2, two adjacent $R_1$ radicals form a ring or do not form a ring with each other;
when $n_2$ is greater than or equal to 2, two adjacent $R_2$ radicals form a ring or do not form a ring with each other; and
when $n_5$ is greater than or equal to 2, two adjacent $R_5$ radicals form a ring or do not form a ring with each other.

**11.** The organic light-emitting device according to claim 10, wherein the organic functional layer comprises at least a light-emitting layer, the light-emitting layer comprises a host material and a guest material, the guest material is the at least one organic compound, and the host material comprises a fused aromatic derivative or a heteroaromatic compound.

**12.** The organic light-emitting device according to claim 11, wherein the host material comprises one or more of an

anthracene derivative, a pyrene derivative, a naphthalene derivative, a pentacene derivative, a phenanthrene compound, a fluoranthene compound, a carbazole derivative, a dibenzofuran derivative, a ladder-type furan compound, or a pyrimidine derivative.

**13.** The organic light-emitting device according to claim 11, wherein a mass ratio of the host material to the guest material is 99:1 to 70:30.

**14.** A display panel comprising an organic light-emitting device, the organic light-emitting device comprising:

a first electrode;
a second electrode disposed opposite to the first electrode; and
an organic functional layer between the first electrode and the second electrode,
wherein a material for the organic functional layer comprises at least one organic compound, or a mixture, or is one prepared from a composition,
the composition comprises the organic compound or the mixture, and at least one organic solvent,
the mixture comprises the organic compound and at least one organic functional material, and the organic functional material is selected from a hole injection material, a hole transport material, an electron transport material, an electron injection material, an electron blocking material, a hole blocking material, a light-emitting material, a host material, or an organic dye,
the organic compound has a structure represented by a general formula (1) or (2):

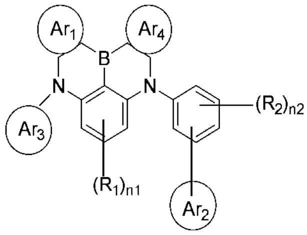
general formula (1)
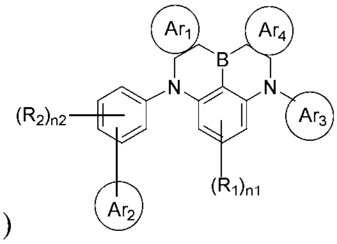
general formula (2),

$Ar_1$ is independently a structure represented by any one selected from the group consisting of formulae (X-1) to (X-3):

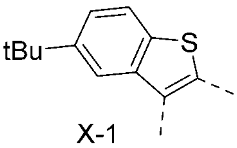
X-1
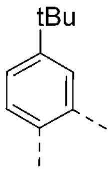
X-2
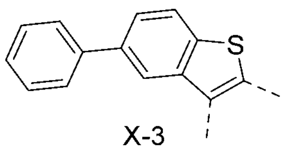
X-3
,

$Ar_3$ and $Ar_4$ are each independently a structure represented by any one selected from the group consisting of formulae (A-1) to (A-5):

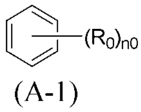
(A-1)
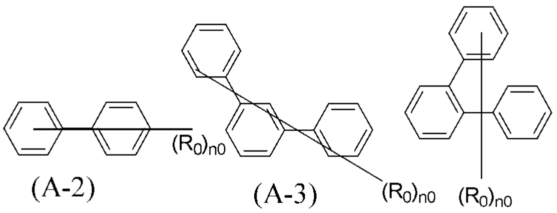
(A-2) (A-3) (A-4)
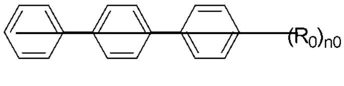
(A-5)
,

when $Ar_1$ is formula X-2, $Ar_4$ is independently a structure represented by any one selected from the group consisting of formulae (A-2) to (A-5),
a linkage site of $Ar_3$ is at a carbon atom of any phenyl ring in $Ar_3$, and fused sites of $Ar_4$ are at two ortho carbon atoms of a same phenyl ring in $Ar_4$,

$Ar_2$ is a structure represented by any one selected from the group consisting of formulae (B-1) to (B-4):

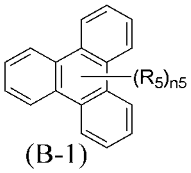
(B-1)

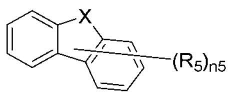
(B-2)

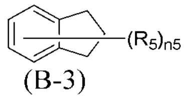
(B-3)

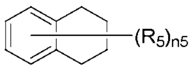
(B-4)

,

X is each independently selected from the group consisting of O, S, N-$CH_3$, N-Ph, and $C(CH_3)_2$,
$n_0$, $n_1$, $n_2$, and $n_5$ are each independently a positive integer selected from the group consisting of 0 to 14,
$R_0$, $R_1$, $R_2$, and $R_5$ are each independently selected from the group consisting of -H, -D, a linear alkyl group having 1 to 20 carbon atoms, a linear alkoxy group having 1 to 20 carbon atoms, a linear thioalkoxy group having 1 to 20 carbon atoms, a branched alkyl group having 3 to 20 carbon atoms, a cyclic alkyl group having 3 to 20 carbon atoms, a branched alkoxy group having 3 to 20 carbon atoms, a cyclic alkoxy group having 3 to 20 carbon atoms, a branched thioalkoxy group having 3 to 20 carbon atoms, a cyclic thioalkoxy group having 3 to 20 carbon atoms, a silyl group, a ketone group having 1 to 20 carbon atoms, an alkoxycarbonyl group having 2 to 20 carbon atoms, an aryloxycarbonyl group having 7 to 20 carbon atoms, an alkylene group having 1 to 20 carbon atoms, -CN, a carbamoyl group, a haloformyl group, a formyl group, an isocyano group, an isocyanate group, a thiocyanate group, an isothiocyanate group, a hydroxyl group, a nitro group, $-CF_3$, -Cl, -Br, -F, a substituted or unsubstituted aromatic group having 6 to 30 ring atoms, a substituted or unsubstituted heteroaromatic group having 5 to 30 ring atoms, a substituted or unsubstituted aryloxy group having 6 to 30 ring atoms, and a substituted or unsubstituted heteroaryloxy group having 5 to 30 ring atoms, and
when $n_0$ is greater than or equal to 2, two adjacent $R_0$ radicals form a ring or do not form a ring with each other;
when $n_1$ is greater than or equal to 2, two adjacent $R_1$ radicals form a ring or do not form a ring with each other;
when $n_2$ is greater than or equal to 2, two adjacent $R_2$ radicals form a ring or do not form a ring with each other; and
when $n_5$ is greater than or equal to 2, two adjacent $R_5$ radicals form a ring or do not form a ring with each other.

**15.** The display panel according to claim 14, wherein the organic compound has a structure represented by any one of general formulae (2-1) to (2-28):

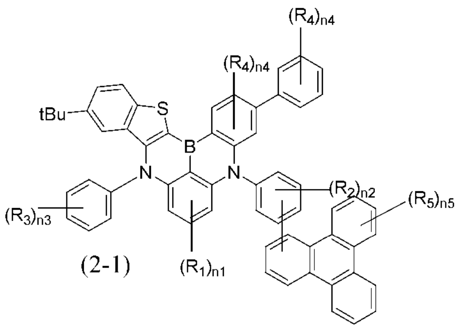
(2-1)

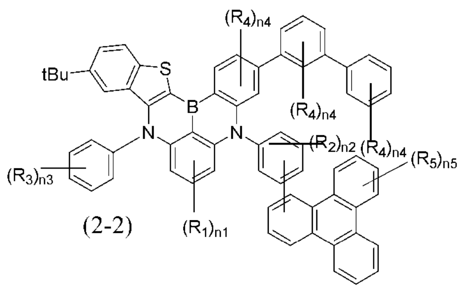
(2-2)

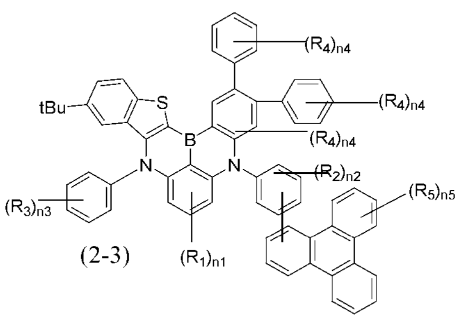
(2-3)

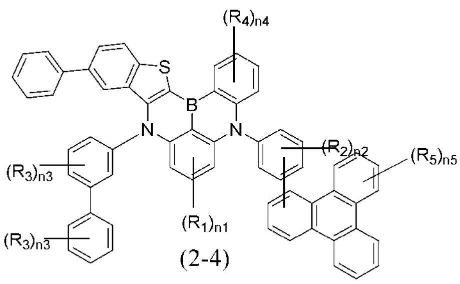
(2-4)

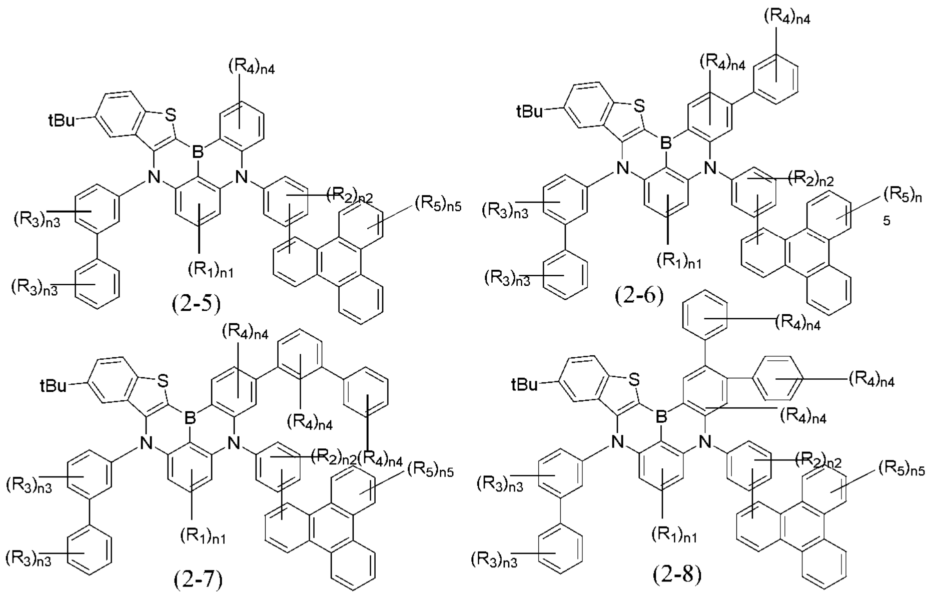

(2-5) (2-6)

(2-7) (2-8)

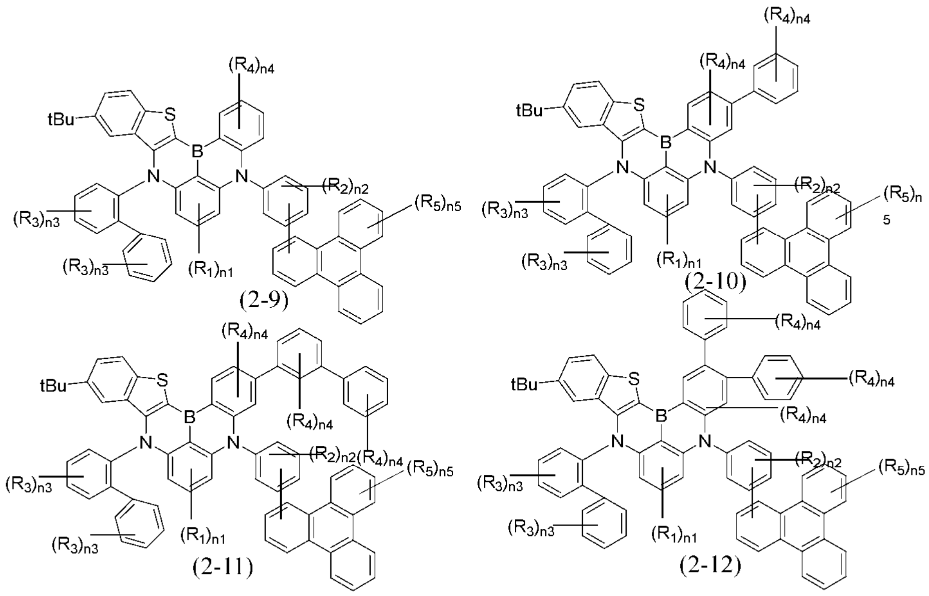

(2-9) (2-10)

(2-11) (2-12)

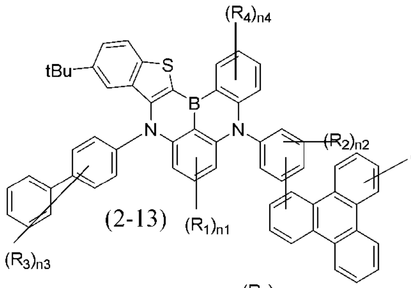
(2-13)

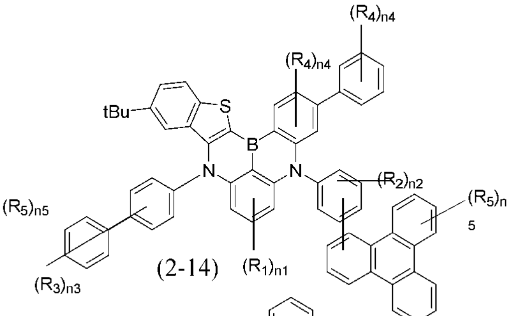
(2-14)

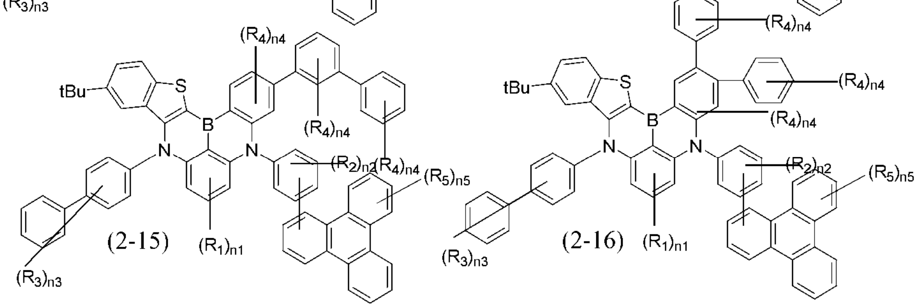
(2-15) (2-16)

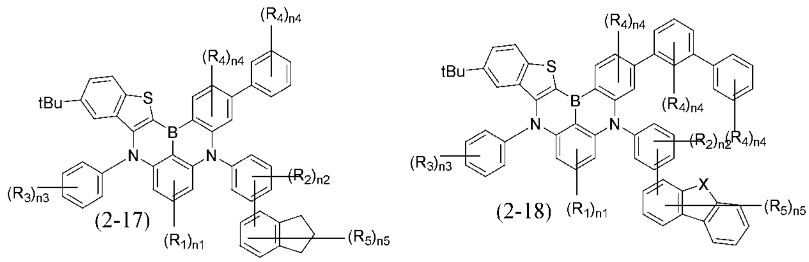
(2-17) (2-18)

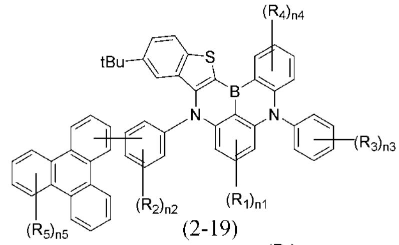
(2-19)

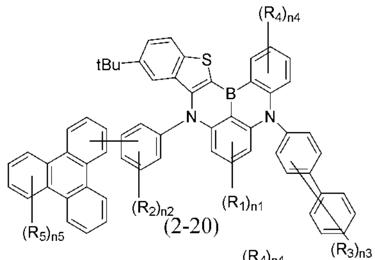
(2-20)

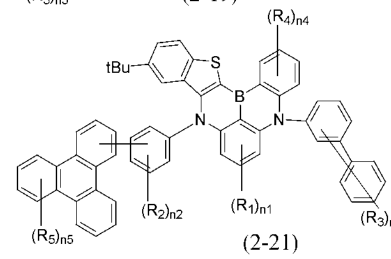
(2-21)

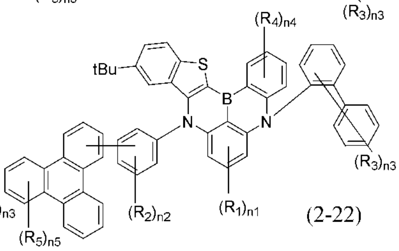
(2-22)

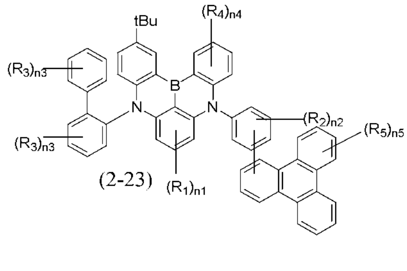
(2-23)

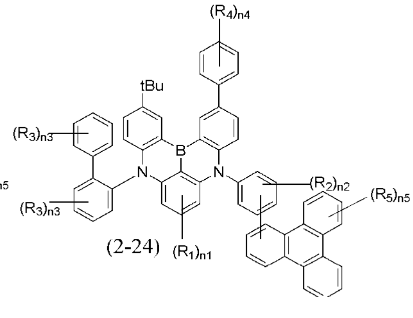
(2-24)

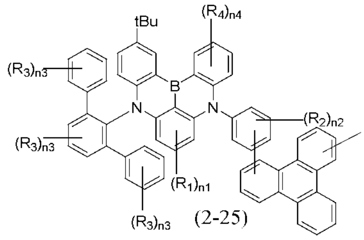
(2-25)

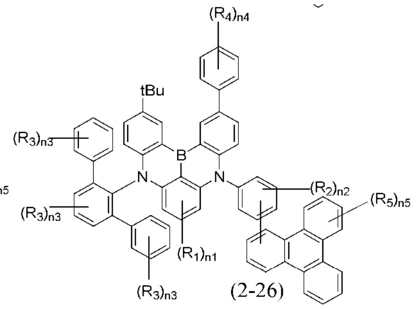
(2-26)

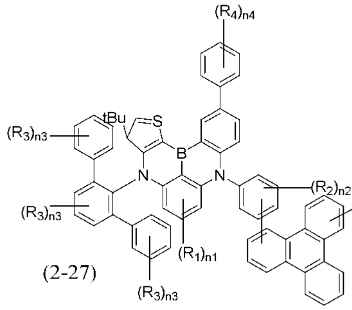
(2-27)

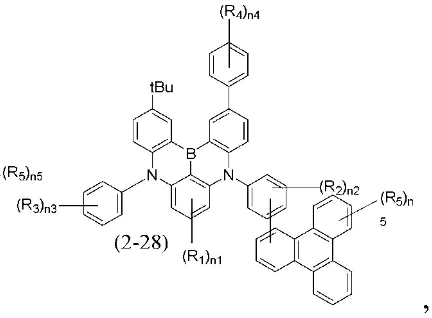
(2-28)

,

$R_3$ and $R_4$ are each independently selected from the group consisting of -H, -D, a linear alkyl group having 1 to 20 carbon atoms, a linear alkoxy group having 1 to 20 carbon atoms, a linear thioalkoxy group having 1 to 20 carbon atoms, a branched alkyl group having 3 to 20 carbon atoms, a cyclic alkyl group having 3 to 20 carbon atoms, a branched alkoxy group having 3 to 20 carbon atoms, a cyclic alkoxy group having 3 to 20 carbon atoms, a branched thioalkoxy group having 3 to 20 carbon atoms, a cyclic thioalkoxy group having 3 to 20 carbon atoms, a silyl group, a ketone group having 1 to 20 carbon atoms, an alkoxycarbonyl group having 2 to 20 carbon atoms, an aryloxycarbonyl group having 7 to 20 carbon atoms, an alkylene group having 1 to 20 carbon atoms, -CN, a carbamoyl group, a haloformyl group, a formyl group, an isocyano group, an isocyanate group, a thiocyanate group, an isothiocyanate group, a hydroxyl group, a nitro group, $-CF_3$, -Cl, -Br, -F, a substituted or unsubstituted aromatic group having 6 to 30 ring atoms, a substituted or unsubstituted heteroaromatic group having 5 to 30 ring atoms, a substituted or unsubstituted aryloxy group having 6 to 30 ring atoms, and a substituted or unsubstituted heteroaryloxy group having 5 to 30 ring atoms,
$n_3$ is greater than or equal to 0 and less than or equal to 5,
when $n_3$ is greater than or equal to 2, two adjacent $R_3$ radicals form a ring or do not form a ring with each other,
$n_4$ is greater than or equal to 0 and less than or equal to 5,
when $n_4$ is greater than or equal to 2, two adjacent $R_4$ radicals form a ring or do not form a ring with each other.

**16.** The display panel according to claim 15, wherein any one of $R_1$, $R_2$, $R_3$, $R_4$, or $R_5$ is independently selected from the group consisting of -H, -D, a linear alkyl group having 1 to 10 carbon atoms, a branched alkyl group having 3 to 10 carbon atoms, and a cyclic alkyl group having 3 to 10 carbon atoms.

**17.** The display panel according to claim 16, wherein any one of $R_1$, $R_2$, $R_3$, $R_4$, or $R_5$ is independently selected from the group consisting of -H, -D, a linear alkyl group having 1 to 4 carbon atoms, and a branched alkyl group having 3 to 5 carbon atoms.

**18.** The display panel according to claim 14, wherein when $Ar_2$ is the structure represented by the formula (B-2), the structure represented by the formula (B-2) is at least one selected from the group consisting of:

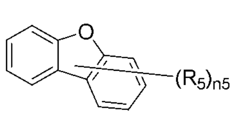
,
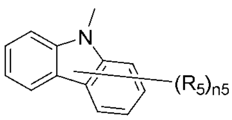
, and
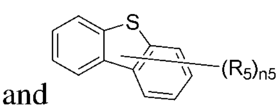
.

**19.** The display panel according to claim 14, wherein the organic functional layer comprises at least a light-emitting layer,

the light-emitting layer comprises a host material and a guest material, the guest material is the at least one organic compound, and the host material comprises a fused aromatic derivative or a heteroaromatic compound.

**20.** The display panel according to claim 19, wherein the host material comprises one or more of an anthracene derivative, a pyrene derivative, a naphthalene derivative, a pentacene derivative, a phenanthrene compound, a fluoranthene compound, a carbazole derivative, a dibenzofuran derivative, a ladder-type furan compound, or a pyrimidine derivative.

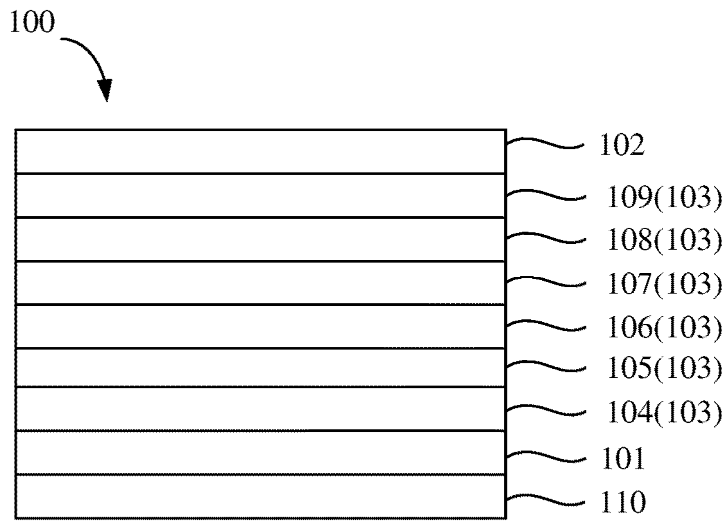
100
102
109(103)
108(103)
107(103)
106(103)
105(103)
104(103)
101
110

FIG. 1

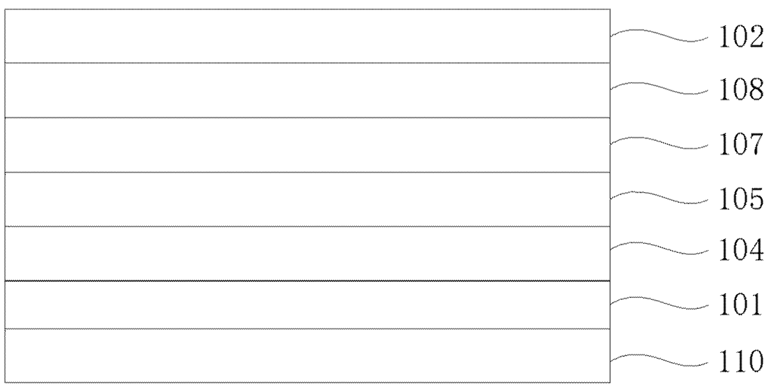
102
108
107
105
104
101
110

FIG. 2

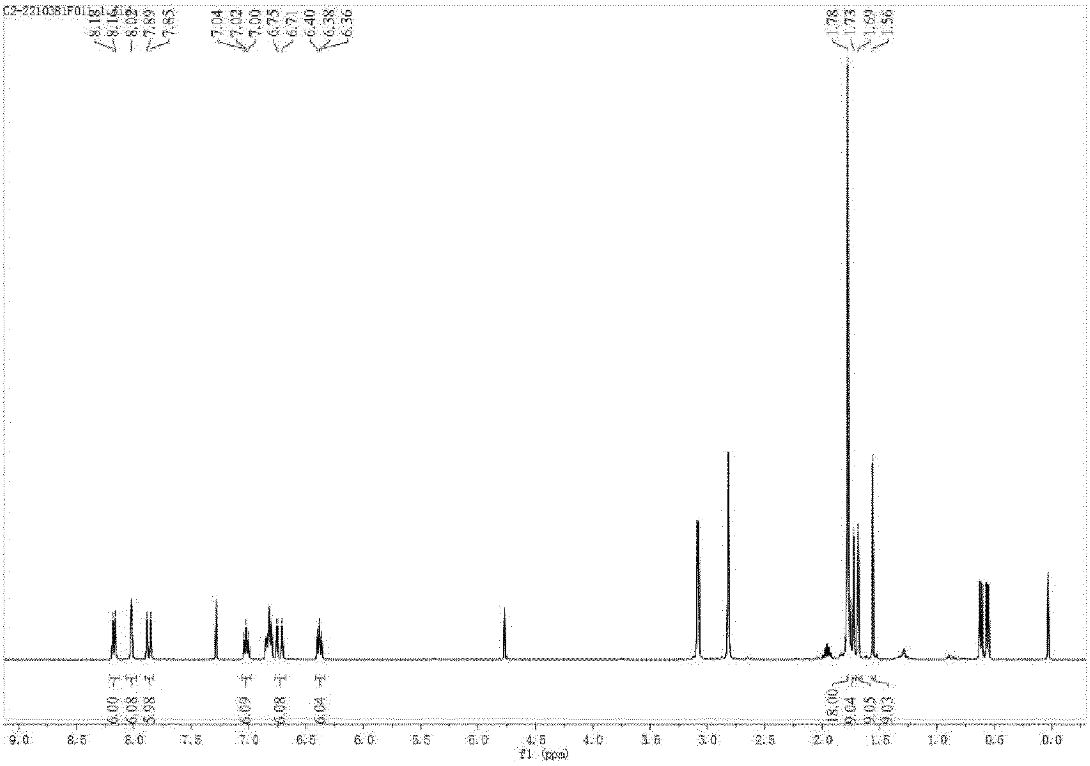

FIG. 3

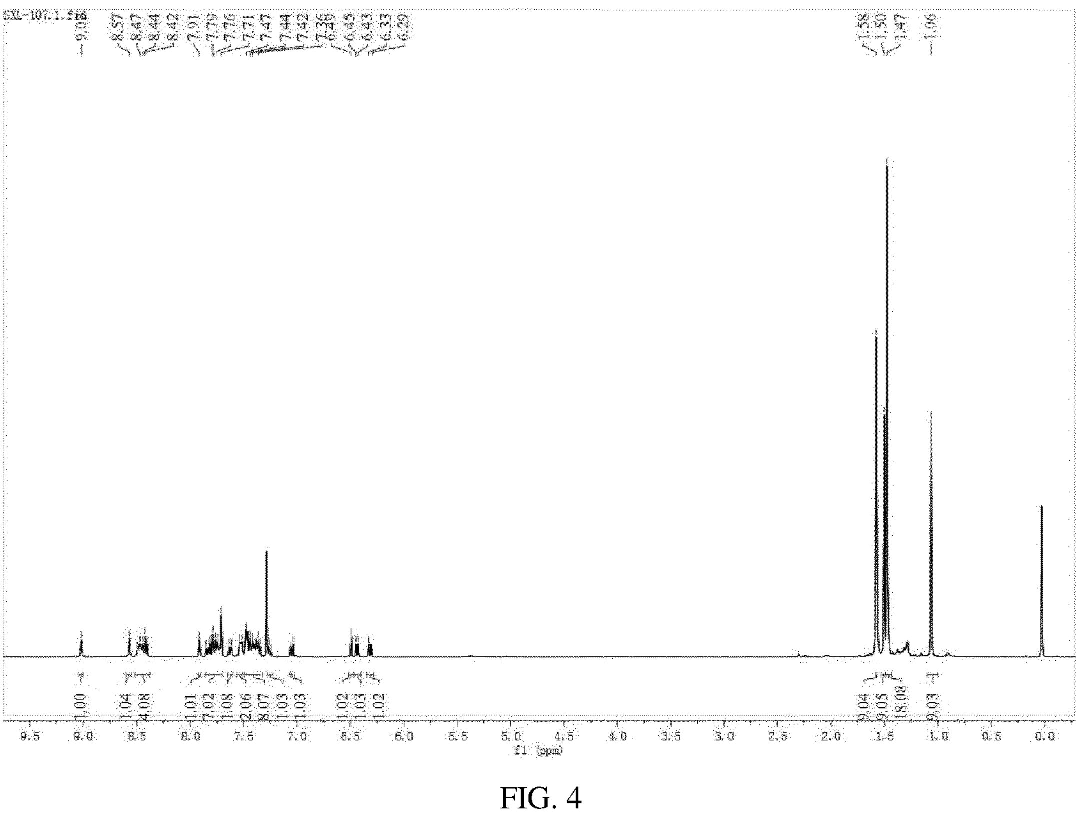

FIG. 4

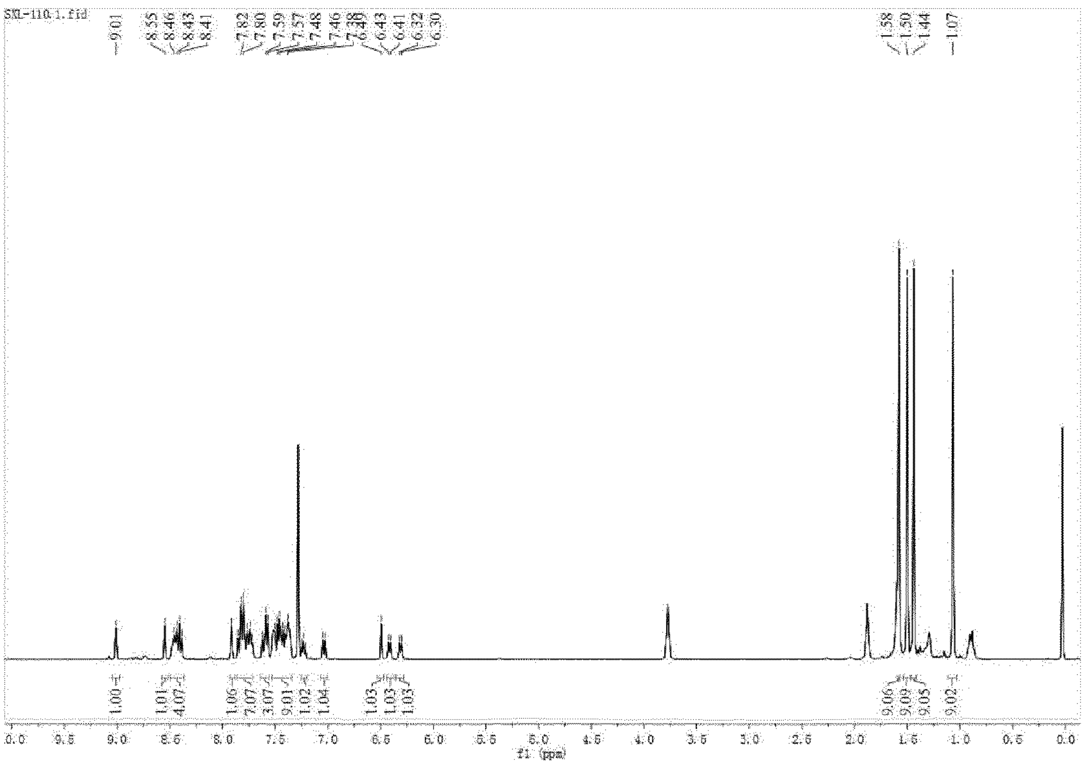


FIG. 5

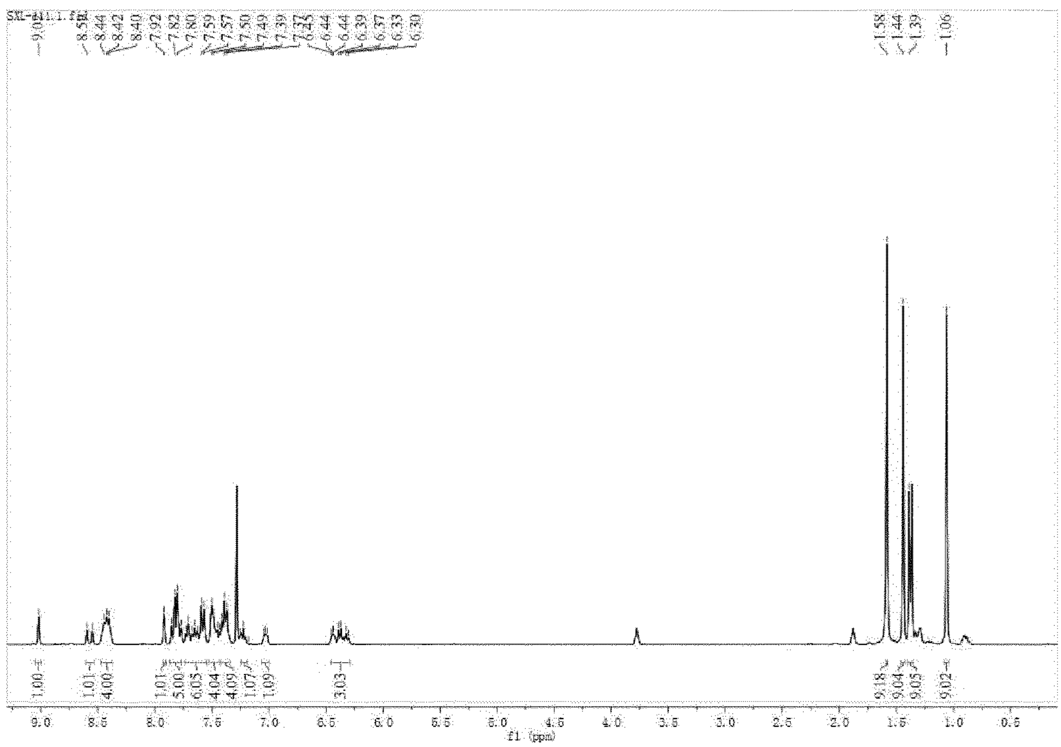


FIG. 6

**INTERNATIONAL SEARCH REPORT**

International application No.
**PCT/CN2023/104688**

**A. CLASSIFICATION OF SUBJECT MATTER**

C07F5/02(2006.01)i; C09K11/06(2006.01)i; H10K85/60(2023.01)i; H10K50/11(2023.01)i

According to International Patent Classification (IPC) or to both national classification and IPC

**B. FIELDS SEARCHED**

Minimum documentation searched (classification system followed by classification symbols)

IPC:C07F,C09K,H10K

Documentation searched other than minimum documentation to the extent that such documents are included in the fields searched

Electronic data base consulted during the international search (name of data base and, where practicable, search terms used)

CNTXT, ENTXTC, VCN, DWPI, CAPLUS(STN), REGISTRY(STN), CNKI: 发光材料, 华星光电, 热激发延迟荧光, 有机电致发光, 有机发光, OLED, TADF, light emitting, organic light emitting device, structural formula search

**C. DOCUMENTS CONSIDERED TO BE RELEVANT**

| Category* | Citation of document, with indication, where appropriate, of the relevant passages | Relevant to claim No. |
|---|---|---|
| X | CN 115724869 A (SHENZHEN CHINA STAR OPTOELECTRONICS SEMICONDUCTOR DISPLAY TECHNOLOGY CO., LTD.) 03 March 2023 (2023-03-03)<br>paragraphs 0006-0028, 0035, 0045-0054 and 0120-0160, embodiments 5 and 21, and tables 1 and 2 | 1-20 |
| X | CN 110662750 A (MATERIAL SCIENCE CO., LTD.) 07 January 2020 (2020-01-07)<br>description, paragraphs 0015-0021, 0049-0056 and 0120-0145 | 1-20 |
| X | CN 114203935 A (SAMSUNG DISPLAY CO., LTD.) 18 March 2022 (2022-03-18)<br>description, paragraphs 0224-0225 and 0243-0339 | 1-20 |
| A | CN 113924665 A (LG CHEMICAL LTD.) 11 January 2022 (2022-01-11)<br>claims 1-17 | 1-20 |
| A | CN 114957223 A (JIANGSU JINGRUNHONG MEASUREMENT AND CONTROL TECHNOLOGY CO., LTD. et al.) 30 August 2022 (2022-08-30)<br>embodiment | 1-20 |
| A | CN 114989200 A (GUANGZHOU ZHUIGUANG TECHNOLOGY CO., LTD.) 02 September 2022 (2022-09-02)<br>claims 1-10 | 1-20 |

☐ Further documents are listed in the continuation of Box C.   ☑ See patent family annex.

* Special categories of cited documents:
- "A" document defining the general state of the art which is not considered to be of particular relevance
- "D" document cited by the applicant in the international application
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| **07 October 2023** | **13 October 2023** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | <br>Telephone No. |

Form PCT/ISA/210 (second sheet) (July 2022)

**INTERNATIONAL SEARCH REPORT**
**Information on patent family members**

International application No.
**PCT/CN2023/104688**

| Patent document cited in search report | | | Publication date (day/month/year) | Patent family member(s) | | | Publication date (day/month/year) |
|---|---|---|---|---|---|---|---|
| CN | 115724869 | A | 03 March 2023 | None | | | |
| CN | 110662750 | A | 07 January 2020 | US | 2020176679 | A1 | 04 June 2020 |
| | | | | KR | 20180127918 | A | 30 November 2018 |
| | | | | KR | 101976556 | B1 | 09 May 2019 |
| | | | | JP | 2020520976 | A | 16 July 2020 |
| | | | | JP | 7026405 | B2 | 28 February 2022 |
| | | | | WO | 2018216990 | A1 | 29 November 2018 |
| | | | | KR | 101876763 | B1 | 11 July 2018 |
| CN | 114203935 | A | 18 March 2022 | US | 2022093874 | A1 | 24 March 2022 |
| | | | | KR | 20220038199 | A | 28 March 2022 |
| CN | 113924665 | A | 11 January 2022 | KR | 20210067944 | A | 08 June 2021 |
| | | | | KR | 102441139 | B1 | 07 September 2022 |
| | | | | KR | 20210067943 | A | 08 June 2021 |
| | | | | KR | 102437216 | B1 | 29 August 2022 |
| | | | | WO | 2021107699 | A1 | 03 June 2021 |
| | | | | WO | 2021107699 | A9 | 20 January 2022 |
| | | | | US | 2022271226 | A1 | 25 August 2022 |
| CN | 114957223 | A | 30 August 2022 | None | | | |
| CN | 114989200 | A | 02 September 2022 | None | | | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2010135519 A1
- US 20090134784 A1
- WO 2011110277 A1
- WO 2011141110 A